(19) Europäisches Patentamt
European Patent Office
Office européen des brevets

(11) EP 4 601 447 A1

(12) # EUROPEAN PATENT APPLICATION

(43) Date of publication:
**13.08.2025 Bulletin 2025/33**

(21) Application number: **24156446.7**

(22) Date of filing: **07.02.2024**

(51) International Patent Classification (IPC):
***H10K 85/30*** *(2023.01)*

(52) Cooperative Patent Classification (CPC):
**H10K 85/341;** H10K 50/17

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Novaled GmbH**
**01099 Dresden (DE)**

(72) Inventors:
- **UVAROV, Vladimir**
  **01099 Dresden (DE)**
- **PINTER, Piermaria**
  **01099 Dresden (DE)**
- **HEGGEMANN, Ulrich**
  **01099 Dresden (DE)**

(74) Representative: **Michalski Hüttermann & Partner Patentanwälte mbB**
**Kaistraße 16A**
**40221 Düsseldorf (DE)**

(54) **ORGANIC ELECTRONIC DEVICE COMPRISING A METAL COMPLEX OF FORMULA (I) AS WELL AS AN DISPLAY DEVICE COMPRISING THE ORGANIC ELECTRONIC DEVICE**

(57) The present invention relates to a compound of formula (Ia) as well as to an organic electronic device comprising a compound of formula (I).

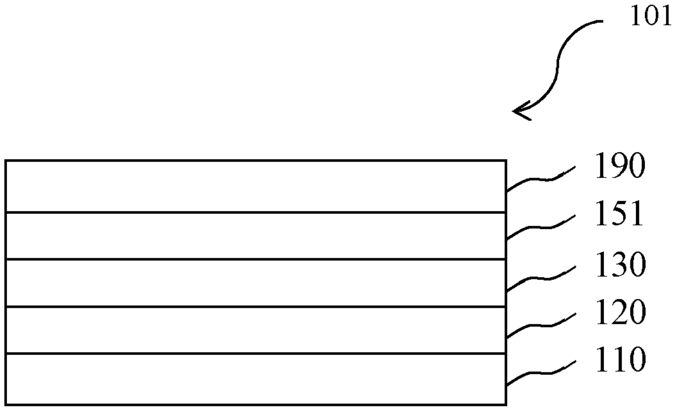


Fig.1

EP 4 601 447 A1

## Description

### Technical Field

Organic electronic device comprising a metal complex of formula (I) as well as an display device comprising the organic electronic device

### Background Art

In the past, organic electronic devices have been developed, especially in the field of organic light-emitting diodes, organic photovoltaics and organic photodetectors which inter alia can be used in display. However, there is a constant need for improved materials for such devices, especially for materials that show good properties for manufacturing and allow the build-up of devices with improved properties

### DISCLOSURE

An aspect of the present invention provides an organic electronic device comprising a first electrode, a second electrode, and a semiconductor layer arranged between the first and the second electrode wherein the semiconductor layer comprises a metal complex of Formula (I):

$$O{=}V(L)_2(AL)_m \qquad (I)$$

wherein:

L is a ligand independently selected from formula (II)

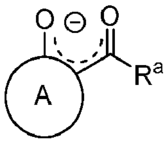

(II),

A is selected from a substituted or unsubstituted $C_3$ to $C_{40}$ carbocyclic ring or ring system, substituted or unsubstituted $C_2$ to $C_{40}$ heterocyclic ring or ring system, substituted or unsubstituted $C_6$ to $C_{40}$ aryl ring or ring system, or substituted or unsubstituted $C_2$ to $C_{40}$ heteroaryl ring or ring system, wherein the carbocyclic ring or the heterocyclic ring may contain one or more double bonds, and wherein the ring system may comprise two or three rings, preferably two rings;

$R^a$ is selected from CN, substituted or unsubstituted $C_1$ to $C_{20}$ alkyl, $CH_3$, $CH_2D$, $CHD_2$, $CD_3$, a partially fluorinated or perfluorinated $C_1$ to $C_{20}$ alkyl, $CFH_2$, CFDH, $CFD_2$, $CF_2H$, $CF_2D$, $CF_3$, substituted or unsubstituted $C_1$ to $C_{20}$ alkenyl, substituted or unsubstituted $C_1$ to $C_{20}$ alkinyl, substituted or unsubstituted $C_3$ to $C_{40}$ cycloalkyl, substituted or unsubstituted $C_2$ to $C_{40}$ heterocycloalkyl, substituted or unsubstituted $C_3$ to $C_{40}$ carbocyclyl ring, substituted or unsubstituted $C_2$ to $C_{40}$ heterocyclyl, substituted or unsubstituted $C_2$ to $C_{40}$ heteroaryl, or substituted or unsubstituted $C_6$ to $C_{40}$ aryl;

AL is an ancillary ligand;
m is an integer selected from 0 to 2.

According to a further aspect of the invention a metal complex of formula (Ia) is provided:

$$O{=}V(L)_2(AL)_m \qquad (Ia)$$

wherein:

L is a ligand independently selected from formula (IIa)

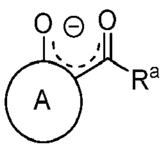

(IIa),

wherein

A is selected from a substituted or unsubstituted $C_3$ to $C_{40}$ carbocyclic ring or ring system, substituted or unsubstituted $C_2$ to $C_{40}$ heterocyclic ring or ring system, substituted or unsubstituted $C_6$ to $C_{40}$ aryl ring or ring system, or substituted or unsubstituted $C_2$ to $C_{40}$ heteroaryl ring or ring system, wherein the carbocyclic ring or the heterocyclic ring may contain one or more double bonds, and wherein the ring system may comprise two or three rings, preferably two rings;
$R^a$ is selected from CN, substituted or unsubstituted $C_1$ to $C_{20}$ alkyl, $CH_3$, $CH_2D$, $CHD_2$, $CD_3$, a partially fluorinated or perfluorinated $C_1$ to $C_{20}$ alkyl, $CFH_2$, CFDH, $CFD_2$, $CF_2H$, $CF_2D$, $CF_3$, substituted or unsubstituted $C_1$ to $C_{20}$ alkenyl, substituted or unsubstituted $C_1$ to $C_{20}$ alkinyl, substituted or unsubstituted $C_3$ to $C_{40}$ cycloalkyl, substituted or unsubstituted $C_2$ to $C_{40}$ heterocycloalkyl, substituted or unsubstituted $C_3$ to $C_{40}$ carbocyclyl ring, substituted or unsubstituted $C_2$ to $C_{40}$ heterocyclyl, substituted or unsubstituted $C_2$ to $C_{40}$ heteroaryl, or substituted or unsubstituted $C_6$ to $C_{40}$ aryl;

AL is an ancillary ligand;
m is an integer selected from 0 to 2,

whereby the following compounds are excluded:

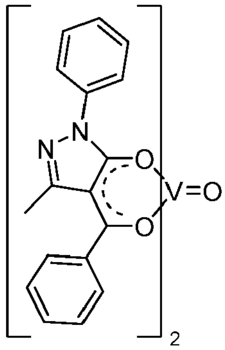 , 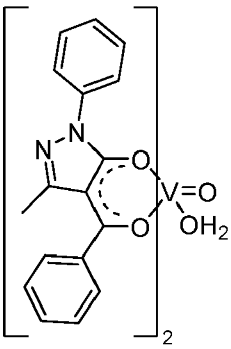 , 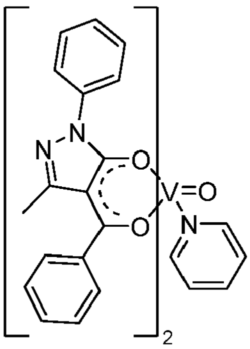 , 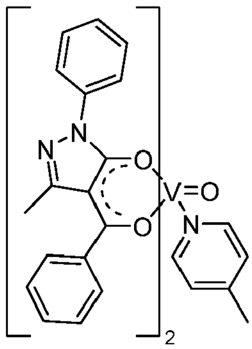 ,

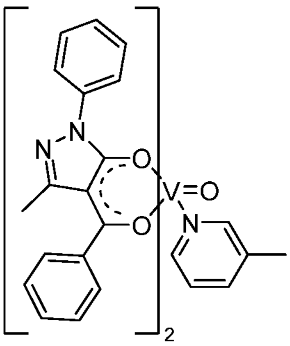 , 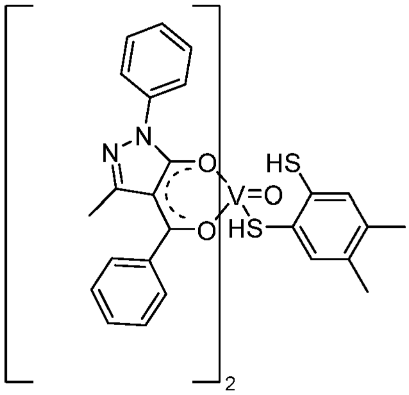 , 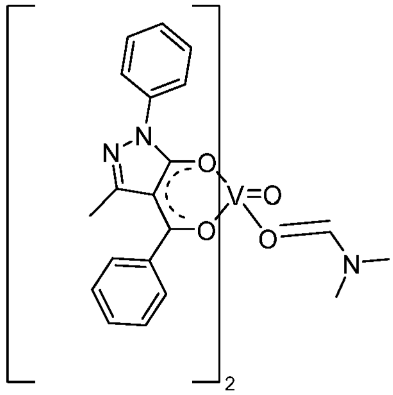 ,

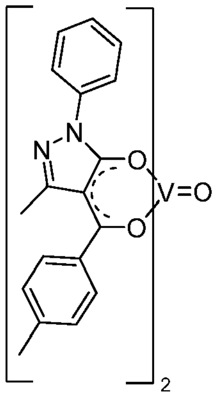 , 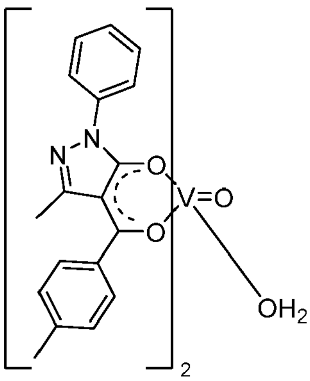 , 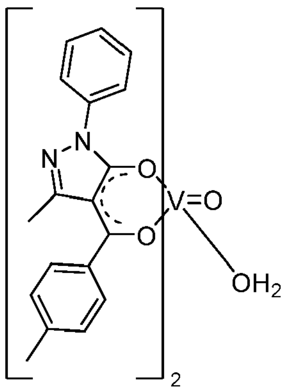 , 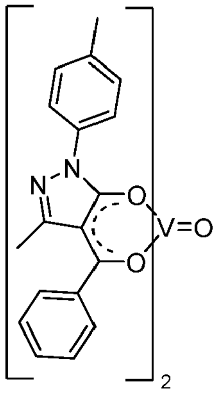 ,

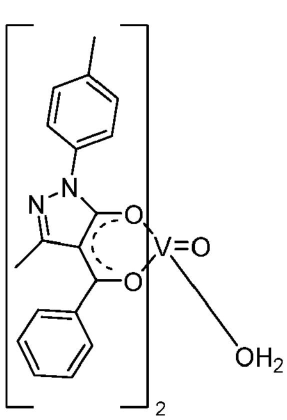, 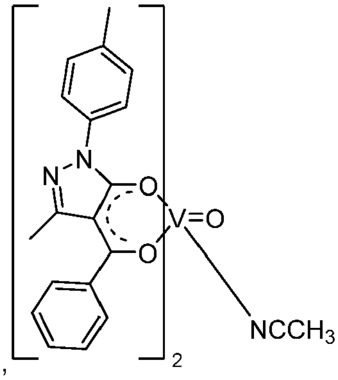, 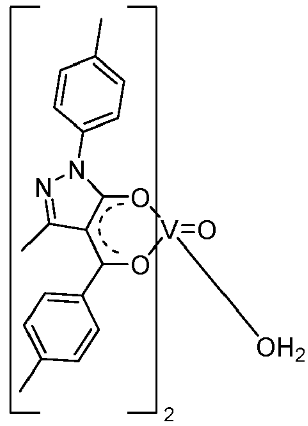,

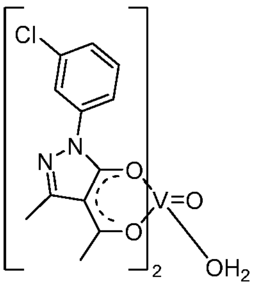, 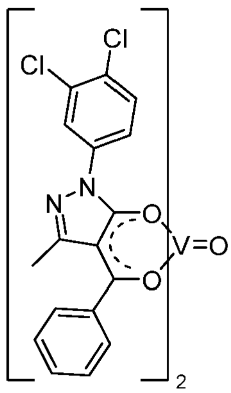, 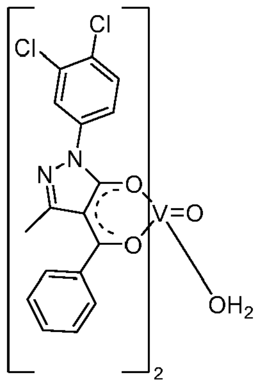, 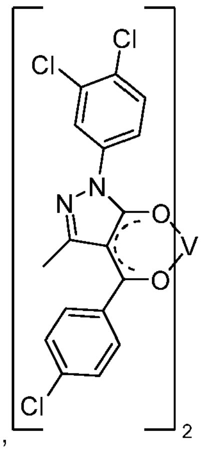,

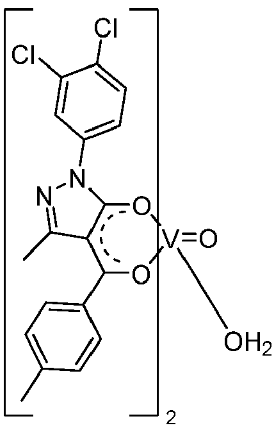, 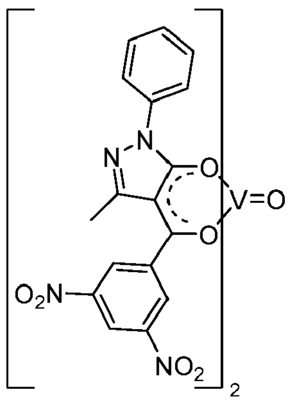, 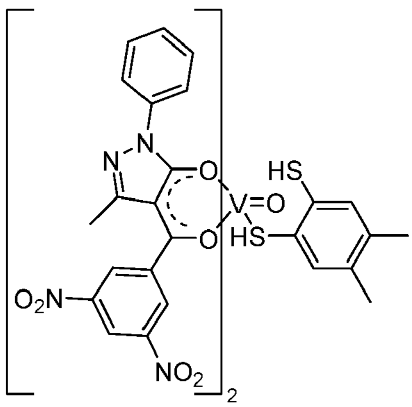,

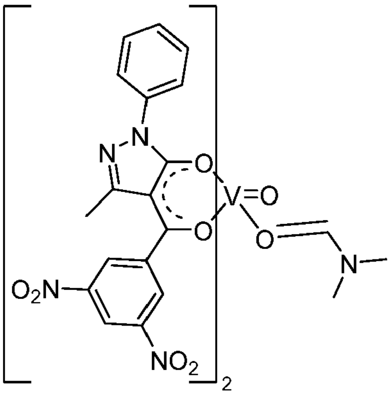, 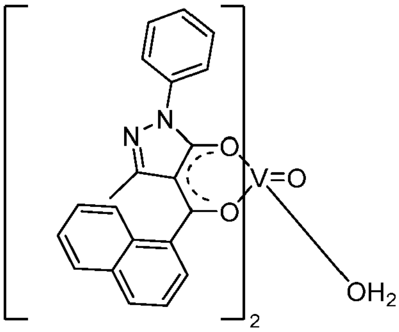, 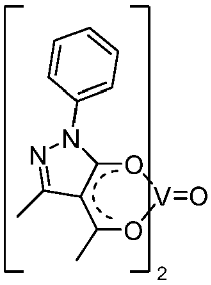,

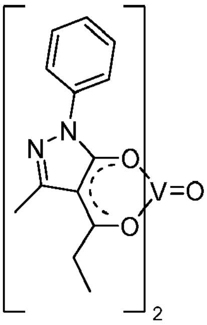, 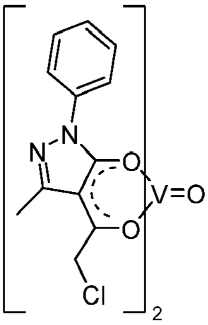, 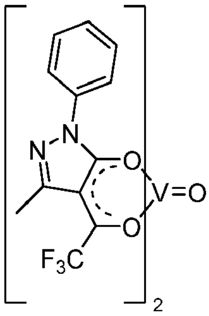, 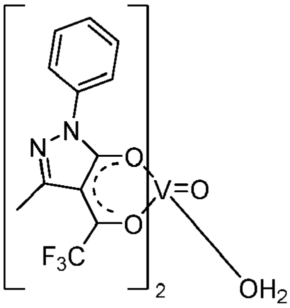, 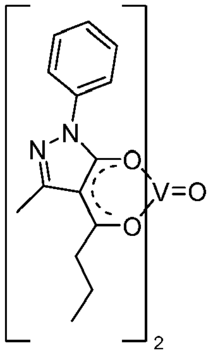,

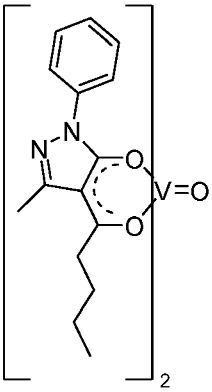, 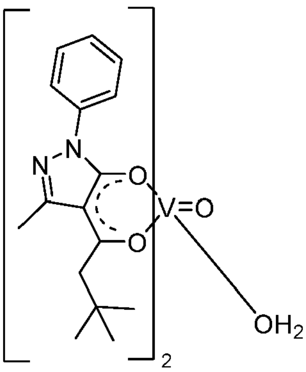, 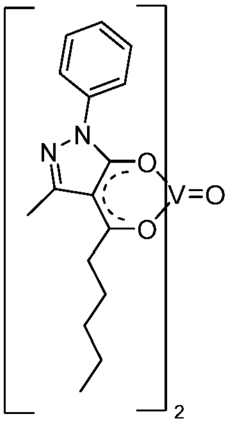, 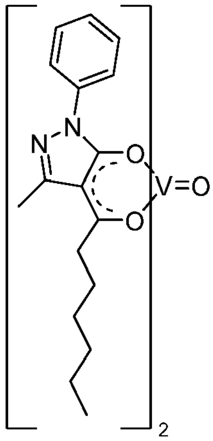,

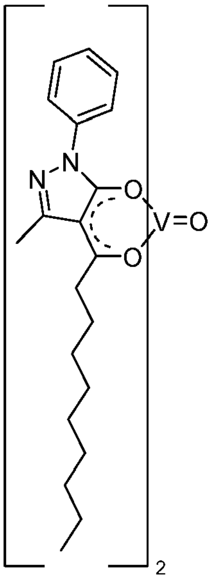 , 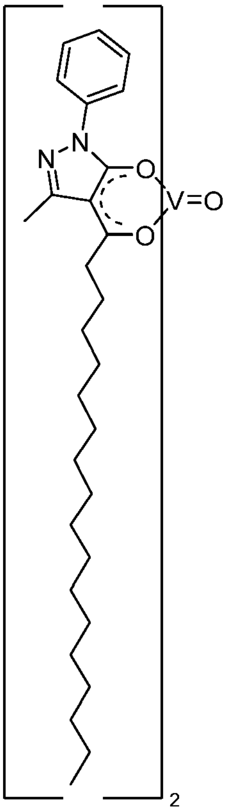 , 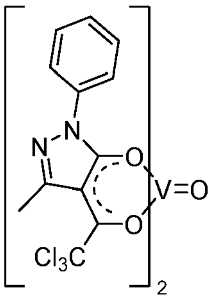 , 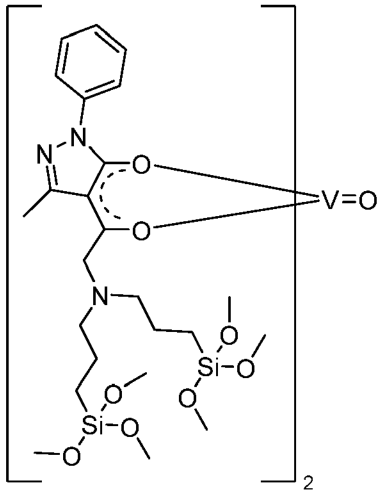 ,

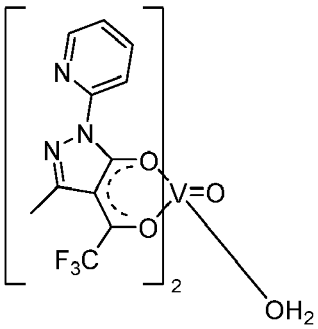 , 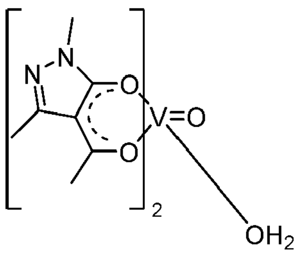 , 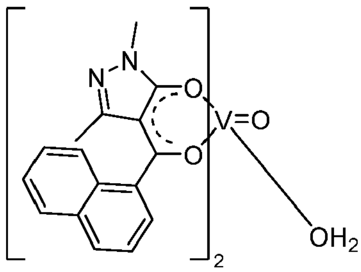 ,

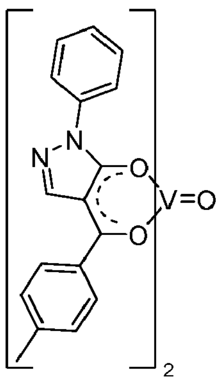 .

The negative charge in the compounds of Formula (II) or Formula (IIa) may be delocalised partially or fully over the β-dicarbonyl group and optionally also over the aryl group(s).

It should be noted that throughout the application and the claims any $R^k$ etc. always refer to the same moieties, unless otherwise noted.

It should be noted that throughout the application and the claims the term "substituents", when referring to

Formula (I) or Formula (Ia) and/or ligand L always are meant to be selected from H, D, halogen, Cl, F, CN, $NO_2$, $C_1$ to $C_{12}$ alkyl, $C_1$ to $C_{12}$ alkoxy, partially or perfluorinated $C_1$ to $C_{12}$ alkyl, $CF_3$, $CF_2H$, partially or perfluorinated $C_1$ to $C_{12}$ alkoxy, or a combination thereof.

Throughout the applications and the claims the term "ring system" shall especially mean that adjacent rings share two common atoms.

In the present specification, when a definition is not otherwise provided, "partially fluorinated" refers to an alkyl group or an alkoxy group in which only part of the hydrogen atoms are replaced by fluorine atoms.

In the present specification, when a definition is not otherwise provided, "perfluorinated" refers to an alkyl group or an alkoxy group in which all hydrogen atoms are replaced by fluorine atoms.

In the present specification, when a definition is not otherwise provided, "substituted" refers to one substituted with a deuterium, $C_1$ to $C_{12}$ alkyl and $C_1$ to $C_{12}$ alkoxy.

However, in the present specification "aryl substituted" refers to a substitution with one or more aryl groups, which themselves may be substituted with one or more aryl and/or heteroaryl groups.

Correspondingly, in the present specification "heteroaryl substituted" refers to a substitution with one or more heteroaryl groups, which themselves may be substituted with one or more aryl and/or heteroaryl groups.

In the present specification, when a definition is not otherwise provided, an "alkyl group" refers to a saturated aliphatic hydrocarbyl group. The alkyl group may be a $C_1$ to $C_{12}$ alkyl group. More specifically, the alkyl group may be a $C_1$ to $C_{10}$ alkyl group or a $C_1$ to $C_6$ alkyl group. For example, a $C_1$ to $C_4$ alkyl group includes 1 to 4 carbons in alkyl chain, and may be selected from methyl, ethyl, propyl, iso-propyl, n-butyl, iso-butyl, sec-butyl, and tert-butyl.

Specific examples of the alkyl group may be a methyl group, an ethyl group, a propyl group, an iso-propyl group, a butyl group, an iso-butyl group, a tert-butyl group, a pentyl group, a hexyl group.

In the context of the present invention, "$^iC_nH_{(2n+1)}$" denotes an iso-alkyl group and "$C_nF_{(2n+1)}$" denotes a perfluorinated iso-alkyl group.

The term "cycloalkyl" refers to saturated hydrocarbyl groups derived from a cycloalkane by formal abstraction of one hydrogen atom from a Atom comprised in the corresponding cycloalkane. Examples of the cycloalkyl group may be a cyclopropyl group, a cyclobutyl group, a cyclopentyl group, a cyclohexyl group, a methylcyclohexyl group, an adamantly group and the like.

The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S.

In the present specification, "aryl group" refers to a hydrocarbyl group which can be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or aromatic ring system refers to a planar ring or ring system of covalently bound carbon atoms, wherein the planar ring or ring system comprises a conjugated system of delocalized electrons fulfilling Hückel's rule. Examples of aryl groups include monocyclic groups like phenyl or tolyl, polycyclic groups which comprise more aromatic rings linked by single bonds, like biphenyl, and polycyclic groups comprising fused rings, like naphthyl or fluorenyl.

Analogously, under heteroaryl, it is especially where suitable understood a group derived by formal abstraction of one ring hydrogen from a heterocyclic aromatic ring in a compound comprising at least one such ring.

Under heterocycloalkyl, it is especially where suitable understood a group derived by formal abstraction of one ring hydrogen from a saturated cycloalkyl ring in a compound comprising at least one such ring.

The term "fused aryl rings" or "condensed aryl rings" is understood the way that two aryl rings are considered fused or condensed when they share at least two common $sp^2$-hybridized carbon atoms

In the present specification, the single bond refers to a direct bond.

In the context of the present invention, "different" means that the compounds do not have an identical chemical structure.

The term "free of", "does not contain", "does not comprise" does not exclude impurities which may be present in the compounds prior to deposition. Impurities have no technical effect with respect to the object achieved by the present invention.

The term "contacting sandwiched" refers to an arrangement of three layers whereby the layer in the middle is in direct contact with the two adjacent layers.

The term "adjacent" in the context of layers especially means that one or two layers may be present between the adjacent layers.

The term "shared" and/or "common" in the context of layers especially means that the layer that is "shared" or "common" forms part of the device(s) that share the layer.

The term "contacting sandwiched" refers to an arrangement of three layers whereby the layer in the middle is in direct contact with the two adjacent layers.

The terms "light-absorbing layer" and "light absorption layer" are used synonymously.

The terms "light-emitting layer", "light emission layer" and "emission layer" are used synonymously.
The terms "OLED", "organic light-emitting diode" and "organic light-emitting device" are used synonymously.
The terms anode, anode layer and anode electrode are used synonymously.
The terms cathode, cathode layer and cathode electrode are used synonymously.
In the specification, hole characteristics refer to an ability to donate an electron to form a hole when an electric field is applied and that a hole formed in the anode may be easily injected into the emission layer and transported in the emission layer due to conductive characteristics according to a highest occupied molecular orbital (HOMO) level.
In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) level.
The term "LUMO level" is understood to mean the lowest unoccupied molecular orbital and is determined in eV (electron volt). The LUMO may also be named "LUMO" or "LUMO energy level".
The term "LUMO level further away from vacuum level" is understood to mean that the absolute value of the LUMO level is higher than the absolute value of the LUMO level of the reference compound.
The term "HOMO level" is understood to mean the highest occupied molecular orbital and is determined in eV (electron volt).
The term "HOMO level further away from vacuum level" is understood to mean that the absolute value of the HOMO level is higher than the absolute value of the HOMO level of the reference compound. For example, the term "further away from vacuum level than the HOMO level of N2,N2,N2',N2',N7,N7,N7',N7'-octakis(4-methoxyphenyl)-9,9'-spirobi [fluorene]-2,2',7,7'-tetraamine is understood to mean that the absolute value of the HOMO level of the matrix compound of the hole injection layer is higher than the HOMO level of N2,N2,N2',N2', N7,N7, N7',N7'-octakis(4-methoxyphenyl)-9,9'-spirobi[fluorene]-2,2',7,7'-tetraamine.
The term "absolute value" is understood to mean the value without the "- "symbol. According to one embodiment of the present invention, the HOMO level of the matrix compound of the hole injection layer may be calculated by quantum mechanical methods.

**Advantageous Effects**

Surprisingly, it was found that many compounds of formula (I) or (Ia) show good processing properties and that many organic devices of the present invention show improved performance in particular a reduced operational voltage and improved stability especially concerning voltage stability over time.
According to one embodiment, the organic electronic device is an electroluminescent device, an organic electroluminescent device, an organic light emitting diode (OLED), a light emitting device, a thin film transistor, a battery, a display device, an organic photovoltaic cell (OPV), organic solar cell (OSC), or an organic photodetector (OPD).
According to one embodiment, the metal complex of formula (I) does not include the following compounds:

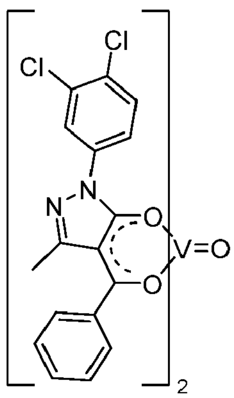

and

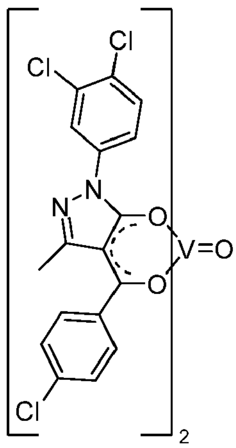

.

According to an embodiment, in the organic electronic device the following compounds of formula (I) are excluded:

| O=V(IV) | Ligand L | Valency m |
|---|---|---|
| O=V(IV) | 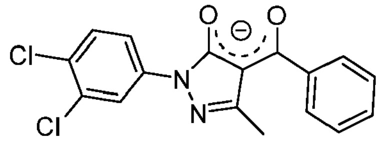 | 0 |
| O=V(IV) | 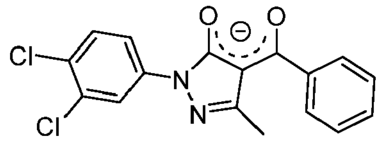 | 1 |
| O=V(IV) | 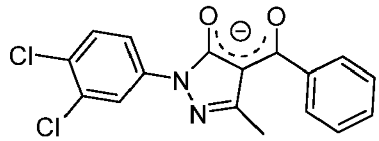 | 2 |
| O=V(IV) | 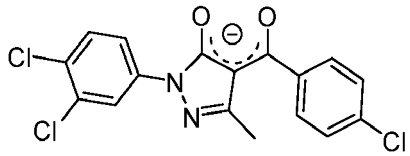 | 0 |
| O=V(IV) | 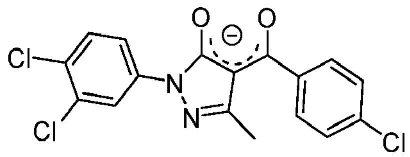 | 1 |
| O=V(IV) | 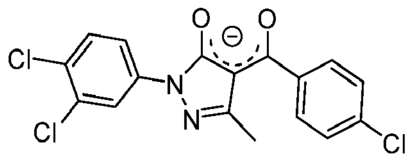 | 2 |

According to an embodiment, wherein the following compounds are excluded from the compound of formula (Ia)

| O=V(IV) | Ligand L | Valency m |
|---|---|---|
| O=V(IV) | 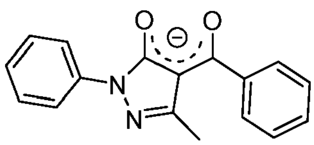 | 0 |
| O=V(IV) | 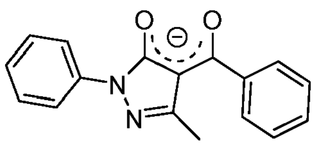 | 1 |
| O=V(IV) | 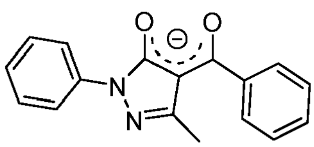 | 2 |

(continued)

| O=V(IV) | Ligand L | Valency m |
|---|---|---|
| O=V(IV) | 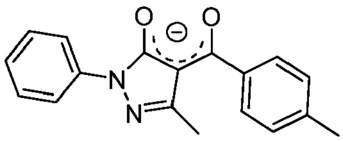 | 0 |
| O=V(IV) | 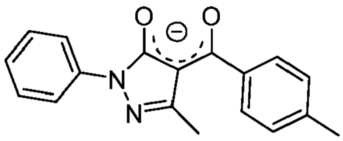 | 1 |
| O=V(IV) | 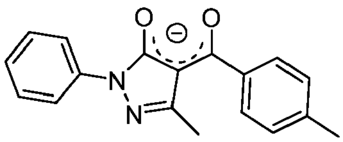 | 2 |
| O=V(IV) | 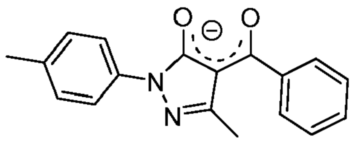 | 0 |
| O=V(IV) | 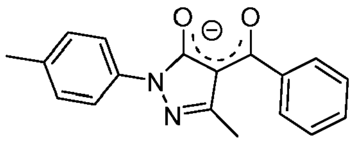 | 1 |
| O=V(IV) | 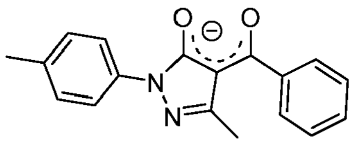 | 2 |
| O=V(IV) | 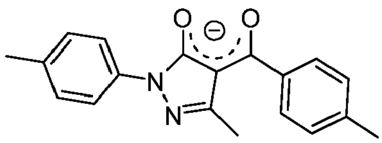 | 0 |
| O=V(IV) | 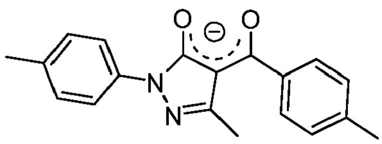 | 1 |
| O=V(IV) | 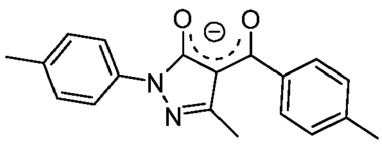 | 2 |
| O=V(IV) | 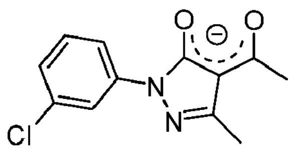 , | 0 |

(continued)

| O=V(IV) | Ligand L | Valency m |
|---|---|---|
| O=V(IV) | 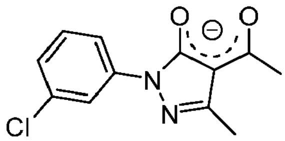 | 1 |
| O=V(IV) | 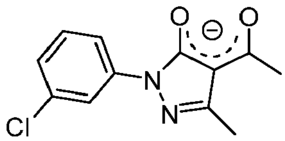 | 2 |
| O=V(IV) | 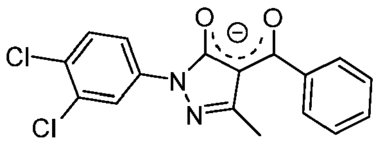 | 0 |
| O=V(IV) | 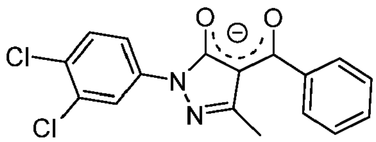 | 1 |
| O=V(IV) | 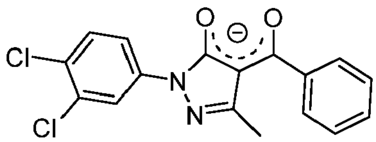 | 2 |
| O=V(IV) | 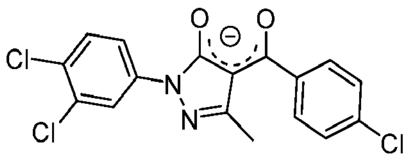 | 0 |
| O=V(IV) | 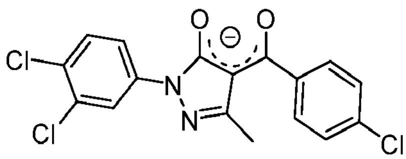 | 1 |
| O=V(IV) | 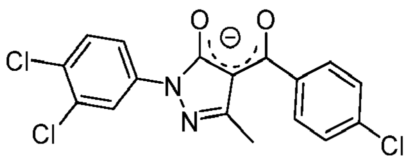 | 2 |
| O=V(IV) | 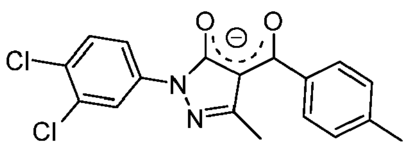 | 0 |
| O=V(IV) | 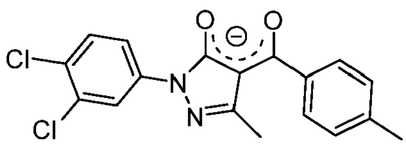 | 1 |

(continued)

| O=V(IV) | Ligand L | Valency m |
|---|---|---|
| O=V(IV) | 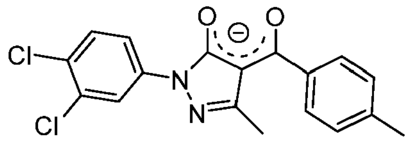 | 2 |
| O=V(IV) | 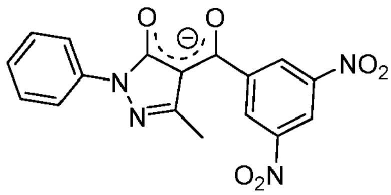 | 0 |
| O=V(IV) | 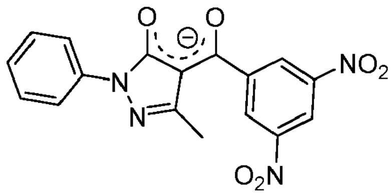 | 1 |
| O=V(IV) | 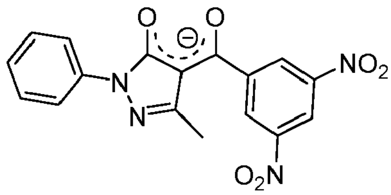 | 2 |
| O=V(IV) | 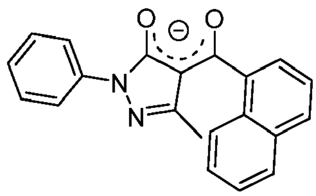 | 0 |
| O=V(IV) | 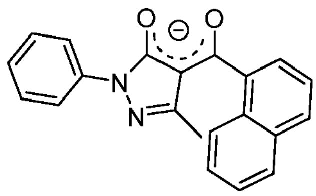 | 1 |
| O=V(IV) | 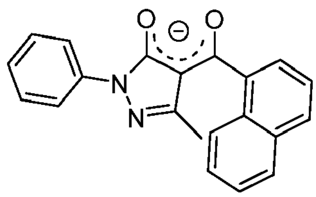 | 2 |
| O=V(IV) | 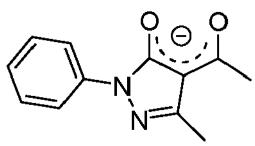 | 0 |

(continued)

| O=V(IV) | Ligand L | Valency m |
|---|---|---|
| O=V(IV) | 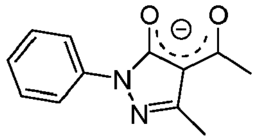 | 1 |
| O=V(IV) | 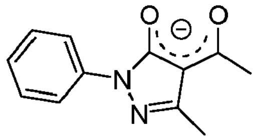 | 2 |
| O=V(IV) | 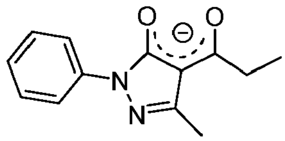 | 0 |
| O=V(IV) | 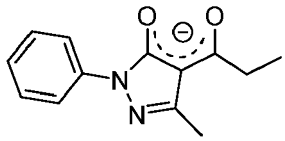 | 1 |
| O=V(IV) | 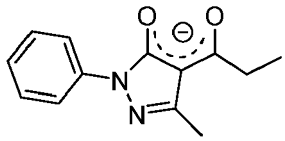 | 2 |
| O=V(IV) | 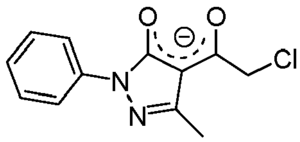 | 0 |
| O=V(IV) | 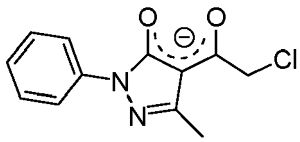 | 1 |
| O=V(IV) | 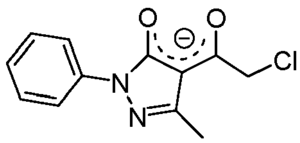 | 2 |
| O=V(IV) | 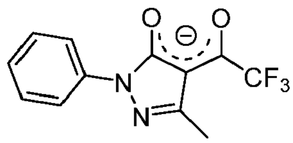 | 0 |
| O=V(IV) | 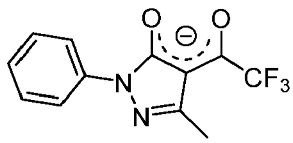 | 1 |

(continued)

| O=V(IV) | Ligand L | Valency m |
|---|---|---|
| O=V(IV) | 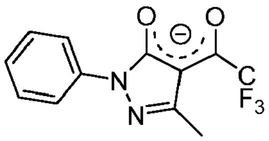 | 2 |
| O=V(IV) | 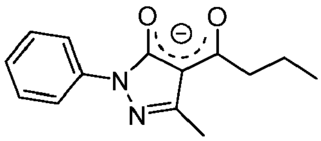 | 0 |
| O=V(IV) | 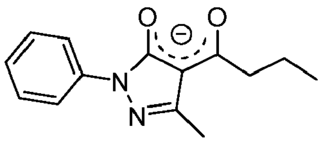 | 1 |
| O=V(IV) | 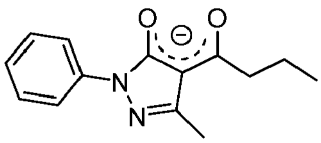 | 2 |
| O=V(IV) | 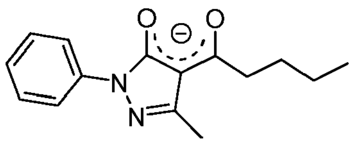 | 0 |
| O=V(IV) | 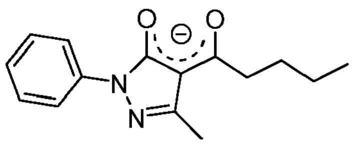 | 1 |
| O=V(IV) | 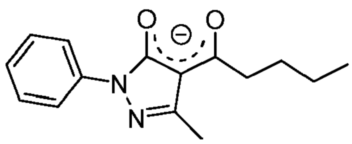 | 2 |
| O=V(IV) | 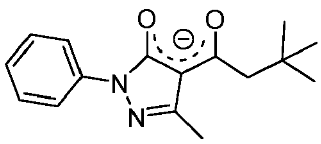 | 0 |
| O=V(IV) | 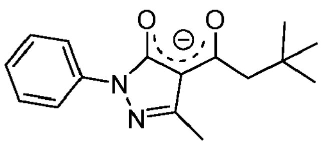 | 1 |
| O=V(IV) | 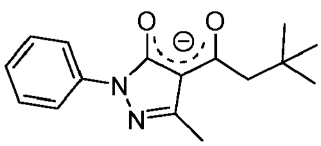 | 2 |

(continued)

| O=V(IV) | Ligand L | Valency m |
|---|---|---|
| O=V(IV) | 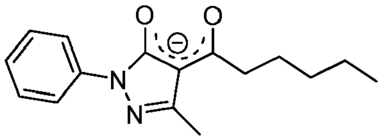 | 0 |
| O=V(IV) | 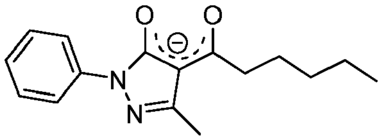 | 1 |
| O=V(IV) | 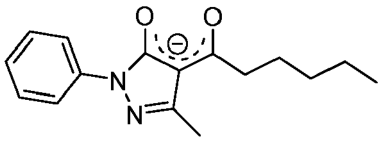 | 2 |
| O=V(IV) | 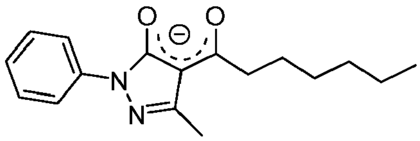 | 0 |
| O=V(IV) | 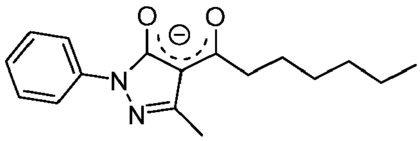 | 1 |
| O=V(IV) | 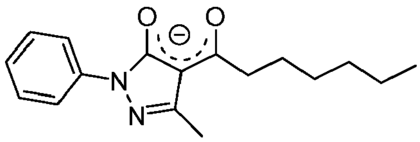 | 2 |
| O=V(IV) | 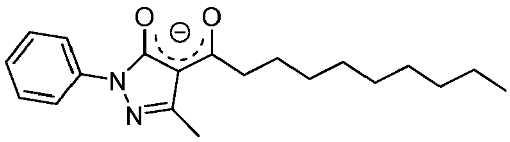 | 0 |
| O=V(IV) | 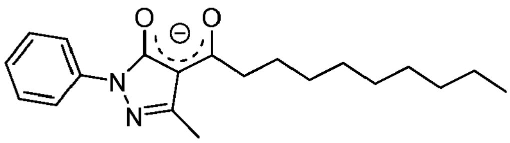 | 1 |
| O=V(IV) | 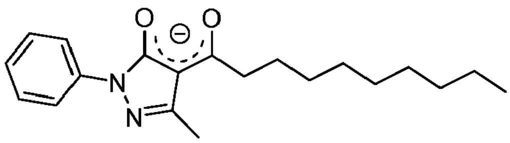 | 2 |
| O=V(IV) | 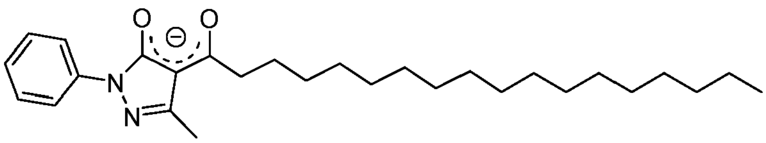 | 0 |

(continued)

| O=V(IV) | Ligand L | Valency m |
|---|---|---|
| O=V(IV) | 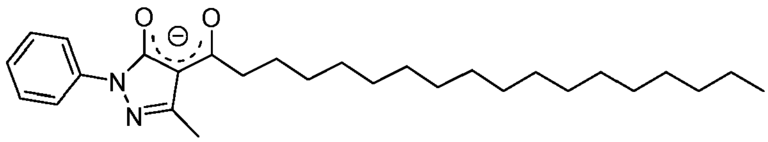 | 1 |
| O=V(IV) | 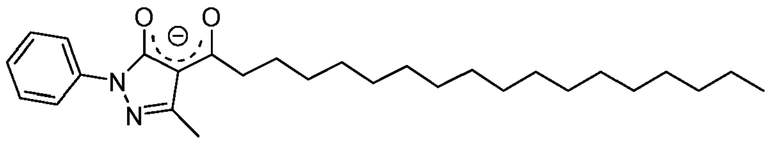 | 2 |
| O=V(IV) | 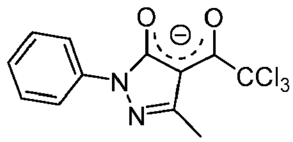 | 0 |
| O=V(IV) | 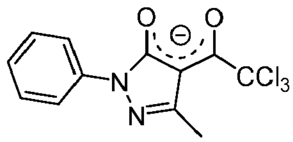 | 1 |
| O=V(IV) | 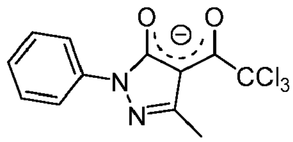 | 2 |
| O=V(IV) | 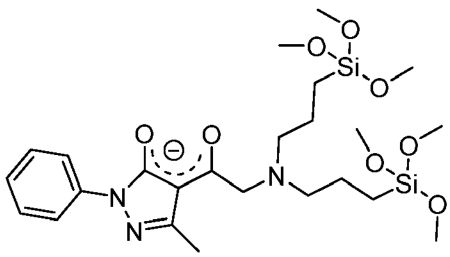 | 0 |
| O=V(IV) | 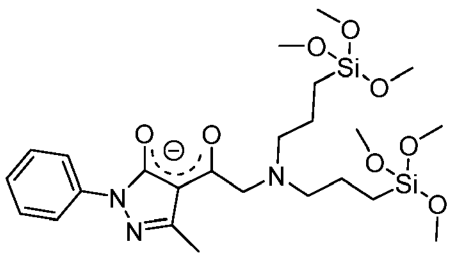 | 1 |
| O=V(IV) | 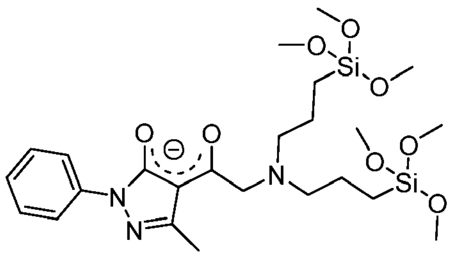 | 2 |

(continued)

| O=V(IV) | Ligand L | Valency m |
|---|---|---|
| O=V(IV) | 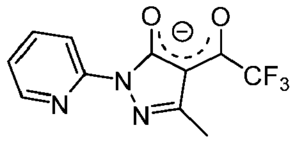 | 0 |
| O=V(IV) | 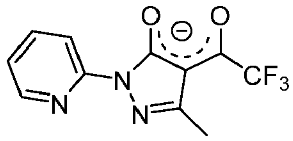 | 1 |
| O=V(IV) | 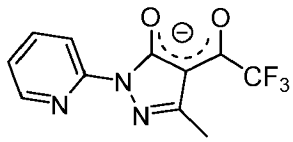 | 2 |
| O=V(IV) | 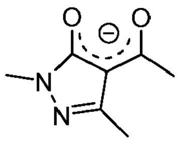 | 0 |
| O=V(IV) | 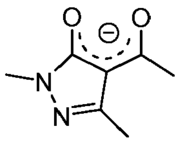 | 1 |
| O=V(IV) | 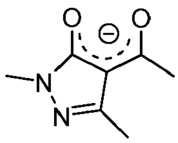 | 2 |
| O=V(IV) | 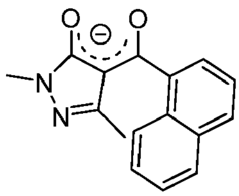 | 0 |
| O=V(IV) | 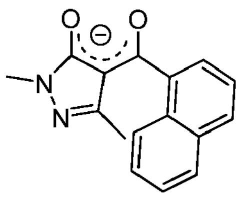 | 1 |
| O=V(IV) | 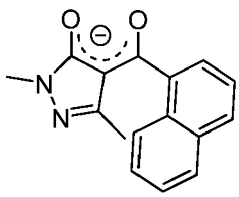 | 2 |

(continued)

| O=V(IV) | Ligand L | Valency m |
|---|---|---|
| O=V(IV) | 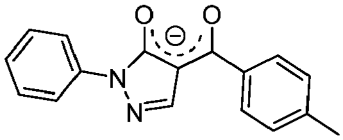 | 0 |
| O=V(IV) | 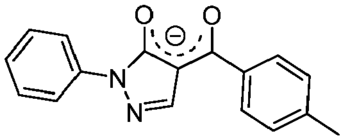 | 1 |
| O=V(IV) | 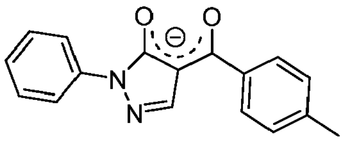 | 2 |

According to one embodiment, the molecular mass of L is selected in the range of ≤ 600 Da and ≥ 176 , preferably ≤ 550 Da and ≥ 280 Da and most preferred ≤ 550 Da and ≥ 240 Da.

According to one embodiment of the invention, the metal complex of Formula (I) or Formula (Ia) comprises at least two fluorine atoms and 10 fluorine atoms or less, preferably 8 fluorine atoms or less.

According to an embodiment, wherein the ligand L of formula (II) or formula (IIa) comprises at least one fluorine atom.

According to an embodiment, wherein the ligand L of formula (II) or formula (IIa) comprises at least two fluorine atoms.

According to an embodiment, wherein the ligand L of formula (II) or formula (IIa) comprises one to ten fluorine atoms; preferably two to ten fluorine atoms; more preferably two to eight fluorine atoms.

According to one embodiment of the present invention, the ligand of formula (II) or formula (IIa) is free of alkoxy groups.

According to an embodiment, both ligands L of formula (II) or formula (IIa) are selected the same.

According to an embodiment, Ligand L is selected from formula (IIb):

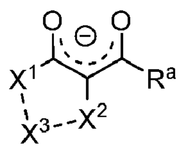 (IIb),

wherein the dashed lines in formula (IIb) denote a single or double bond;

$X^1$ is selected from a direct bond, N, O, $NR^1$, $CR^1$;

$X^2$ is selected from N, O, $CR^2$, CO, $SO_2$;

$X^3$ is selected from N, O, $CR^3$, $NR^3$ or substituted or unsubstituted $C_1$ to $C_3$ alkylenediyl group;

$R^1$ is selected from substituted or unsubstituted $C_1$ to $C_{12}$ alkyl, substituted or unsubstituted $C_6$ to $C_{19}$ aryl or $C_2$ to $C_{20}$ heteroaryl group;

$R^2$ is selected from H, D, CN, substituted or unsubstituted $C_1$ to $C_{12}$ alkyl, substituted or unsubstituted $C_3$ to $C_5$ alkenyl, substituted or unsubstituted $C_6$ to $C_{19}$ aryl or $C_2$ to $C_{20}$ heteroaryl group;

$R^3$ is selected from H, D, substituted or unsubstituted $C_1$ to $C_{12}$ alkyl, substituted or unsubstituted $C_3$ to $C_5$ alkenyl, substituted or unsubstituted $C_6$ to $C_{19}$ aryl or $C_2$ to $C_{20}$ heteroaryl group;

wherein two of $X^1$, $X^3$, $R^1$ and $R^3$ may form a 5 to 7 membered ring;

$R^a$ is selected from CN, substituted or unsubstituted $C_1$ to $C_{20}$ alkyl, $CH_3$, $CH_2D$, $CHD_2$, $CD_3$, a partially fluorinated or perfluorinated $C_1$ to $C_{20}$ alkyl, $CFH_2$, CFDH, $CFD_2$, $CF_2H$, $CF_2D$, $CF_3$, substituted or unsubstituted $C_1$ to $C_{20}$ alkenyl, substituted or unsubstituted $C_1$ to $C_{20}$ alkinyl, substituted or unsubstituted $C_3$ to $C_{40}$ cycloalkyl, substituted or unsubstituted $C_2$ to $C_{40}$ heterocycloalkyl, substituted or unsubstituted $C_3$ to $C_{40}$ carbocyclyl ring, substituted or unsubstituted $C_2$ to $C_{40}$ heterocyclyl, substituted or unsubstituted $C_2$ to $C_{40}$ heteroaryl, or substituted or unsubstituted $C_6$ to $C_{40}$ aryl.

The term "alkylenediyl" group especially means and/or comprises moities with a "carbon backbone" selected from C=, C=C and C=C-C=.

According to one embodiment, Ligand L is selected from formulae (IIc) to (IIf):

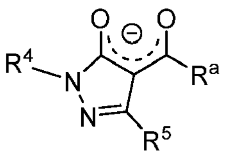 (IIc), 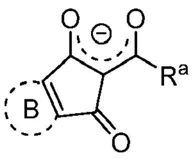 (IId), 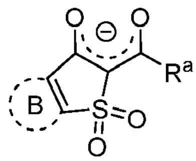 (IIe), 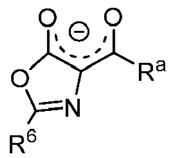 (IIf),

Wherein

$R^4$ is selected from unsubstituted and substituted $C_1$ to $C_{12}$ alkyl, substituted or unsubstituted $C_6$ to $C_{19}$ aryl, substituted or unsubstituted $C_2$ to $C_{20}$ heteroaryl, substituted or unsubstituted 6-membered heteroaryl, preferably $R^2$ is selected from substituted or unsubstituted $C_6$ to $C_{19}$ aryl, substituted or unsubstituted $C_2$ to $C_{20}$ heteroaryl, substituted or unsubstituted 6-membered heteroaryl;
$R^5$ is selected from substituted or unsubstituted $C_1$ to $C_{12}$ alkyl, substituted or unsubstituted $C_6$ to $C_{19}$ aryl, substituted or unsubstituted $C_2$ to $C_{20}$ heteroaryl, substituted or unsubstituted 6-membered heteroaryl, or CN;
$R^6$ is selected from unsubstituted and substituted $C_1$ to $C_{12}$ alkyl, substituted or unsubstituted $C_6$ to $C_{19}$ aryl, substituted or unsubstituted $C_2$ to $C_{20}$ heteroaryl, substituted or unsubstituted 6-membered heteroaryl;
B is selected from substituted or unsubstituted $C_6$ to $C_{19}$ aryl, substituted or unsubstituted $C_2$ to $C_{20}$ heteroaryl ring or a ring system, wherein the ring system may comprise one or two rings, preferably one ring;
$R^a$ is selected from CN, substituted or unsubstituted $C_1$ to $C_{20}$ alkyl, $CH_3$, $CH_2D$, $CHD_2$, $CD_3$, a partially fluorinated or perfluorinated $C_1$ to $C_{20}$ alkyl, $CFH_2$, CFDH, $CFD_2$, $CF_2H$, $CF_2D$, $CF_3$, substituted or unsubstituted $C_1$ to $C_{20}$ alkenyl, substituted or unsubstituted $C_1$ to $C_{20}$ alkinyl, substituted or unsubstituted $C_3$ to $C_{40}$ cycloalkyl, substituted or unsubstituted $C_2$ to $C_{40}$ heterocycloalkyl, substituted or unsubstituted $C_3$ to $C_{40}$ carbocyclyl ring, substituted or unsubstituted $C_2$ to $C_{40}$ heterocyclyl, substituted or unsubstituted $C_2$ to $C_{40}$ heteroaryl, or substituted or unsubstituted $C_6$ to $C_{40}$ aryl.

According to one embodiment, Ligand L is selected from formulae (IIc) to (IIf):

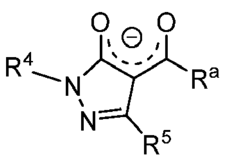 (IIc), 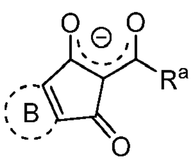 (IId), 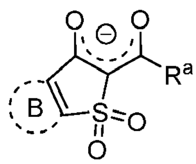 (IIe), 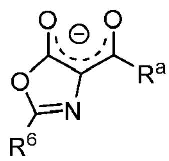 (IIf),

Wherein

$R^4$ is selected from unsubstituted and substituted $C_1$ to $C_{12}$ alkyl, substituted or unsubstituted $C_6$ to $C_{19}$ aryl, substituted or unsubstituted $C_2$ to $C_{20}$ heteroaryl, substituted or unsubstituted 6-membered heteroaryl, preferably $R^2$ is selected from substituted or unsubstituted $C_6$ to $C_{19}$ aryl, substituted or unsubstituted $C_2$ to $C_{20}$ heteroaryl, substituted or unsubstituted 6-membered heteroaryl;
$R^5$ is selected from substituted $C_1$ to $C_{12}$ alkyl or unsubstituted $C_2$ to $C_{12}$ alkyl, substituted or unsubstituted $C_6$ to $C_{19}$ aryl, substituted or unsubstituted $C_2$ to $C_{20}$ heteroaryl, substituted or unsubstituted 6-membered heteroaryl, or CN;
$R^6$ is selected from unsubstituted and substituted $C_1$ to $C_{12}$ alkyl, substituted or unsubstituted $C_6$ to $C_{19}$ aryl, substituted or unsubstituted $C_2$ to $C_{20}$ heteroaryl, substituted or unsubstituted 6-membered heteroaryl;
B is selected from substituted or unsubstituted $C_6$ to $C_{19}$ aryl, substituted or unsubstituted $C_2$ to $C_{20}$ heteroaryl ring or a ring system, wherein the ring system may comprise one or two rings, preferably one ring;
$R^a$ is selected from CN, substituted or unsubstituted $C_1$ to $C_{20}$ alkyl, $CH_3$, $CH_2D$, $CHD_2$, $CD_3$, a partially fluorinated or perfluorinated $C_1$ to $C_{20}$ alkyl, $CFH_2$, CFDH, $CFD_2$, $CF_2H$, $CF_2D$, $CF_3$, substituted or unsubstituted $C_1$ to $C_{20}$ alkenyl, substituted or unsubstituted $C_1$ to $C_{20}$ alkinyl, substituted or unsubstituted $C_3$ to $C_{40}$ cycloalkyl, substituted or unsubstituted $C_2$ to $C_{40}$ heterocycloalkyl, substituted or unsubstituted $C_3$ to $C_{40}$ carbocyclyl ring, substituted or unsubstituted $C_2$ to $C_{40}$ heterocyclyl, substituted or unsubstituted $C_2$ to $C_{40}$ heteroaryl, or substituted or unsubstituted $C_6$ to $C_{40}$ aryl.

According to one embodiment of the invention, ligand L, ligand of formula (II) or formula (IIa), ligand of formula

(IIb) and/or the ligands of formulae (IIc) to (IIf) comprise two or more and ten or less fluorine atoms, preferably 8 fluorine atoms or less.

According to one embodiment of the invention, ligand L, ligand of formula (II) or formula (IIa), ligand of formula (IIb) and/or the ligands of formulae (IIc) to (IIf) comprise at least one fluorine atom.

According to one embodiment of the invention, ligand L, ligand of formula (II) or formula (IIa), ligand of formula (IIb) and/or the ligands of formulae (IIc) to (IIf) comprise comprises at least two fluorine atoms.

According to one embodiment of the invention, ligand L, ligand of formula (II) or formula (IIa), ligand of formula (IIb) and/or the ligands of formulae (IIc) to (IIf) comprise one to ten fluorine atoms; preferably two to ten fluorine atoms; more preferably two to eight fluorine atoms.

According to one embodiment, L is selected from formulae (IIg) or (IIh):

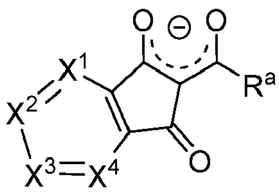 (IIg), 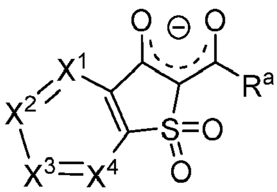 (IIh),

wherein

$X^1$ is selected from $CR^{21}$ or N;
$X^2$ is selected from $CR^{22}$ or N;
$X^3$ is selected from $CR^{23}$ or N;
$X^4$ is selected from $CR^{24}$ or N;

wherein 0, 1 or 2 of the group consisting of $X^1$, $X^2$, $X^3$, $X^4$ are selected from N;
$R^{21}$ to $R^{24}$ are independently selected from H, D, halogen, Cl, F, CN, $NO_2$, $C_1$ to $C_{12}$ alkyl, $C_1$ to $C_{12}$ alkoxy, partially or perfluorinated $C_1$ to $C_{12}$ alkyl, $CF_3$, $CF_2R$, $CFR_2$, $CF_2H$, $CFH_2$, partially or perfluorinated $C_1$ to $C_{12}$ alkoxy, or a combination thereof, wherein R is H or D, preferably H; and whereby any $R^k$ to $R^{k+1}$ may form a ring, wherein k is an integer from 1 to 3;
$R^a$ is selected from CN, substituted or unsubstituted $C_1$ to $C_{20}$ alkyl, $CH_3$, $CH_2D$, $CHD_2$, $CD_3$, a partially fluorinated or perfluorinated $C_1$ to $C_{20}$ alkyl, $CFH_2$, CFDH, $CFD_2$, $CF_2H$, $CF_2D$, $CF_3$, substituted or unsubstituted $C_1$ to $C_{20}$ alkenyl, substituted or unsubstituted $C_1$ to $C_{20}$ alkinyl, substituted or unsubstituted $C_3$ to $C_{40}$ cycloalkyl, substituted or unsubstituted $C_2$ to $C_{40}$ heterocycloalkyl, substituted or unsubstituted $C_3$ to $C_{40}$ carbocyclyl ring, substituted or unsubstituted $C_2$ to $C_{40}$ heterocyclyl, substituted or unsubstituted $C_2$ to $C_{40}$ heteroaryl, or substituted or unsubstituted $C_6$ to $C_{40}$ aryl.

Preferably, $R^{21}$ to $R^{24}$ are independently selected from H, D, halogen, Cl, F, CN, partially or perfluorinated $C_1$ to $C_{12}$ alkyl, $CF_3$, $CF_2R$, $CFR_2$, $CF_2H$, $CFH_2$, or a combination thereof, wherein R is H or D, preferably H; more preferred $R^{21}$ to $R^{24}$ are independently selected from H, D, F, $CF_3$, $CF_2R$, $CFR_2$, $CF_2H$, $CFH_2$, or a combination thereof, wherein R is H or D, preferably H.

According to one embodiment of the invention, the ligands of formulae (IIg) and (IIh) comprise between two and 10 fluorine atoms, preferably 8 fluorine atoms or less.

According to one embodiment of the invention, the ligands of formulae (IIg) and (IIh) comprise comprises at least one fluorine atom.

According to one embodiment of the invention, the ligands of formulae (IIg) and (IIh) comprise at least two fluorine atoms.

According to one embodiment of the invention, the ligands of formulae (IIg) and (IIh) comprise one to ten fluorine atoms; preferably two to ten fluorine atoms; more preferably two to eight fluorine atoms.

According to one embodiment of the invention, wherein ligand L, ligand of formula (II) or formula (IIa), ligand of formula (Πb), the ligands of formulae (IIc) to (IIf) and/or the ligands of formulae (IIg) and (IIh) comprise between two and 10 fluorine atoms.

According to one embodiment of the invention, wherein ligand L, ligand of formula (II) or formula (IIa), ligand of formula (Πb), the ligands of formulae (IIc) to (IIf) and/or the ligands of formulae (IIg) and (IIh) comprise at least one fluorine atom.

According to one embodiment of the invention, wherein ligand L, ligand of formula (II) or formula (IIa), ligand of formula (Πb), the ligands of formulae (IIc) to (IIf) and/or the ligands of formulae (IIg) and (IIh) comprise at least two fluorine

atoms.

According to one embodiment of the invention, wherein ligand L, ligand of formula (II) or formula (IIa), ligand of formula (Πb), the ligands of formulae (IIc) to (IIf) and/or the ligands of formulae (IIg) and (IIh) comprise one to ten fluorine atoms; preferably two to ten fluorine atoms; more preferably two to eight fluorine atoms.

According to one embodiment, Ligand L is selected from formulae (IIc), (IIf), (IIg) and/or (IIh).

According to one embodiment, A is selected from substituted or unsubstituted $C_5$ to $C_{19}$ carbocyclic ring or a ring system, substituted or unsubstituted $C_2$ to $C_{20}$ heterocyclic ring or a ring system, substituted or unsubstituted $C_6$ to $C_{19}$ aryl, or substituted or unsubstituted $C_2$ to $C_{20}$ heteroaryl, wherein the carbocyclic ring or the heterocyclic ring may contain one or more double bonds.

According to one embodiment, one or more substituents of A are independently selected from D, electron-withdrawing group, =O, =S, CN, halogen, Cl, F, substituted or unsubstituted $C_1$ to $C_{20}$ alkyl, $CH_3$, $CH_2D$, $CHD_2$, $CD_3$, a partially fluorinated or perfluorinated $C_1$ to $C_{20}$ alkyl, $CFH_2$, CFDH, $CFD_2$, $CF_2H$, $CF_2D$, $CF_3$, substituted or unsubstituted $C_1$ to $C_{20}$ alkenyl, substituted or unsubstituted $C_1$ to $C_{20}$ alkinyl, substituted or unsubstituted $C_3$ to $C_{40}$ cycloalkyl, substituted or unsubstituted $C_2$ to $C_{40}$ heterocycloalkyl, substituted or unsubstituted $C_3$ to $C_{40}$ carbocyclyl ring, or substituted or unsubstituted $C_2$ to $C_{40}$ heterocyclyl, substituted or unsubstituted $C_2$ to $C_{40}$ heteroaryl ring or ring system, or substituted or unsubstituted $C_6$ to $C_{40}$ aryl ring or ring system.

According to one embodiment, one or more substituents of A are independently selected from D, electron-withdrawing group, =O, =S, CN, halogen, Cl, F, substituted or unsubstituted $C_1$ to $C_{12}$ alkyl, $CH_3$, $CH_2D$, $CHD_2$, $CD_3$, a partially fluorinated or perfluorinated $C_1$ to $C_{12}$ alkyl, $CFH_2$, CFDH, $CFD_2$, $CF_2H$, $CF_2D$, $CF_3$, substituted or unsubstituted $C_1$ to $C_{12}$ alkenyl, substituted or unsubstituted $C_1$ to $C_{12}$ alkinyl, substituted or unsubstituted $C_5$ to $C_{19}$ cycloalkyl, substituted or unsubstituted $C_2$ to $C_{20}$ heterocycloalkyl, substituted or unsubstituted $C_5$ to $C_{19}$ carbocyclyl ring, or substituted or unsubstituted $C_2$ to $C_{20}$ heterocyclyl, substituted or unsubstituted $C_2$ to $C_{20}$ heteroaryl, or substituted or unsubstituted $C_6$ to $C_{19}$ aryl.

According to an embodiment, wherein the one or more substituent of ring A are independently selected from D, electron-withdrawing group, =O, =S, CN, halogen, Cl, F, substituted $C_1$ to $C_{20}$ alkyl, $CH_2D$, $CHD_2$, $CD_3$, unsubstituted $C_2$ to $C_{20}$ alkyl, a partially fluorinated or perfluorinated $C_1$ to $C_{20}$ alkyl, $CFH_2$, CFDH, $CFD_2$, $CF_2H$, $CF_2D$, $CF_3$, substituted or unsubstituted $C_1$ to $C_{20}$ alkenyl, substituted or unsubstituted $C_1$ to $C_{20}$ alkinyl, substituted or unsubstituted $C_3$ to $C_{40}$ cycloalkyl, substituted or unsubstituted $C_2$ to $C_{40}$ heterocycloalkyl, substituted or unsubstituted $C_3$ to $C_{40}$ carbocyclyl ring, or substituted or unsubstituted $C_2$ to $C_{40}$ heterocyclyl, substituted or unsubstituted $C_2$ to $C_{40}$ heteroaryl, or substituted or unsubstituted $C_6$ to $C_{40}$ aryl.

According to an embodiment, wherein the one or more substituent of ring A are independently selected from D, electron-withdrawing group, =O, =S, CN, halogen, Cl, F, substituted $C_1$ to $C_{12}$ alkyl, , $CH_2D$, $CHD_2$, $CD_3$, unsubstituted $C_2$ to $C_{12}$ alkyl, a partially fluorinated or perfluorinated $C_1$ to $C_{12}$ alkyl, $CFH_2$, CFDH, $CFD_2$, $CF_2H$, $CF_2D$, $CF_3$, substituted or unsubstituted $C_1$ to $C_{12}$ alkenyl, substituted or unsubstituted $C_1$ to $C_{12}$ alkinyl, substituted or unsubstituted $C_5$ to $C_{19}$ cycloalkyl, substituted or unsubstituted $C_2$ to $C_{20}$ heterocycloalkyl, substituted or unsubstituted $C_5$ to $C_{19}$ carbocyclyl ring, or substituted or unsubstituted $C_2$ to $C_{20}$ heterocyclyl, substituted or unsubstituted $C_2$ to $C_{20}$ heteroaryl, or substituted or unsubstituted $C_6$ to $C_{19}$ aryl.

According to one embodiment, one or more substituent of the one or more substituent of A are independently selected from D, electron-withdrawing group, halogen, Cl, F, CN, $CH_3$, $CH_2D$, $CHD_2$, $CD_3$, partially or perfluorinated $C_1$ to $C_8$ alkyl, $CFH_2$, CFDH, $CFD_2$, $CF_2H$, $CF_2D$, $CF_3$, partially or perfluorinated $C_1$ to $C_8$ alkoxy, $OCH_3$, $OCH_2D$, $OCHD_2$, $OCD_3$, $OCFH_2$, OCFDH, $OCFD_2$, $OCF_2H$, $OCF_2D$, $OCF_3$.

According to one embodiment, one or more substituents of A are independently selected from D, electron-withdrawing group, =O, =S, CN, halogen, Cl, F, substituted or unsubstituted $C_1$ to $C_{20}$ alkyl, $CH_3$, $CH_2D$, $CHD_2$, $CD_3$, a partially fluorinated or perfluorinated $C_1$ to $C_{20}$ alkyl, $CFH_2$, CFDH, $CFD_2$, $CF_2H$, $CF_2D$, $CF_3$, substituted or unsubstituted $C_1$ to $C_{20}$ alkenyl, substituted or unsubstituted $C_1$ to $C_{20}$ alkinyl, substituted or unsubstituted $C_3$ to $C_{40}$ cycloalkyl, substituted or unsubstituted $C_2$ to $C_{40}$ heterocycloalkyl, substituted or unsubstituted $C_3$ to $C_{40}$ carbocyclyl ring, or substituted or unsubstituted $C_2$ to $C_{40}$ heterocyclyl, substituted or unsubstituted $C_2$ to $C_{40}$ heteroaryl ring or ring system, or substituted or unsubstituted $C_6$ to $C_{40}$ aryl ring or ring system and one or more substituents on $R^a$ are independently selected from an D, electron-withdrawing group, halogen, Cl, F, CN, partially or perfluorinated $C_1$ to $C_8$ alkyl, $CH_3$, $CH_2D$, $CHD_2$, $CD_3$, $CFH_2$, CFDH, $CFD_2$, $CF_2H$, $CF_2D$, $CF_3$, partially or perfluorinated $C_1$ to $C_8$ alkoxy, $OCH_3$, $OCH_2D$, $OCHD_2$, $OCD_3$, $OCFH_2$, OCFDH, $OCFD_2$, $OCF_2H$, $OCF_2D$, $OCF_3$.

According to one embodiment, one or more substituents on $R^a$ are independently selected from an D, electron-withdrawing group, halogen, Cl, F, CN, partially or perfluorinated $C_1$ to $C_8$ alkyl, $CH_3$, $CH_2D$, $CHD_2$, $CD_3$, $CFH_2$, CFDH, $CFD_2$, $CF_2H$, $CF_2D$, $CF_3$, partially or perfluorinated $C_1$ to $C_8$ alkoxy, $OCH_3$, $OCH_2D$, $OCHD_2$, $OCD_3$, $OCFH_2$, OCFDH, $OCFD_2$, $OCF_2H$, $OCF_2D$, $OCF_3$.

According to one embodiment, one or more substituents of A are independently selected from D, electron-withdrawing group, =O, =S, CN, halogen, Cl, F, substituted or unsubstituted $C_1$ to $C_{20}$ alkyl, $CH_3$, $CH_2D$, $CHD_2$, $CD_3$, a partially fluorinated or perfluorinated $C_1$ to $C_{20}$ alkyl, $CFH_2$, CFDH, $CFD_2$, $CF_2H$, $CF_2D$, $CF_3$, substituted or unsubstituted

$C_1$ to $C_{20}$ alkenyl, substituted or unsubstituted $C_1$ to $C_{20}$ alkinyl, substituted or unsubstituted $C_3$ to $C_{40}$ cycloalkyl, substituted or unsubstituted $C_2$ to $C_{40}$ heterocycloalkyl, substituted or unsubstituted $C_3$ to $C_{40}$ carbocyclyl ring, or substituted or unsubstituted $C_2$ to $C_{40}$ heterocyclyl, substituted or unsubstituted $C_2$ to $C_{40}$ heteroaryl ring or ring system, or substituted or unsubstituted $C_6$ to $C_{40}$ aryl ring or ring system;
and one or more substituents on $R^a$ are independently selected from an D, electron-withdrawing group, halogen, Cl, F, CN, partially or perfluorinated $C_1$ to $C_8$ alkyl, $CH_3$, $CH_2D$, $CHD_2$, $CD_3$, $CFH_2$, CFDH, $CFD_2$, $CF_2H$, $CF_2D$, $CF_3$, partially or perfluorinated $C_1$ to $C_8$ alkoxy, $OCH_3$, $OCH_2D$, $OCHD_2$, $OCD_3$, $OCFH_2$, OCFDH, $OCFD_2$, $OCF_2H$, $OCF_2D$, $OCF_3$.

According to an embodiment, one or more substituent of A are independently selected from D, electron-withdrawing group, =O, =S, CN, halogen, Cl, F, substituted or unsubstituted $C_1$ to $C_{20}$ alkyl, $CH_3$, $CH_2D$, $CHD_2$, $CD_3$, a partially fluorinated or perfluorinated $C_1$ to $C_{20}$ alkyl, $CFH_2$, CFDH, $CFD_2$, $CF_2H$, $CF_2D$, $CF_3$, substituted or unsubstituted $C_1$ to $C_{20}$ alkenyl, substituted or unsubstituted $C_1$ to $C_{20}$ alkinyl, substituted or unsubstituted $C_3$ to $C_{40}$ cycloalkyl, substituted or unsubstituted $C_2$ to $C_{40}$ heterocycloalkyl, substituted or unsubstituted $C_3$ to $C_{40}$ carbocyclyl ring, or substituted or unsubstituted $C_2$ to $C_{40}$ heterocyclyl, substituted or unsubstituted $C_2$ to $C_{40}$ heteroaryl ring or ring system, or substituted or unsubstituted $C_6$ to $C_{40}$ aryl ring or ring system; and one or more substituent on $R^a$ are independently selected from an D, electron-withdrawing group, halogen, Cl, F, CN, partially or perfluorinated $C_1$ to $C_8$ alkyl, $CH_3$, $CH_2D$, $CHD_2$, $CD_3$, $CFH_2$, CFDH, $CFD_2$, $CF_2H$, $CF_2D$, $CF_3$, partially or perfluorinated $C_1$ to $C_8$ alkoxy, $OCH_3$, $OCH_2D$, $OCHD_2$, $OCD_3$, $OCFH_2$, OCFDH, $OCFD_2$, $OCF_2H$, $OCF_2D$, $OCF_3$.

According to an embodiment, the one or more substituent of the one or more substituent of A are independently selected from D, electron-withdrawing group, halogen, Cl, F, CN, $CH_3$, $CH_2D$, $CHD_2$, $CD_3$, partially or perfluorinated $C_1$ to $C_8$ alkyl, $CFH_2$, CFDH, $CFD_2$, $CF_2H$, $CF_2D$, $CF_3$, partially or perfluorinated $C_1$ to $C_8$ alkoxy, $OCH_3$, $OCH_2D$, $OCHD_2$, $OCD_3$, $OCFH_2$, OCFDH, $OCFD_2$, $OCF_2H$, $OCF_2D$, $OCF_3$; and one or more substituent on $R^a$ are independently selected from an D, electron-withdrawing group, halogen, Cl, F, CN, partially or perfluorinated $C_1$ to $C_8$ alkyl, $CH_3$, $CH_2D$, $CHD_2$, $CD_3$, $CFH_2$, CFDH, $CFD_2$, $CF_2H$, $CF_2D$, $CF_3$, partially or perfluorinated $C_1$ to $C_8$ alkoxy, $OCH_3$, $OCH_2D$, $OCHD_2$, $OCD_3$, $OCFH_2$, OCFDH, $OCFD_2$, $OCF_2H$, $OCF_2D$, $OCF_3$.

According to an embodiment, A is selected from substituted or unsubstituted $C_5$ to $C_{19}$ carbocyclic ring or ring system, substituted or unsubstituted $C_2$ to $C_{20}$ heterocyclic ring or ring system, substituted or unsubstituted $C_6$ to $C_{19}$ aryl, or substituted or unsubstituted $C_2$ to $C_{20}$ heteroaryl, wherein the carbocyclic ring or the heterocyclic ring may contain one or more double bonds, wherein one or more substituents of A are independently selected from D, electron-withdrawing group, =O, =S, CN, halogen, Cl, F, substituted or unsubstituted $C_1$ to $C_{20}$ alkyl, $CH_3$, $CH_2D$, $CHD_2$, $CD_3$, a partially fluorinated or perfluorinated $C_1$ to $C_{20}$ alkyl, $CFH_2$, CFDH, $CFD_2$, $CF_2H$, $CF_2D$, $CF_3$, substituted or unsubstituted $C_1$ to $C_{20}$ alkenyl, substituted or unsubstituted $C_1$ to $C_{20}$ alkinyl, substituted or unsubstituted $C_3$ to $C_{40}$ cycloalkyl, substituted or unsubstituted $C_2$ to $C_{40}$ heterocycloalkyl, substituted or unsubstituted $C_3$ to $C_{40}$ carbocyclyl ring, or substituted or unsubstituted $C_2$ to $C_{40}$ heterocyclyl, substituted or unsubstituted $C_2$ to $C_{40}$ heteroaryl ring or ring system, or substituted or unsubstituted $C_6$ to $C_{40}$ aryl ring or ring system.

According to an embodiment, A is selected from substituted or unsubstituted $C_5$ to $C_{19}$ carbocyclic ring, substituted or unsubstituted $C_2$ to $C_{20}$ heterocyclic ring, substituted or unsubstituted $C_6$ to $C_{19}$ aryl, or substituted or unsubstituted $C_2$ to $C_{20}$ heteroaryl, wherein the carbocyclic ring or the heterocyclic ring may contain one or more double bonds,
wherein the one or more substituent of A are independently selected from D, electron-withdrawing group, =O, =S, CN, halogen, Cl, F, substituted or unsubstituted $C_1$ to $C_{20}$ alkyl, $CH_3$, $CH_2D$, $CHD_2$, $CD_3$, a partially fluorinated or perfluorinated $C_1$ to $C_{20}$ alkyl, $CFH_2$, CFDH, $CFD_2$, $CF_2H$, $CF_2D$, $CF_3$, substituted or unsubstituted $C_1$ to $C_{20}$ alkenyl, substituted or unsubstituted $C_1$ to $C_{20}$ alkinyl, substituted or unsubstituted $C_3$ to $C_{40}$ cycloalkyl, substituted or unsubstituted $C_2$ to $C_{40}$ heterocycloalkyl, substituted or unsubstituted $C_3$ to $C_{40}$ carbocyclyl ring, or substituted or unsubstituted $C_2$ to $C_{40}$ heterocyclyl, substituted or unsubstituted $C_2$ to $C_{40}$ heteroaryl ring or ring system, or substituted or unsubstituted $C_6$ to $C_{40}$ aryl ring or ring system; wherein the one or more substituents of the one or more substituents of A are independently selected from D, electron-withdrawing group, halogen, Cl, F, CN, $CH_3$, $CH_2D$, $CHD_2$, $CD_3$, partially or perfluorinated $C_1$ to Cs alkyl, $CFH_2$, CFDH, $CFD_2$, $CF_2H$, $CF_2D$, $CF_3$, partially or perfluorinated $C_1$ to $C_8$ alkoxy, $OCH_3$, $OCH_2D$, $OCHD_2$, $OCD_3$, $OCFH_2$, OCFDH, $OCFD_2$, $OCF_2H$, $OCF_2D$, $OCF_3$.

According to an embodiment, A is selected from substituted or unsubstituted $C_5$ to $C_{19}$ carbocyclic ring, substituted or unsubstituted $C_2$ to $C_{20}$ heterocyclic ring, substituted or unsubstituted $C_6$ to $C_{19}$ aryl, or substituted or unsubstituted $C_2$ to $C_{20}$ heteroaryl, wherein the carbocyclic ring or the heterocyclic ring may contain one or more double bonds,
wherein the one or more substituent of A are independently selected from D, electron-withdrawing group, =O, =S, CN, halogen, Cl, F, substituted $C_1$ to $C_{20}$ alkyl, unsubstituted $C_2$ to $C_{20}$ alkyl, $CH_2D$, $CHD_2$, $CD_3$, a partially fluorinated or perfluorinated $C_1$ to $C_{20}$ alkyl, $CFH_2$, CFDH, $CFD_2$, $CF_2H$, $CF_2D$, $CF_3$, substituted or unsubstituted $C_1$ to $C_{20}$ alkenyl, substituted or unsubstituted $C_1$ to $C_{20}$ alkinyl, substituted or unsubstituted $C_3$ to $C_{40}$ cycloalkyl, substituted or unsubstituted $C_2$ to $C_{40}$ heterocycloalkyl, substituted or unsubstituted $C_3$ to $C_{40}$ carbocyclyl ring, or substituted or unsubstituted $C_2$ to $C_{40}$ heterocyclyl, substituted or unsubstituted $C_2$ to $C_{40}$ heteroaryl ring or ring system, or substituted or unsubstituted

$C_6$ to $C_{40}$ aryl ring or ring system; wherein the one or more substituents of the one or more substituents of A are independently selected from D, electron-withdrawing group, halogen, Cl, F, CN, $CH_3$, $CH_2D$, $CHD_2$, $CD_3$, partially or perfluorinated $C_1$ to Cs alkyl, $CFH_2$, CFDH, $CFD_2$, $CF_2H$, $CF_2D$, $CF_3$, partially or perfluorinated $C_1$ to $C_8$ alkoxy, $OCH_3$, $OCH_2D$, $OCHD_2$, $OCD_3$, $OCFH_2$, OCFDH, $OCFD_2$, $OCF_2H$, $OCF_2D$, $OCF_3$.

According to an embodiment, A is selected from substituted or unsubstituted $C_5$ to $C_{19}$ carbocyclic ring, substituted or unsubstituted $C_2$ to $C_{20}$ heterocyclic ring, substituted or unsubstituted $C_6$ to $C_{19}$ aryl, or substituted or unsubstituted $C_2$ to $C_{20}$ heteroaryl, wherein the carbocyclic ring or the heterocyclic ring may contain one or more double bonds; wherein one or more substituents on $R^a$ are independently selected from an D, electron-withdrawing group, halogen, Cl, F, CN, partially or perfluorinated $C_1$ to $C_8$ alkyl, $CH_3$, $CH_2D$, $CHD_2$, $CD_3$, $CFH_2$, CFDH, $CFD_2$, $CF_2H$, $CF_2D$, $CF_3$, partially or perfluorinated $C_1$ to $C_8$ alkoxy, $OCH_3$, $OCH_2D$, $OCHD_2$, $OCD_3$, $OCFH_2$, OCFDH, $OCFD_2$, $OCF_2H$, $OCF_2D$, $OCF_3$.

According to an embodiment, A is selected from substituted or unsubstituted $C_5$ to $C_{19}$ carbocyclic ring, substituted or unsubstituted $C_2$ to $C_{20}$ heterocyclic ring, substituted or unsubstituted $C_6$ to $C_{19}$ aryl, or substituted or unsubstituted $C_2$ to $C_{20}$ heteroaryl, wherein the carbocyclic ring or the heterocyclic ring may contain one or more double bonds, wherein the one or more substituent of A are independently selected from D, electron-withdrawing group, =O, =S, CN, halogen, Cl, F, substituted or unsubstituted $C_1$ to $C_{20}$ alkyl, $CH_3$, $CH_2D$, $CHD_2$, $CD_3$, a partially fluorinated or perfluorinated $C_1$ to $C_{20}$ alkyl, $CFH_2$, CFDH, $CFD_2$, $CF_2H$, $CF_2D$, $CF_3$, substituted or unsubstituted $C_1$ to $C_{20}$ alkenyl, substituted or unsubstituted $C_1$ to $C_{20}$ alkinyl, substituted or unsubstituted $C_3$ to $C_{40}$ cycloalkyl, substituted or unsubstituted $C_2$ to $C_{40}$ heterocycloalkyl, substituted or unsubstituted $C_3$ to $C_{40}$ carbocyclyl ring, or substituted or unsubstituted $C_2$ to $C_{40}$ heterocyclyl, substituted or unsubstituted $C_2$ to $C_{40}$ heteroaryl, or substituted or unsubstituted $C_6$ to $C_{40}$ aryl; and wherein one or more substituents on $R^a$ are independently selected from an D, electron-withdrawing group, halogen, Cl, F, CN, partially or perfluorinated $C_1$ to $C_8$ alkyl, $CH_3$, $CH_2D$, $CHD_2$, $CD_3$, $CFH_2$, CFDH, $CFD_2$, $CF_2H$, $CF_2D$, $CF_3$, partially or perfluorinated $C_1$ to $C_8$ alkoxy, $OCH_3$, $OCH_2D$, $OCHD_2$, $OCD_3$, $OCFH_2$, OCFDH, $OCFD_2$, $OCF_2H$, $OCF_2D$, $OCF_3$.

According to an embodiment, A is selected from substituted or unsubstituted $C_5$ to $C_{19}$ carbocyclic ring or ring system, substituted or unsubstituted $C_2$ to $C_{20}$ heterocyclic ring or ring system, substituted or unsubstituted $C_6$ to $C_{19}$ aryl, or substituted or unsubstituted $C_2$ to $C_{20}$ heteroaryl, wherein the carbocyclic ring or the heterocyclic ring may contain one or more double bonds,

According to an embodiment, A is selected from a substituted or unsubstituted $C_5$ to $C_{19}$ carbocyclic ring or ring system, substituted or unsubstituted $C_2$ to $C_{20}$ heterocyclic ring or ring system, substituted or unsubstituted $C_6$ to $C_{19}$ aryl, or substituted or unsubstituted $C_2$ to $C_{20}$ heteroaryl, wherein the carbocyclic ring or the heterocyclic ring may contain one or more double bonds,

wherein the one or more substituent of A are independently selected from D, electron-withdrawing group, =O, =S, CN, halogen, Cl, F, substituted or unsubstituted $C_1$ to $C_{20}$ alkyl, $CH_3$, $CH_2D$, $CHD_2$, $CD_3$, a partially fluorinated or perfluorinated $C_1$ to $C_{20}$ alkyl, $CFH_2$, CFDH, $CFD_2$, $CF_2H$, $CF_2D$, $CF_3$, substituted or unsubstituted $C_1$ to $C_{20}$ alkenyl, substituted or unsubstituted $C_1$ to $C_{20}$ alkinyl, substituted or unsubstituted $C_3$ to $C_{40}$ cycloalkyl, substituted or unsubstituted $C_2$ to $C_{40}$ heterocycloalkyl, substituted or unsubstituted $C_3$ to $C_{40}$ carbocyclyl ring, or substituted or unsubstituted $C_2$ to $C_{40}$ heterocyclyl, substituted or unsubstituted $C_2$ to $C_{40}$ heteroaryl ring or ring system, or substituted or unsubstituted $C_6$ to $C_{40}$ aryl ring or ring system;

wherein the one or more substituents of the one or more substituent of A are independently selected from D, electron-withdrawing group, halogen, Cl, F, CN, $CH_3$, $CH_2D$, $CHD_2$, $CD_3$, partially or perfluorinated $C_1$ to $C_8$ alkyl, $CFH_2$, CFDH, $CFD_2$, $CF_2H$, $CF_2D$, $CF_3$, partially or perfluorinated $C_1$ to $C_8$ alkoxy, $OCH_3$, $OCH_2D$, $OCHD_2$, $OCD_3$, $OCFH_2$, OCFDH, $OCFD_2$, $OCF_2H$, $OCF_2D$, $OCF_3$;

and wherein one or more substituent on $R^a$ are independently selected from an D, electron-withdrawing group, halogen, Cl, F, CN, partially or perfluorinated $C_1$ to $C_8$ alkyl, $CH_3$, $CH_2D$, $CHD_2$, $CD_3$, $CFH_2$, CFDH, $CFD_2$, $CF_2H$, $CF_2D$, $CF_3$, partially or perfluorinated $C_1$ to $C_8$ alkoxy, $OCH_3$, $OCH_2D$, $OCHD_2$, $OCD_3$, $OCFH_2$, OCFDH, $OCFD_2$, $OCF_2H$, $OCF_2D$, $OCF_3$.

According to an embodiment, A is selected from a substituted or unsubstituted $C_5$ to $C_{19}$ carbocyclic ring or ring system, substituted or unsubstituted $C_2$ to $C_{20}$ heterocyclic ring or ring system, substituted or unsubstituted $C_6$ to $C_{19}$ aryl, or substituted or unsubstituted $C_2$ to $C_{20}$ heteroaryl, wherein the carbocyclic ring or the heterocyclic ring may contain one or more double bonds,

wherein the one or more substituent of A are independently selected from D, electron-withdrawing group, =O, =S, CN, halogen, Cl, F, substituted $C_1$ to $C_{20}$ alkyl or unsubstituted $C_2$ to $C_{20}$ alkyl, $CH_2D$, $CHD_2$, $CD_3$, a partially fluorinated or perfluorinated $C_1$ to $C_{20}$ alkyl, $CFH_2$, CFDH, $CFD_2$, $CF_2H$, $CF_2D$, $CF_3$, substituted or unsubstituted $C_1$ to $C_{20}$ alkenyl, substituted or unsubstituted $C_1$ to $C_{20}$ alkinyl, substituted or unsubstituted $C_3$ to $C_{40}$ cycloalkyl, substituted or unsubstituted $C_2$ to $C_{40}$ heterocycloalkyl, substituted or unsubstituted $C_3$ to $C_{40}$ carbocyclyl ring, or substituted or

unsubstituted $C_2$ to $C_{40}$ heterocyclyl, substituted or unsubstituted $C_2$ to $C_{40}$ heteroaryl ring or ring system, or substituted or unsubstituted $C_6$ to $C_{40}$ aryl ring or ring system;
wherein the one or more substituents of the one or more substituent of A are independently selected from D, electron-withdrawing group, halogen, Cl, F, CN, $CH_3$, $CH_2D$, $CHD_2$, $CD_3$, partially or perfluorinated $C_1$ to $C_8$ alkyl, $CFH_2$, CFDH, $CFD_2$, $CF_2H$, $CF_2D$, $CF_3$, partially or perfluorinated $C_1$ to $C_8$ alkoxy, $OCH_3$, $OCH_2D$, $OCHD_2$, $OCD_3$, $OCFH_2$, OCFDH, $OCFD_2$, $OCF_2H$, $OCF_2D$, $OCF_3$;
and wherein one or more substituent on $R^a$ are independently selected from an D, electron-withdrawing group, halogen, Cl, F, CN, partially or perfluorinated $C_1$ to $C_8$ alkyl, $CH_3$, $CH_2D$, $CHD_2$, $CD_3$, $CFH_2$, CFDH, $CFD_2$, $CF_2H$, $CF_2D$, $CF_3$, partially or perfluorinated $C_1$ to $C_8$ alkoxy, $OCH_3$, $OCH_2D$, $OCHD_2$, $OCD_3$, $OCFH_2$, OCFDH, $OCFD_2$, $OCF_2H$, $OCF_2D$, $OCF_3$.

According to one emodiment, Ligand L of formula (II) or formula (IIa) comprises at least one group selected from substituted or unsubstituted $C_1$ to $C_{20}$ alkyl, a partially fluorinated or perfluorinated $C_1$ to $C_{20}$ alkyl.

According to an embodiment, wherein $R^a$ of formulae (II), (IIa), (IIb), (IIc), (IId),(IIe) is selected from $CH_3$, $CF_3$, $C_2F_5$, $C_3F_7$, $C_4F_9$, $CFH_2$, $CF_2H$, $CF_2CF_2H$, $(CF_2)_2CF_2H$, $CH(CF_2H)_2$, $CF(CF_2H)_2$, $C(CF_2H)_3$ and the following formulae **J1 to J114:**

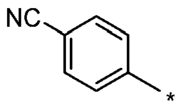 (J1), 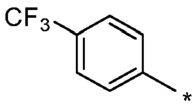 (J2), 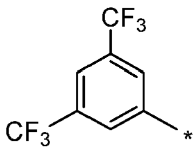 (J3), 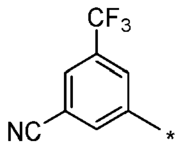 (J4), 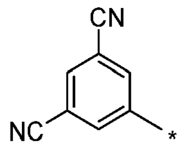

(J5), 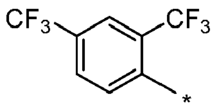 (J6), 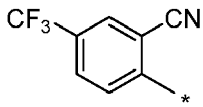 (J7), 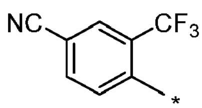 (J8), 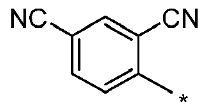 (J9),

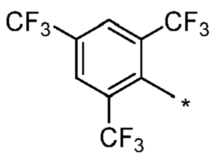 (J10), 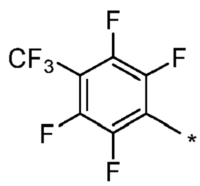 (J11), 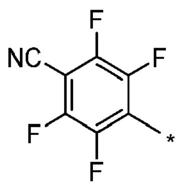 (J12), 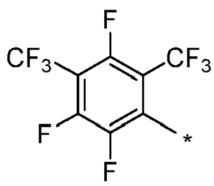 (J13),

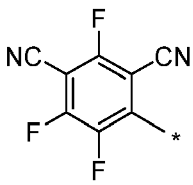 (J14), 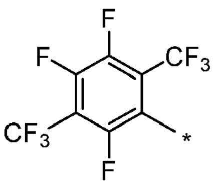 (J15), 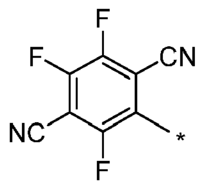 (J16), 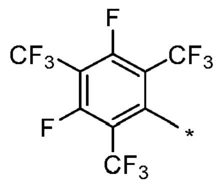 (J17),

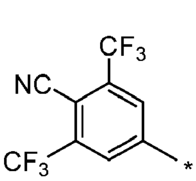 (J18), 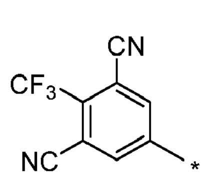 (J19), 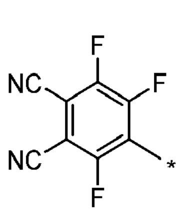 (J20), 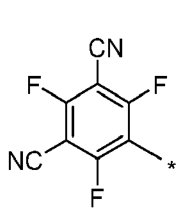 (J21),

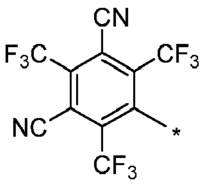 (J22), 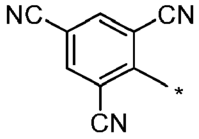 (J23), 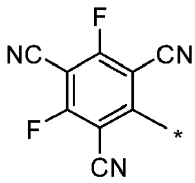 (J24), 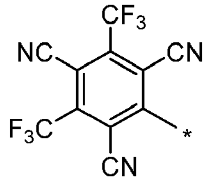 (J25),

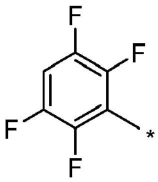 (J26), 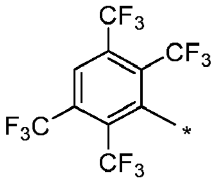 (J27), 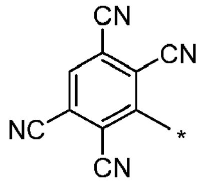 (J28), 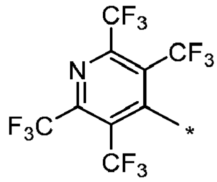 (J29),

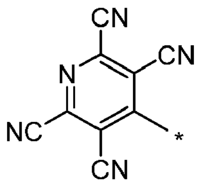 (J30), 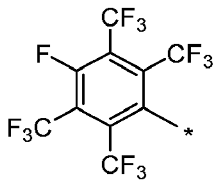 (J31), 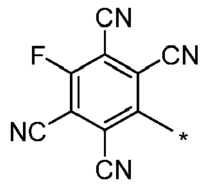 (J32), 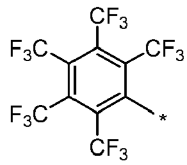 (J33),

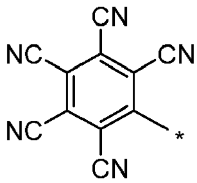 (J34), 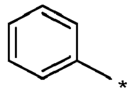 (J35), 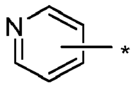 (J36), 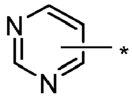 (J37),

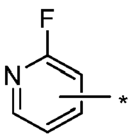 (J38), 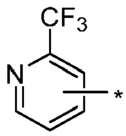 (J39), 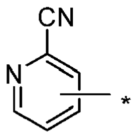 (J40), 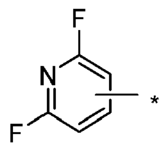 (J41),

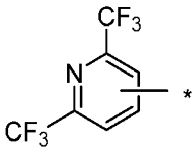 (J42), 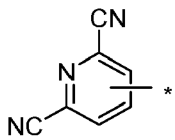 (J43), 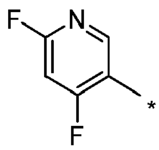 (J44), 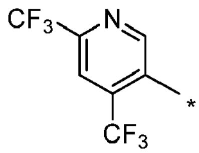 (J45),

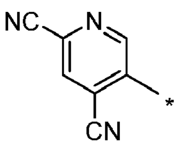 (J46), 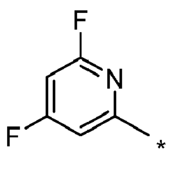 (J47), 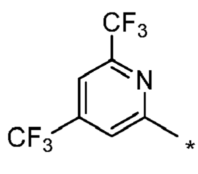 (J48), 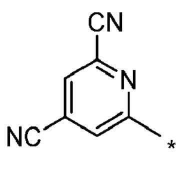 (J49),

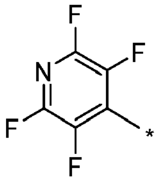 (J50), 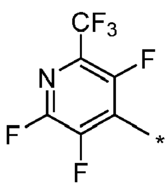 (J51), 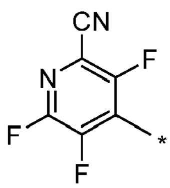 (J52), 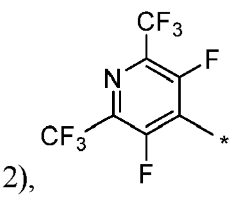 (J53),

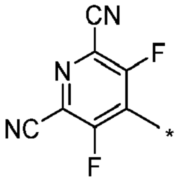 (J54), 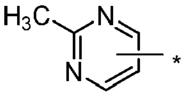 (J55), 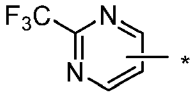 (J56), 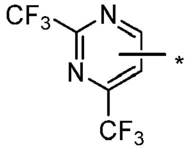 (J57),

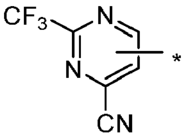 (J58), 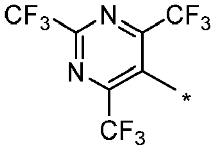 (J59), 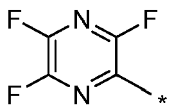 (J60), 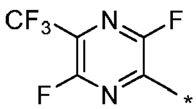 (J61),

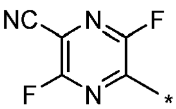 (J62), 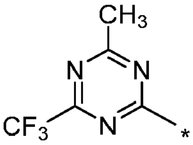 (J63), 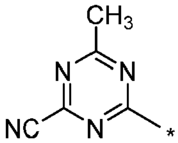 (J64), 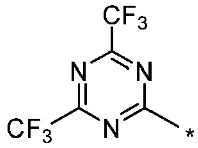 (J65),

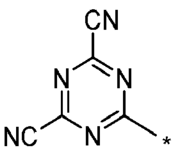 (J66), 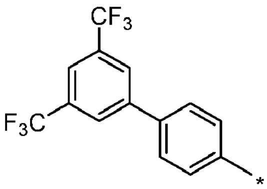 (J67), 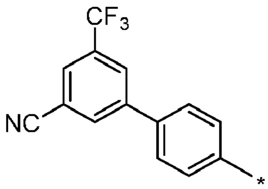 (J68),

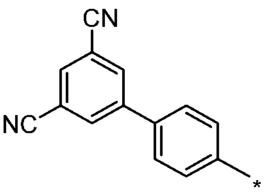 (J69), 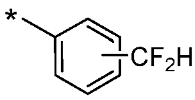 (J70), 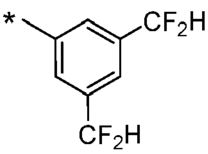 (J71), 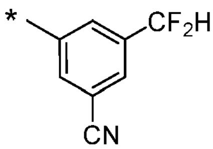 (J72),

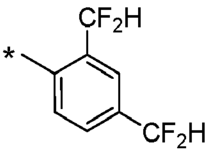 (J73), 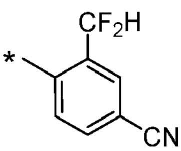 (J74), 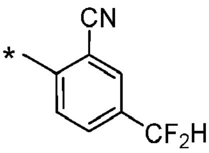 (J75), 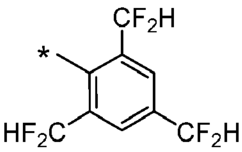 (J76),

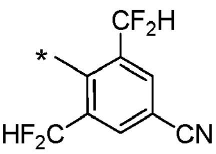 (J77), 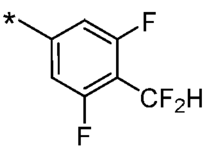 (JJ78, 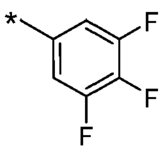 (J79), 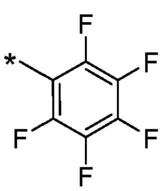 (J80),

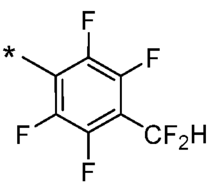 (J81), 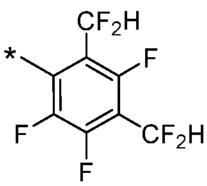 (J82), 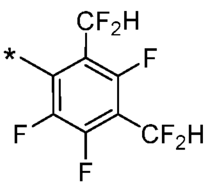 (J83), 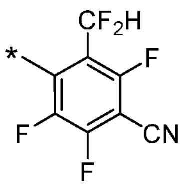 (J84),

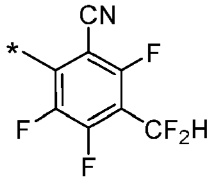 (J85), 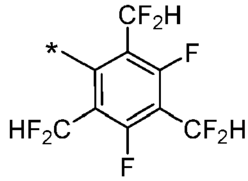 (J86), 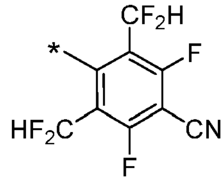 (J87), 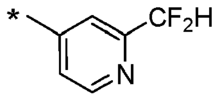 (J88),

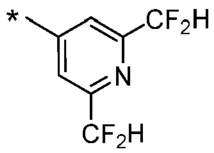 (J89); 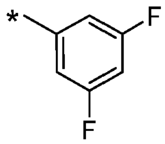 (J90), 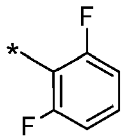 (J91), 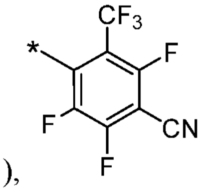 (J92), 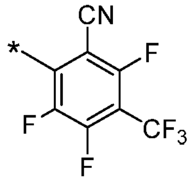

(J93), 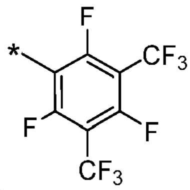 (J94), 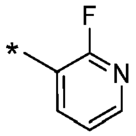 (J95), 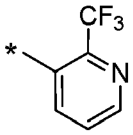 (J96), 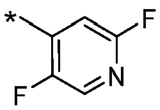 (J97), 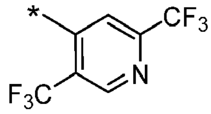

(J98), 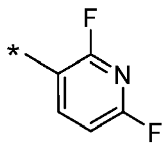 (J99), 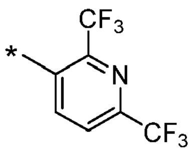 (J100), 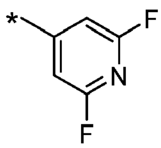 (J101), 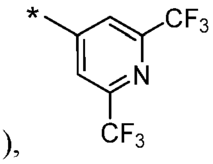 (J102),

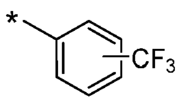 (J103) 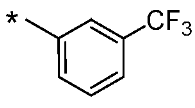 (J104), 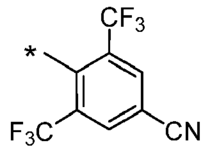 (J105), 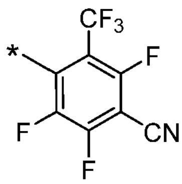 (J106),

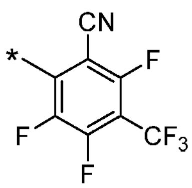 (J107), 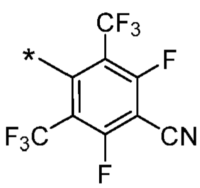 (J108), 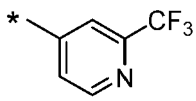 (J109), 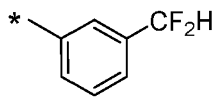 (J110),

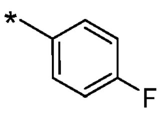 (J111), 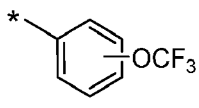 (J112), 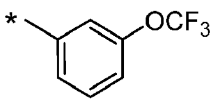 (J113), 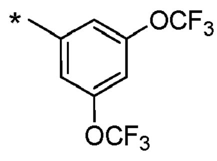 (J114);

wherein the "*" denotes the binding position.

According to one embodiment, $R^a$ of formulae (II), (IIa), (IIb), (IIc), (IId),(IIe) is selected from $CH_3$, $CF_3$, $CF_2H$, and from the following moieties

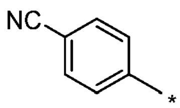 (J1), 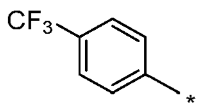 (J2), 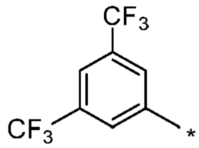 (J3), 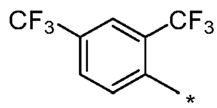 (J6),

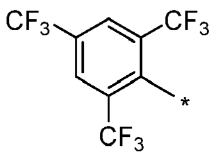 (J10), 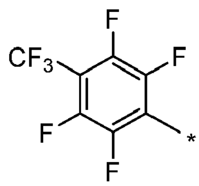 (J11), 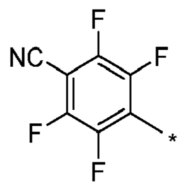 (J12), 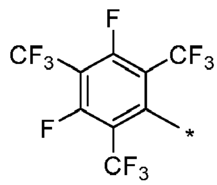 (J17),

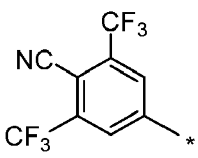 (J18), 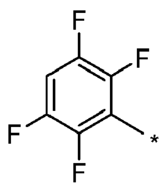 (J26), 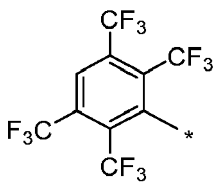 (J27), 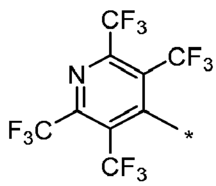 (J29),

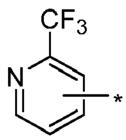 (J39), 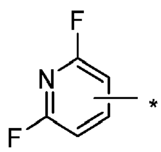 (J41), 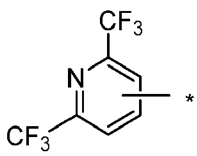 (J42), 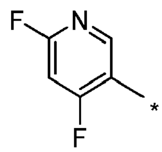 (J44),

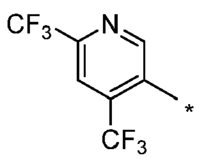 (J45), 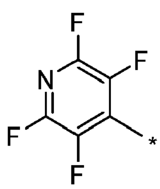 (J50), 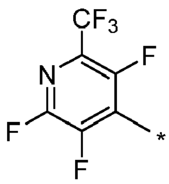 (J51), 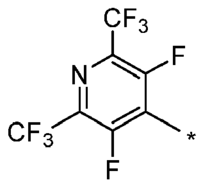 (J53),

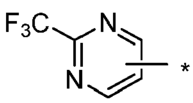 (J56), 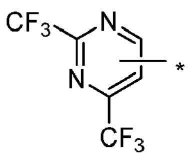 (J57), 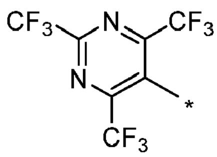 (J59), 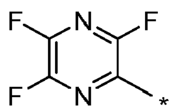 (J60),

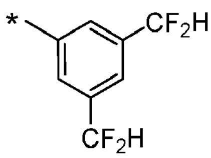 (J71), 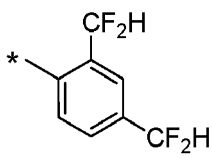 (J73), 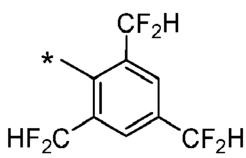 (J76), 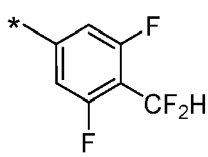 (J78),

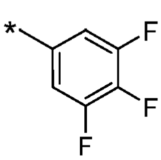 (J79), 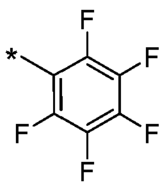 (J80), 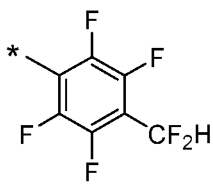 (J81), 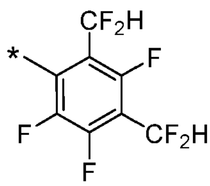 (J82),

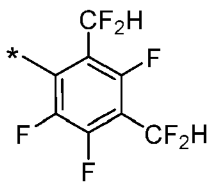 (J83), 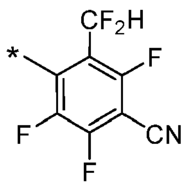 (J84), 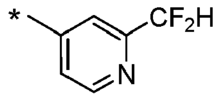 (J88), 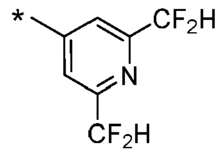 (J89);

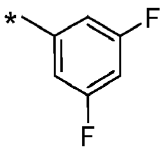 (J90), 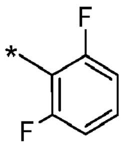 (J91), 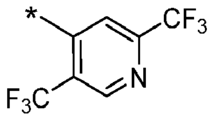 (J98), 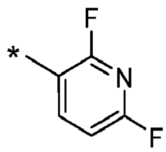 (J99),

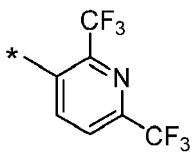 (J100), 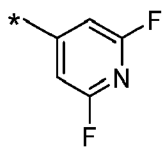 (J101) 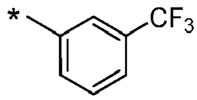 (J104), 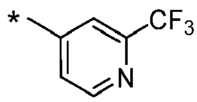 (J109),

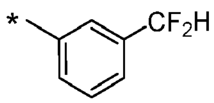 (J110), 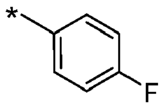 (J111), 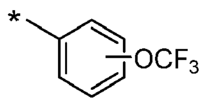 (J112), 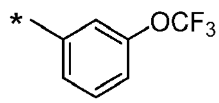 (J113).

According to one embodiment, $R^a$ of formulae (II), (IIa), (IIb), (IIc), (IId),(IIe) is selected from $CF_3$, $CF_2H$, and from the following moieties

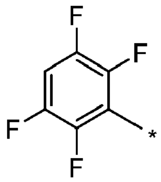 (J26), 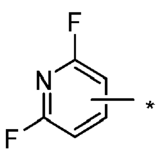 (J41), 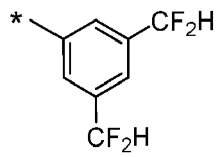 (J71), 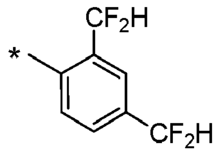 (J73),

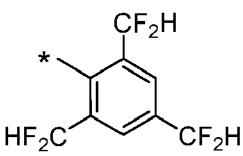 (J76), 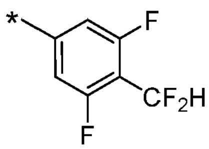 (J78), 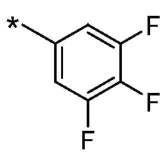 (J79), 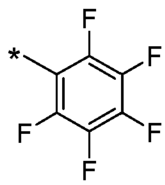 (J80),

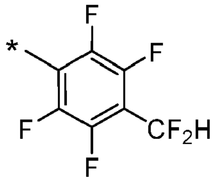 (J81), 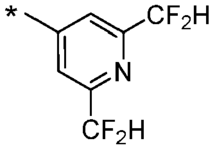 (J89); 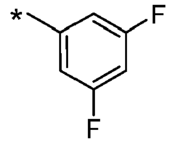 (J90)

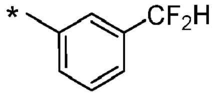 (J110), 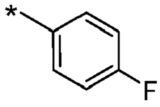 (J111), 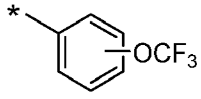 (J112), 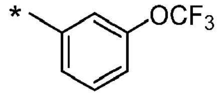 (J113),

According to one embodiment, $R^a$ of formulae (II), (IIa), (IIb), (IIc), (IId),(IIe) is selected from $CF_2H$, and from the following moieties

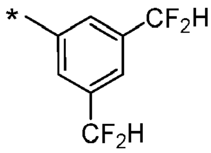 (J71), 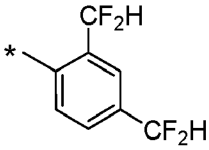 (J73), 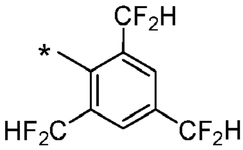 (J76), 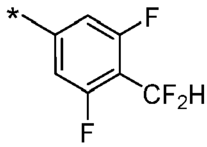 (J78),

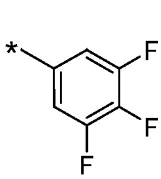 (J79), 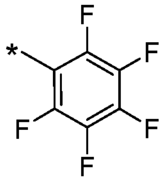 (J80), 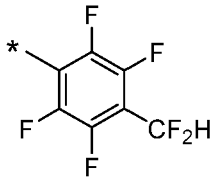 (J81), 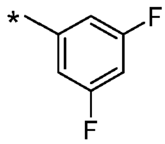 (J90),

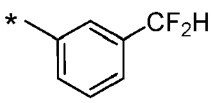 (J110), 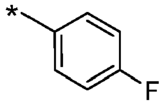 (J111),

According to an embodiment of Formula (I) $R^4$ of formula (IIb) is selected from **K1** to **K114**

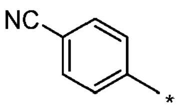 (K1), 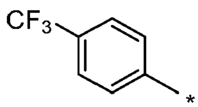 (K2), 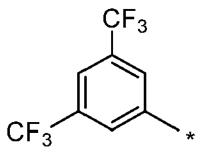 (K3), 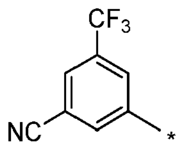 (K4),

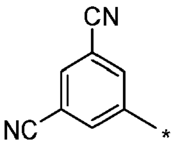 (K5), 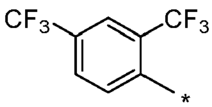 (K6), 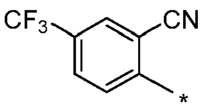 (K7), 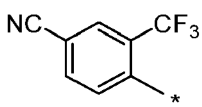 (K8),

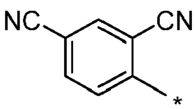 (K9), 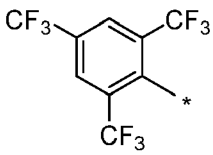 (K10), 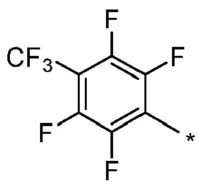 (K11), 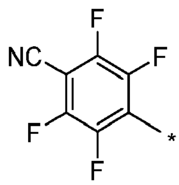 (K12),

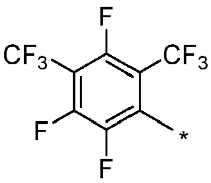 (K13), 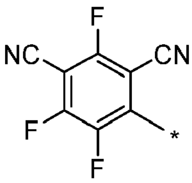 (K14), 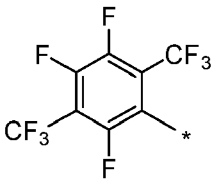 (K15), 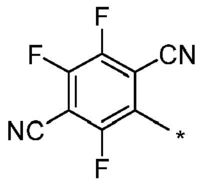 (K16),

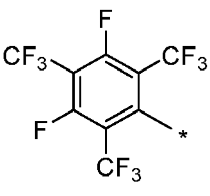 (K17), 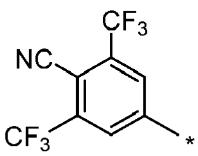 (K18), 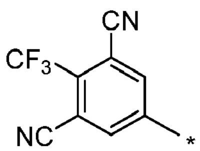 (K19), 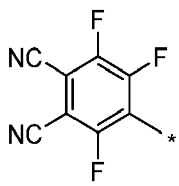 (K20),

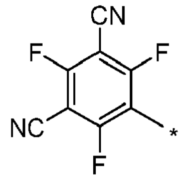 (K21), 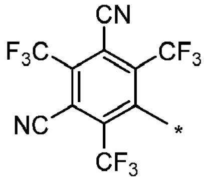 (K22), 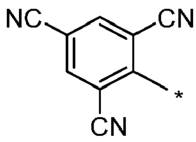 (K23), 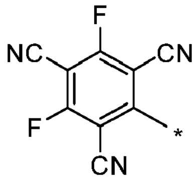 (K24),

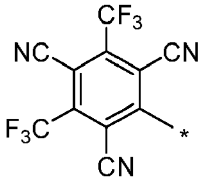 (K25), 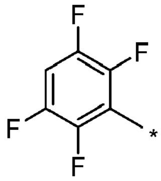 (K26), 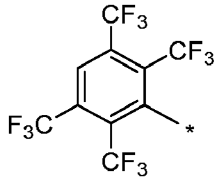 (K27), 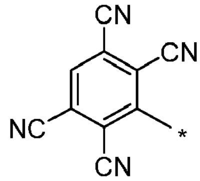 (K28),

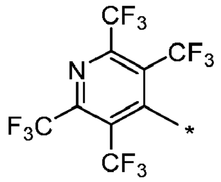 (K29), 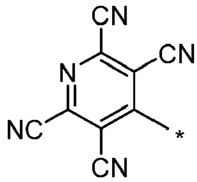 (K30), 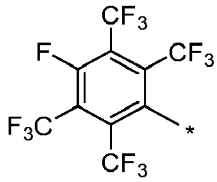 (K31), 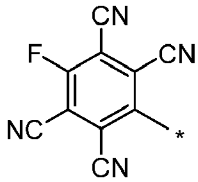 (K32),

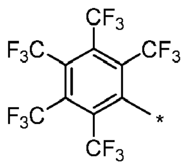 (K33), 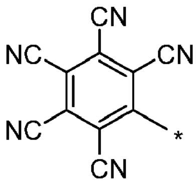 (K34), 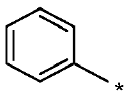 (K35), 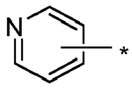 (K36), 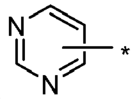 (K37),

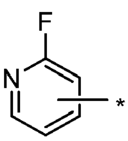 (K38), 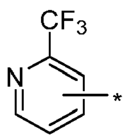 (K39), 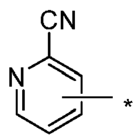 (K40), 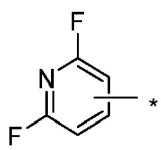 (K41),

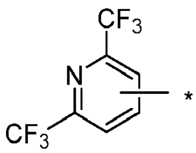 (K42), 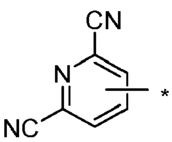 (K43), 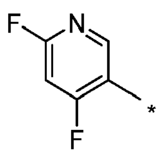 (K44), 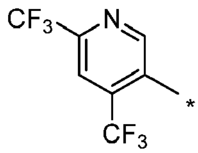 (K45),

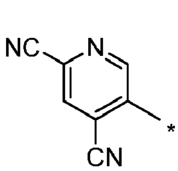 (K46), 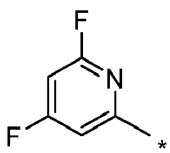 (K47), 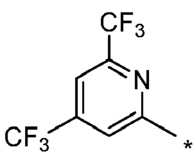 (K48), 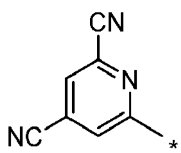 (K49),

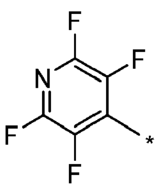 (K50), 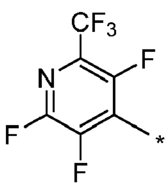 (K51), 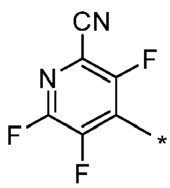 (K52), 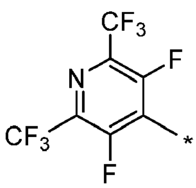 (K53),

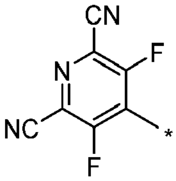 (K54), 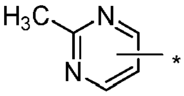 (K55), 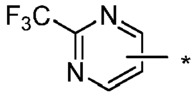 (K56), 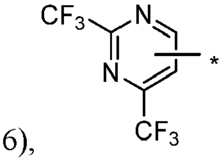 (K57,

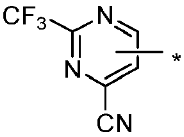 (K58), 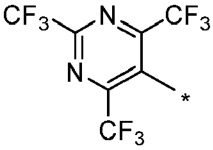 (K59), 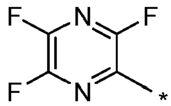 (K60), 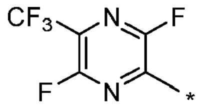 (K61),

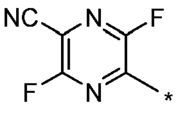 (K62), 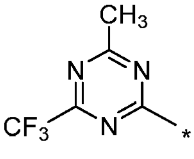 (K63), 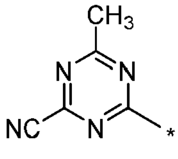 (K64), 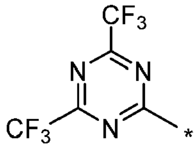 (K65),

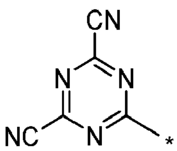 (K66), 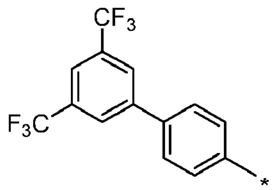 (K67), 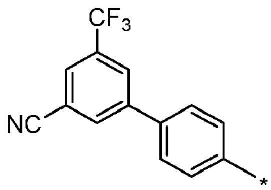 (K68),

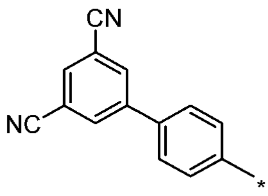 (K69), 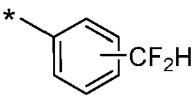 (K70), 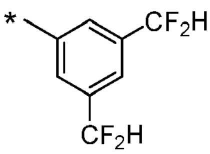 (K71),

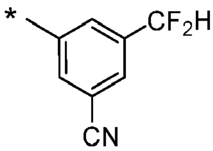 (K72), 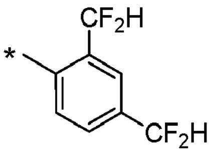 (K73), 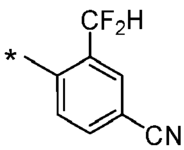 (K74), 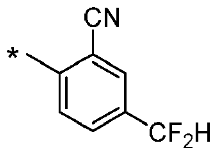 (75),

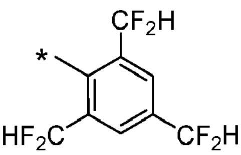 (K76), 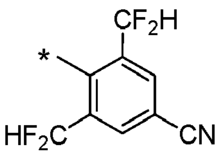 (K77), 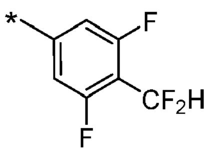 (K78), 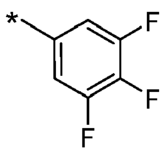 (K79),

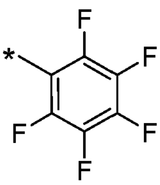 (K80), 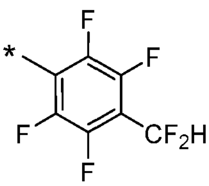 (K81), 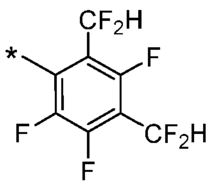 (K82), 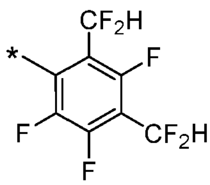 (K83),

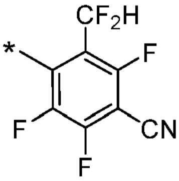 (K84), 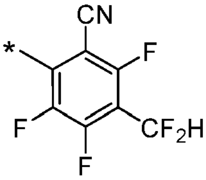 (K85), 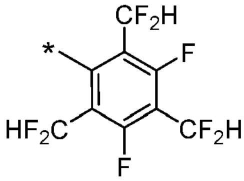 (K86), 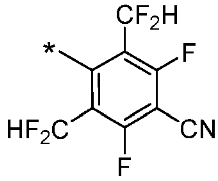 (K87),

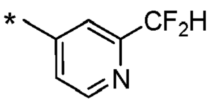 (K88), 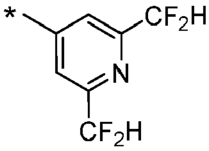 (K89); 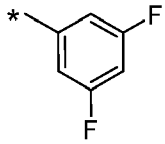 (K90), 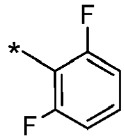 (K91)

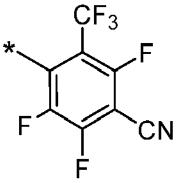 (K92), 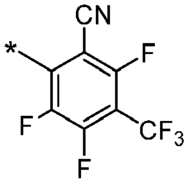 (K93), 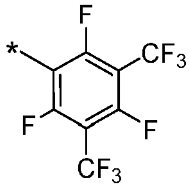 (K94), 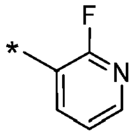 (K95),

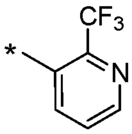 (K96), 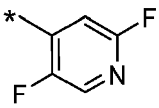 (K97), 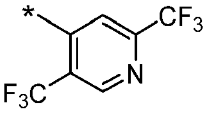 (K98), 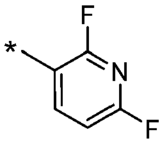 (K99),

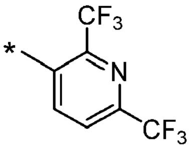 (K100), 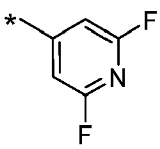 (K101), 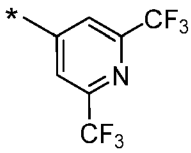 (K102), 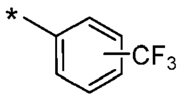 (K103),

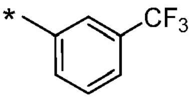 (K104), 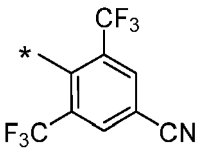 (K105), 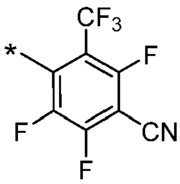 (K106), 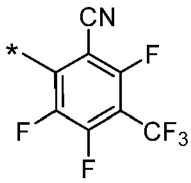 (K107),

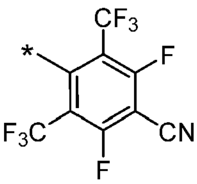 (K108), 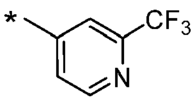 (K109), 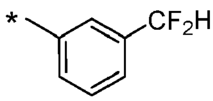 (K110), 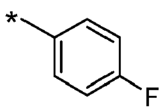 (K111),

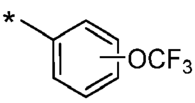 (K112), 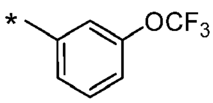 (K113), 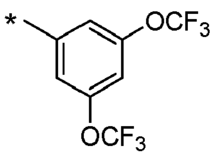 (K114);

wherein the "*" denotes the binding position.

According to an embodiment of Formula (I) $R^4$ of formula (IIb) is selected from the following moieties:

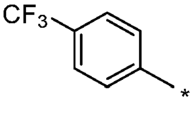 (K2), 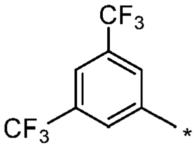 (K3), 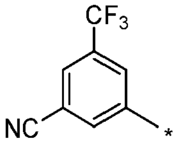 (K4), 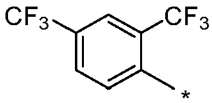 (K6),

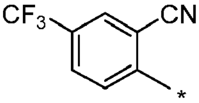 (K7), 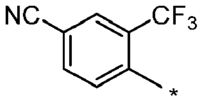 (K8), 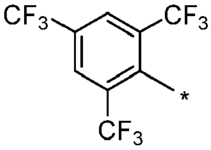 (K10), 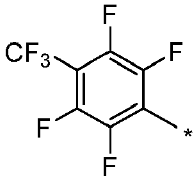 (K11),

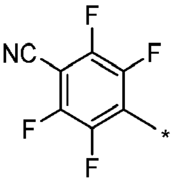 (K12), 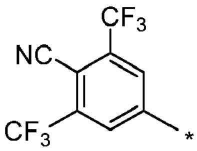 (K18), 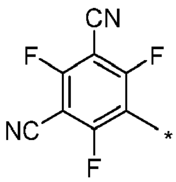 (K21), , 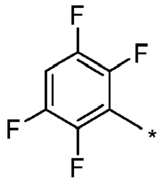 (K26),

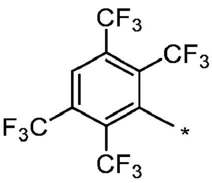 (K27), 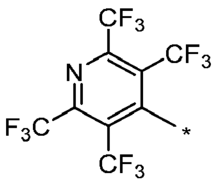 (K29), 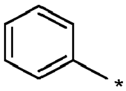 (K35), 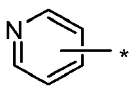 (K36), 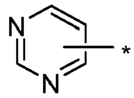
(K37),

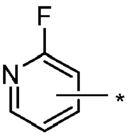 (K38), 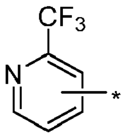 (K39), 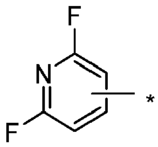 (K41), 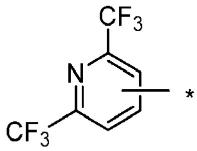 (K42),

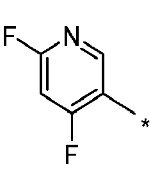 (K44), 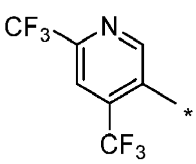 (K45), 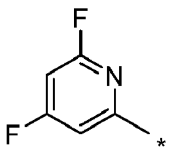 (K47), 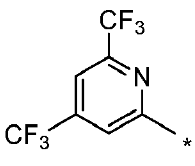 (K48),

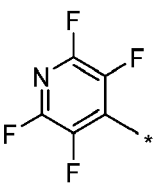 (K50), 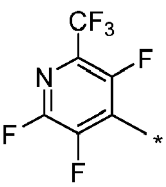 (K51), 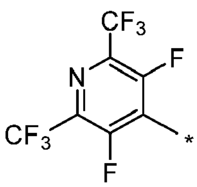 (K53), 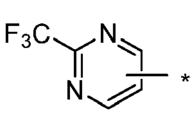 (K56),

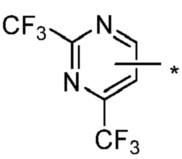 (K57), 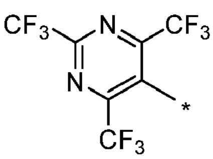 (K59), 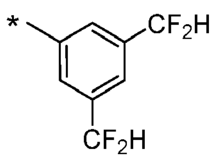 (K71), 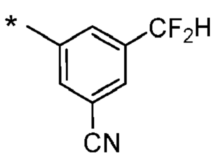 (K72),

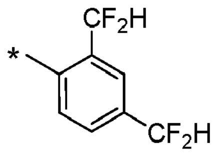 (K73), 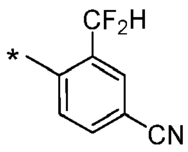 (K74), 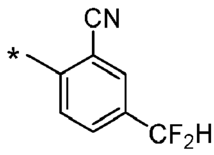 (K75), 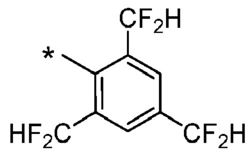 (K76),

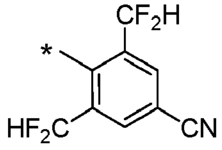 (K77), 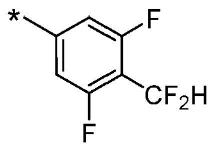 (K78), 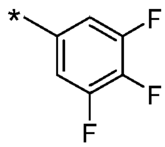 (K79), 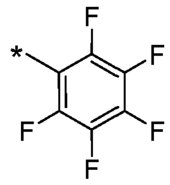 (K80),

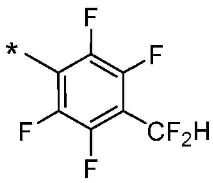 (K81), 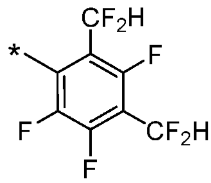 (K82), 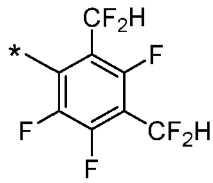 (K83), 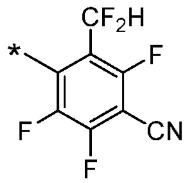 (K84),

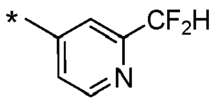 (K88), 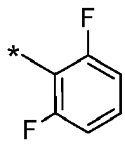 (K91), 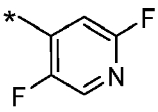 (K97), 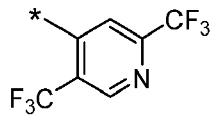 (K98),

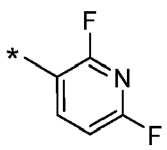 (K99), 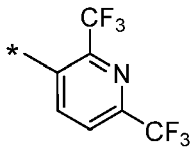 (K100), 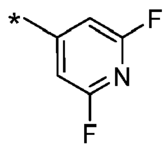 (K101), 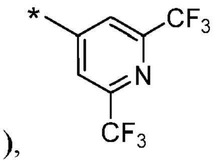 (K102),

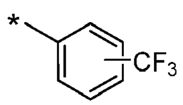 (K103), 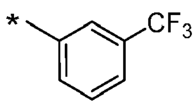 (K104), 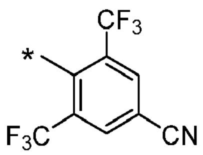 (K105), 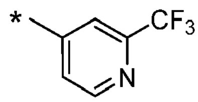 (K109),

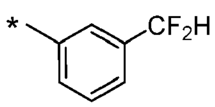 (K110), 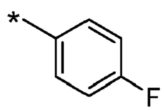 (K111), 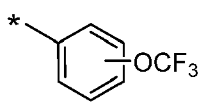 (K112), 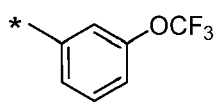 (K113),

wherein the "*" denotes the binding position.

According to an embodiment of Formula (I) $R^4$ of formula (IIb) is selected from the following moieties:

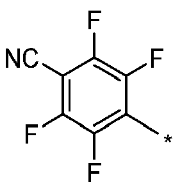 (K12), , 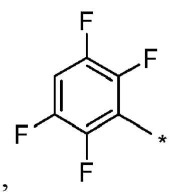 (K26), 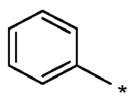 (K35), 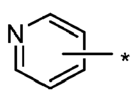 (K36), 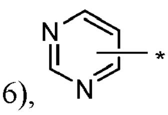 (K37),

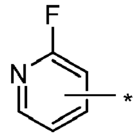 (K38), 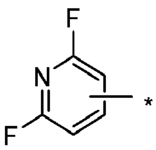 (K41), 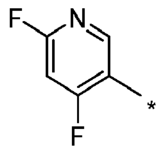 (K44), 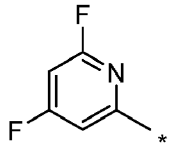 (K47),

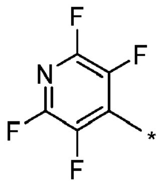 (K50), 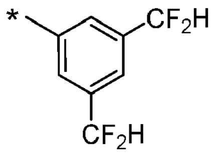 (K71), 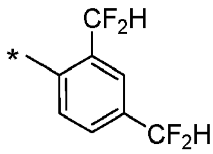 (K73), 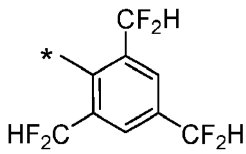 (K76),

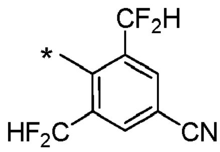 (K77), 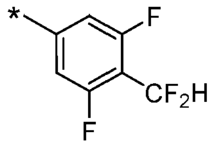 (K78), 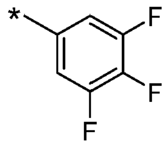 (K79), 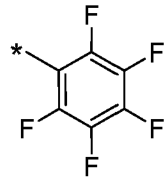 (K80),

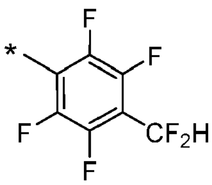 (K81), 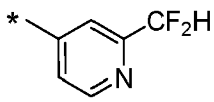 (K88), 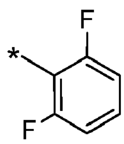 (K91), 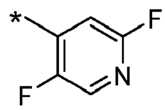 (K97), ,

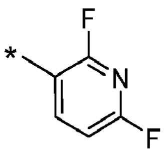 (K99), 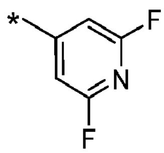 (K101), 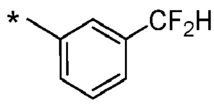 (K110), 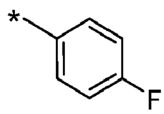 (K111),

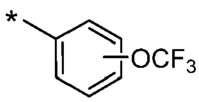 (K112), 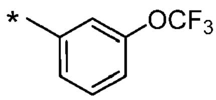 (K113),

wherein the "*" denotes the binding position.

According to an embodiment of Formula (I) $R^4$ of formula (IIb) is selected from the following moieties:

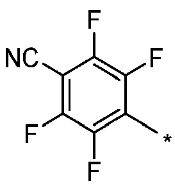 (K12), , 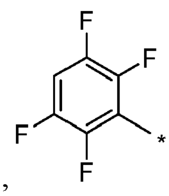 (K26), 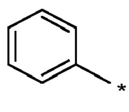 (K35), 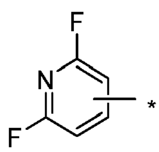 (K41),

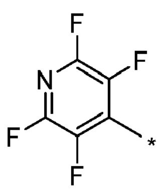 (K50), 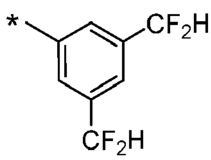 (K71), 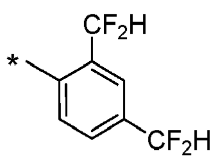 (K73), 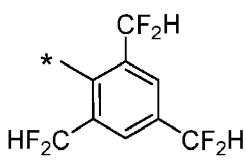 (K76),

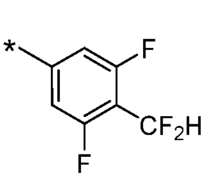 (K78), 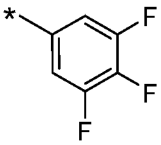 (K79), 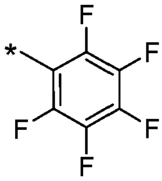 (K80), 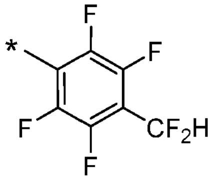 (K81),

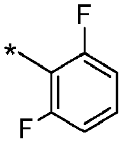 (K91) 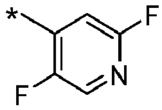 (K97), , 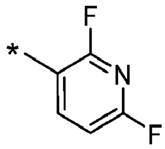 (K99), 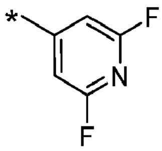 (K101)

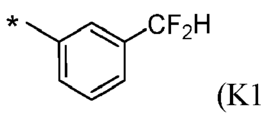 (K110), 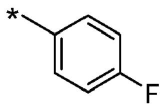 (K111), 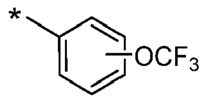 (K112), 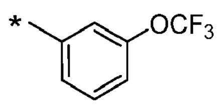 (K113),

wherein the "*" denotes the binding position.

According to an embodiment of Formula (I), wherein $R^5$ of formula (IIb) is selected from $CH_3$, $CF_3$, $C_2F_5$, $C_3F_7$, $C_4F_9$, $CFH_2$, $CF_2H$, $CF_2CF_2H$, $(CF_2)_2CF_2H$, $CH(CF_2H)_2$, $CF(CF_2H)_2$, $C(CF_2H)_3$, CN and the following formulae **L1 to L114:**

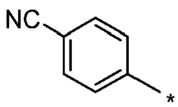 (L1), 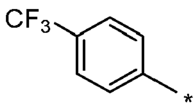 (L2), 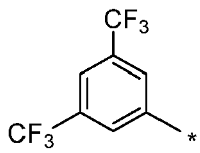 (L3), 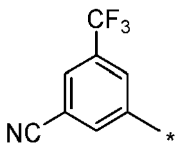 (L4), 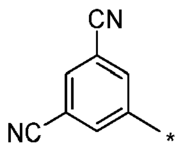

(L5), 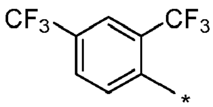 (L6), 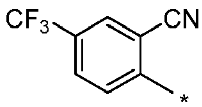 (L7), 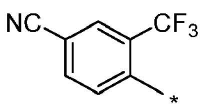 (L8), 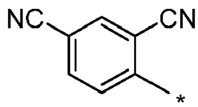 (L9),

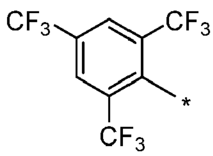 (L10), 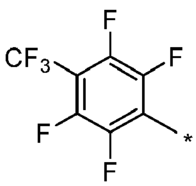 (L11), 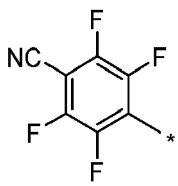 (L12), 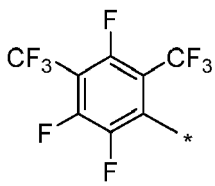 (L13),

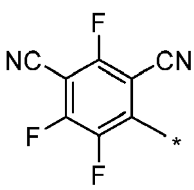 (L14), 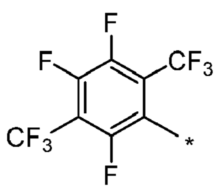 (L15), 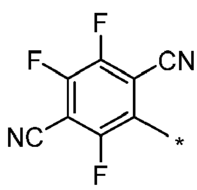 (L16), 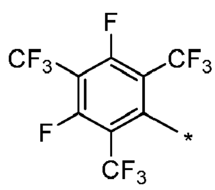 (L17),

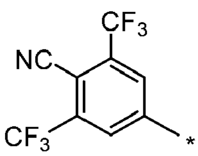 (L18), 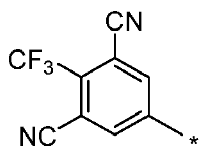 (L19), 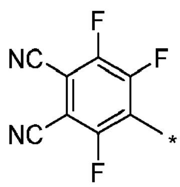 (L20), 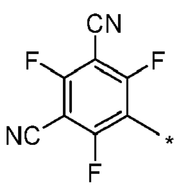 (L21),

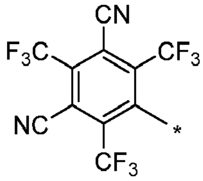 (L22), 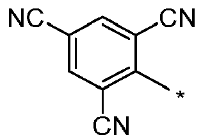 (L23), 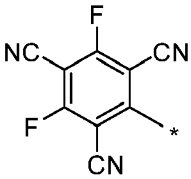 (L24), 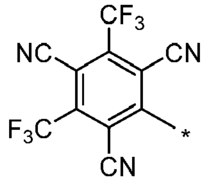 (L25),

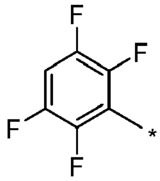 (L26), 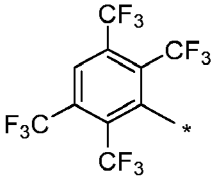 (L27), 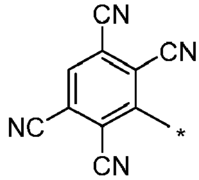 (L28), 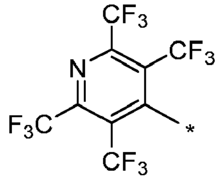 (L29),

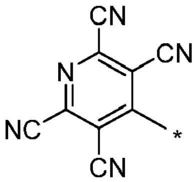 (L30), 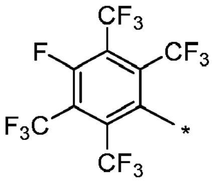 (L31), 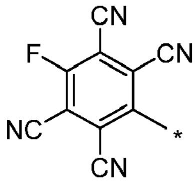 (L32), 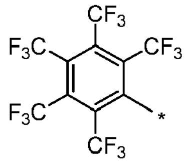 (L33),

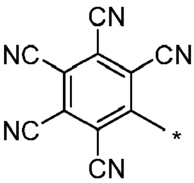 (L34), 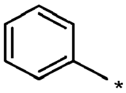 (L35), 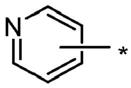 (L36), 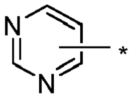 (L37), 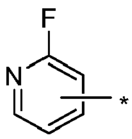 (L38),

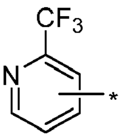 (L39), 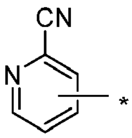 (L40), 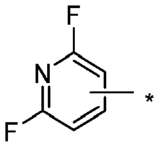 (L41), 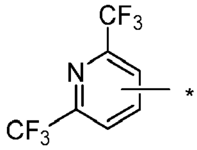 (L42),

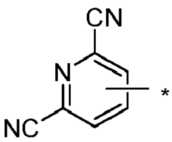 (L43), 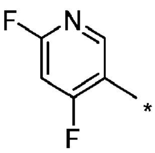 (L44), 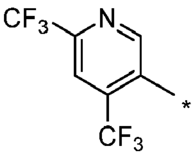 (L45), 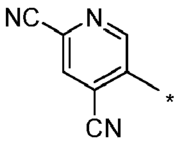 (L46), 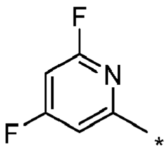

(L47), 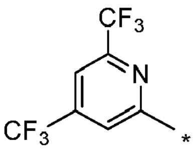 (L48), 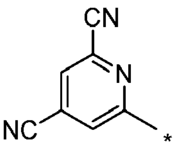 (L49), 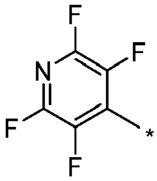 (L50), 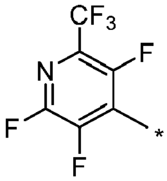 (L51),

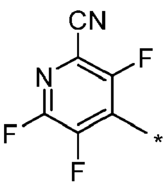 (L52), 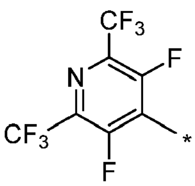 (L53), 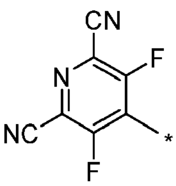 (L54), 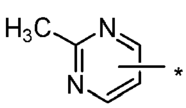 (L55),

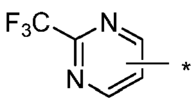 (L56), 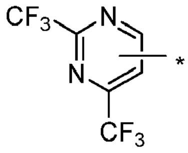 (L57), 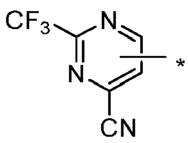 (L58), 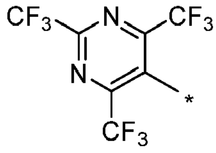 (L59),

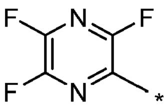 (L60), 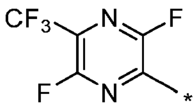 (L61), 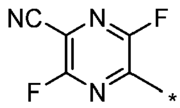 (L62), 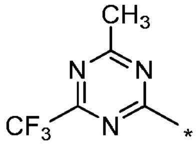 (L63),

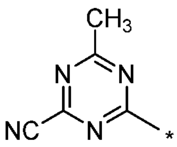 (L64), 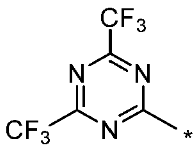 (L65), 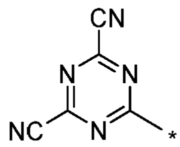 (L66), 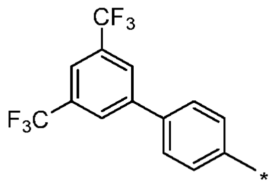 (L67),

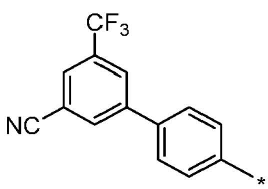 (L68), 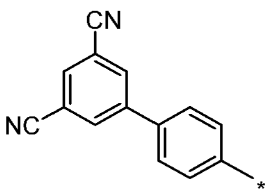 (L69), 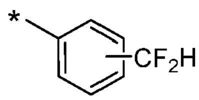 (L70), 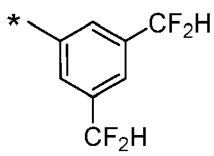

(L71), 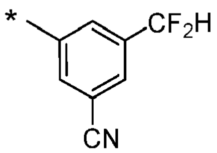 (L72), 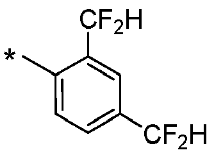 (L73), 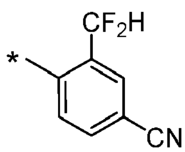 (L74), 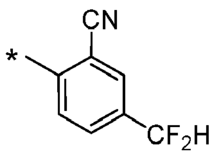

(L75), 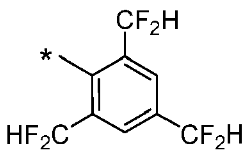 (L76), 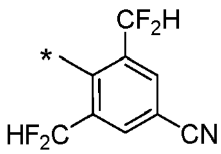 (L77), 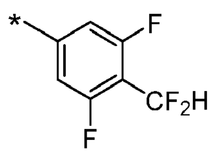 (L78),

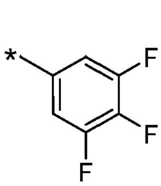 (L79), 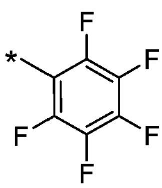 (L80), 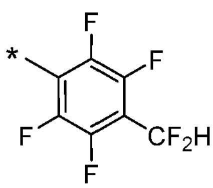 (L81), 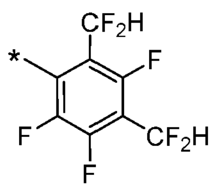 (L82),

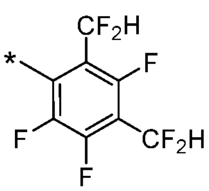 (L83), 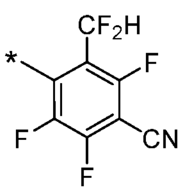 (L84), 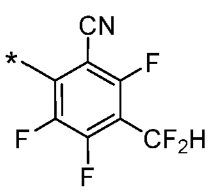 (L85), 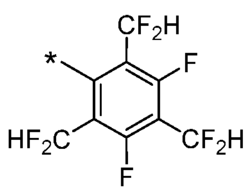 (L86),

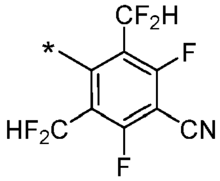 (L87), 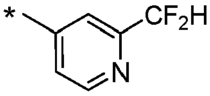 (L88), 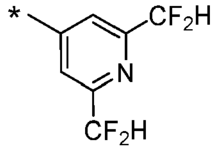 (L89); 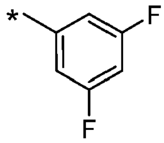 (L90),

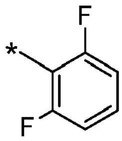 (L91), 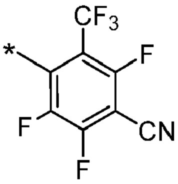 (L92), 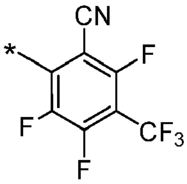 (L93), 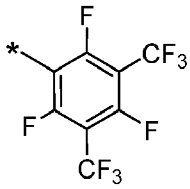 (L94),

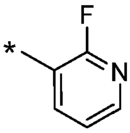 (L95), 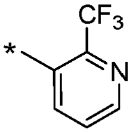 (L96), 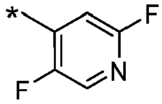 (L97), 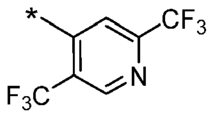 (L98), 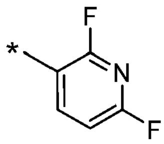

(L99), 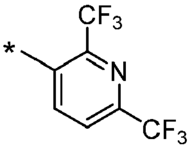 (L100), 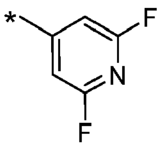 (L101), 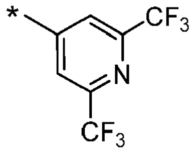 (L102), 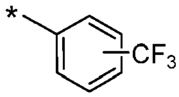 (L103),

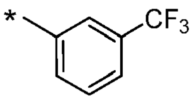 (L104), 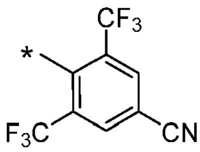 (L105), 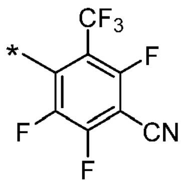 (L106), 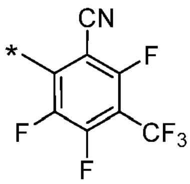 (L107),

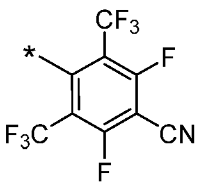 (L108), 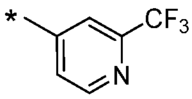 (L109), 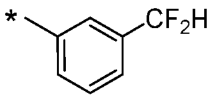 (L110), 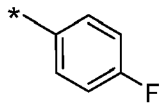 (L111),

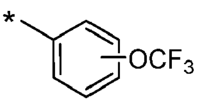 (L112), 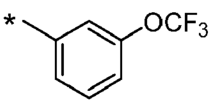 (L113), 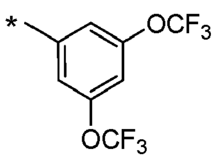 (L114);

wherein the "*" denotes the binding position.

According to an embodiment of Formula (I), wherein $R^5$ of formula (IIb) is selected from $CH_3$, $CF_3$, $CF_2H$, CN, and the following moieties:

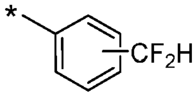 (L70), 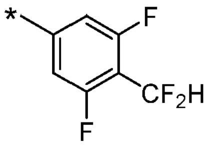 (L78), 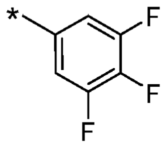 (L79), 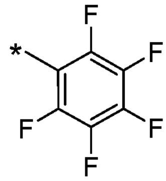 (L80),

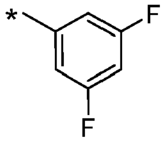 (L90), 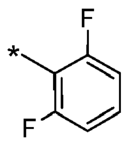 (L91), 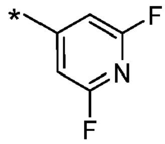 (L101), 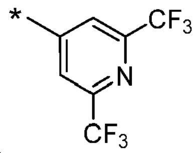 (L102),

wherein the "*" denotes the binding position.

According to an embodiment of Formula (I), wherein $R^5$ of formula (IIb) is selected from $CH_3$, $CF_3$, $CF_2H$,, CN and the following moieties:

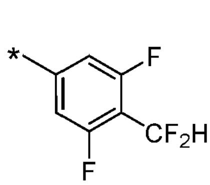 (L78), 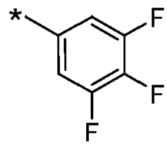 (L79), 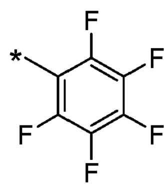 (L80),

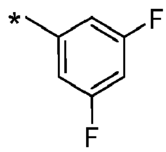 (L90), 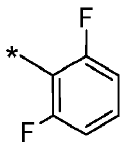 (L91), 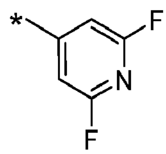 (L101),

wherein the "*" denotes the binding position.

According to an embodiment of Formula (I), wherein $R^5$ of formula (IIb) is selected from $CH_3$,, CN and $CF_2H$,

According to one embodiment of Formula (IIb), $R^4$ of formula (IIb) is selected from the formulae **K1 to K114,** and $R^5$ of formula (IIb) is selected from $CH_3$, $CF_3$, $C_2F_5$, $C_3F_7$, $C_4F_9$, $CFH_2$, $CF_2H$, $CF_2CF_2H$, $(CF_2)_2CF_2H$, $CH(CF_2H)_2$, $CF(CF_2H)_2$, $C(CF_2H)_3$, CN, and the formulae **L1 to L114**.

According to an embodiment of Formula (I) $R^6$ of formula (IIe) is selected from **M1 to M114:**

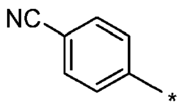 (M1), 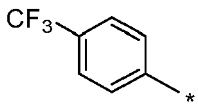 (M2), 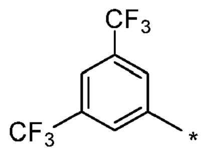 (M3), 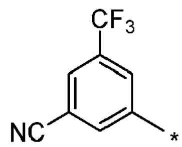 (M4),

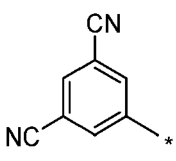 (M5), 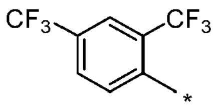 (M6), 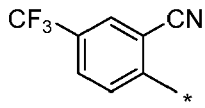 (M7), 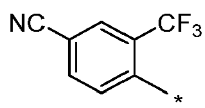 (M8),

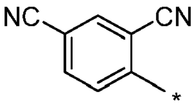 (M9), 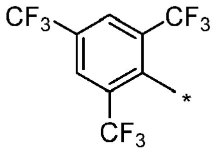 (M10), 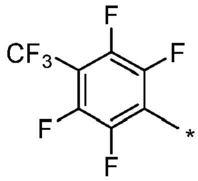 (M11), 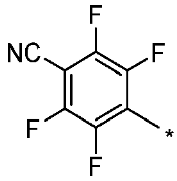 (M12),

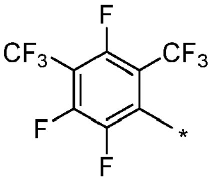 (M13), 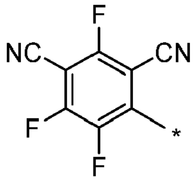 (M14), 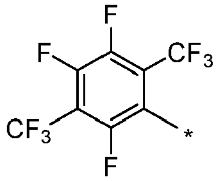 (M15), 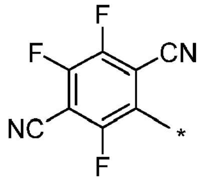 (M16),

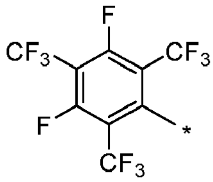 (M17), 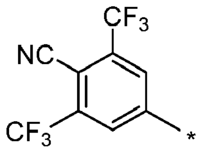 (M18), 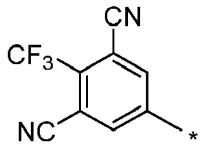 (M19), 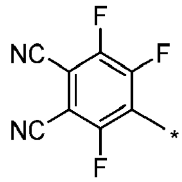 (M20),

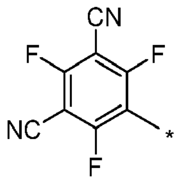 (M21), 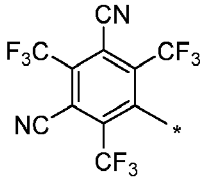 (M22), 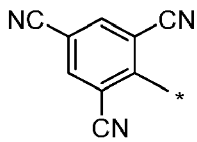 (M23), 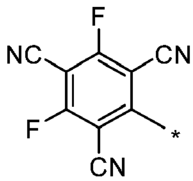 (M24),

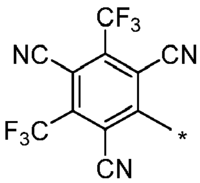 (M25), 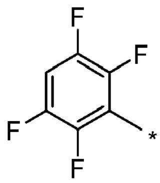 (M26), 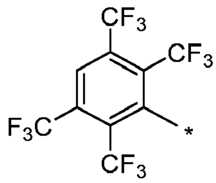 (M27), 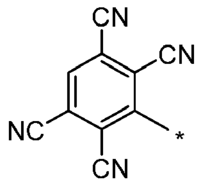 (M28),

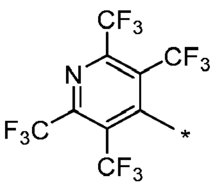 (M29), 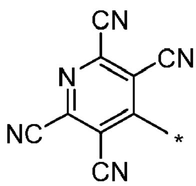 (M30), 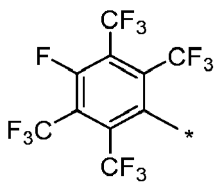 (M31), 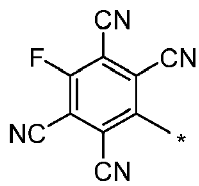

(M32), 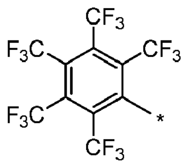 (M33), 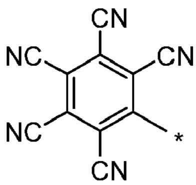 (M34), 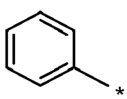 (M35), 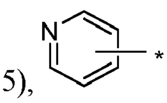 (M36),

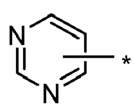 (M37), 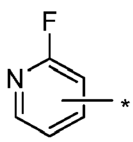 (M38), 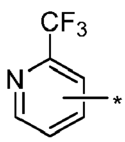 (M39), 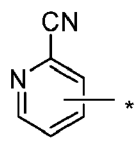 (M40),

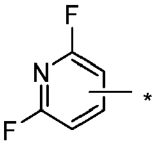 (M41), 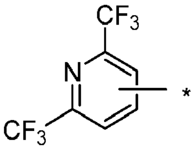 (M42), 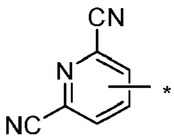 (M43), 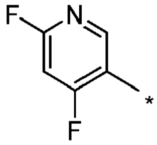 (M44),

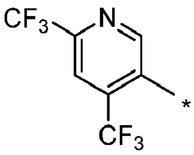 (M45), 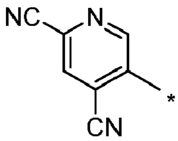 (M46), 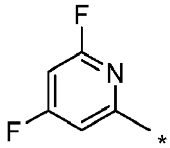 (M47), 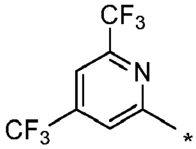 (M48),

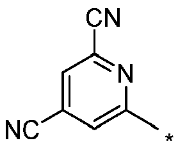 (M49), 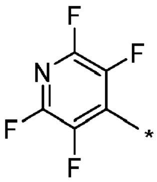 (M50), 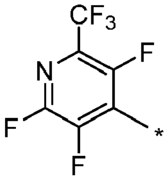 (M51), 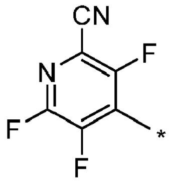 (M52),

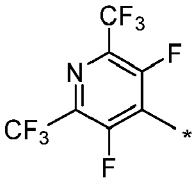 (M53), 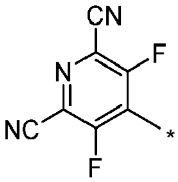 (M54), 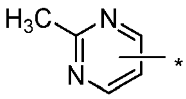 (M55), 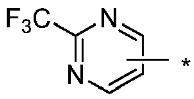 (M56),

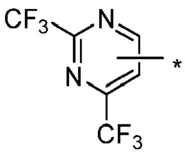 (M57), 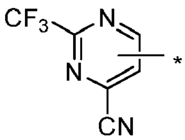 (M58), 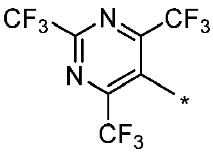 (M59), 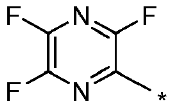 (M60),

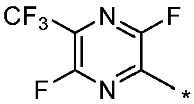 (M61), 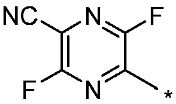 (M62), 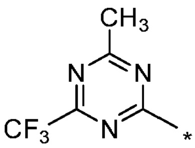 (M63), 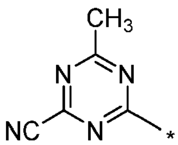 (M64),

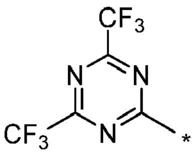 (M65), 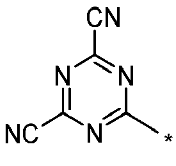 (M66), 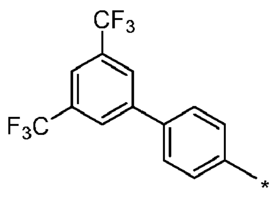 (M67),

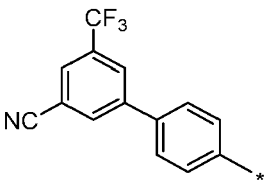 (M68), 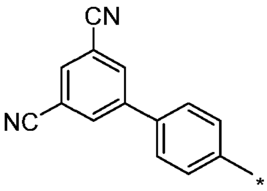 (M69), 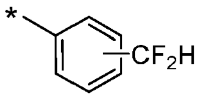 (M70),

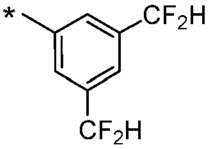 (M71), 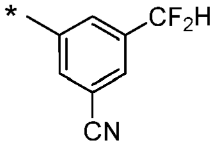 (M72), 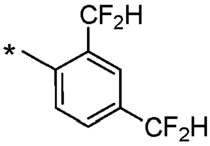 (M73), 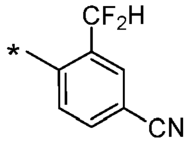 (M74),

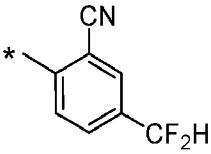 (M75), 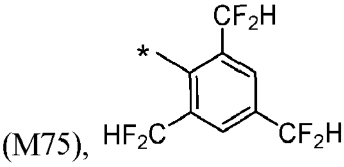 (M76), 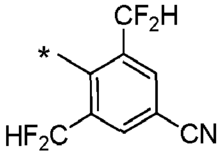 (M77),

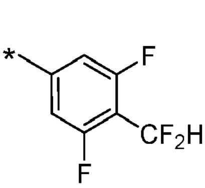 (M78), 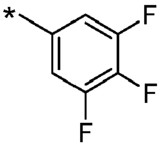 (M79), 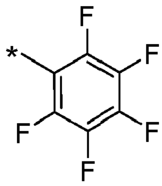 (M80), 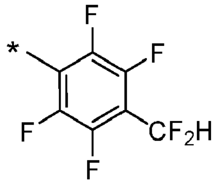 (M81),

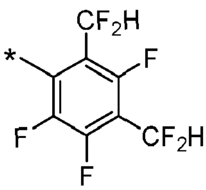 (M82), 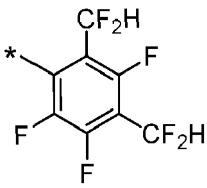 (M83), 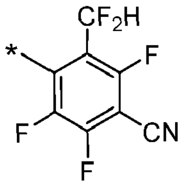 (M84), 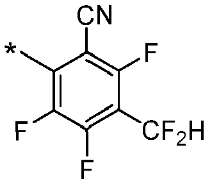 (M85),

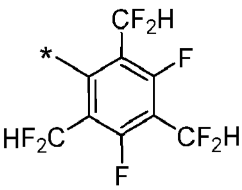 (M86), 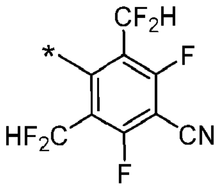 (M87), 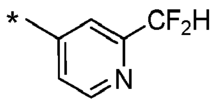 (M88),

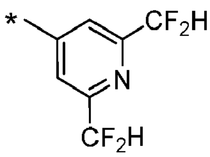 (M89), 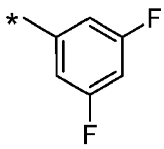 (M90), 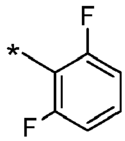 (M91), 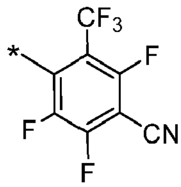 (M92),

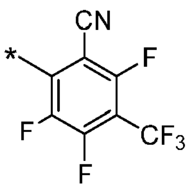 (M93), 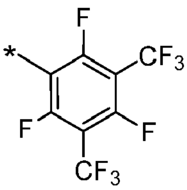 (M94), 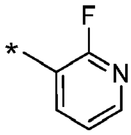 (M95), 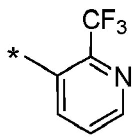 (M96),

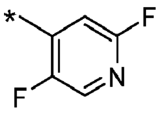 (M97), 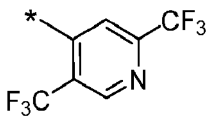 (M98), 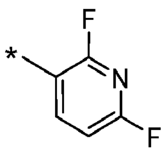 (M99), 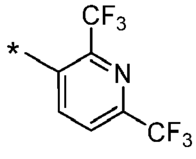 (M100),

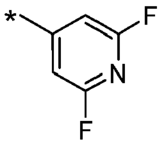 (M101), 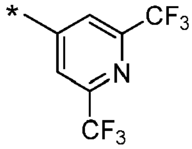 (M102), 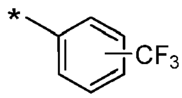 (M103), 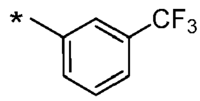 (M104),

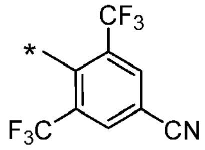 (M105), 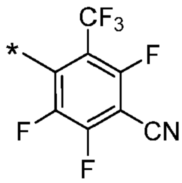 (M106), 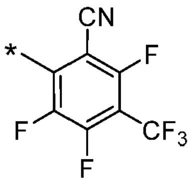 (M107), 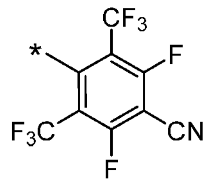 (M108),

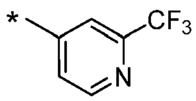 (M109), 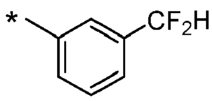 (M110), 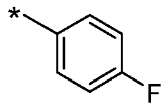 (M111), 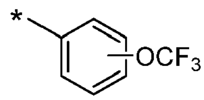 (M112),

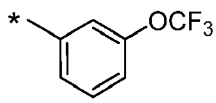 (M113), 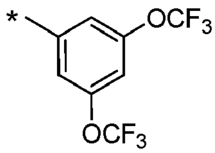 (M114)

wherein the "*" denotes the binding position.

According to an embodiment of Formula (I) $R^6$ of formula (IIe) is selected from the following moieties:

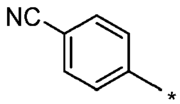 (M1), 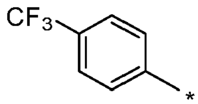 (M2), 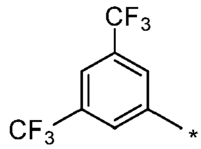 (M3), 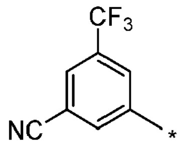 (M4),

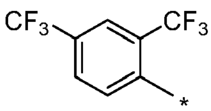 (M6), 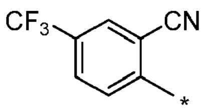 (M7), 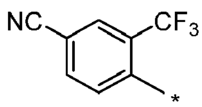 (M8), 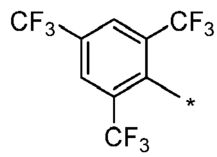 (M10),

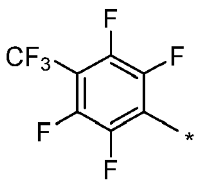 (M11), 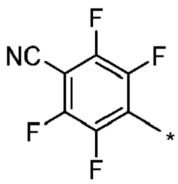 (M12), 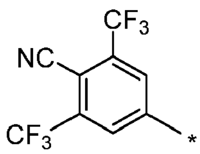 (M18), 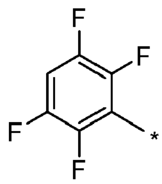 (M26),

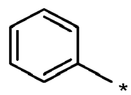 (M35), 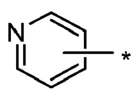 (M36), 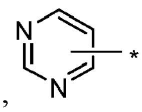 (M37), 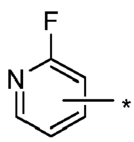 (M38), 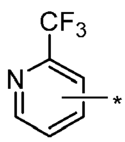 (M39),

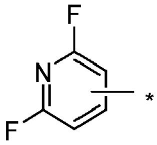 (M41), 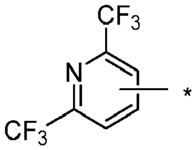 (M42), 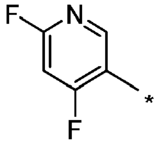 (M44), 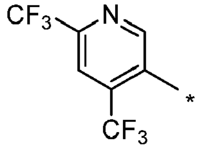 (M45),

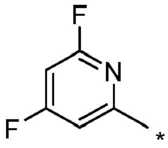 (M47), 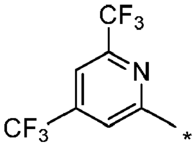 (M48), 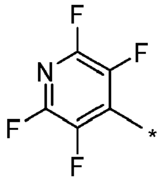 (M50), 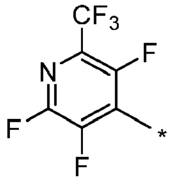 (M51),

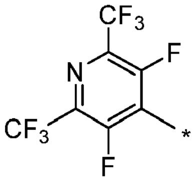 (M53), 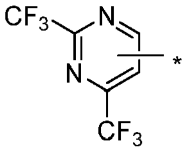 (M57), 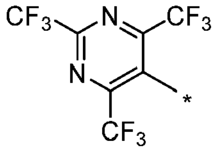 (M59), 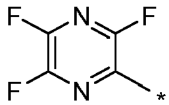 (M60),

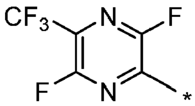 (M61), 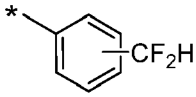 (M70), 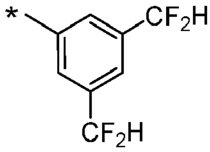 (M71), 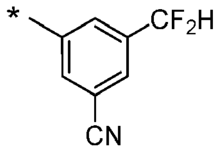 (M72),

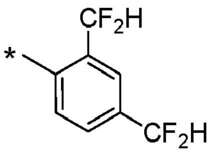 (M73), 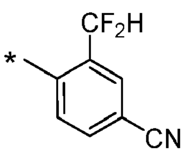 (M74), 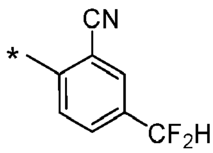 (M75),

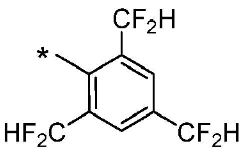 (M76), 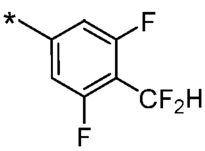 (M78), 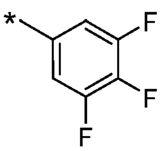 (M79), 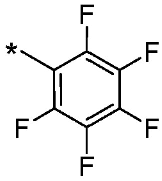 (M80),

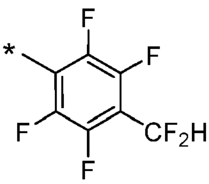 (M81), 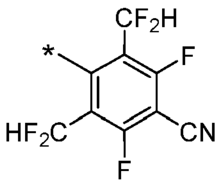 (M87), 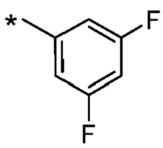 (M90), 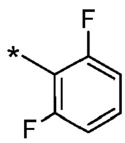 (M91),

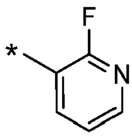 (M95), 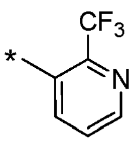 (M96), 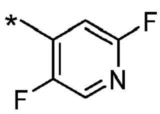 (M97), 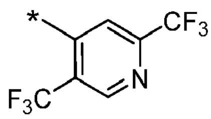 (M98),

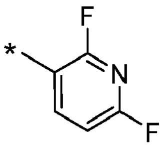 (M99), 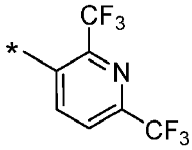 (M100), 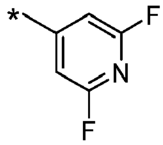 (M101), 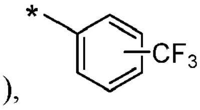 (M103),

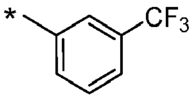 (M104), 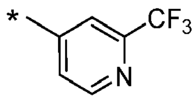 (M109), 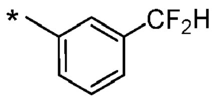 (M110), 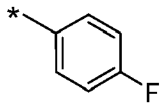 (M111),

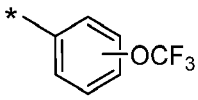 (M112), 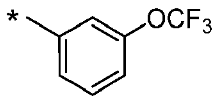 (M113),

wherein the "*" denotes the binding position.

According to an embodiment of Formula (I) $R^6$ of formula (IIe) is selected from the following moieties:

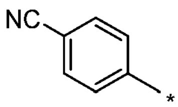 (M1), 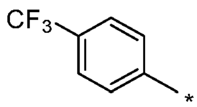 (M2), 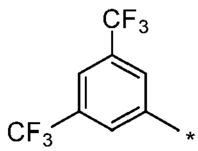 (M3), 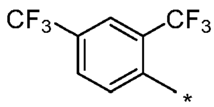 (M6),

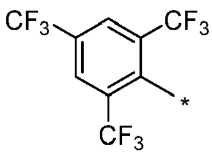 (M10), 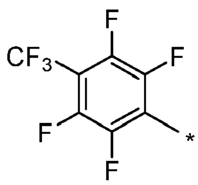 (M11), 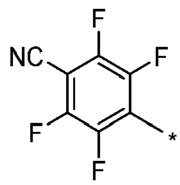 (M12), 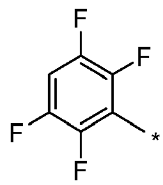 (M26),

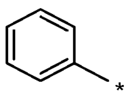 (M35), 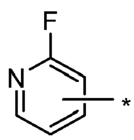 (M38), 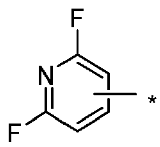 (M41), 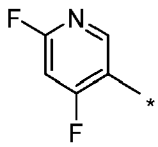 (M44),

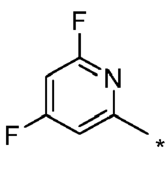 (M47), 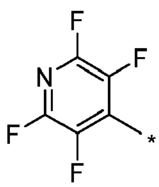 (M50), 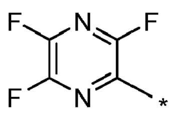 (M60), 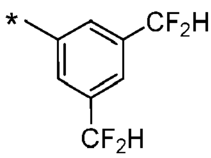 (M71),

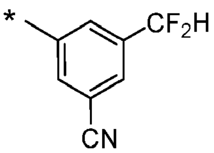 (M72), 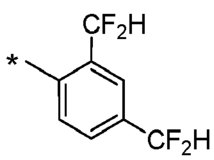 (M73), 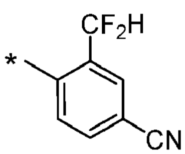 (M74), 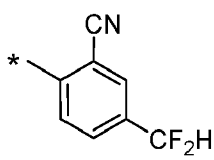 (M75),

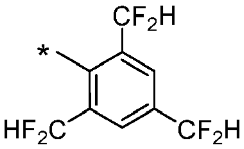 (M76), 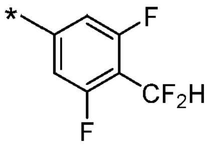 (M78), 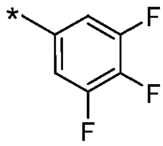 (M79), 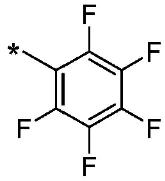 (M80),

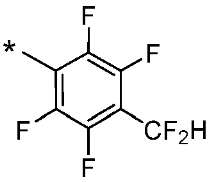 (M81), 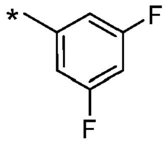 (M90), 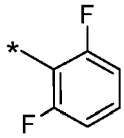 (M91), 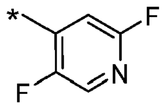 (M97),

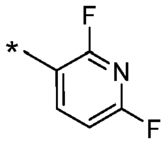 (M99), 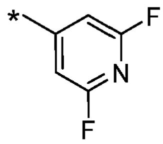 (M101), 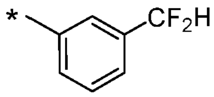 (M110), 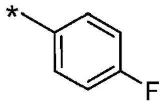 (M111),

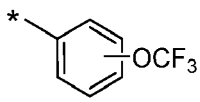 (M112), 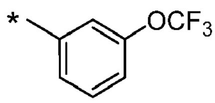 (M113),

wherein the "*" denotes the binding position.

According to an embodiment of Formula (I) $R^6$ of formula (IIe) is selected from the following moieties:

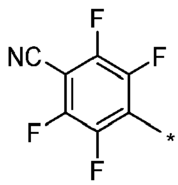 (M12), 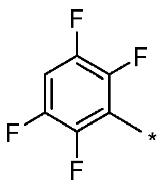 (M26), 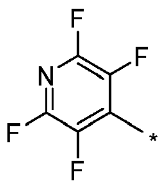 (M50), 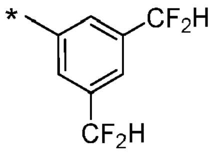 (M71),

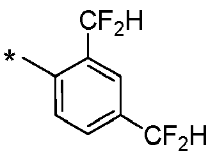 (M73), 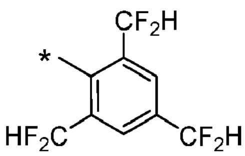 (M76), 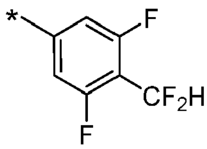 (M78), 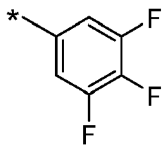 (M79),

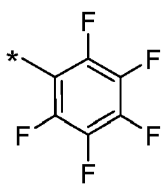 (M80), 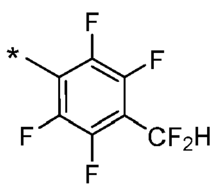 (M81), 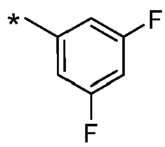 (M90), 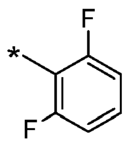 (M91),

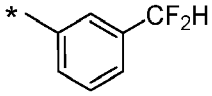 (M110), 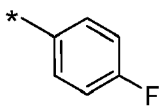 (M111), 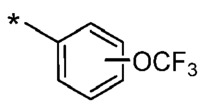 (M112),

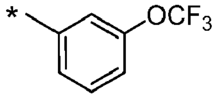

(M113),

wherein the "*" denotes the binding position.

According to one embodiment, Ligand L is selected from formulae (IIb) to (IIe); wherein

$R^a$ of formulae (IIb) to (IIe) is selected from $CH_3$, $CF_3$, $C_2F_5$, $C_3F_7$, $C_4F_9$, $CFH_2$, $CF_2H$, $CF_2CF_2H$, $(CF_2)_2CF_2H$, $CH(CF_2H)_2$, $CF(CF_2H)_2$, $C(CF_2H)_3$ and formulae **J1to J114;**

$R^4$ of formula (IIb) is selected from the formulae **K1 to K114,** and $R^5$ of formula (IIb) is selected from $CH_3$, $CF_3$, $C_2F_5$, $C_3F_7$, $C_4F_9$, $CFH_2$, $CF_2H$, $CF_2CF_2H$, $(CF_2)_2CF_2H$, $CH(CF_2H)_2$, $CF(CF_2H)_2$, $C(CF_2H)_3$, CN, and the formulae **L1 to L114;**

$R^6$ of formula (IIe) is selected from formulae **M1 to M114.**

According to one embodiment, Ligand L is selected from formulae (IIb), (IIe), (IIf) and/or IIg.

According to one embodiment, Ligand L is selected from formulae (IIb), (IIe), (IIf) and/or (IIg); wherein

$R^a$ of formulae (IIb), (IIe), (IIf) and/or (IIg) is selected from $CH_3$, $CF_3$, $C_2F_5$, $C_3F_7$, $C_4F_9$, $CFH_2$, $CF_2H$, $CF_2CF_2H$, $(CF_2)_2CF_2H$, $CH(CF_2H)_2$, $CF(CF_2H)_2$, $C(CF_2H)_3$ and formulae **J1 to J114;**

$R^4$ of formula (IIb) is selected from formulae **K1 to K112,** and $R^5$ of formula (IIb) is selected from $CH_3$, $CF_3$, $C_2F_5$, $C_3F_7$, $C_4F_9$, $CFH_2$, $CF_2H$, $CF_2CF_2H$, $(CF_2)_2CF_2H$, $CH(CF_2H)_2$, $CF(CF_2H)_2$, $C(CF_2H)_3$, CN, phenyl and the formulae **L1 to L114;**

$R^6$ of formula (IIe) is selected from formulae **M1 to M114;**

$R^{21}$ to $R^{24}$ of formulae (IIf) and (IIg) are independently selected from H, D, halogen, Cl, F, CN, $C_1$ to $C_{12}$ alkyl, $C_1$ to $C_{12}$ alkoxy, partially or perfluorinated $C_1$ to $C_{12}$ alkyl, $CF_3$, $CF_2R$, $CFR_2$, $CF_2H$, $CFH_2$, or a combination thereof, wherein R is H or D, preferably H; more preferred $R^{21}$ to $R^{24}$ are independently selected from H, D, F, $CF_3$, $CF_2R$, $CFR_2$, $CF_2H$, $CFH_2$, or a combination thereof, wherein R is H or D, preferably H.

According to one embodiment, Ligand L is selected from formulae (IIc), (IId), (IIe), (IIf) and/or (IIg).

According to one embodiment, Ligand L is selected from formulae (IIc), (IId), (IIe), (IIf) and/or (IIg), wherein

$R^a$ of formulae (IIe), (IIf) and/or (IIg) is selected from $CH_3$, $CF_3$, $C_2F_5$, $C_3F_7$, $C_4F_9$, $CFH_2$, $CF_2H$, $CF_2CF_2H$, $(CF_2)_2CF_2H$, $CH(CF_2H)_2$, $CF(CF_2H)_2$, $C(CF_2H)_3$ and formulae J1 to J114;

$R^6$ of formula (IIe) is selected from formulae **M1 to M114;**

$R^{21}$ to $R^{24}$ of formulae (IIf) and (IIg) are independently selected from H, D, halogen, Cl, F, CN, $C_1$ to $C_{12}$ alkyl, $C_1$ to $C_{12}$ alkoxy, partially or perfluorinated $C_1$ to $C_{12}$ alkyl, $CF_3$, $CF_2R$, $CFR_2$, $CF_2H$, $CFH_2$, or a combination thereof, wherein R is H or D, preferably H; more preferred $R^{21}$ to $R^{24}$ are independently selected from H, D, F, $CF_3$, $CF_2R$, $CFR_2$, $CF_2H$, $CFH_2$, or a combination thereof, wherein R is H or D, preferably H.

According to one embodiment, Ligand L is selected from formulae (IIe).

According to one embodiment, Ligand L is selected from formulae (IIe), wherein $R^6$ of formula (IIe) is selected from formulae **M1 to M114.**

According to one embodiment, Ligand L is selected from formulae (IIf) and/or (IIg); wherein

$R^a$ of formulae (IIf) and/or (IIg) is selected from $CH_3$, $CF_3$, $C_2F_5$, $C_3F_7$, $C_4F_9$, $CFH_2$, $CF_2H$, $CF_2CF_2H$, $(CF_2)_2CF_2H$, $CH(CF_2H)_2$, $CF(CF_2H)_2$, $C(CF_2H)_3$ and formulae **J1 to J112;**

$R^{21}$ to $R^{24}$ of formulae (IIf) and (IIg) are independently selected from H, D, halogen, Cl, F, CN, $C_1$ to $C_{12}$ alkyl, $C_1$ to $C_{12}$ alkoxy, partially or perfluorinated $C_1$ to $C_{12}$ alkyl, $CF_3$, $CF_2R$, $CFR_2$, $CF_2H$, $CFH_2$, or a combination thereof, wherein R is H or D, preferably H; more preferred $R^{21}$ to $R^{24}$ are independently selected from H, D, F, $CF_3$, $CF_2R$, $CFR_2$, $CF_2H$, $CFH_2$, or a combination thereof, wherein R is H or D, preferably H.

According to an embodiment, Ligand L of formula (II) or formula (IIa) is selected from A1 to A217, B1 to B117, $C_1$ to C31, D1 to D83, E1 to E173:

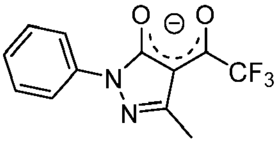 (A1), 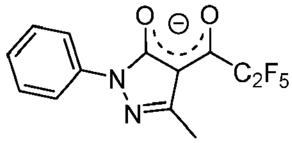 (A2), 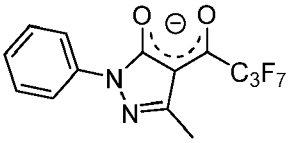 (A3),

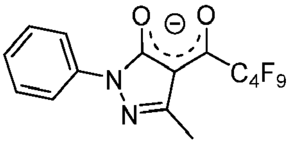 (A4), 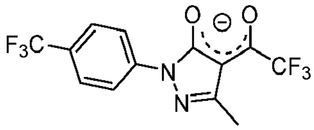 (A5), 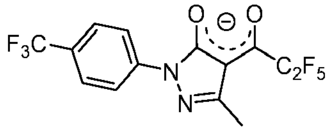 (A6),

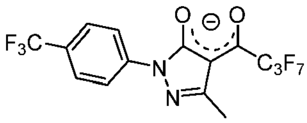 (A7), 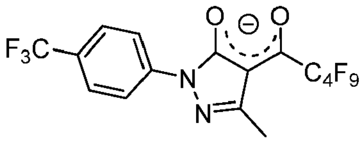 (A8), 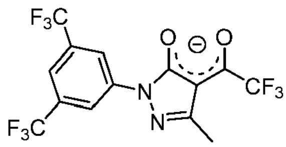 (A9),

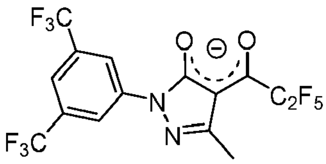 (A10), 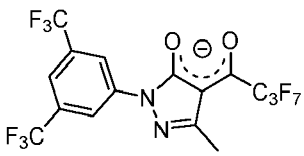 (A11), 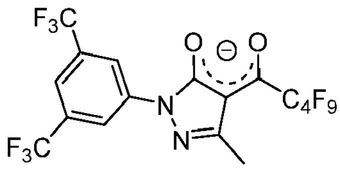

(A12), 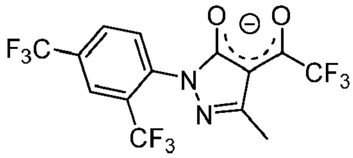 (A13), 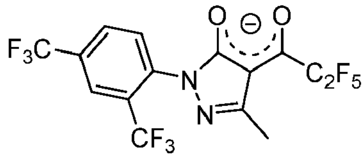 (A14),

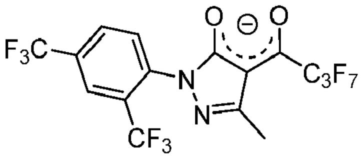 (A15), 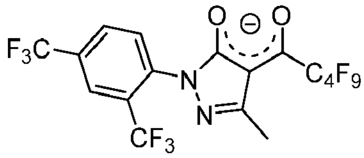 (A16),

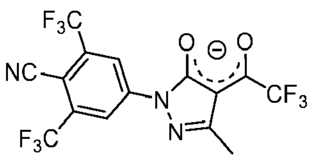 (A17), 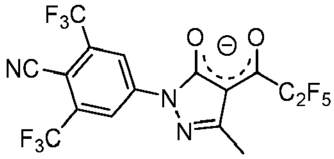 (A18), 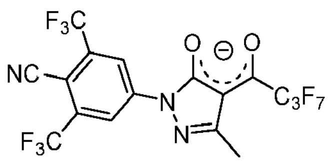

(A19), 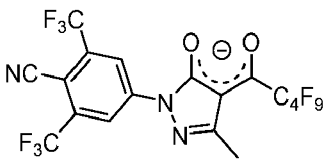 (A20), 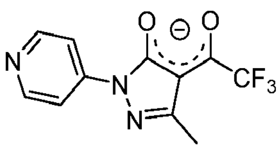 (A21), 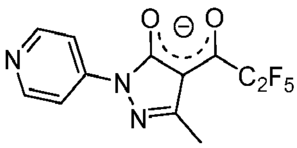

(A22), 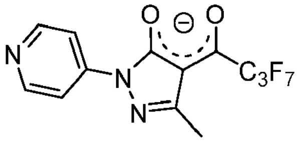 (A23), 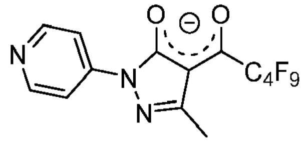 (A24), 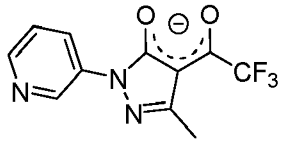

(A25), 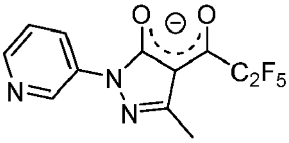 (A26), 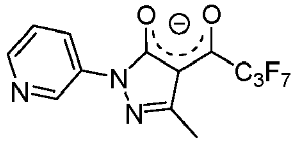 (A27), 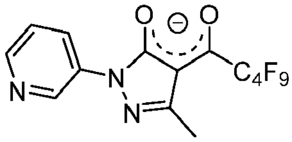

(A28), 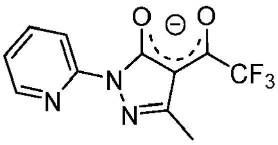 (A29), 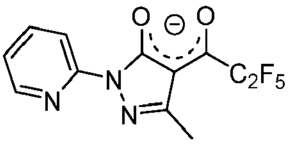 (A30), 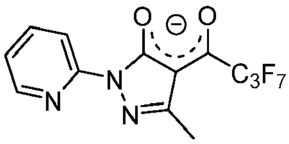 (A31),

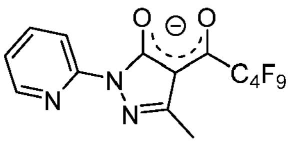 (A32), 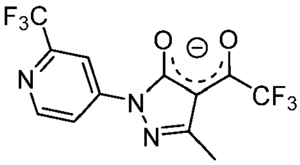 (A33), 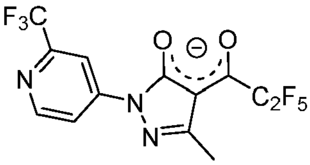 (A34),

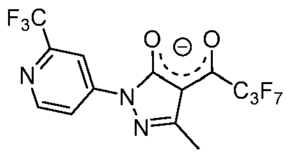 (A35), 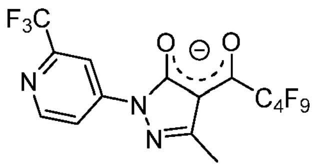 (A36), 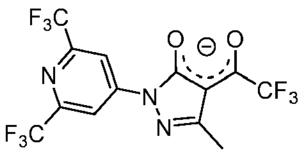 (A37),

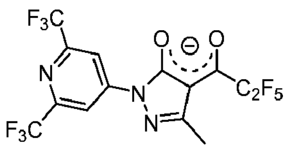 (A38), 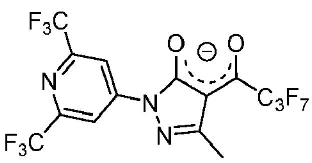 (A39), 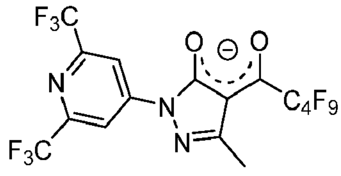 (A40),

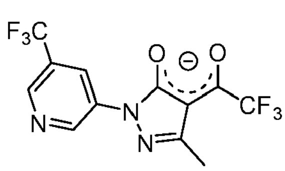 (A41), 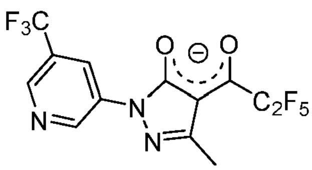 (A42), 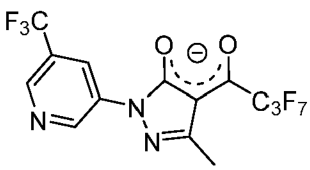 (A43),

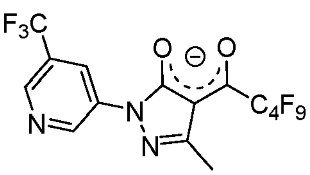 (A44), 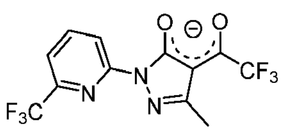 (A45), 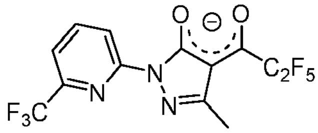 (A46),

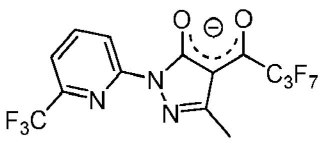 (A47), 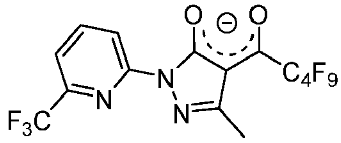 (A48), 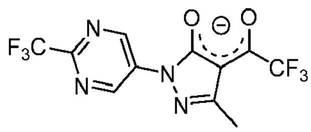

(A49), 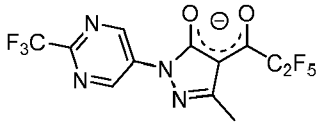 (A50), 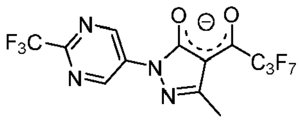 (A51), 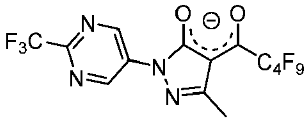

(A52),

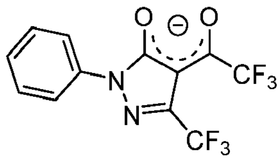 (A53), 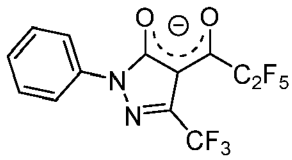 (A54), 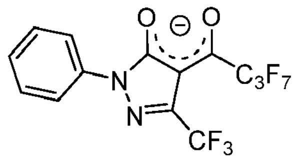 (A55),

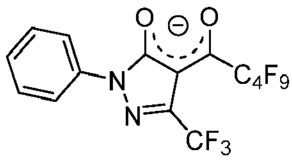 (A56), 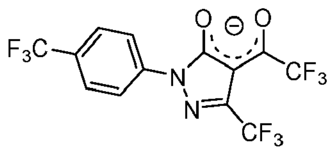 (A57), 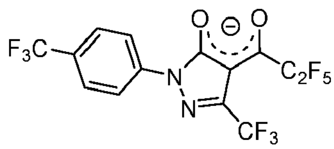 (A58),

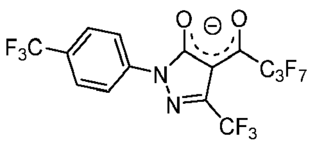 (A59), 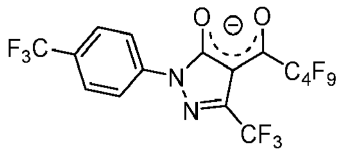 (A60), 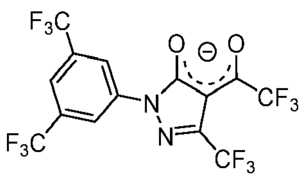

(A61), 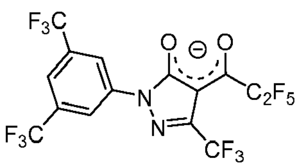 (A62), 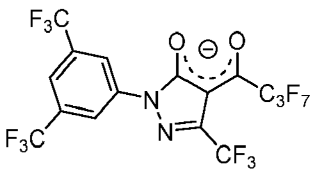 (A63), 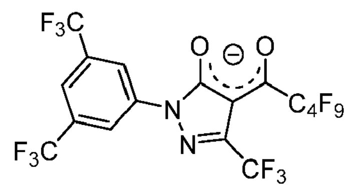

(A64), 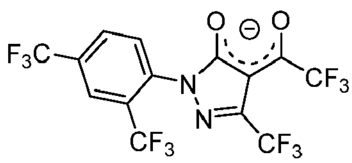 (A65), 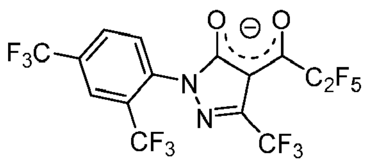 (A66),

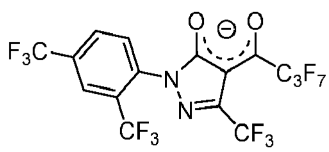 (A67), 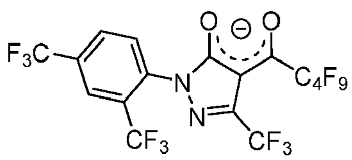 (A68), 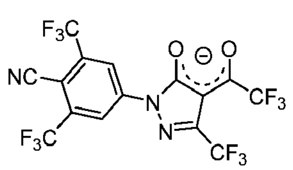

(A69),

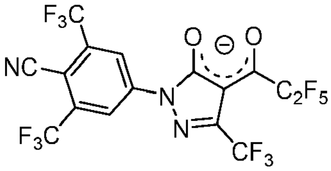 (A70), 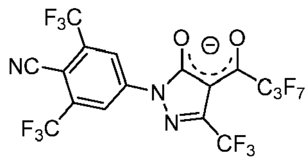 (A71), 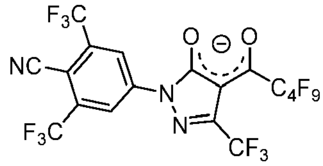

(A72), 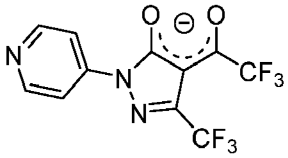 (A73), 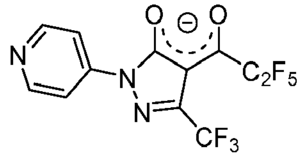 (A74), 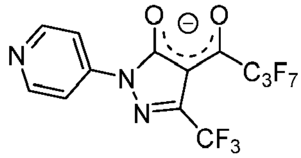

(A75), 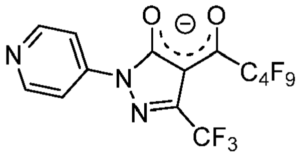 (A76), 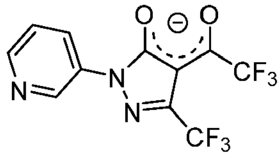 (A77), 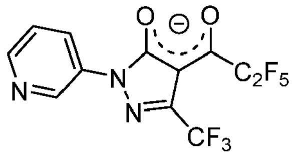

(A78), 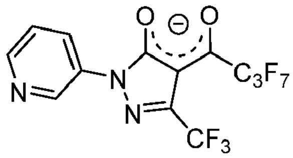 (A79), 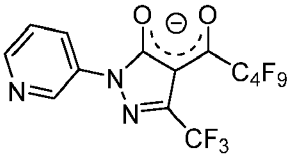 (A80), 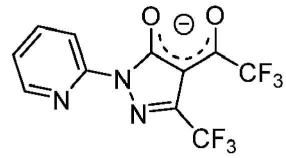

(A81), 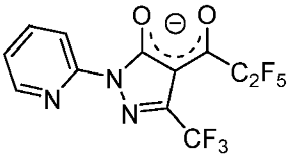 (A82), 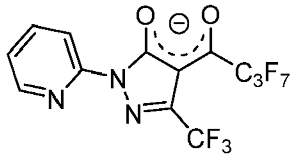 (A83), 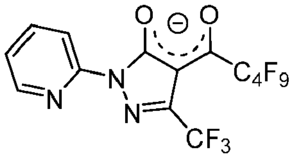

(A84), 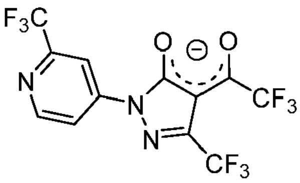 (A85), 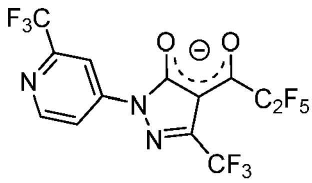 (A86), 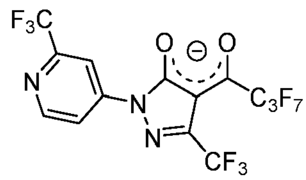

(A87), 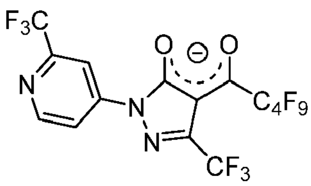 (A88), 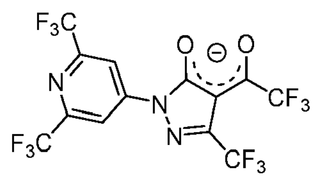 (A89),

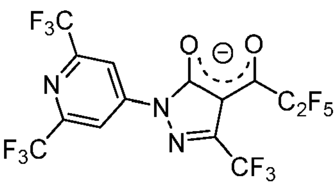 (A90), 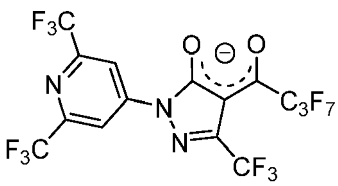 (A91), 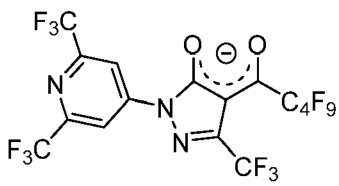

(A92), 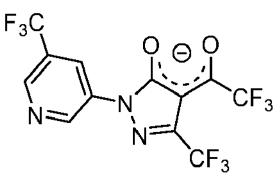 (A93), 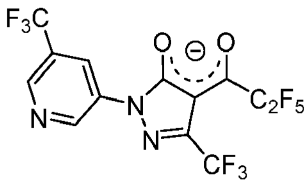 (A94), 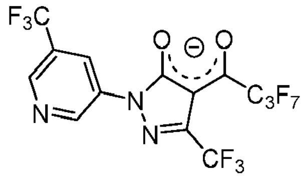

(A95), 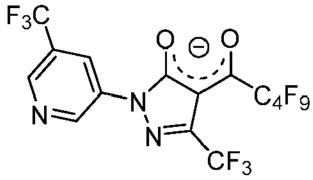 (A96), 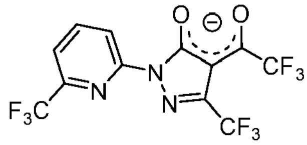 (A97),

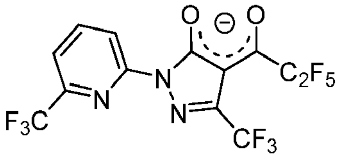 (A98), 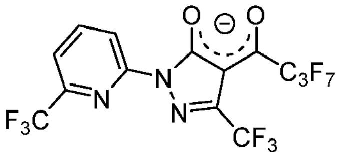 (A99), 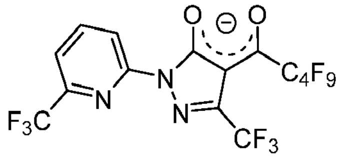

(A100), 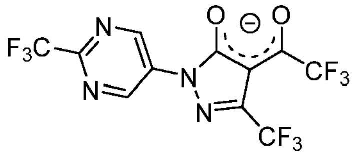 (A101), 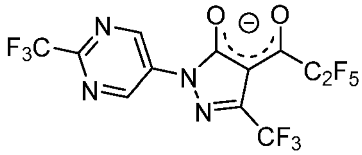 (A102),

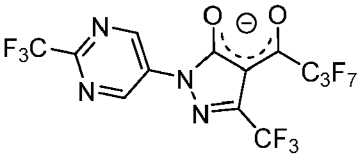 (A103), 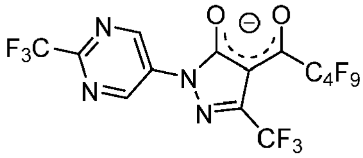 (A104),

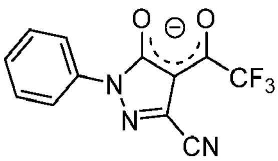 (A105), 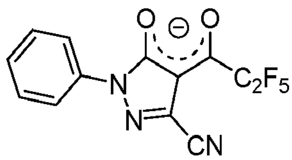 (A106), 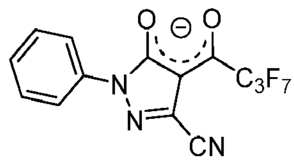 (A107),

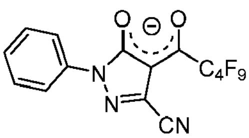 (A108), 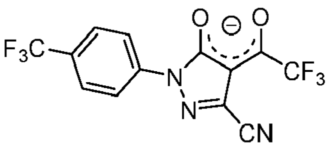 (A109), 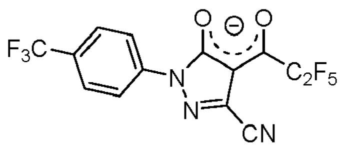

(A110), 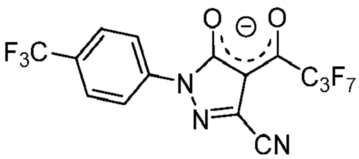 (A111), 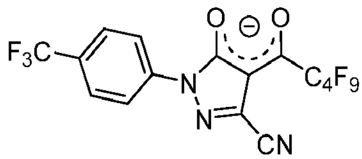 (A112),

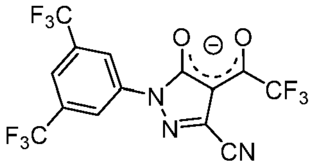 (A113), 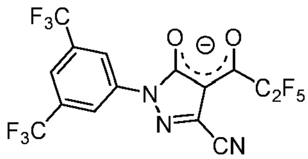 (A114), 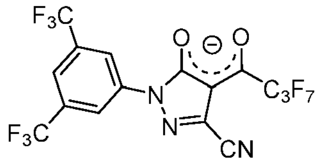

(A115), 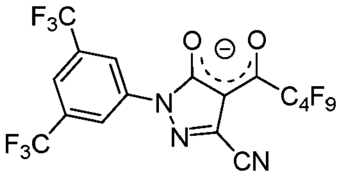 (A116), 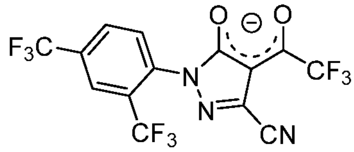 (A117),

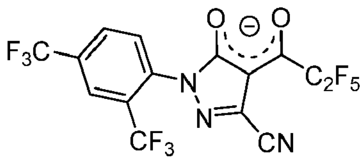 (A118), 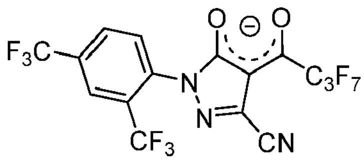 (A119),

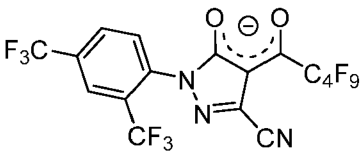 (A120), 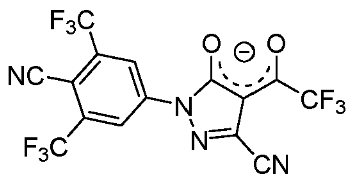 (A121),

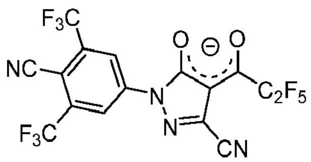 (A122), 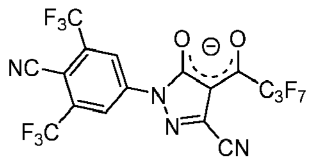 (A123), 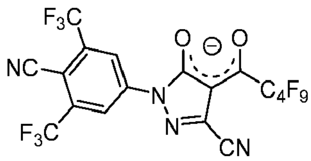

(A124), 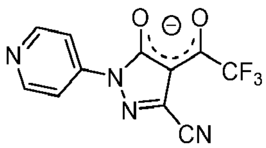 (A125), 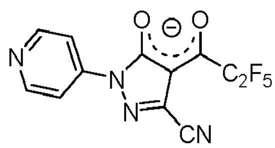 (A126), 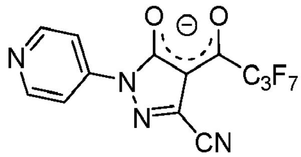

(A127), 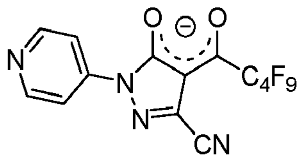 (A128), 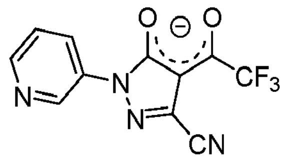 (A129), 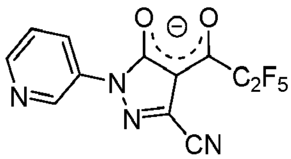

(A130), 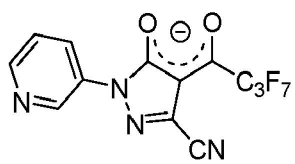 (A131), 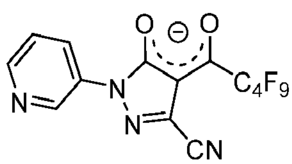 (A132), 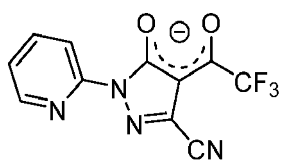

(A133), 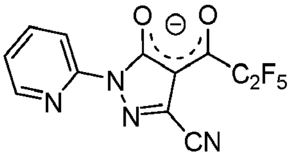 (A134), 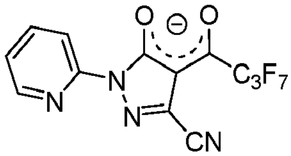 (A135), 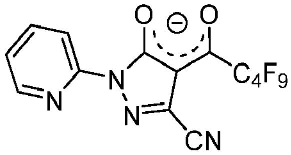

(A136), 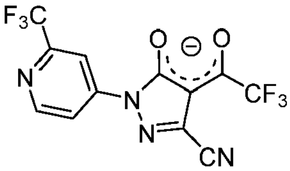 (A137), 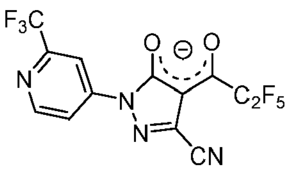 (A138), 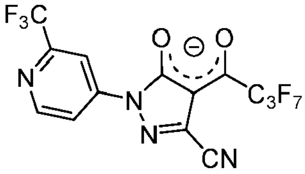

(A139), 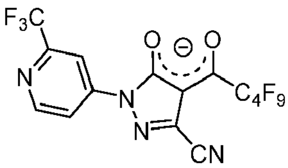 (A140), 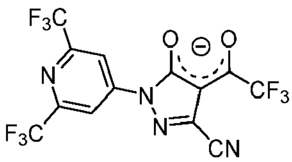 (A141), 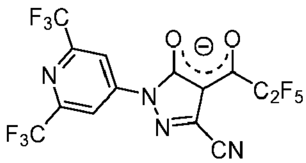

(A142), 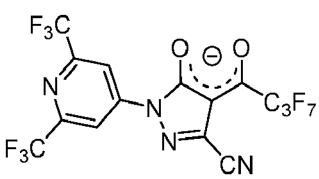 (A143), 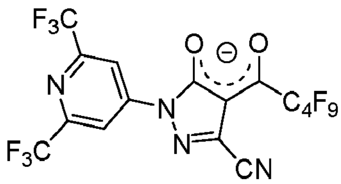 (A144),

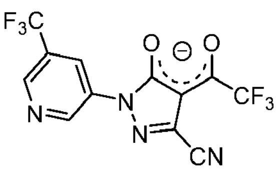 (A145), 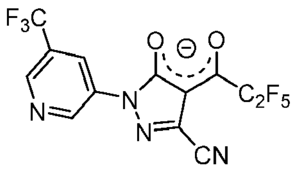 (A146), 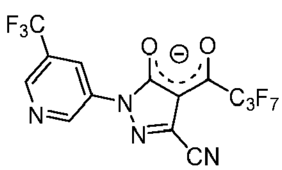 (A147),

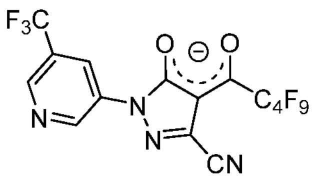 (A148), 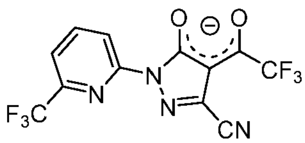 (A149), 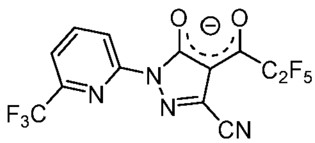

(A150), 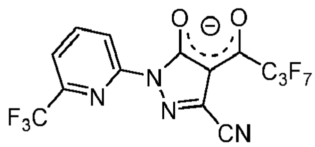 (A151), 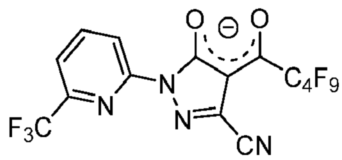 (A152),

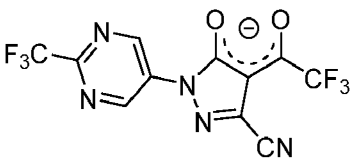 (A153), 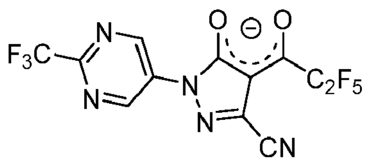 (A154),

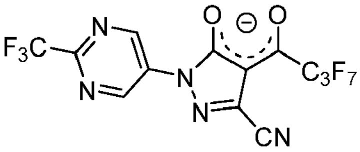 (A155), 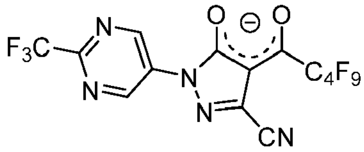 (A156),

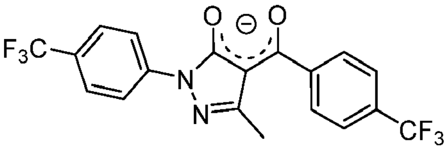 (A157), 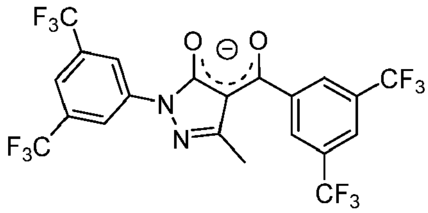 (A158),

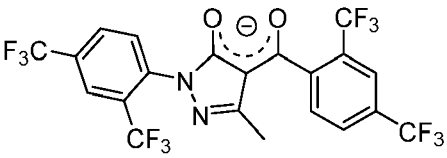 (A159), 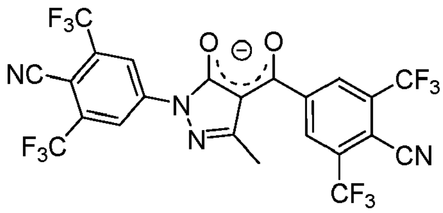 (A160),

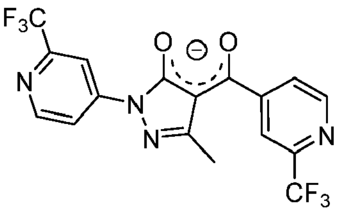 (A161), 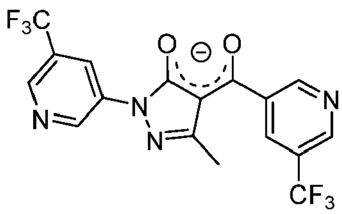 (A162),

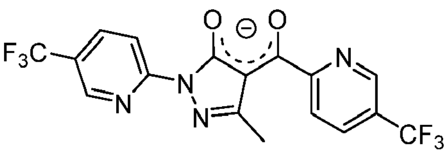 (A163), 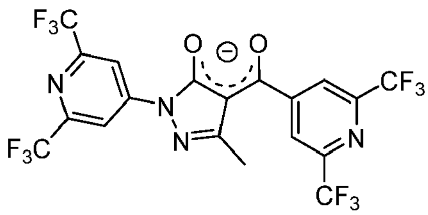 (A164),

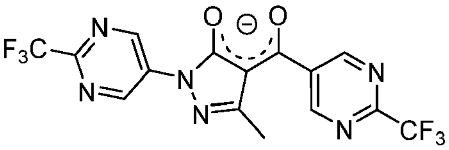 (A165), 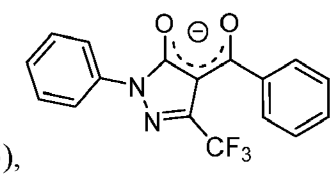 (A166),

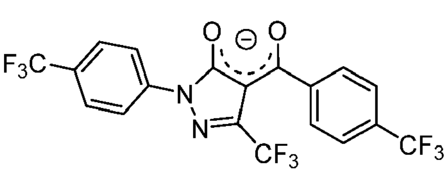 (A167), 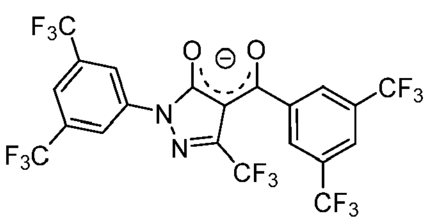 (A168),

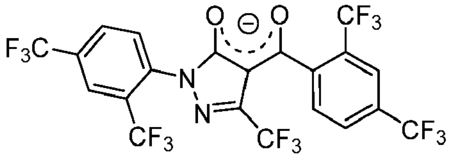 (A169), 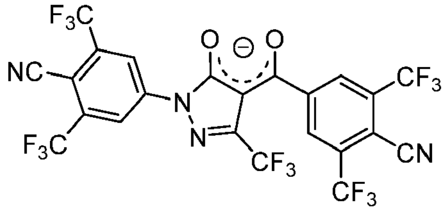 (A170),

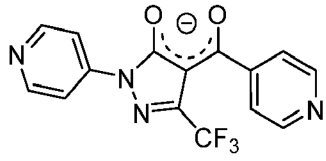 (A171), 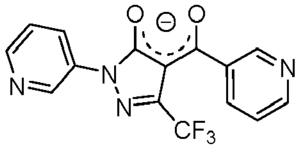 (A172), 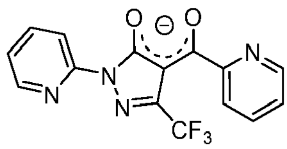 (A173),

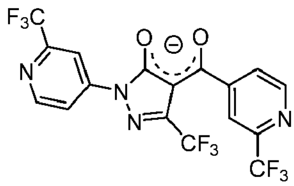 (A174), 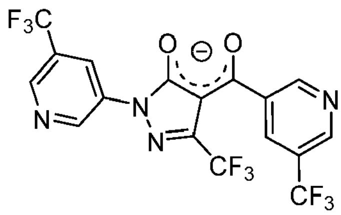 (A175),

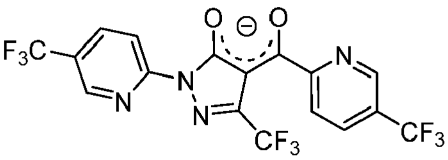 (A176), 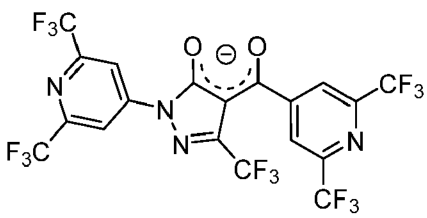 (A177),

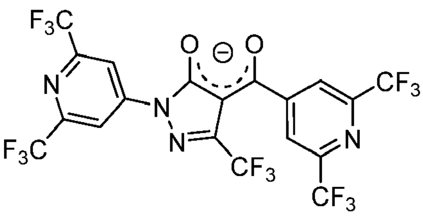 (A178), 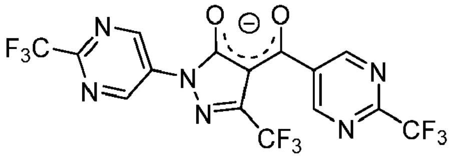 (A179),

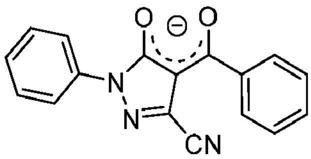 (A180), 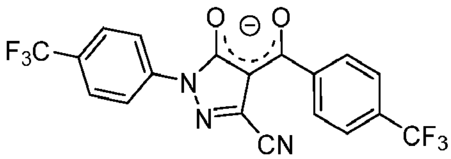 (A181),

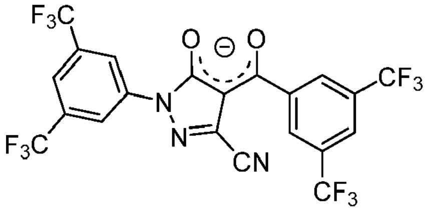 (A182), 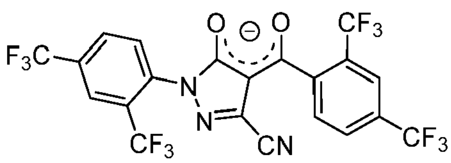 (A183),

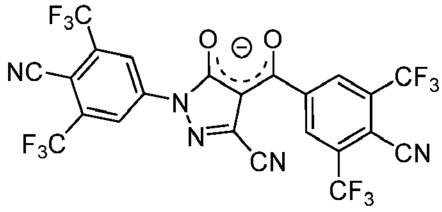 (A184), 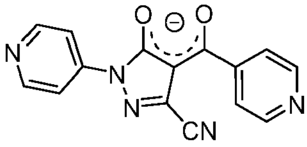 (A185),

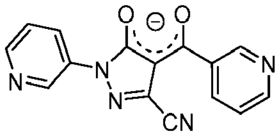 (A186), 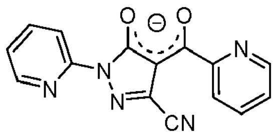 (A187), 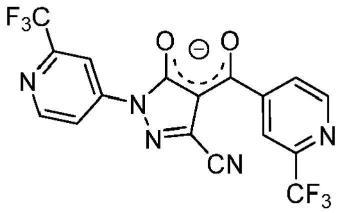 (A188),

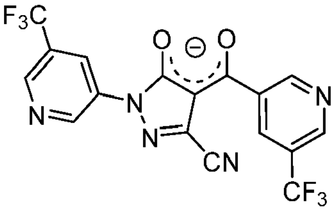 (A189), 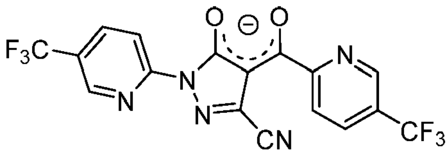 (A190),

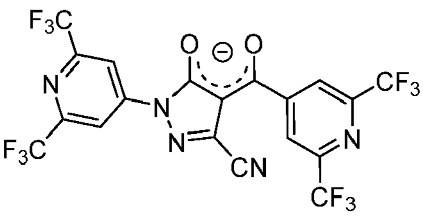 (A191), 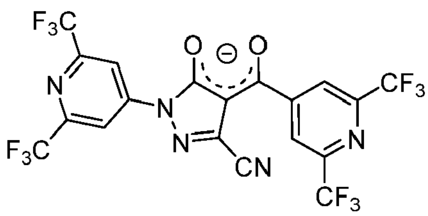 (A192),

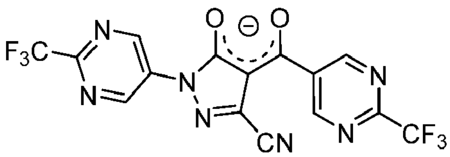 (A193), 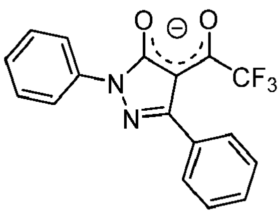 (A194),

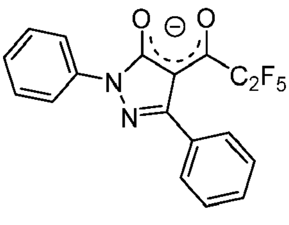 (A195), 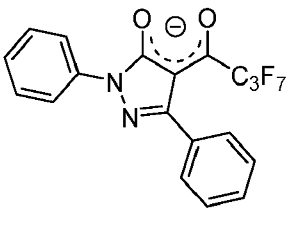 (A196), 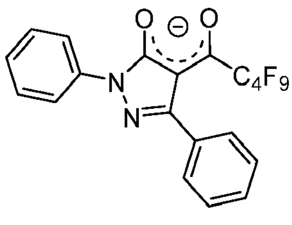 (A197),

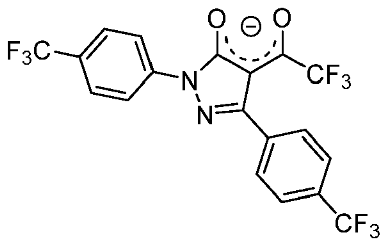 (A198), 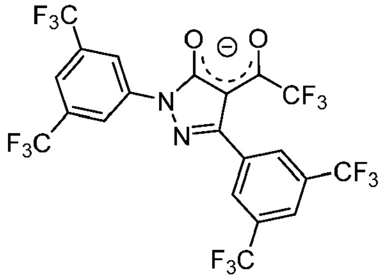 (A199),

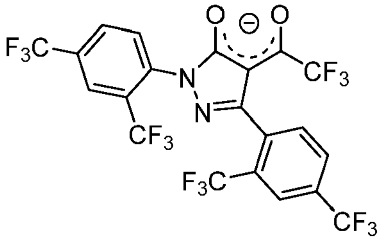 (A200), 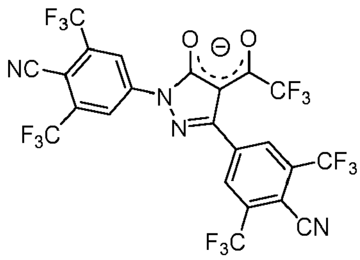 (A201), 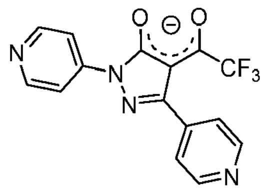

(A202), 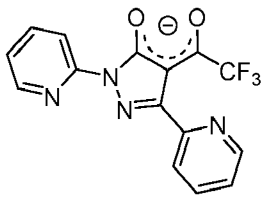 (A203), 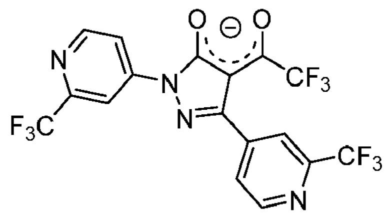 (A204),

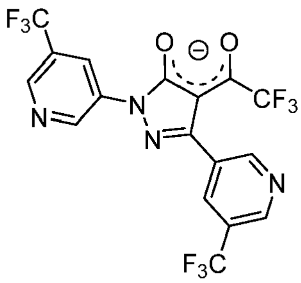 (A205), 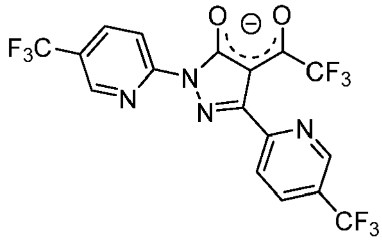 (A206),

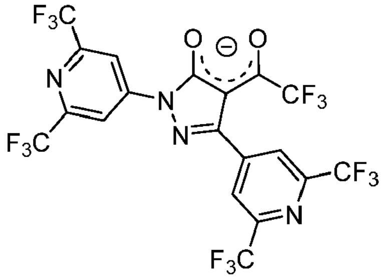 (A207), 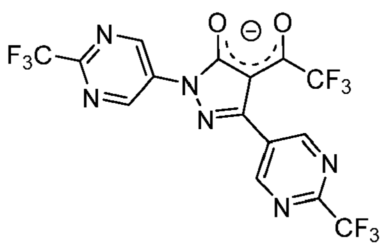 (A208),

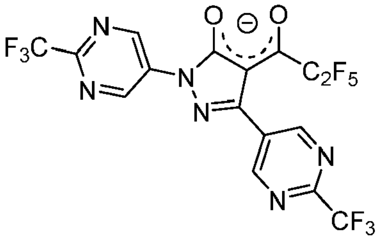
(A209),

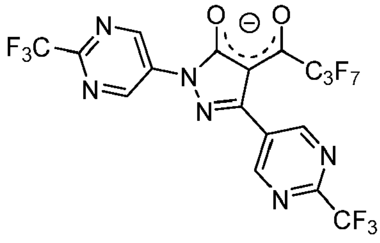
(A210),

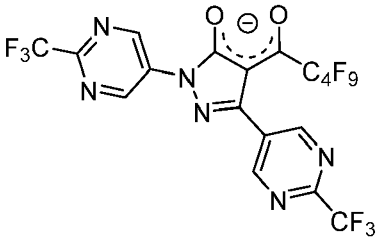
(A211),

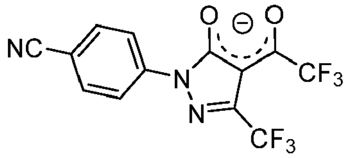
(A212),

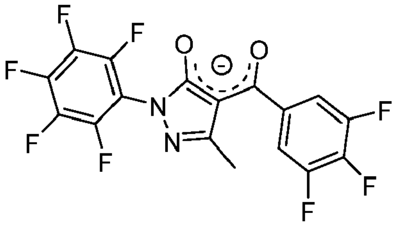
(A213)

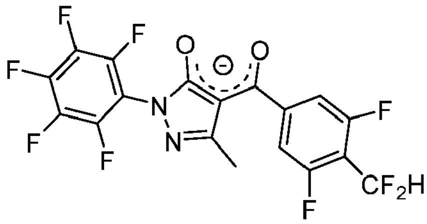
(A214)

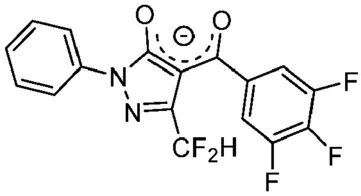
(A215)

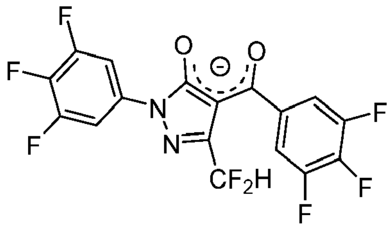
(A216)

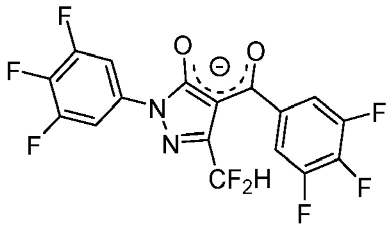
(A217)

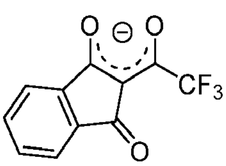
B1,

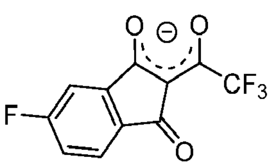
B2,

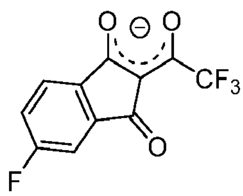
B3,

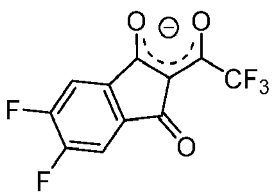
B4,

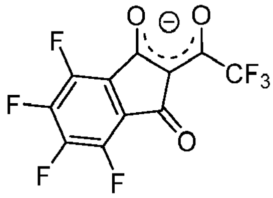 B5, 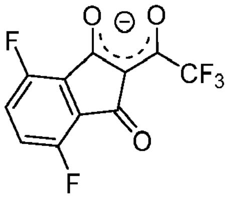 B6, 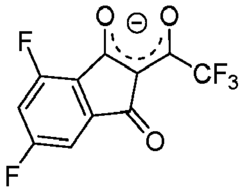 B7, 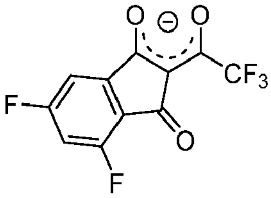 B8,

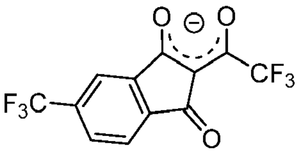 B9, 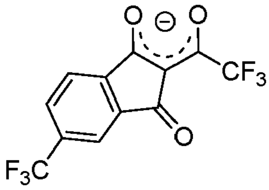 B10, 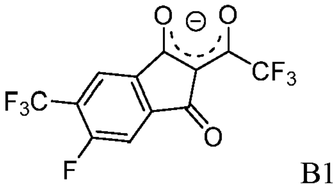 B11,

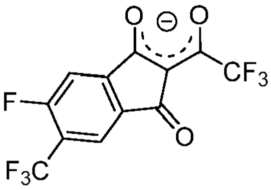 B12, 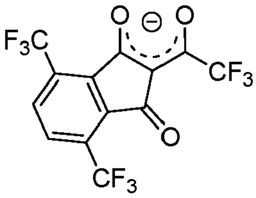 B13, 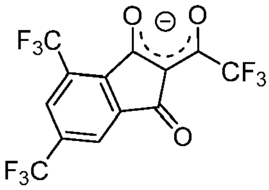 B14,

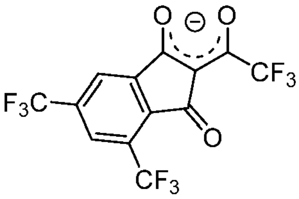 B15, 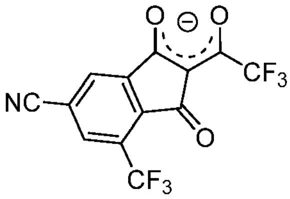 B16, 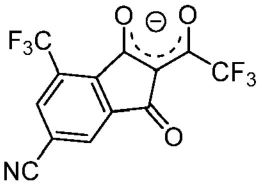 B17,

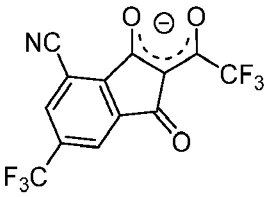 B18, 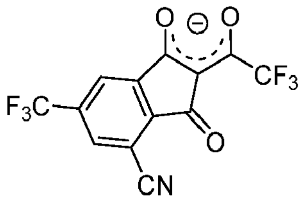 B19, 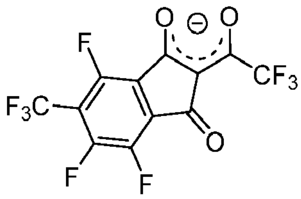 B20,

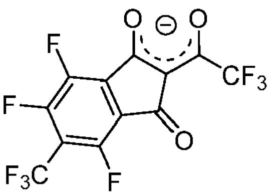 B21, 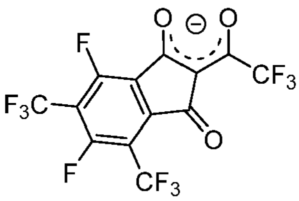 B22, 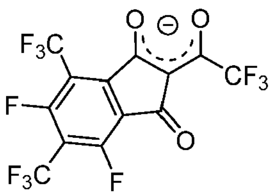 B23,

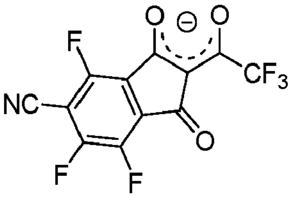 B24, 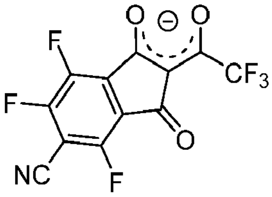 B25, 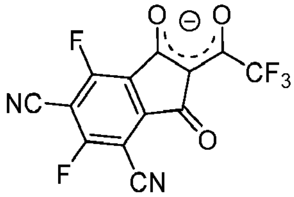 B26,

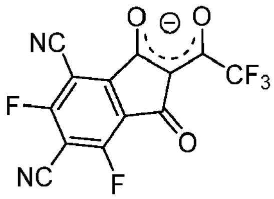 B27, 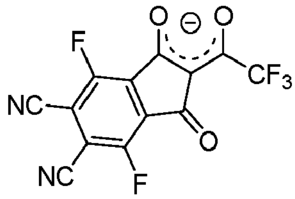 B28, 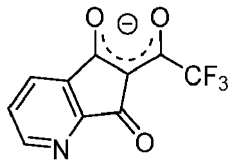 B29,

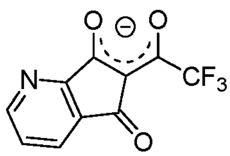 B30, 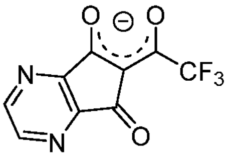 B31, 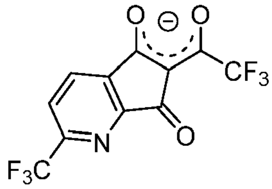 B32, 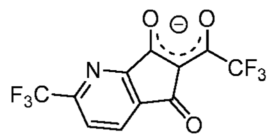

B33, 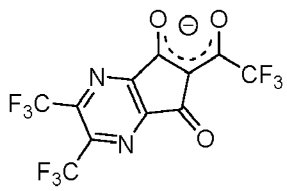 B34, 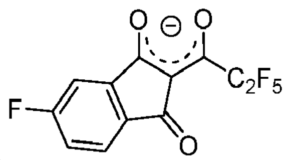 B35, 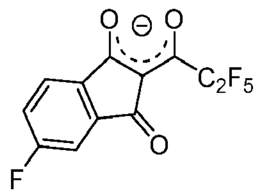 B36,

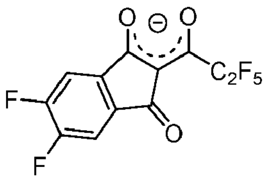 B37, 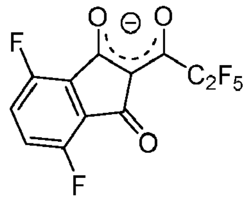 B38, 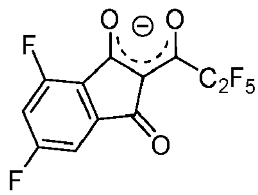 B39,

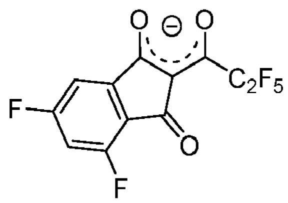 B40, 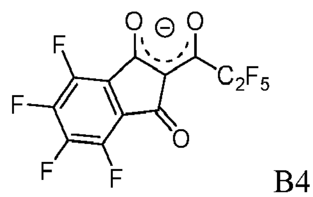 B41, 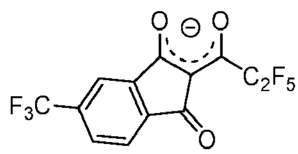 B42,

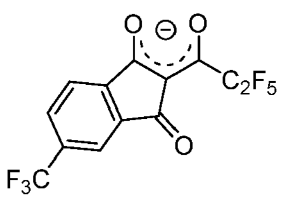 B43, 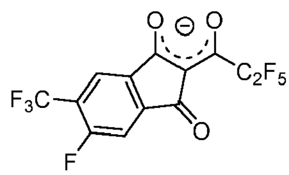 B44, 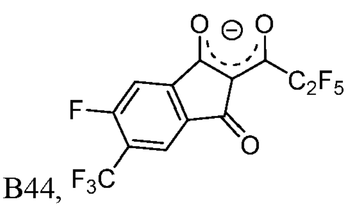 B45,

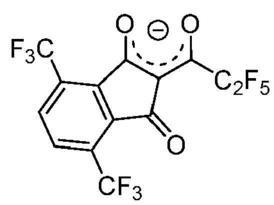 B46, 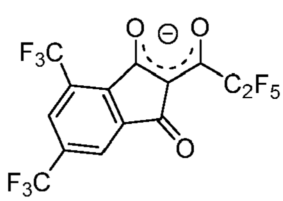 B47, 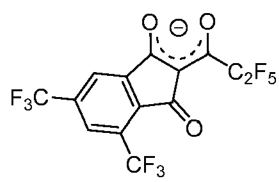 B48,

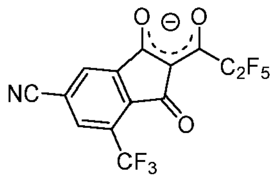 B49, 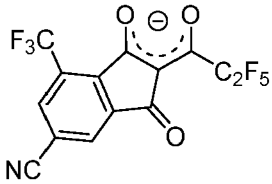 B50, 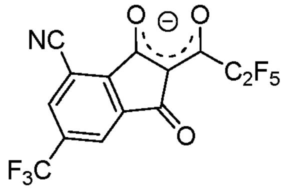 B51,

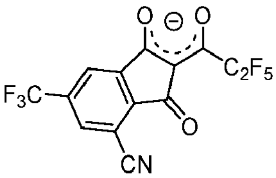 B52, 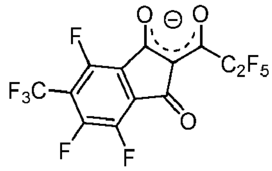 B53, 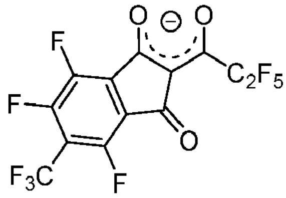 B54,

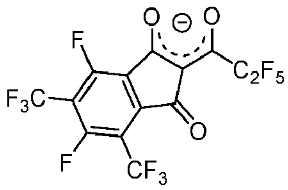 B55, 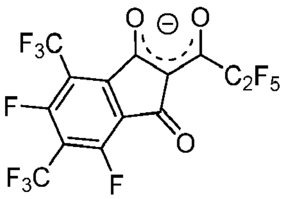 B56, 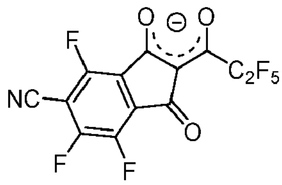 B57,

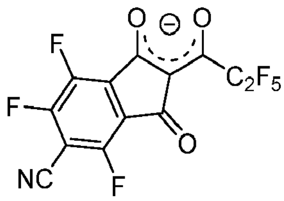 B58, 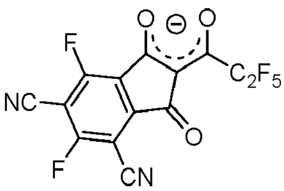 B59, 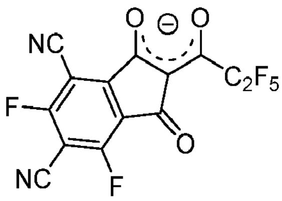 B60,

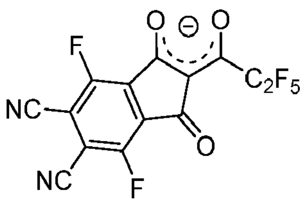 B61, 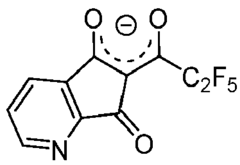 B62, 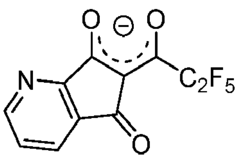 B63,

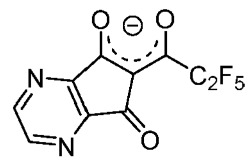 B64, 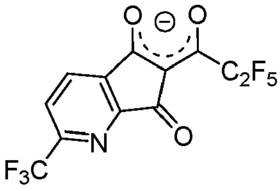 B65, 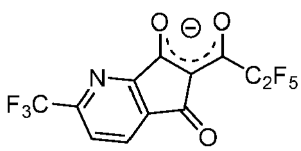 B66,

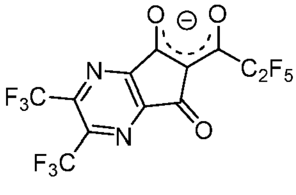 B67, 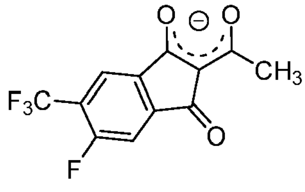 B68, 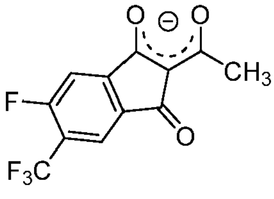 B69,

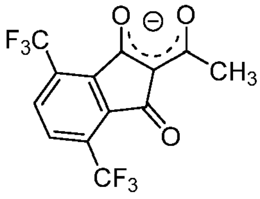 B70, 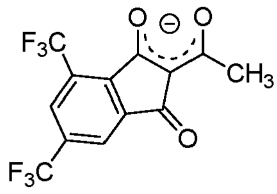 B71, 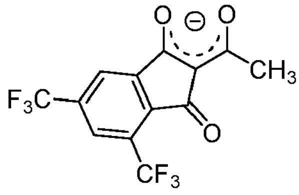 B72,

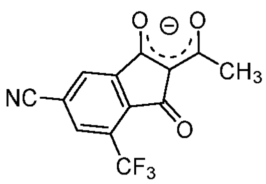 B73, 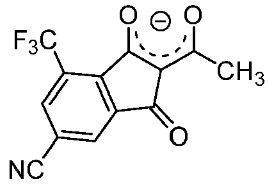 B74, 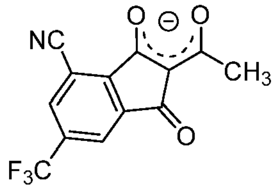 B75,

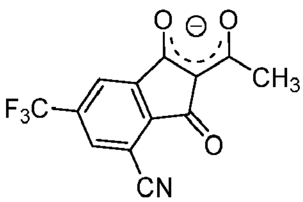 B76, 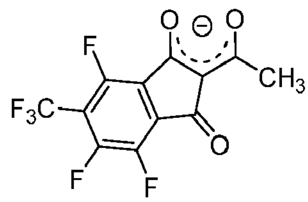 B77, 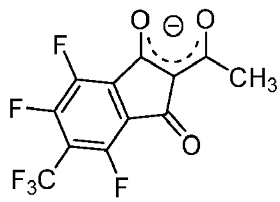 B78,

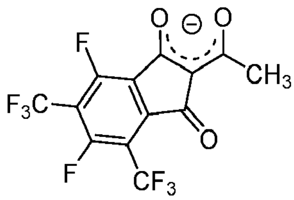 B79, 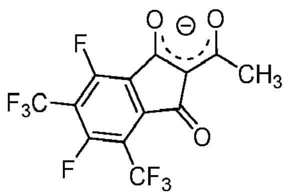 B80, 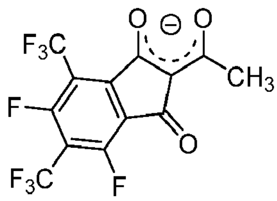 B81,

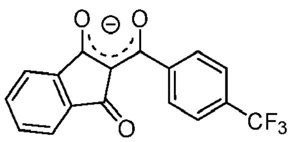 B82, 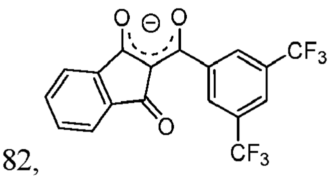 B83, 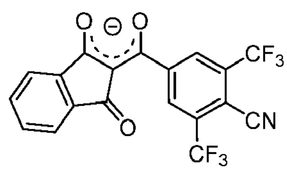 B84,

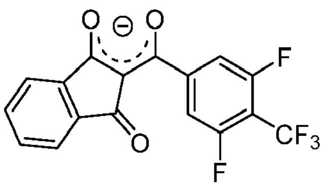 B85, 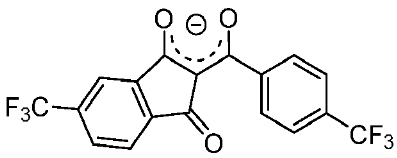 B86, 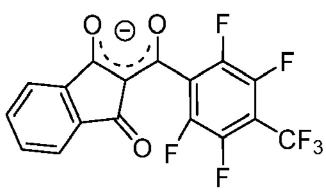

B87, 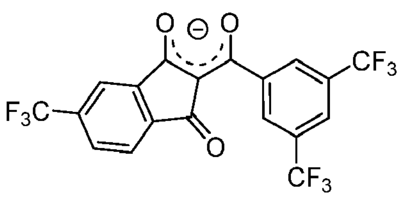 B88, 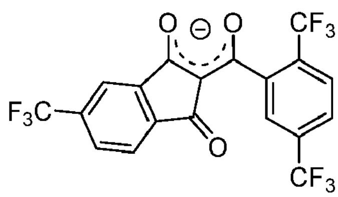 B89,

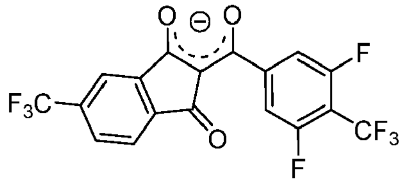 B90, 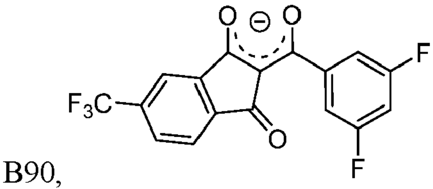 B91,

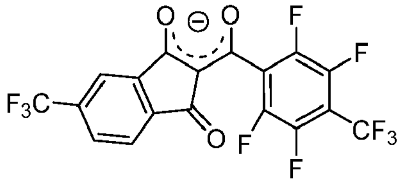 B92, 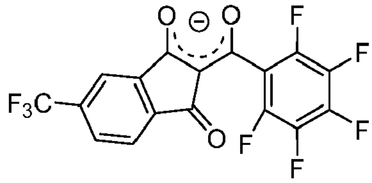 B93,

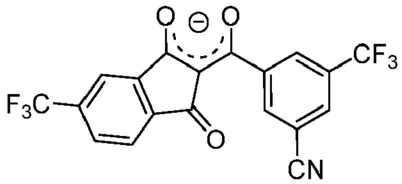 B94, 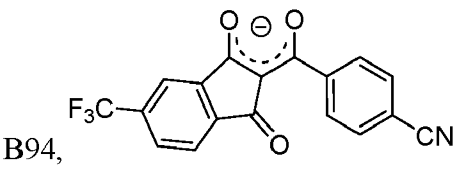 B95,

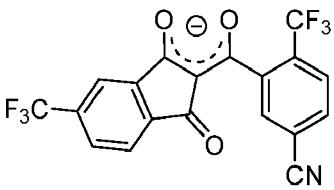 B96, 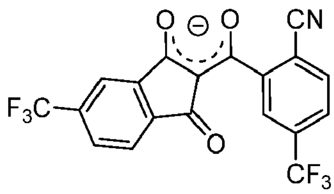 B97, 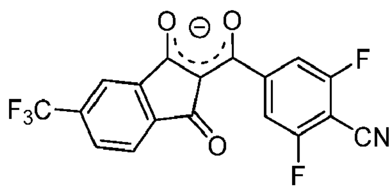

B98, 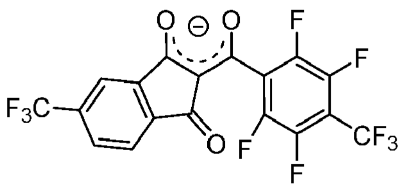 B99, 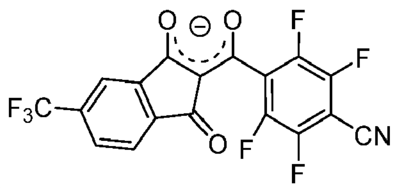 B100,

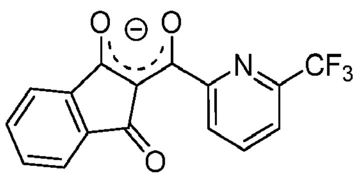 B101, 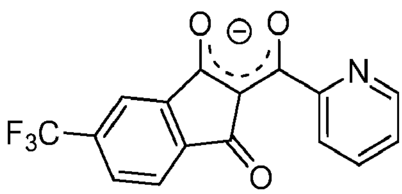 B102,

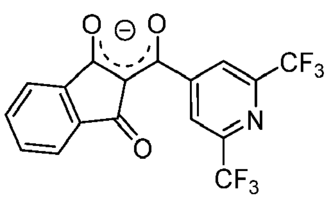 B103, 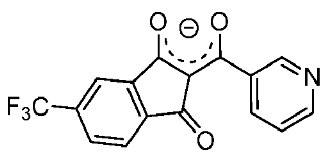 B104, 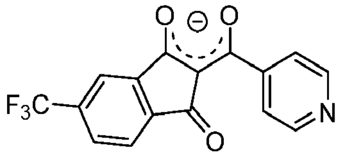

B105, 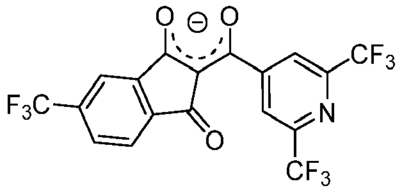 B106, 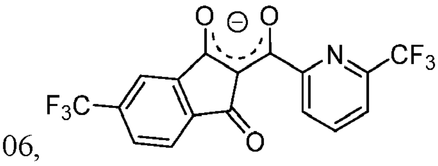 B107,

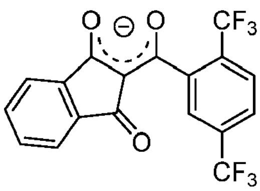 B108, 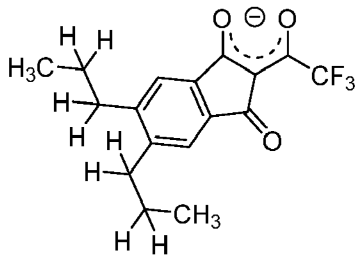 B109, 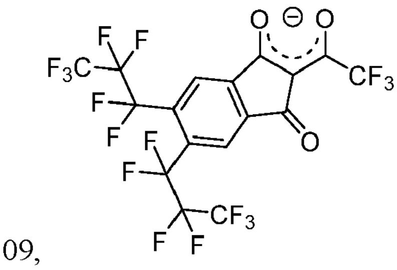 B110,

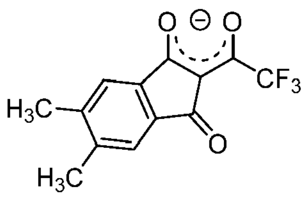 B111, 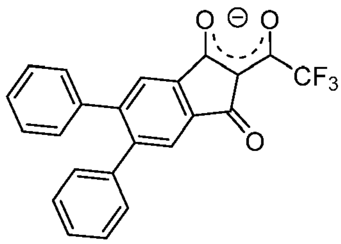 B112, 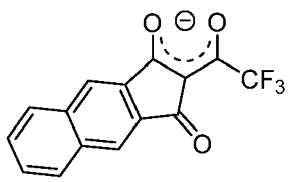 B113,

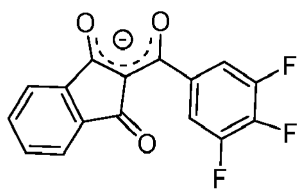 (B114), 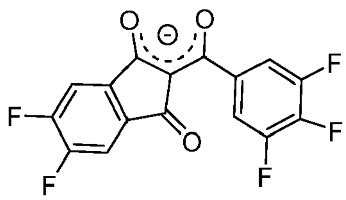 (B115), 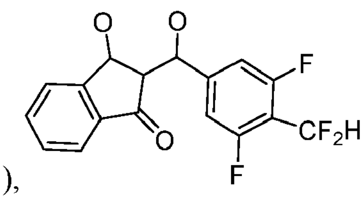

(B116), 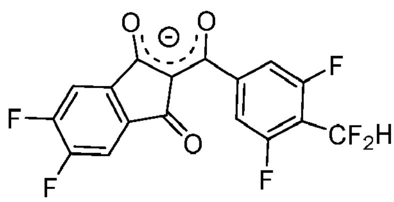 (B117),

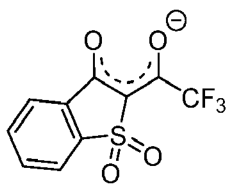 (C1), 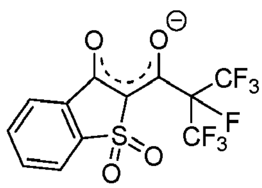 (C2), 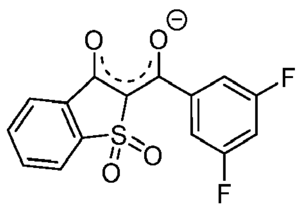 (C3),

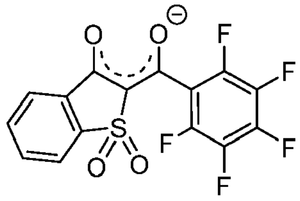 (C4), 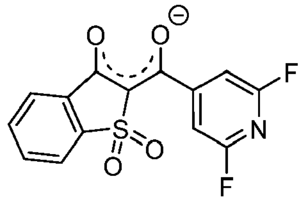 (C5), 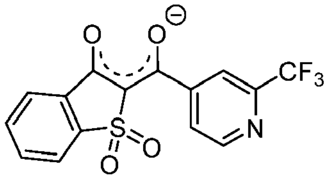 (C6),

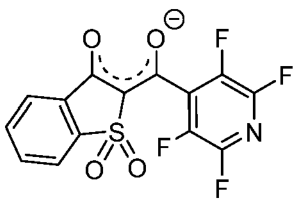 (C7), 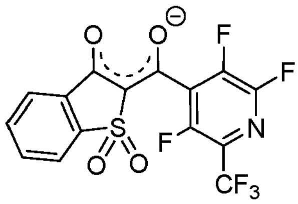 (C8), 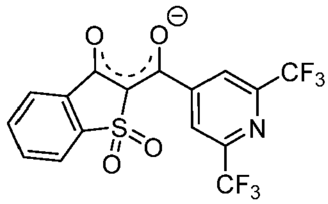 (C9),

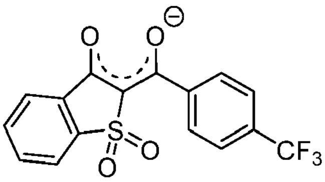 (C10), 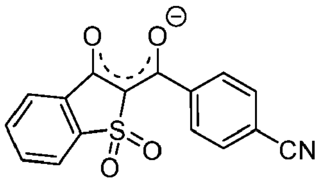 (C11), 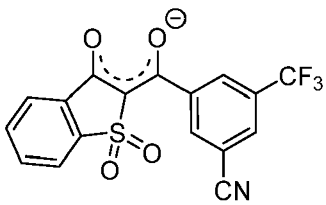

(C12), 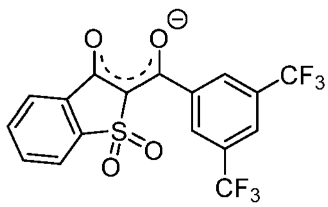 (C13), 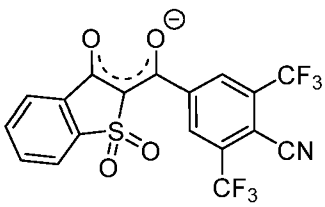 (C14),

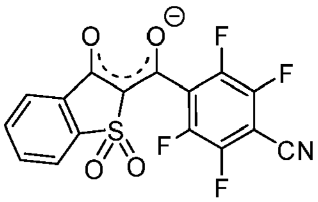 (C15), 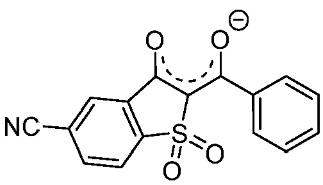 (C16), 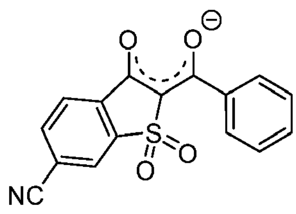 (C17),

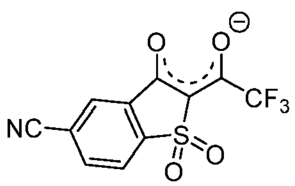 (C18), 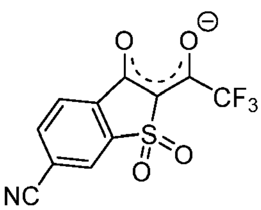 (C19), 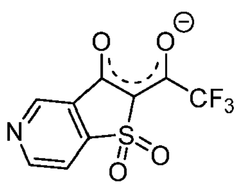 (C20),

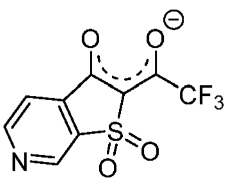 (C21), 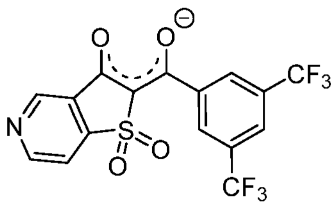 (C22), 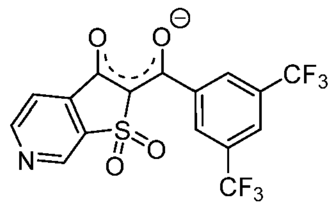 (C23),

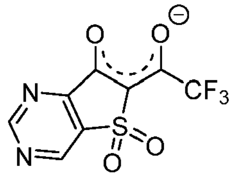 (C24), 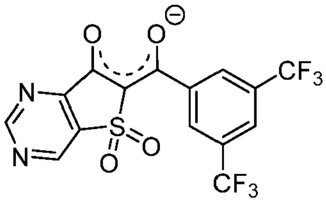 (C25), 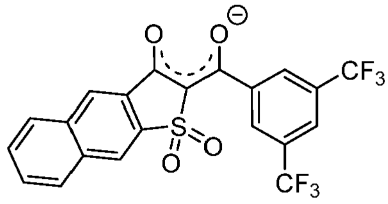 (C26),

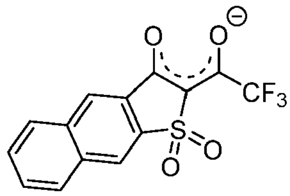 (C27); 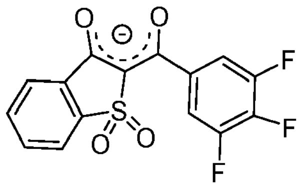 (C28), 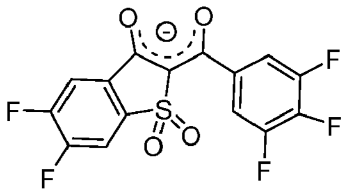 (C29),

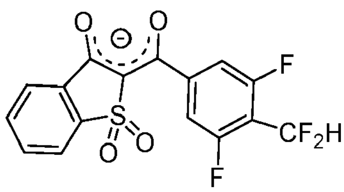 (C30), 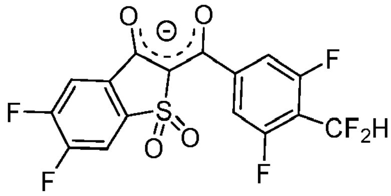 (C31),

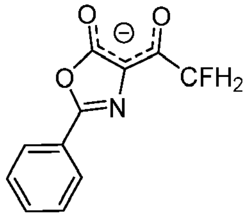 (D1), 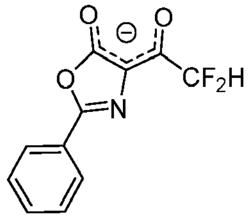 (D2), 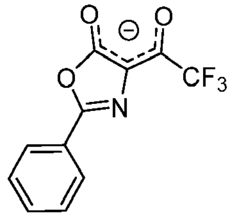 (D3),

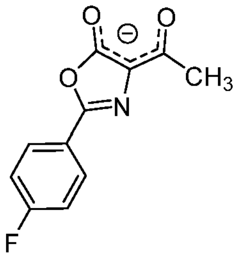 (D4), 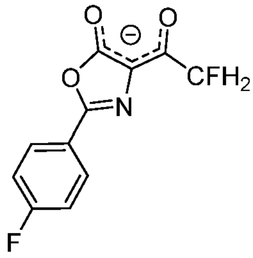 (D5), 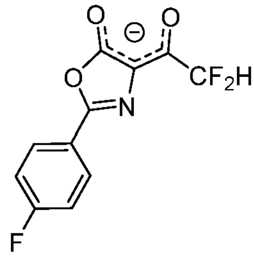 (D6),

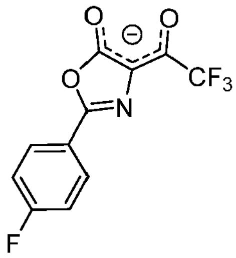 (D7), 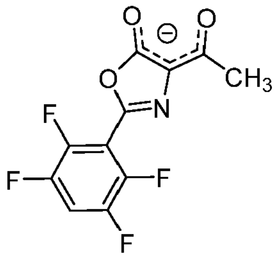 (D8), 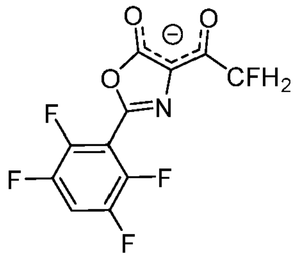 (D9),

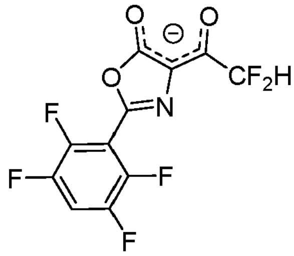 (D10), 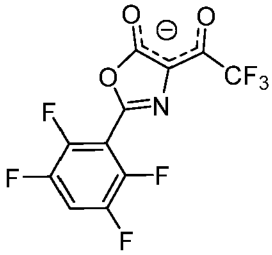 (D11), 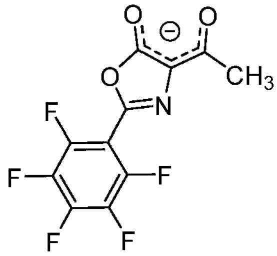 (D12),

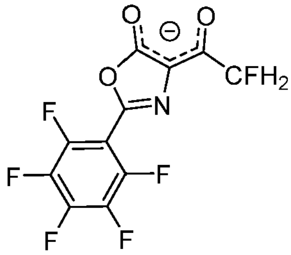 (D13), 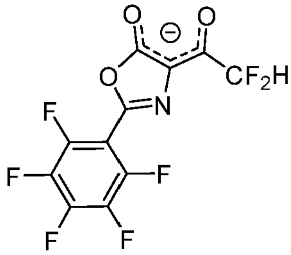 (D14), 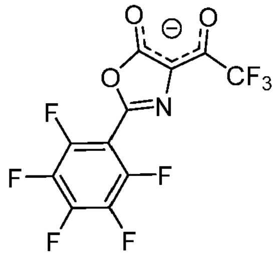 (D15),

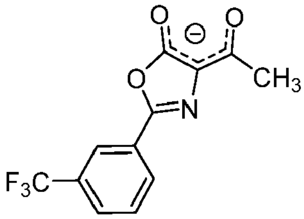 (D16), 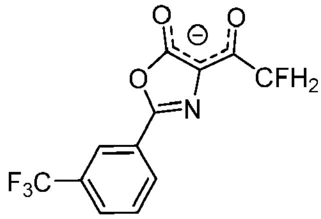 (D17), 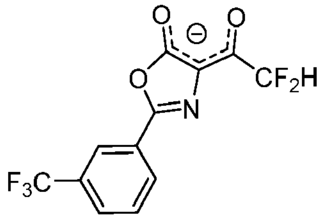 (D18),

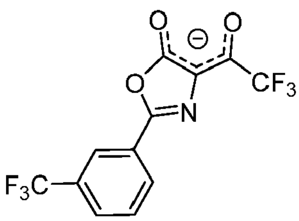 (D19), 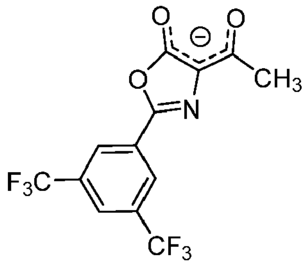 (D20), 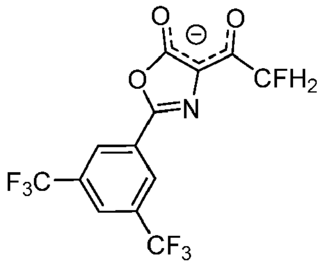 (D21),

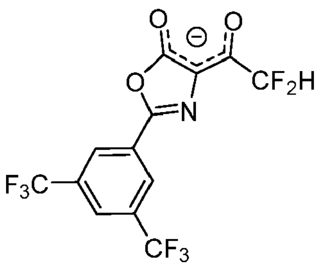 (D22), 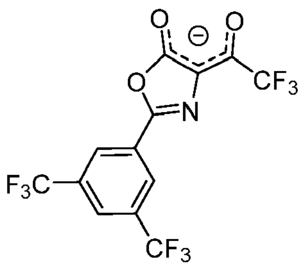 (D23), 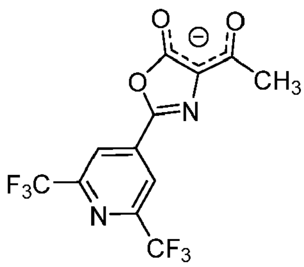 (D24),

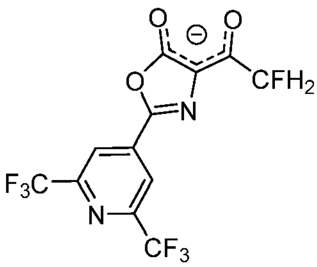 (D25), 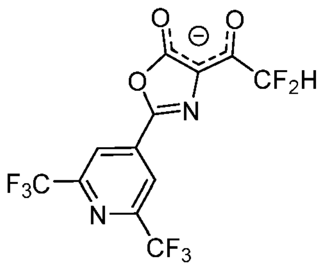 (D26), 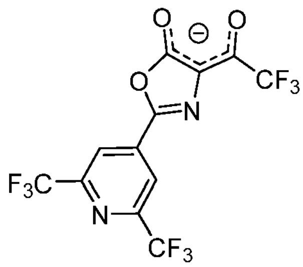 (D27),

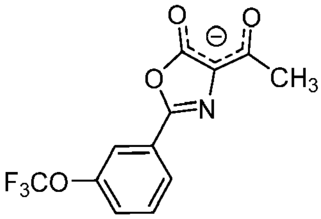 (D28), 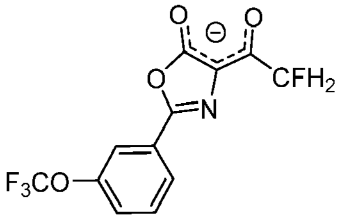 (D29),

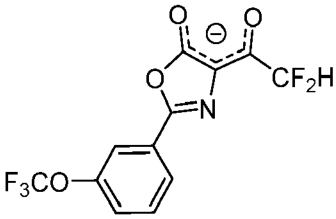 (D30), 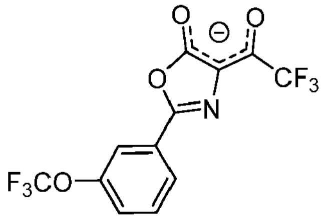 (D31),

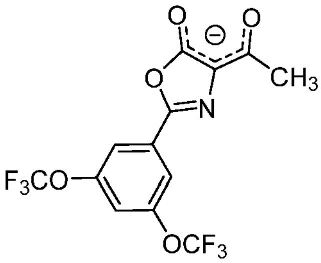 (D32), 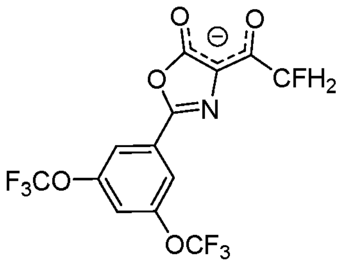 (D33),

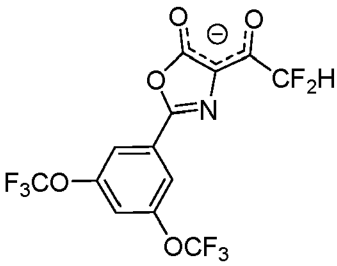 (D34), 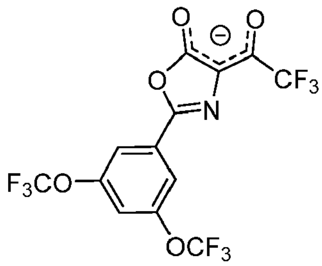 (D35),

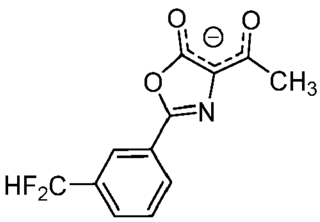 (D36), 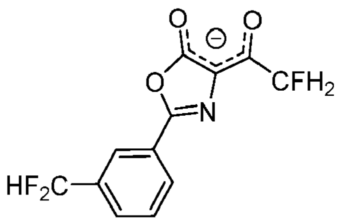 (D37),

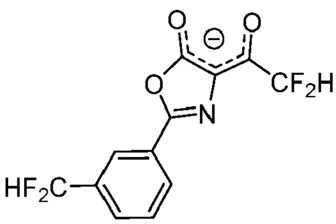 (D38), 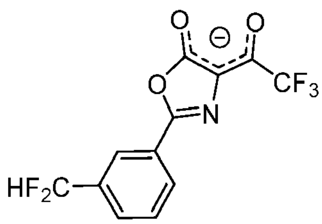 (D39),

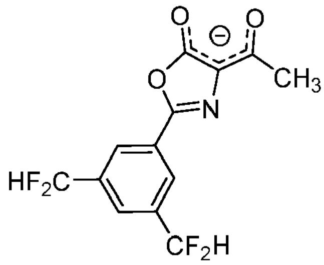 (D40), 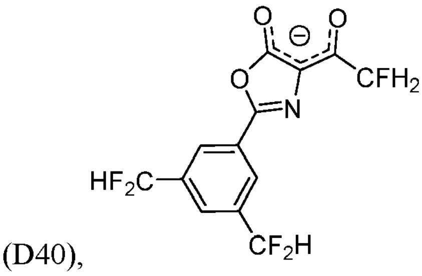 (D41),

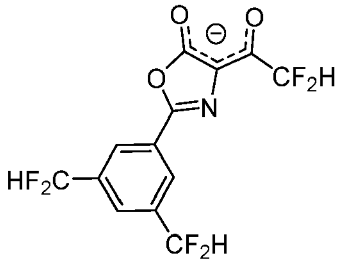 (D42), 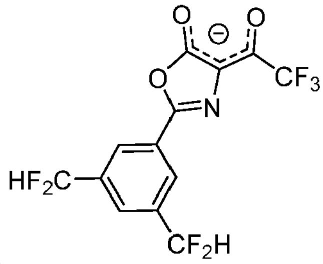 (D43), 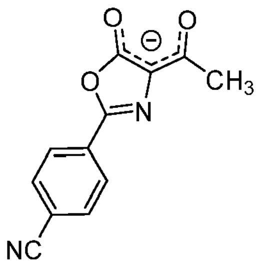 (D44),

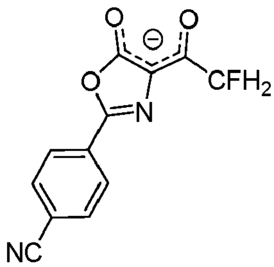 (D45), 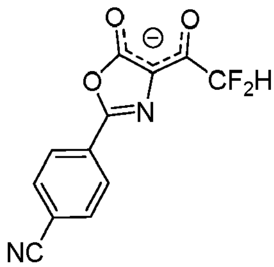 (D46), 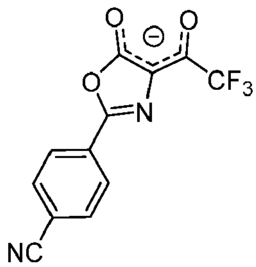 (D47),

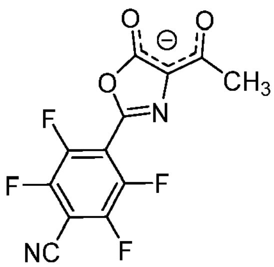 (D48), 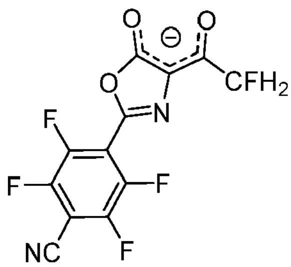 (D49), 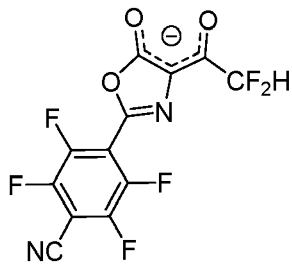 (D50),

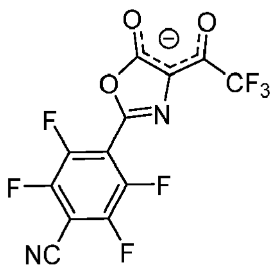 (D51), 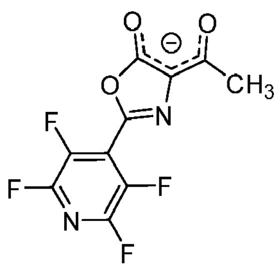 (D52), 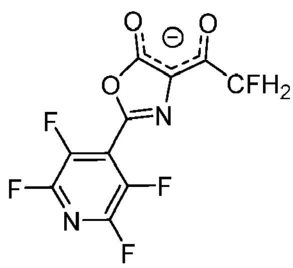 (D53),

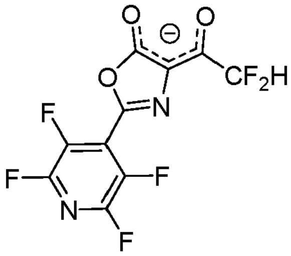 (D54), 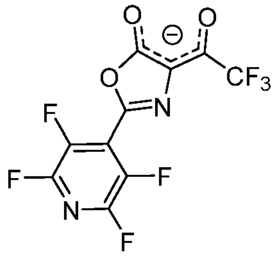 (D55), 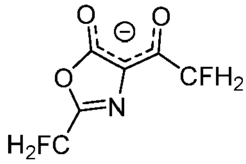 (D56),

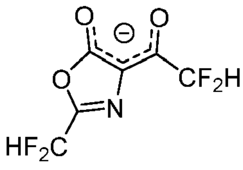 (D57), 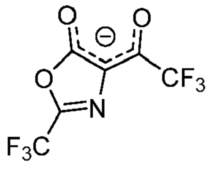 (D58), 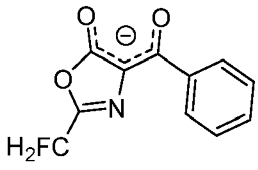 (D59),

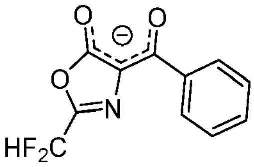 (D60), 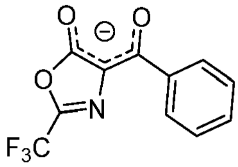 (D61), 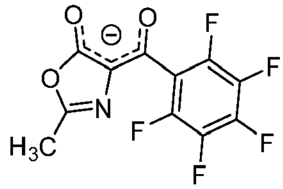 (D62),

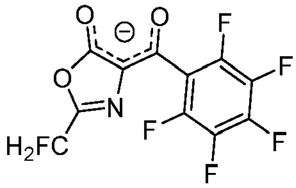 (D63), 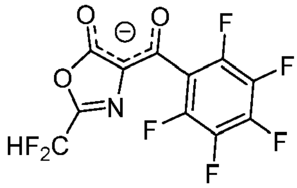 (D64), 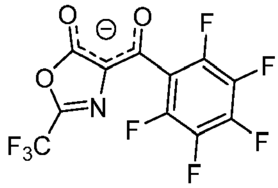 (D65),

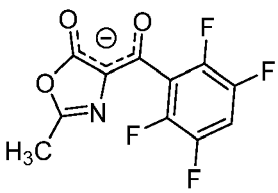 (D66), 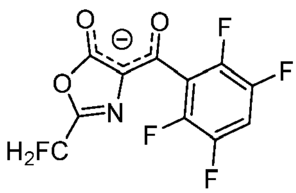 (D67), 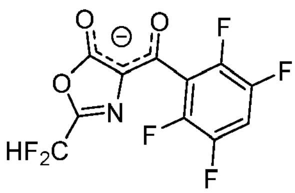 (D68),

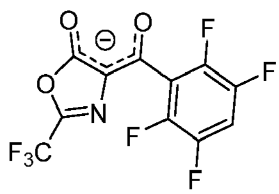 (D69), 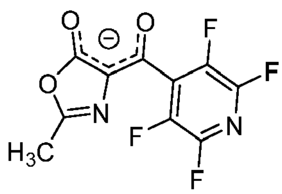 (D70), 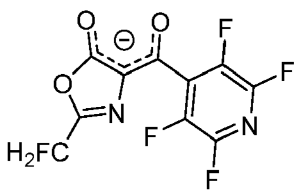 (D71),

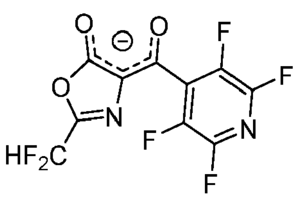 (D72), 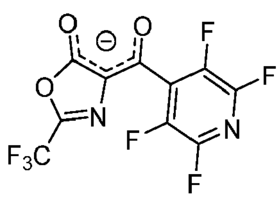 (D73), 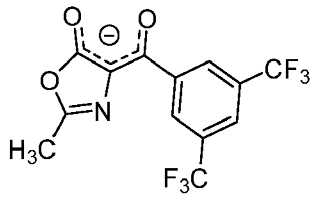 (D74),

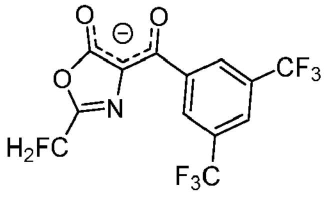 (D75), 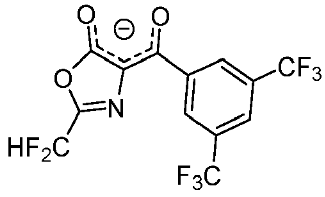 (D76), 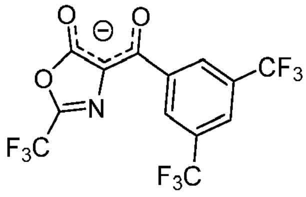 (D77),

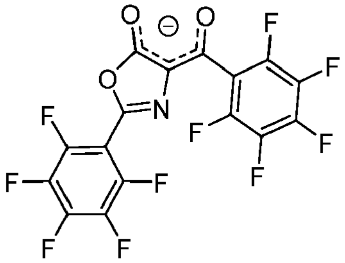 (D78), 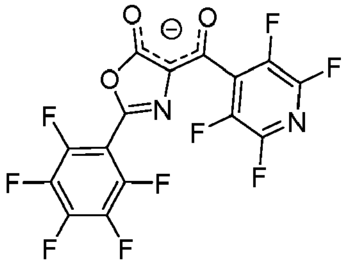 (D79),

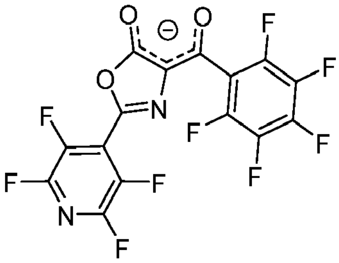 (D80), 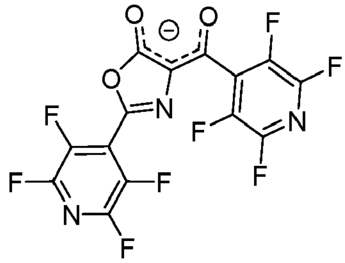 (D81), 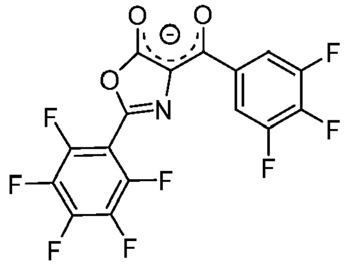

(D82), 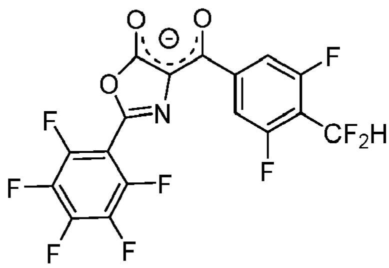 (D83)

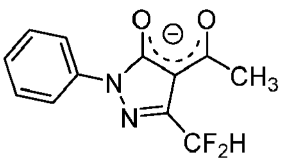 (E1), 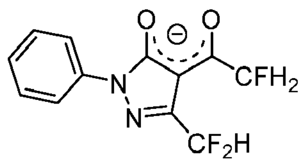 (E2), 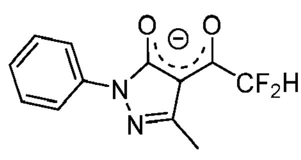 (E3),

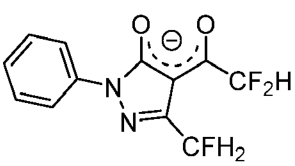 (E4), 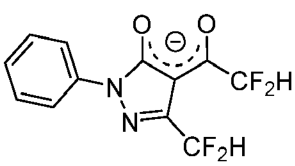 (E5), 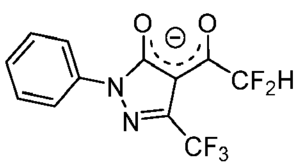 (E6),

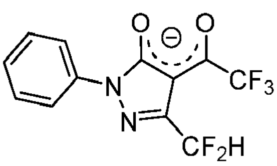 (E7), 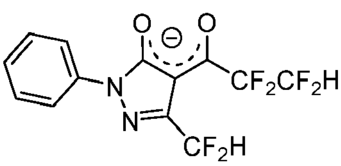 (E8), 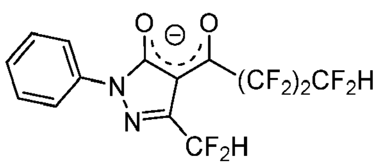 (E9),

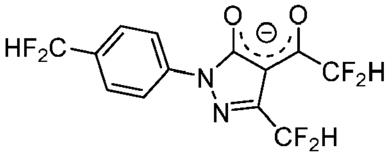 (E10), 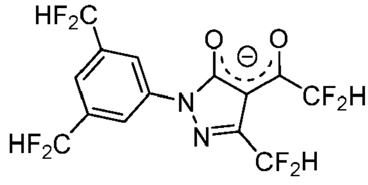 (E11),

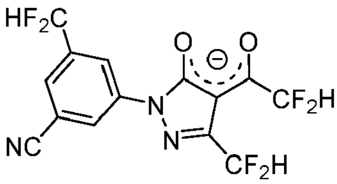 (E12), 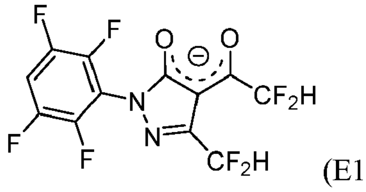 (E13),

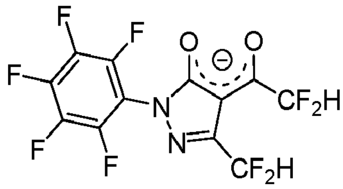 (E14), 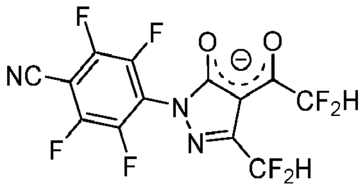 (E15),

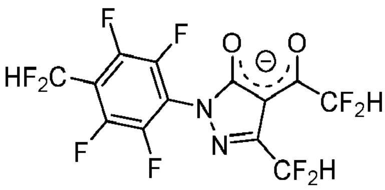 (E16), 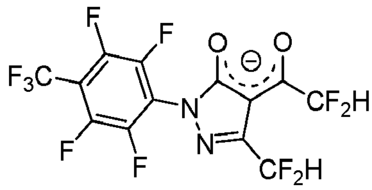 (E17),

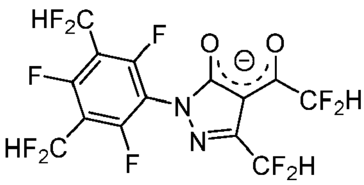 (E18), 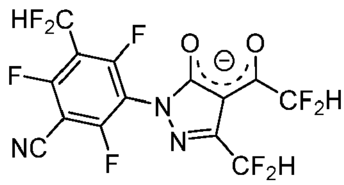 (E19),

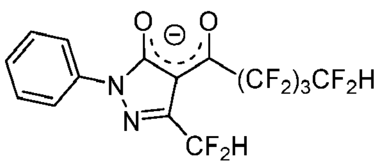 (E20), 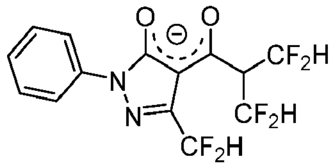 (E21),

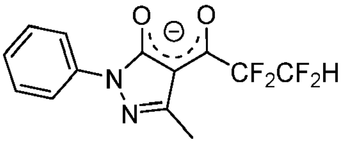 (E22), 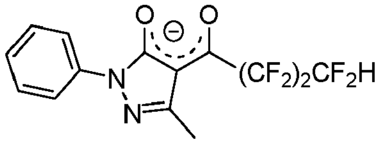 (E23),

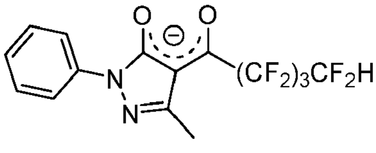 (E24), 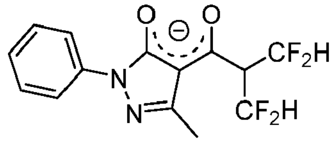 (E25),

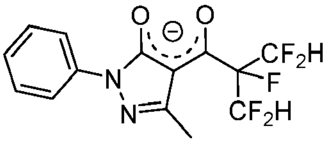 (E26), 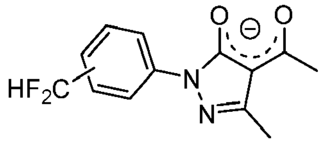 (E27), 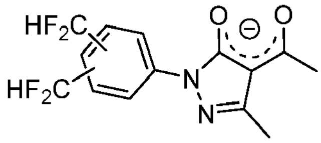

(E28), 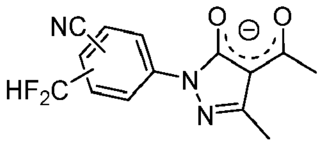 (E29), 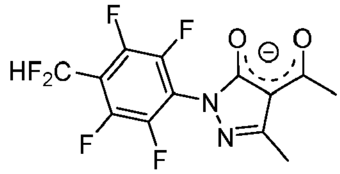 (E30), 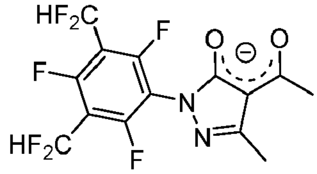

(E31), 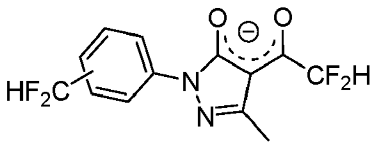 (E32), 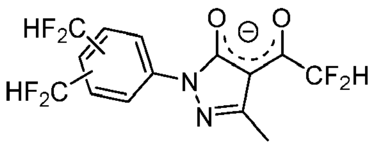 (E33),

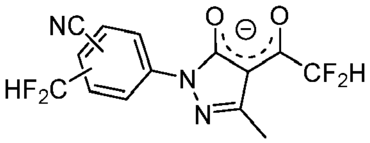 (E34), 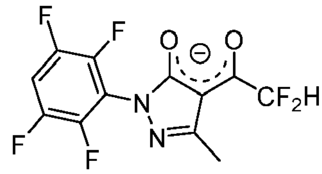 (E35),

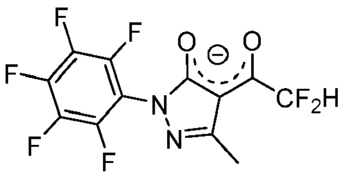 (E36), 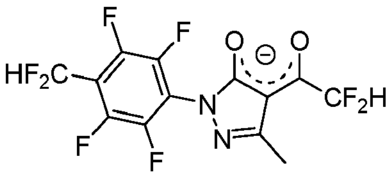 (E37),

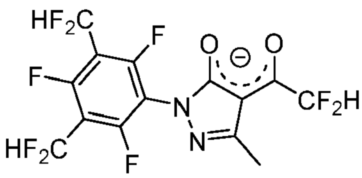 (E38), 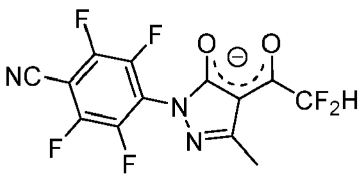 (E39),

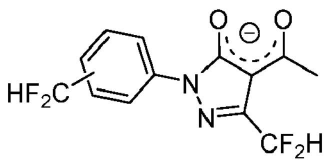 (E40), 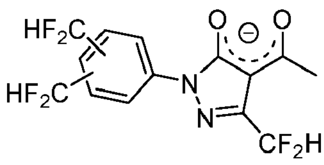 (E41),

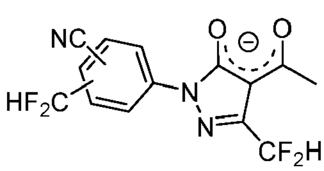 (E42), 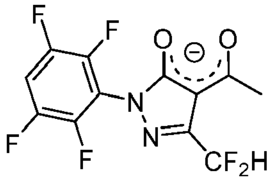 (E43),

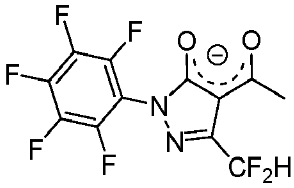 (E44), 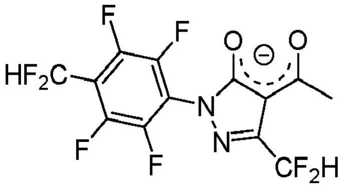 (E45), 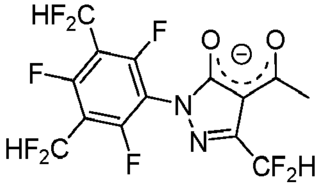 (E46),

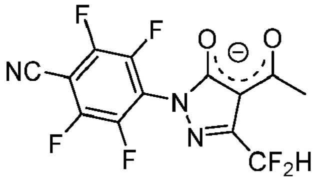 (E47), 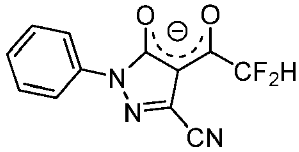 (E48), 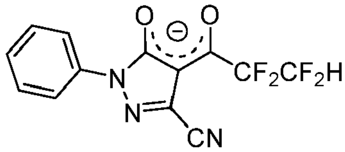 (E49),

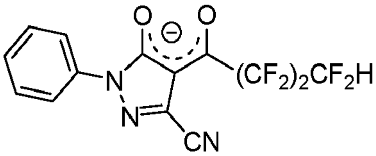 (E50), 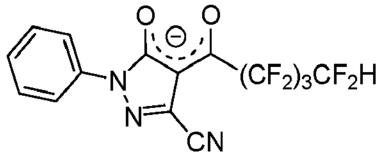 (E51),

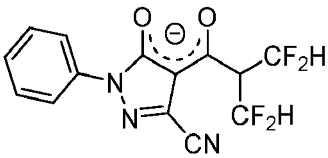 (E52), 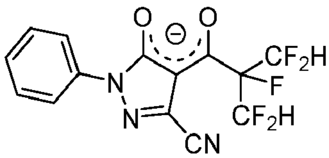 (E53), 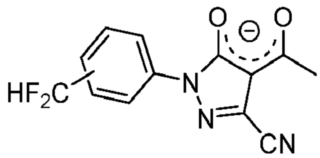

(E54), 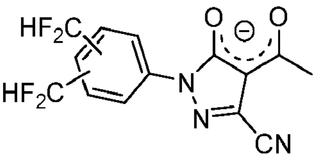 (E55), 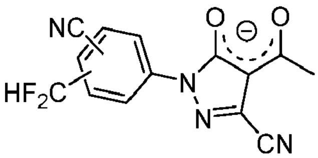 (E56),

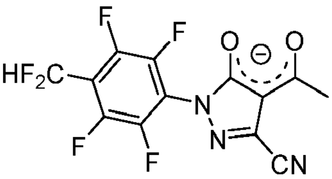 (E57), 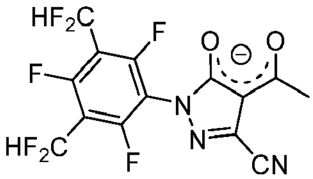 (E58), 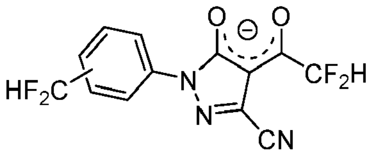

(E59),

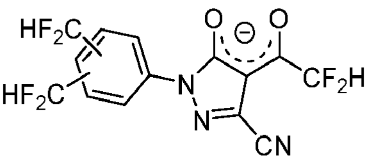 (E60), 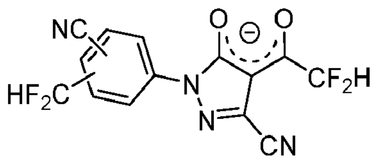 (E61),

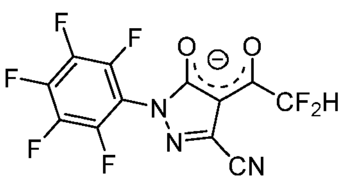 (E62), 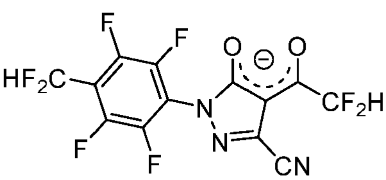 (E63),

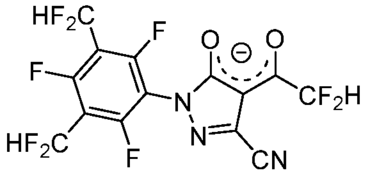 (E64), 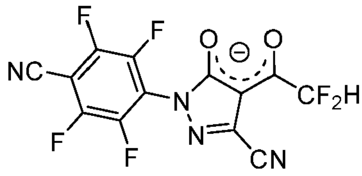 (E65),

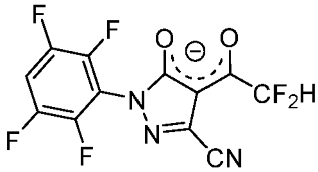 (E66), 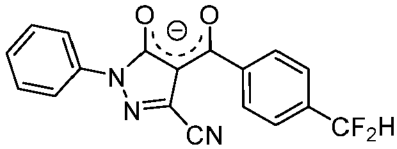 (E67),

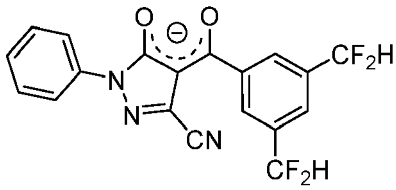 (E68), 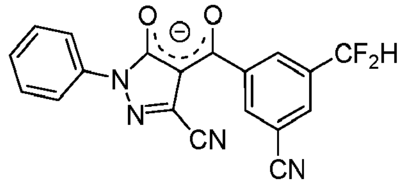 (E69),

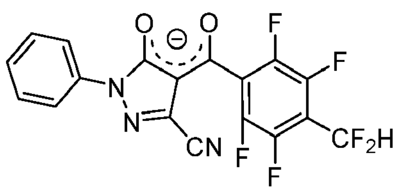 (E70), 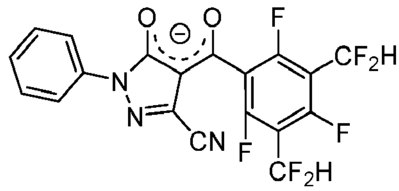 (E71),

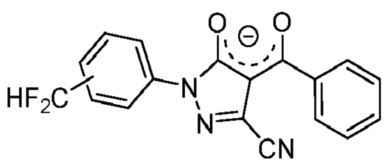 (E72), 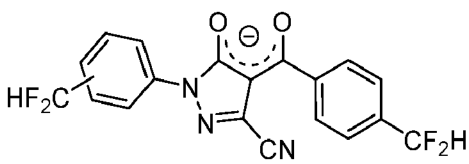 (E73),

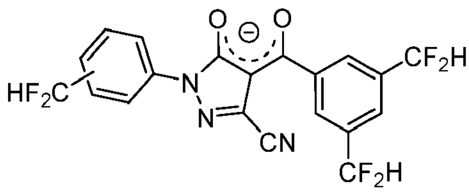 (E74), 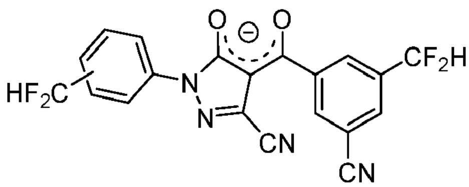 (E75),

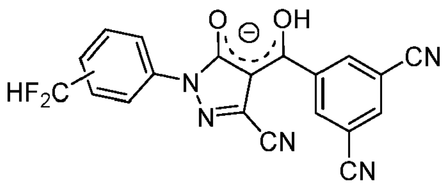 (E76), 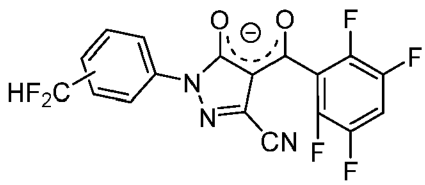 (E77),

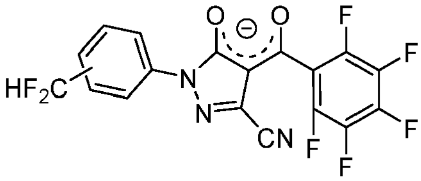 (E78), 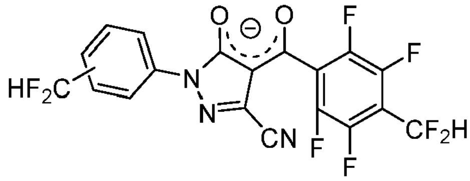 (E79),

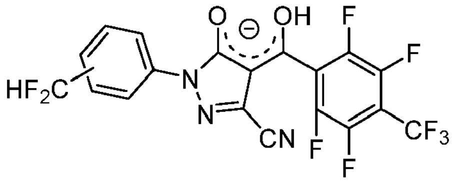 (E80), 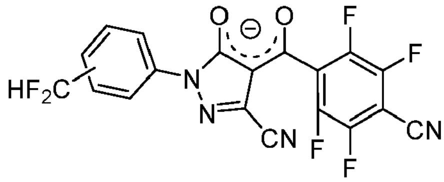 (E81),

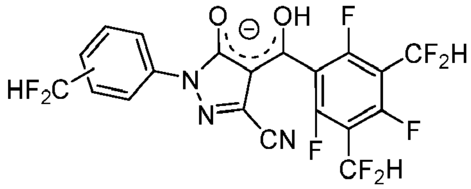 (E82), 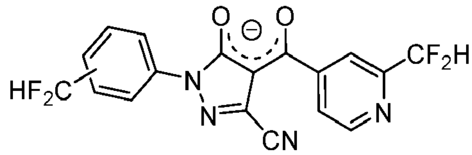 (E83),

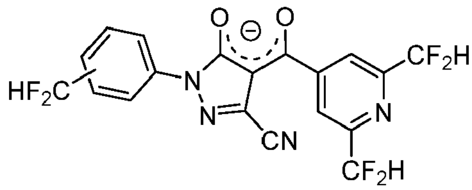 (E84), 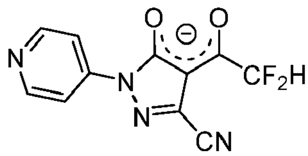 (E85),

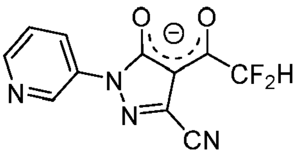 (E86), 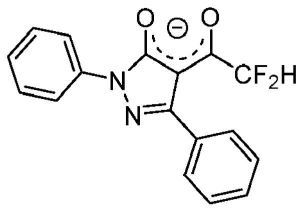 (E87), 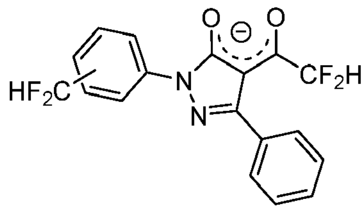

(E88),

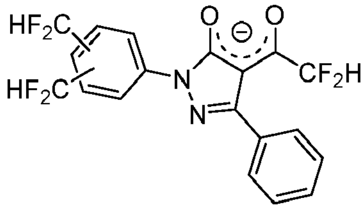 (E89), 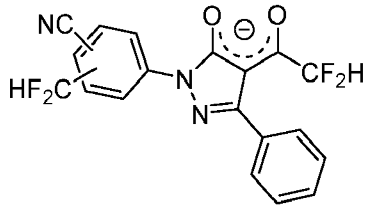 (E90),

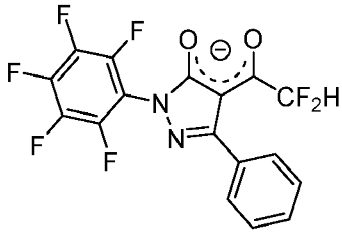 (E91), 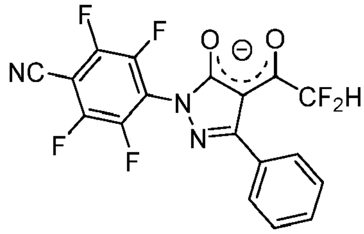 (E92),

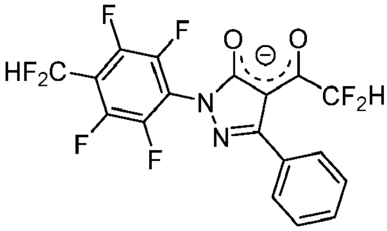 (E93), 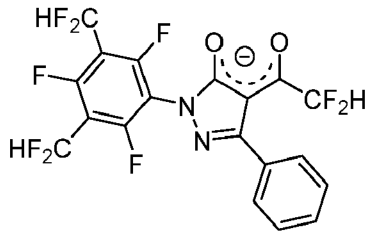 (E94),

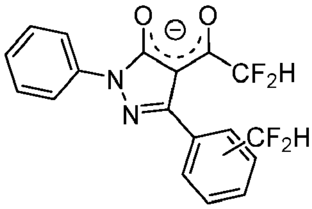 (E95), 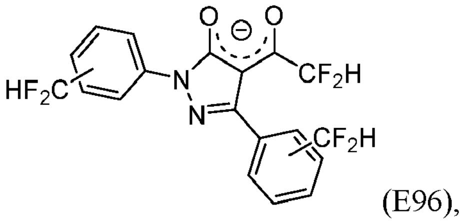 (E96),

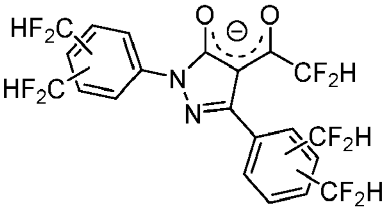 (E97), 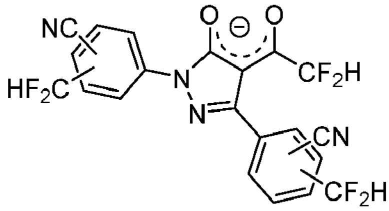 (E98),

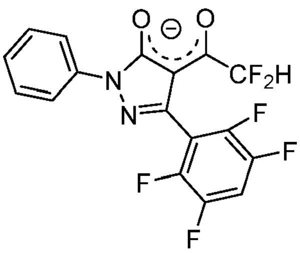 (E99), 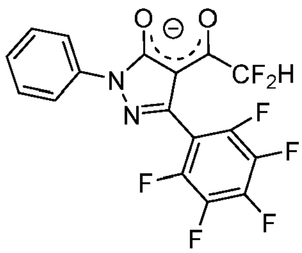 (E100), 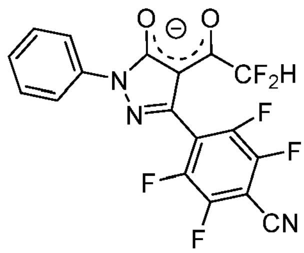 (E101),

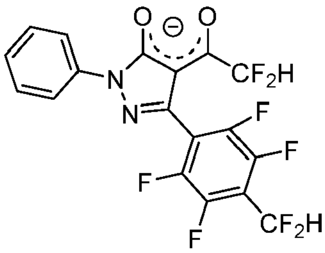 (E102), 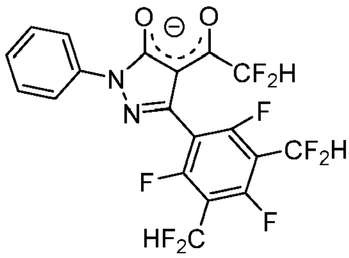 (E103),

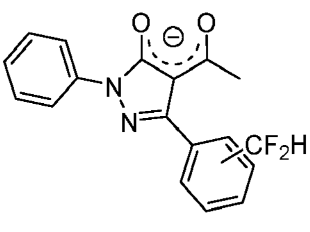 (E104), 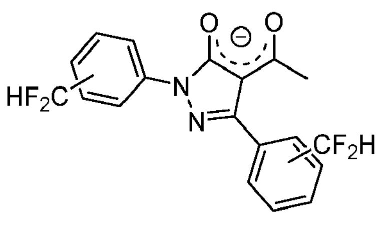 (E105),

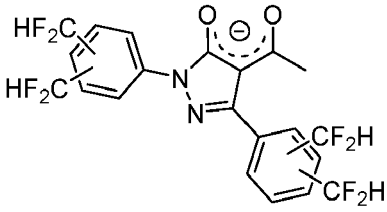 (E106), 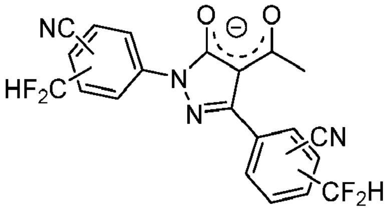 (E107),

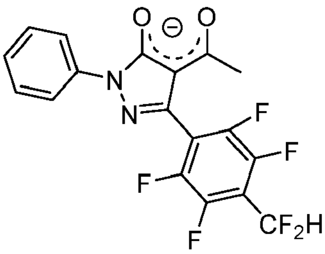 (E108), 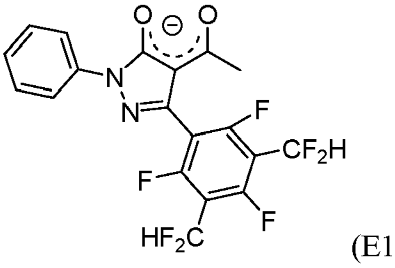 (E109),

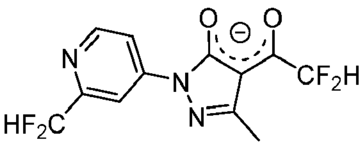 (E110), 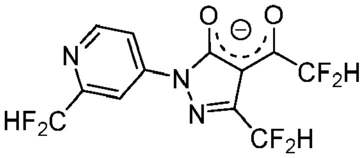 (E111),

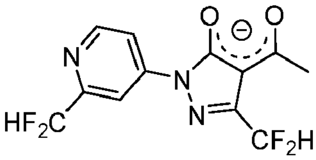 (E112), 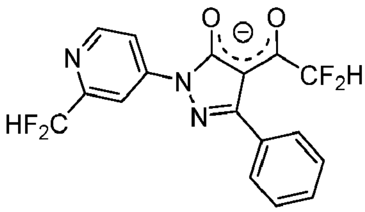 (E113),

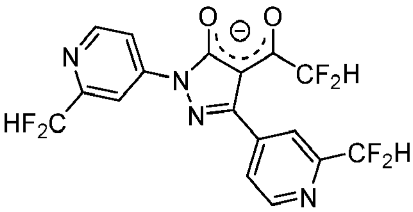 (E114), 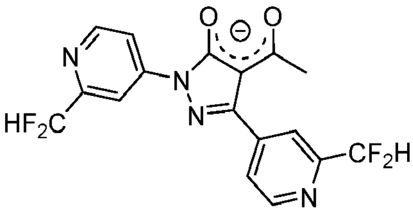 (E115),

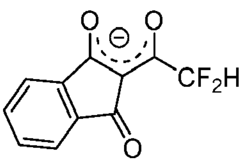 (E116), 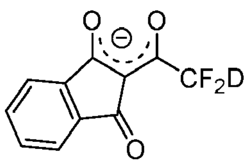 (E116-D), 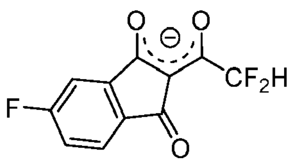 (E117),

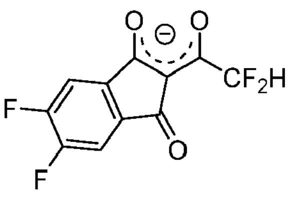 (E118), 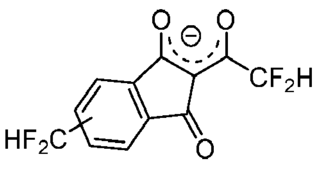 (E119), 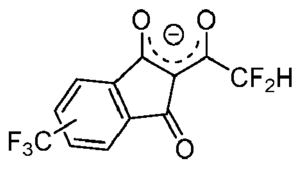 (E120),

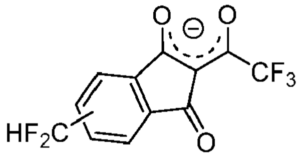 (E121), 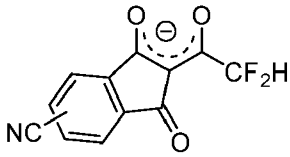 (E122), 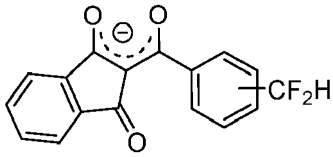

(E123), 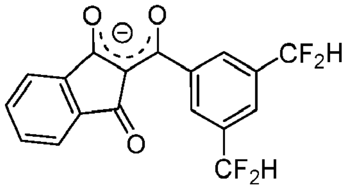 (E124), 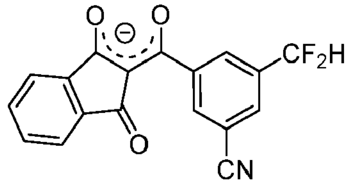 (E125),

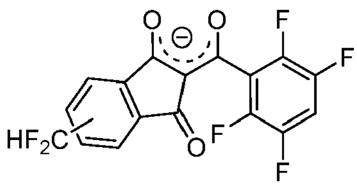 (E126), 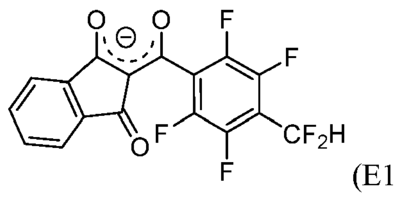 (E127),

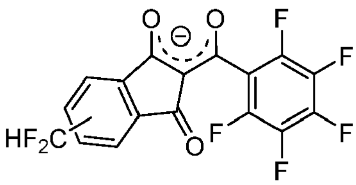 (E128), 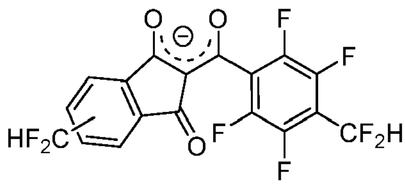 (E129),

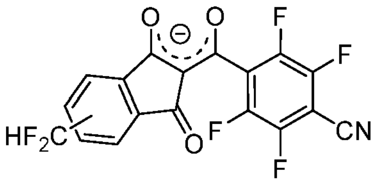 (E130), 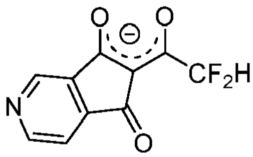 (E131), 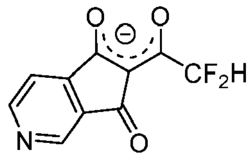 (E132),

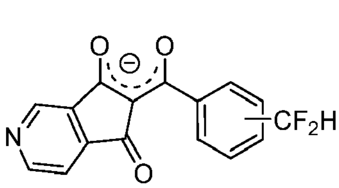 (E133), 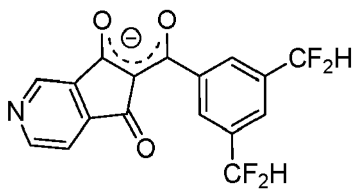 (E134),

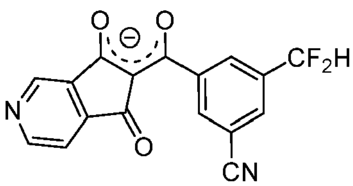 (E135), 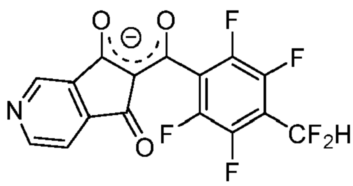 (E136),

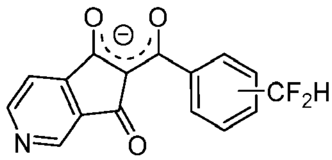 (E137), 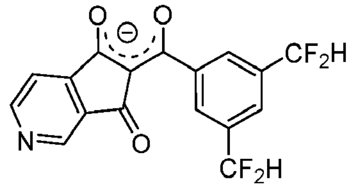 (E138),

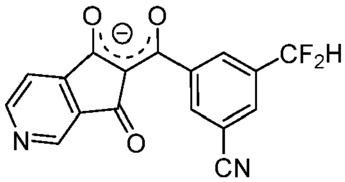 (E139), 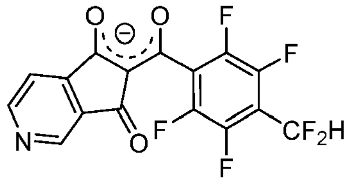 (E140),

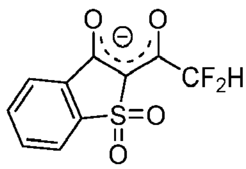 (E141), 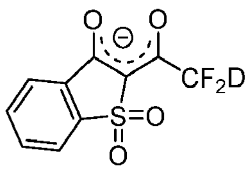 (E141-D),

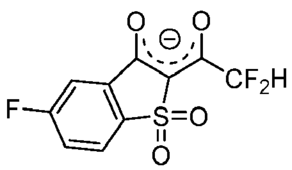 (E142), 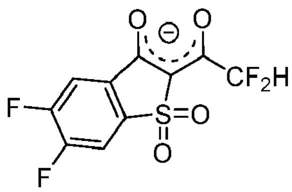 (E143), 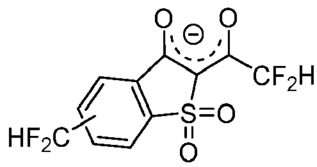 (E144),

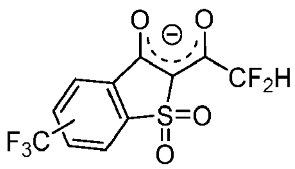 (E145), 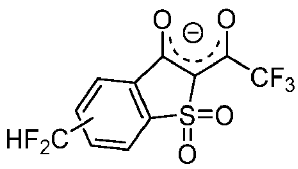 (E146), 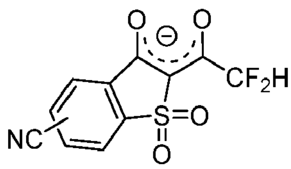 (E147),

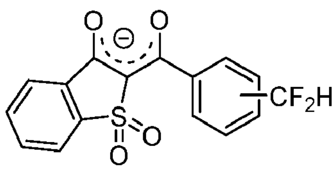 (E148),

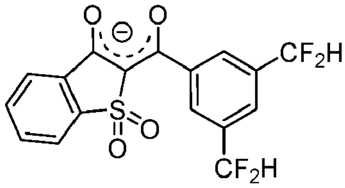 (E149), 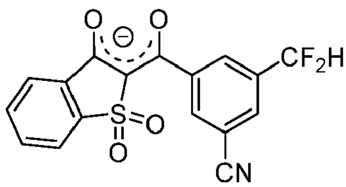 (E150),

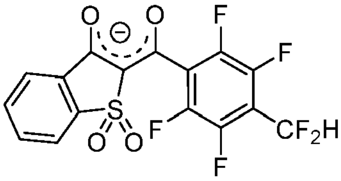 (E151), 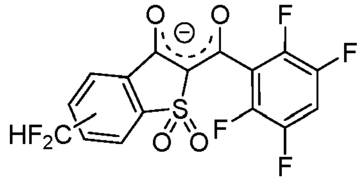 (E152),

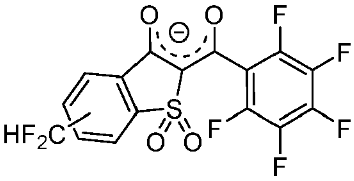 (E153), 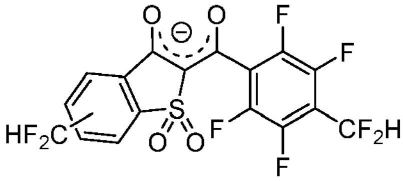 (E154),

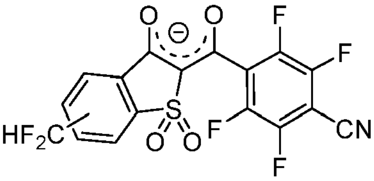 (E155), 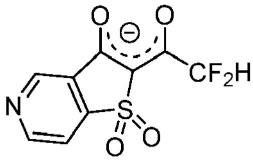 (E156), 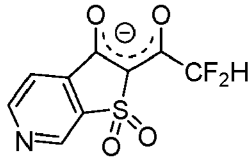 (E157),

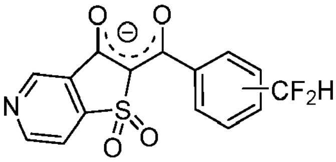 (E158), 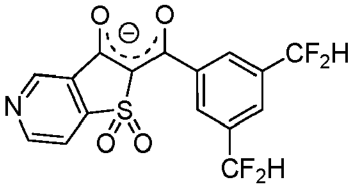 (E159),

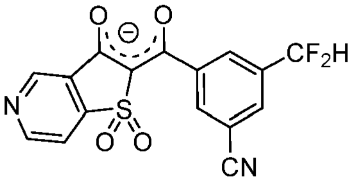 (E160), 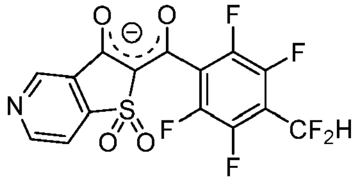 (E161),

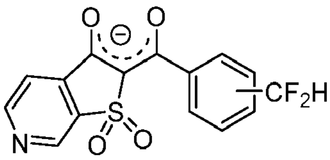 (E162), 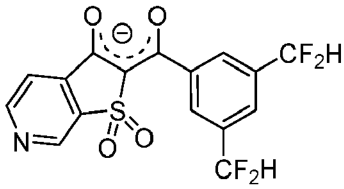 (E163),

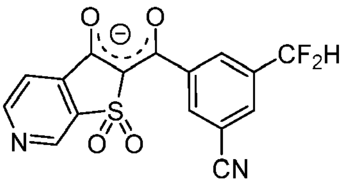 (E164), 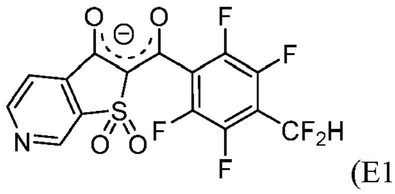 (E165),

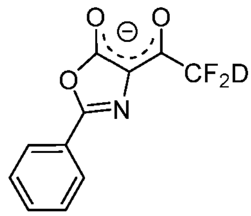 (E166), 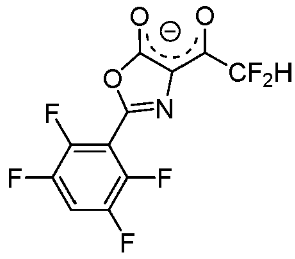 (E167),

, , 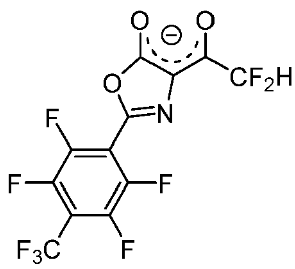 (E168),

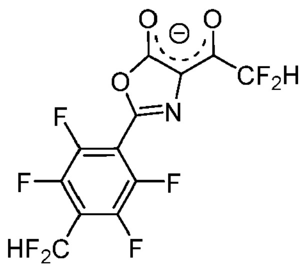 (E169), 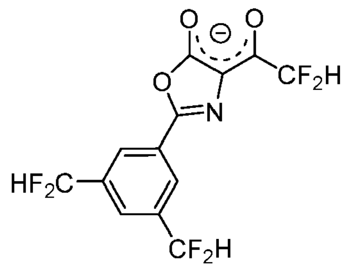 (E170),

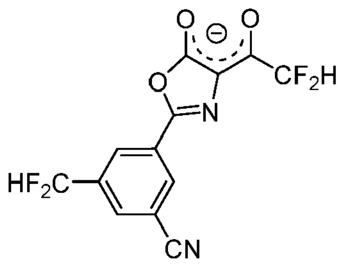 (E170), 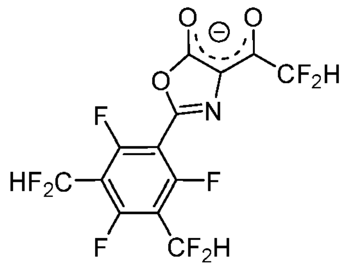 (E171),

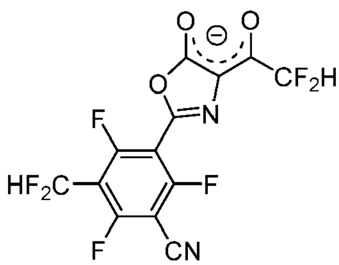 (E172), 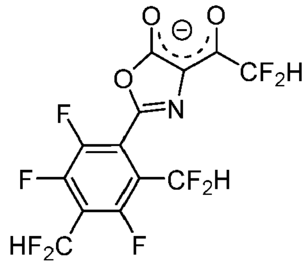 (E173).

According to an embodiment, Ligand L of formula (II) or formula (IIa) is selected from the following compounds:

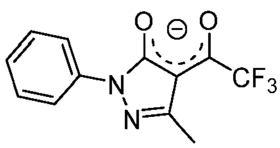 (A1), 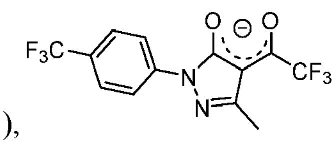 (A5), 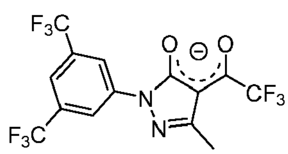 (A9),

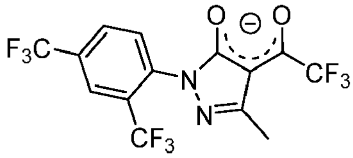 (A13), 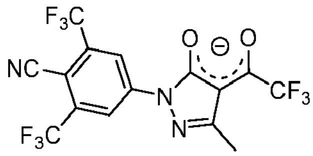 (A17), 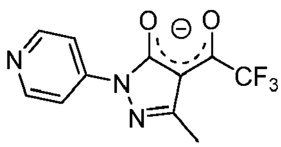 (A21),

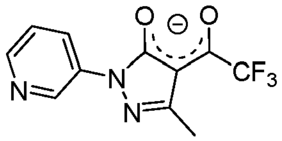 (A25), 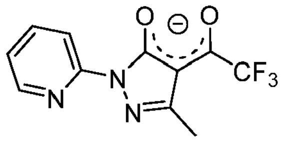 (A29), 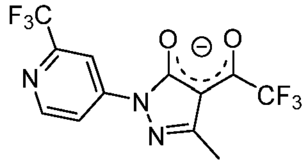 (A33),

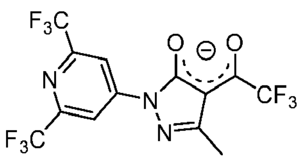 (A37), 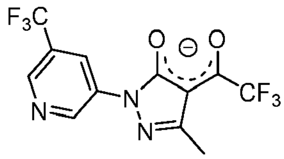 (A41), 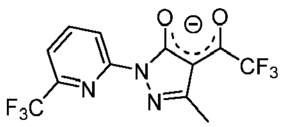 (A45),

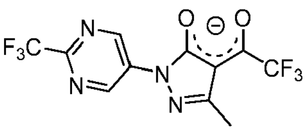 (A49), 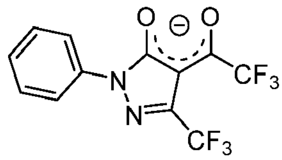 (A53), 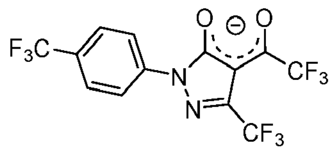 (A57),

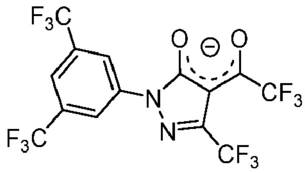 (A61), 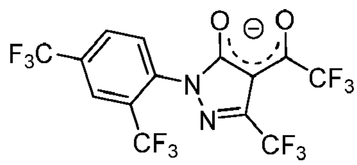 (A65),

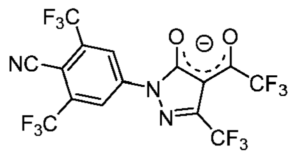 (A69), 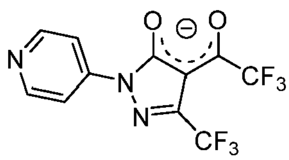 (A73), 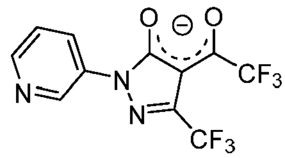 (A77),

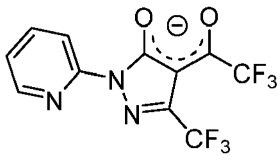 (A81), 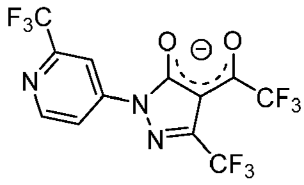 (A85), 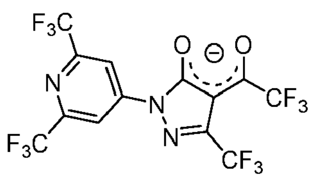 (A89),

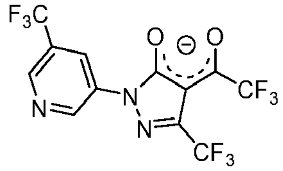 (A93), 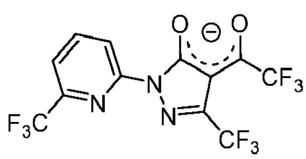 (A97), 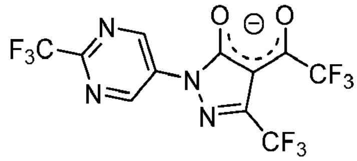 (A101),

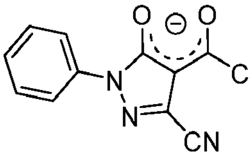 (A105), 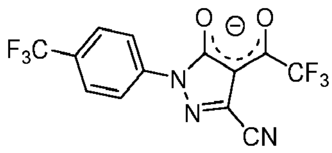 (A109),

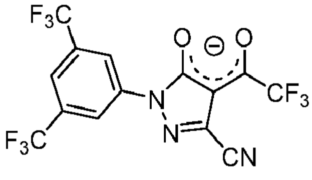 (A113), 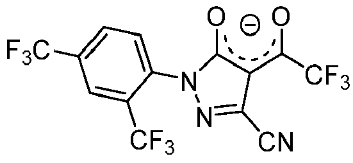 (A117),

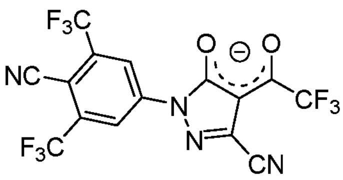 (A121), 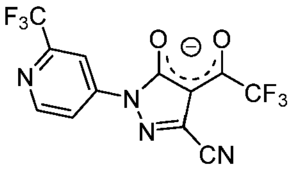 (A137),

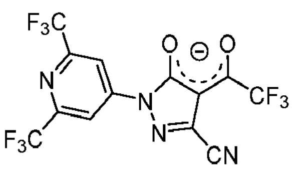 (A141), 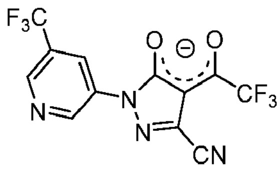 (A145), 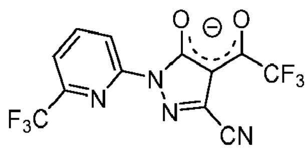 (A149),

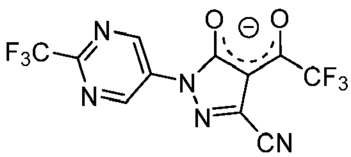 (A153), 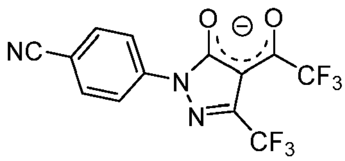 (A212),

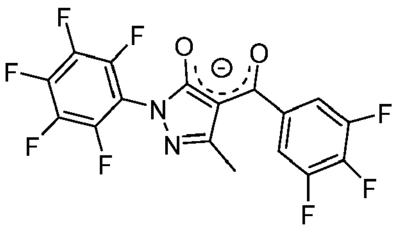 (A213) 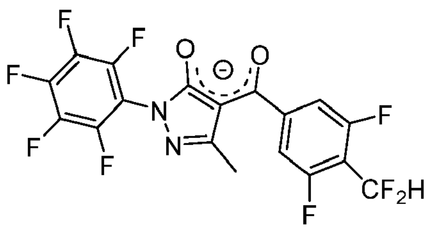 (A214)

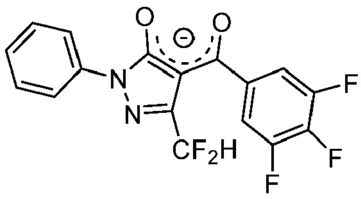 (A215)

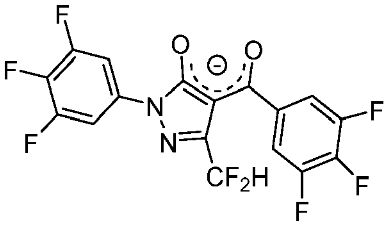
(A216)

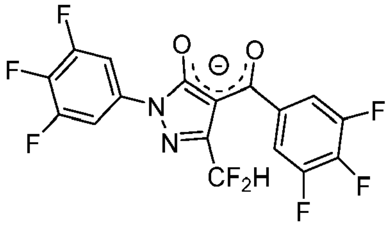
(A217)

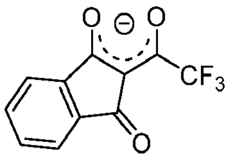
B1,

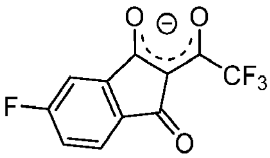
B2,

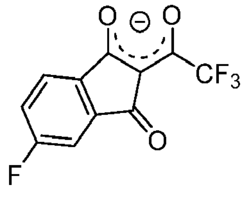
B3,

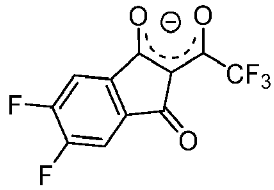
B4,

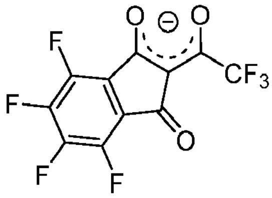
B5,

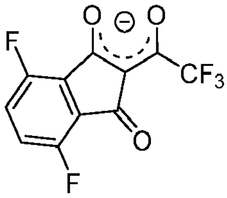
B6,

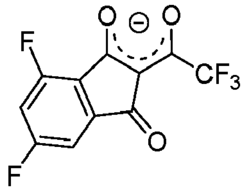
B7,

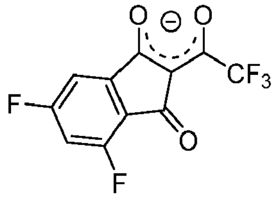
B8,

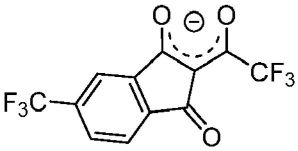
B9,

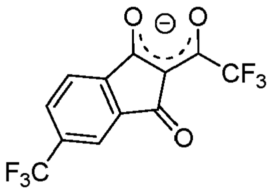
B10,

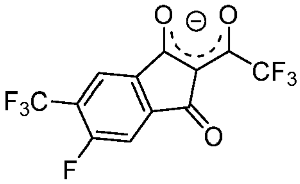
B11,

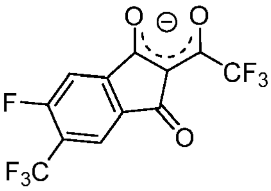
B12,

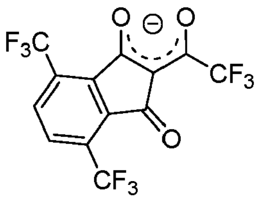
B13,

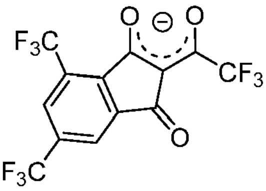
B14,

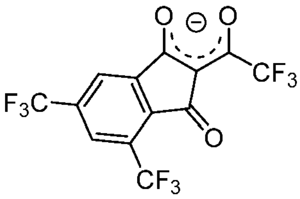
B15,

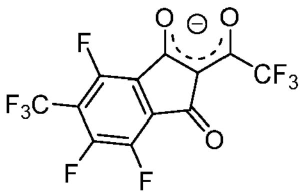
B20,

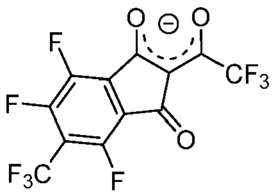
B21,

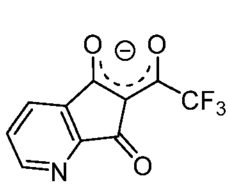
B29,

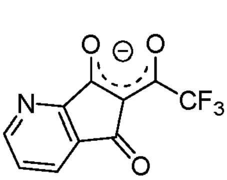
B30,

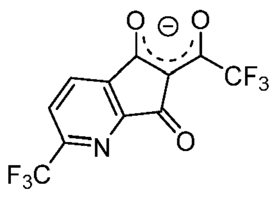
B32,

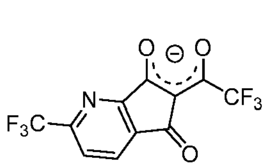

B33, , 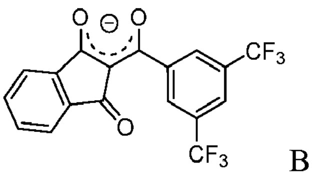 B83, 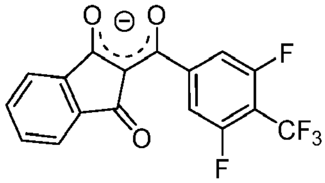 B85, ,

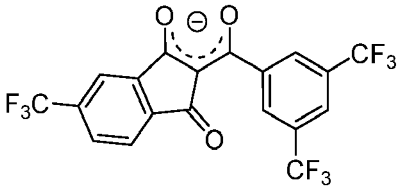 B88, 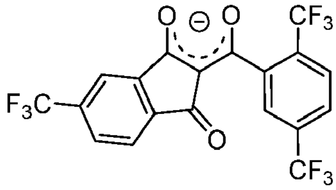 B89,

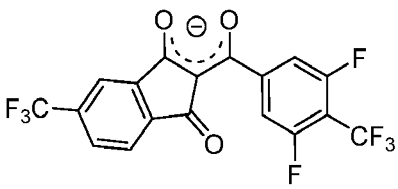 B90, 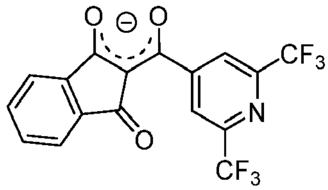 B103,

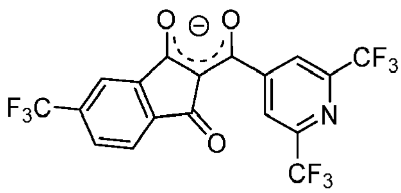 B106, 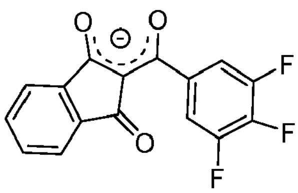 (B114),

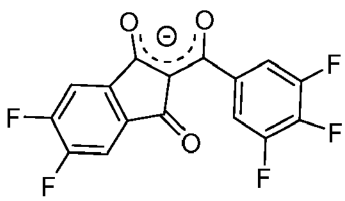 (B115), 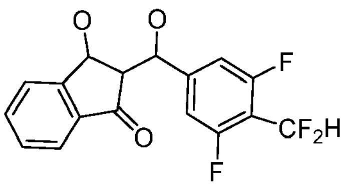 (B116) ,

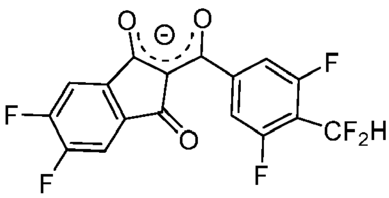 (B117), 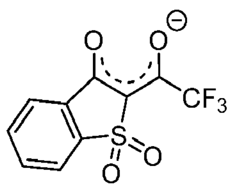 (C1), 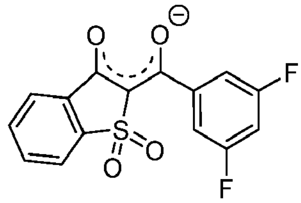 (C3),

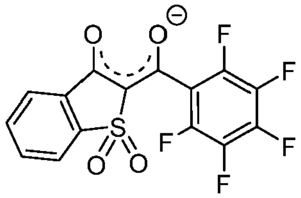 (C4), 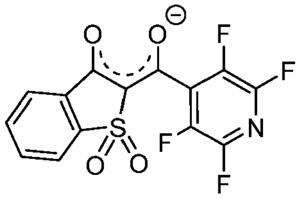 (C7), 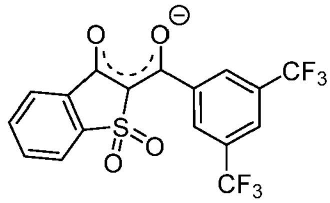 (C13),

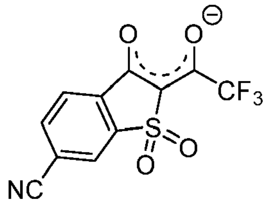 (C19), 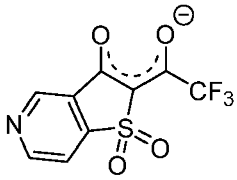 (C20), 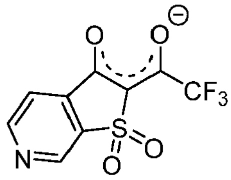 (C21),

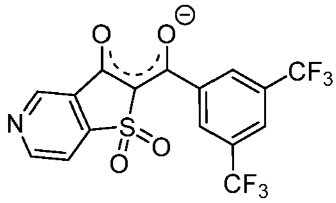 (C22), 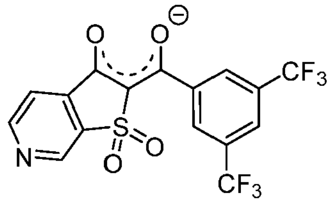 (C23),

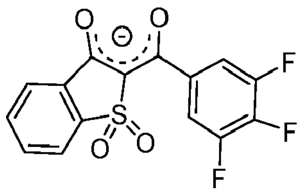 (C28), 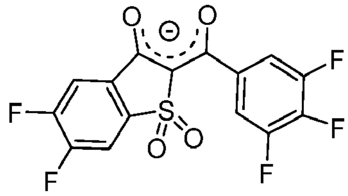 (C29),

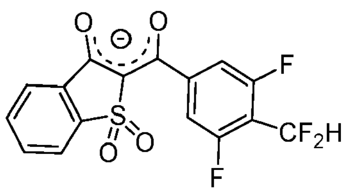 (C30), 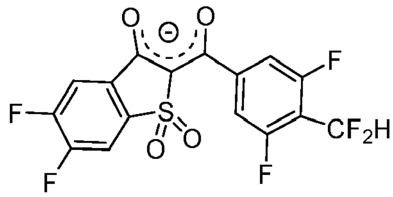 (C31),

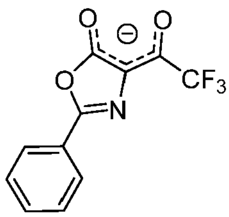 (D3), 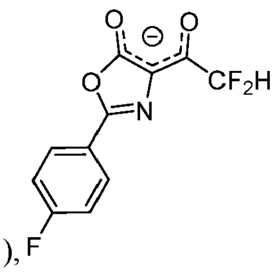 (D6),

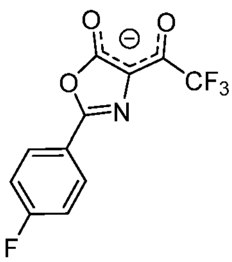 (D7), 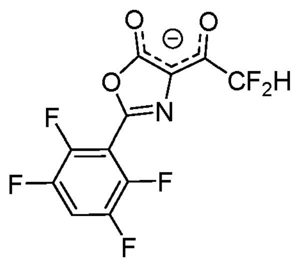 (D10), 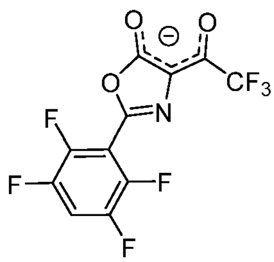 (D11),

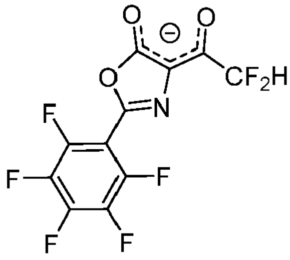 (D14), 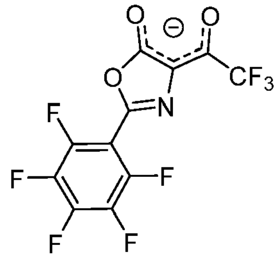 (D15), 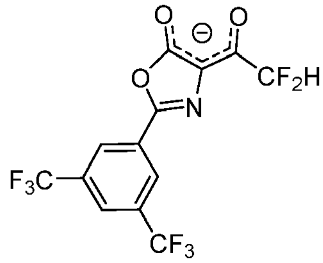 (D22),

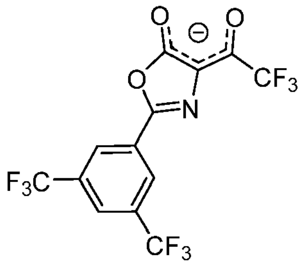 (D23), 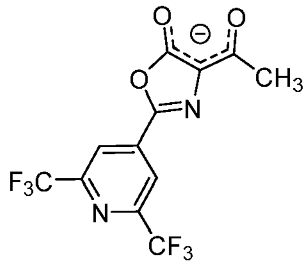 (D24), 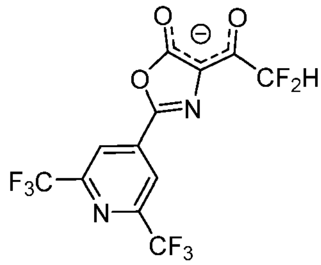 (D26),

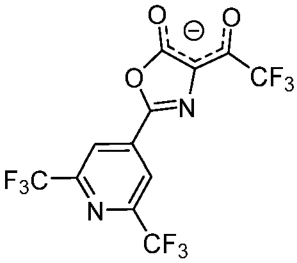 (D27), 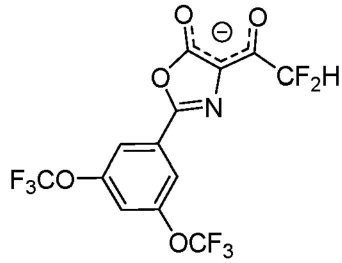 (D34), 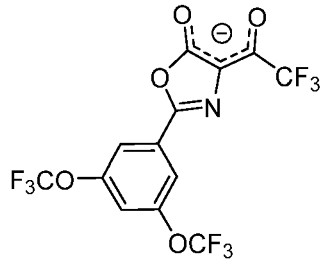

(D35),

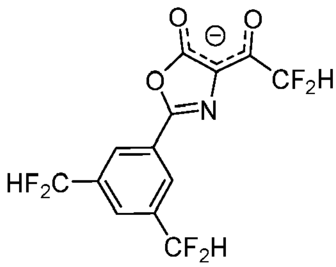 (D42), 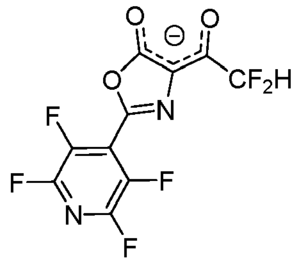 (D54), 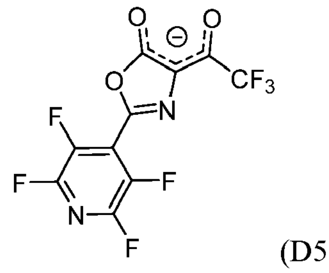 (D55),

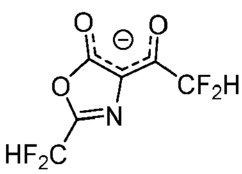 (D57), 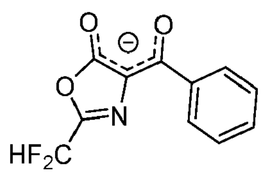 (D60), 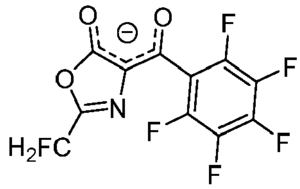 (D63),

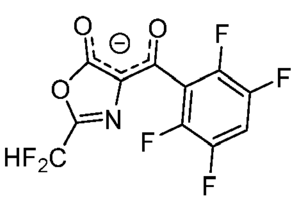 (D68), 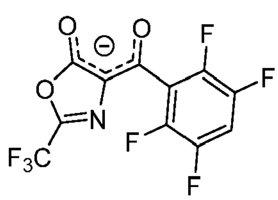 (D69), 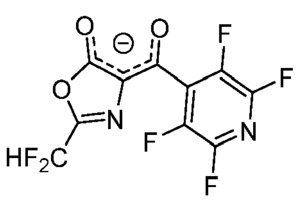 (D72),

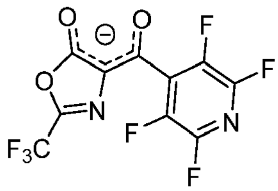 (D73), 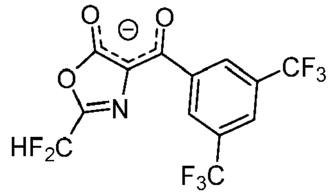 (D76), 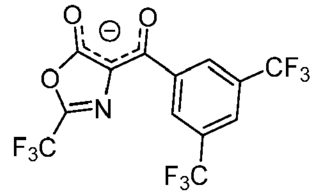 (D77),

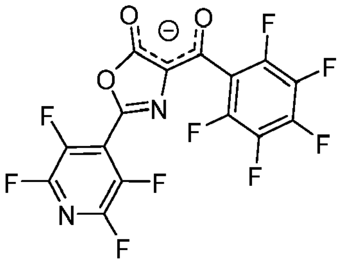 (D80), 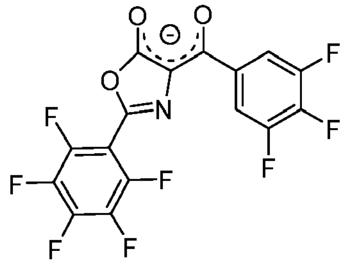 (D82),

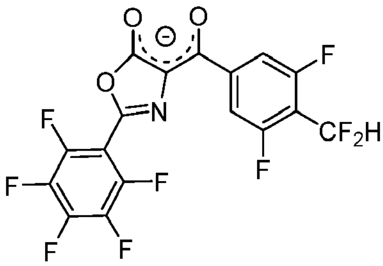 (D83), 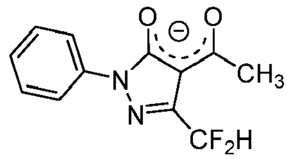 (E1), 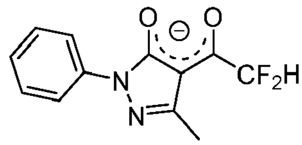 (E3),

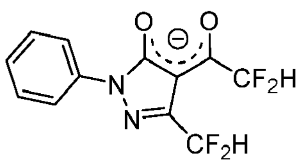 (E5), 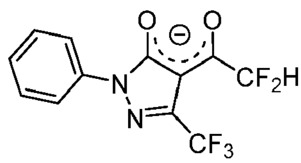 (E6), 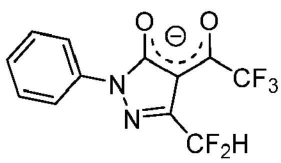 (E7),

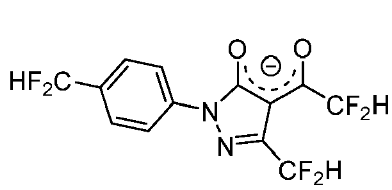 (E10), 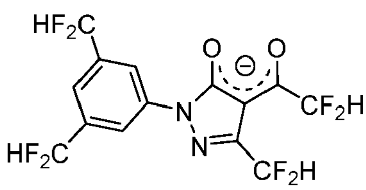 (E11),

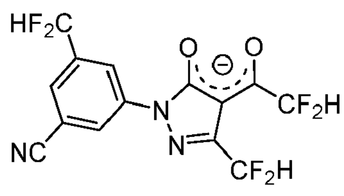 (E12), 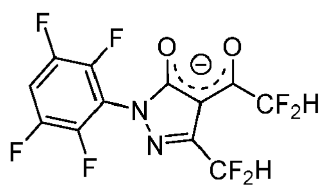 (E13),

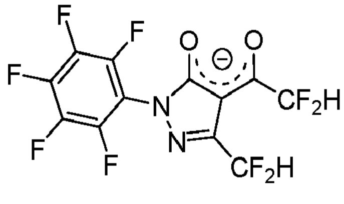 (E14), 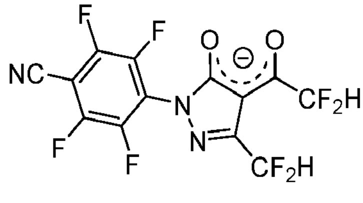 (E15),

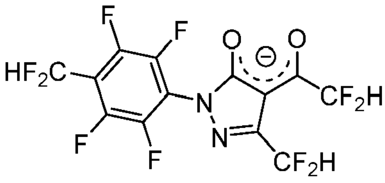 (E16), 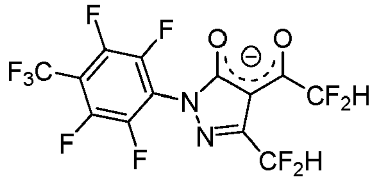 (E17),

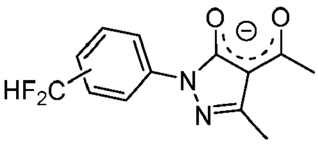 (E27), 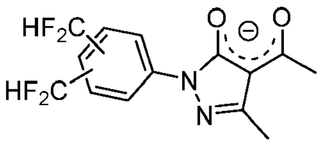 (E28), 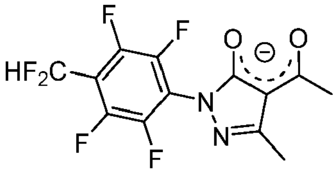

(E30), 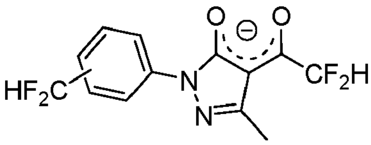 (E32), 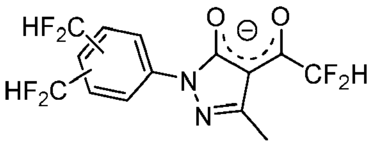 (E33),

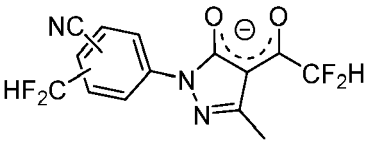 (E34), 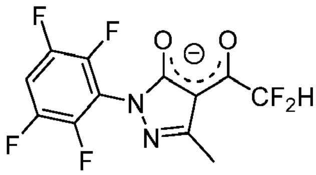 (E35),

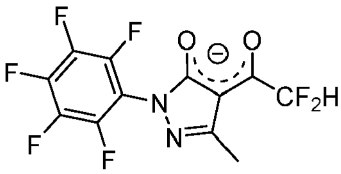 (E36), 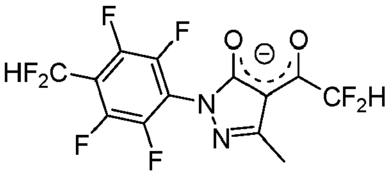 (E37),

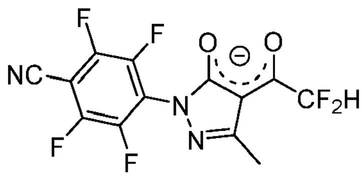 (E39),

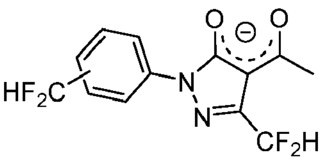 (E40), 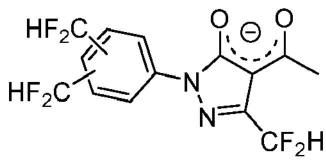 (E41),

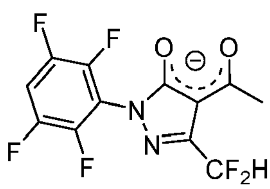 (E43),

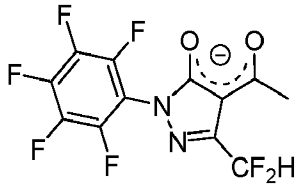 (E44), 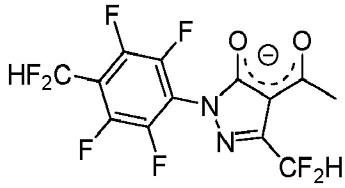 (E45), 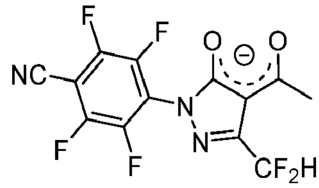 (E47),

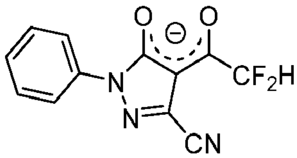 (E48), 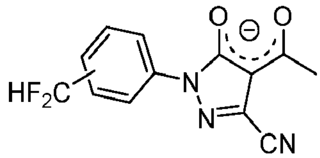 (E54), 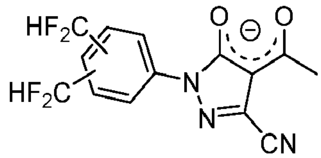 (E55),

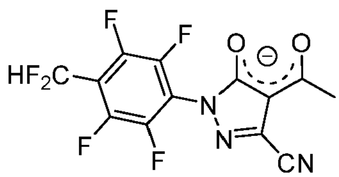 (E57), 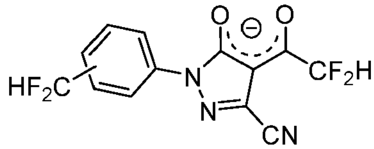 (E59),

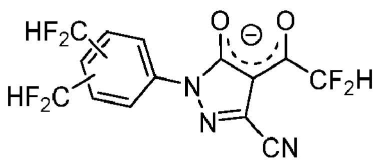 (E60),

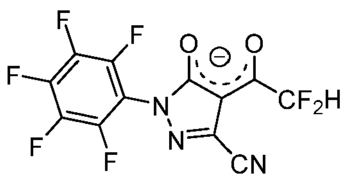 (E62), 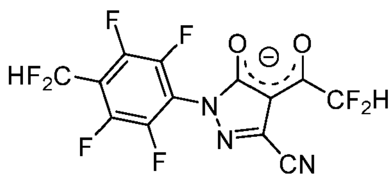 (E63),

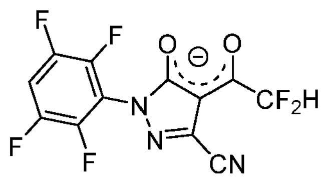 (E66), 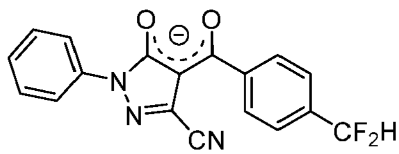 (E67),

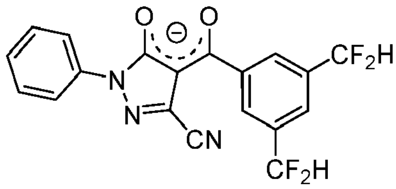 (E68), 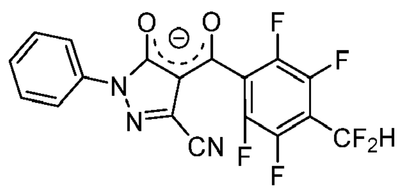 (E70),

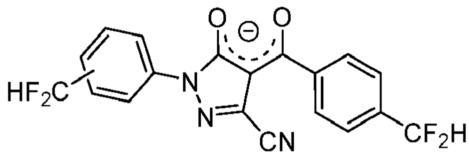 (E73), 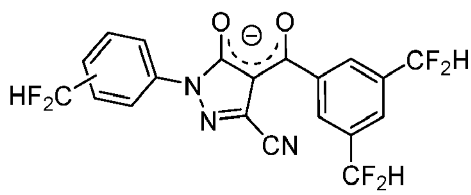 (E74),

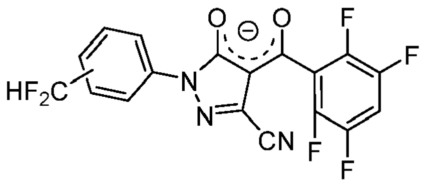 (E77), 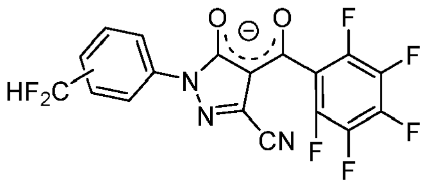 (E78),

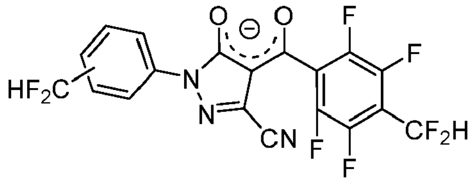 (E79), 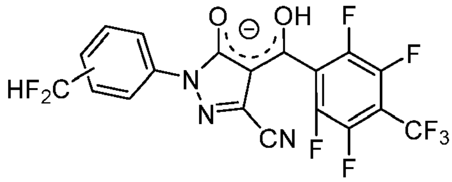 (E80),

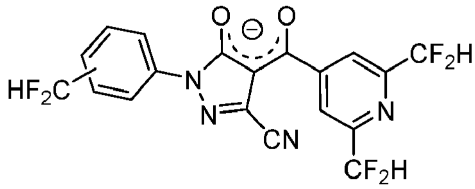 (E84),

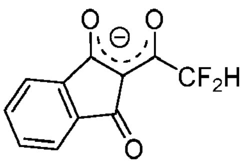 (E116), 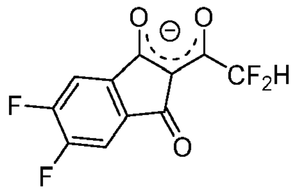 (E118), 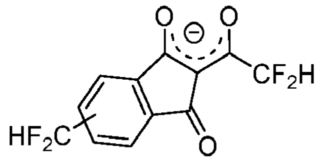 (E119),

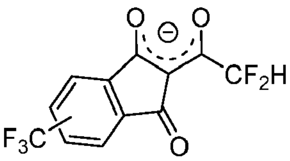 (E120), 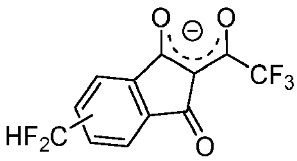 (E121), 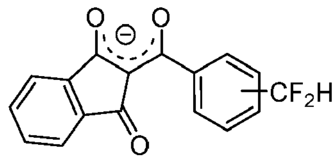

(E123), 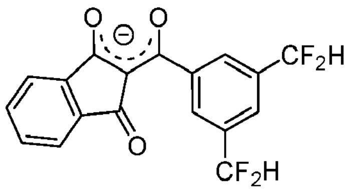 (E124), 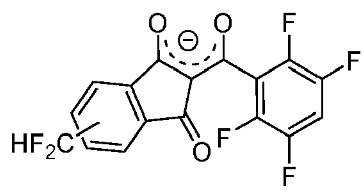 (E126),

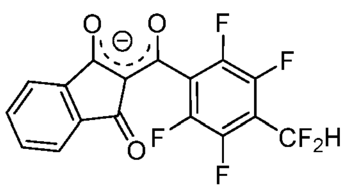 (E127), 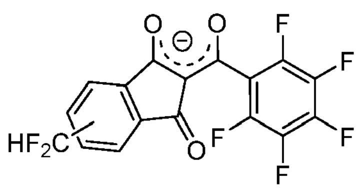 (E128),

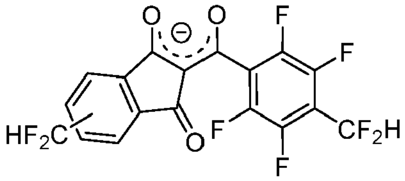 (E129), 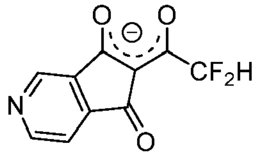 (E131), 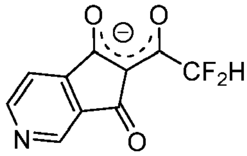 (E132),

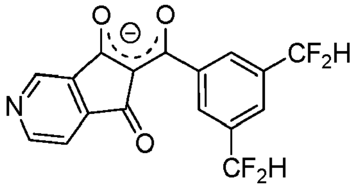 (E134), 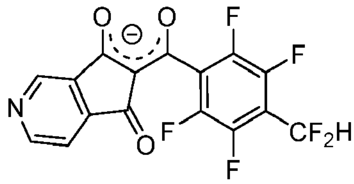 (E136),

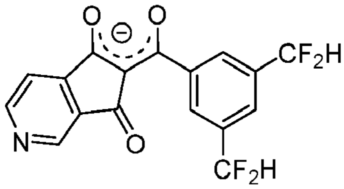 (E138), 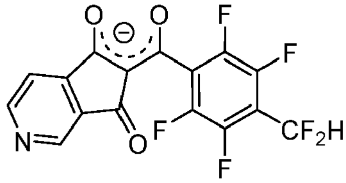 (E140), 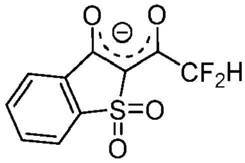

(E141), 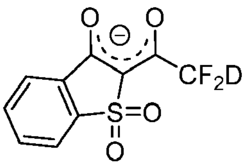 (E141-D), 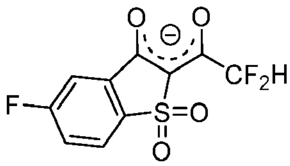 (E142), 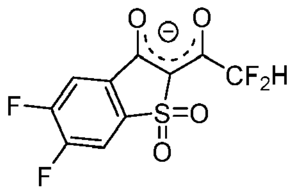

(E143), 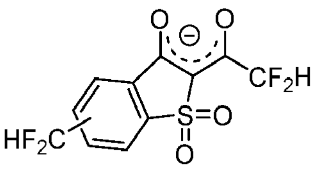 (E144), 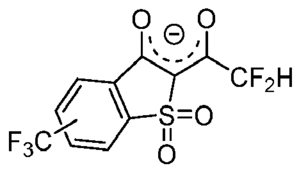 (E145), 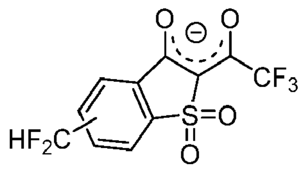

(E146), 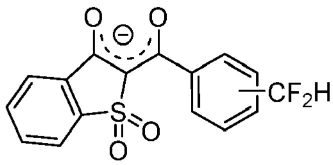 (E148), 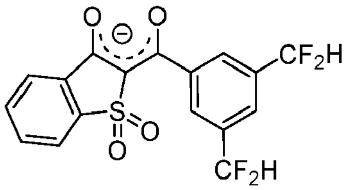 (E149),

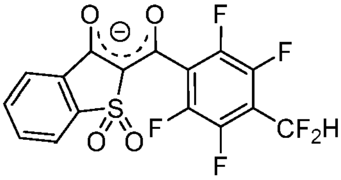 (E151), 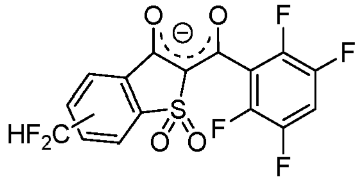 (E152),

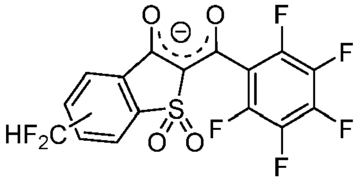 (E153), 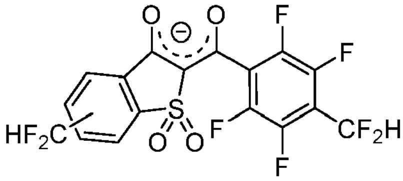 (E154),

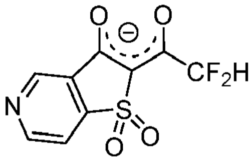 (E156), 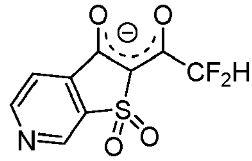 (E157), 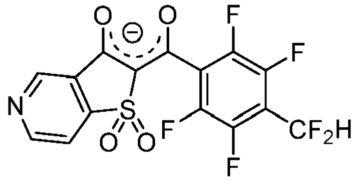 (E161),

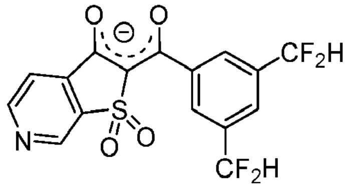 (E163),

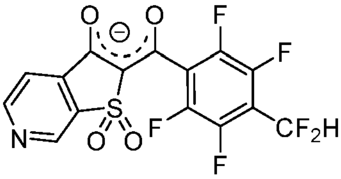 (E165), 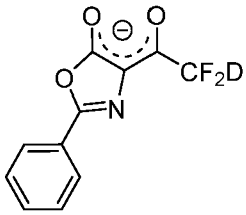 (E166), 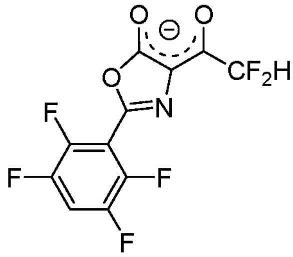 (E167),

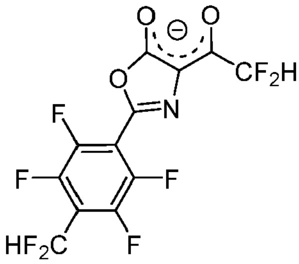 (E169), 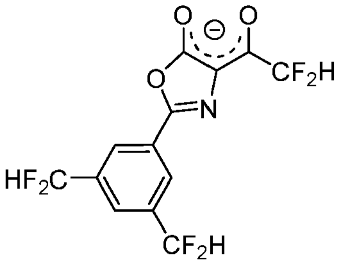 (E170),

According to an embodiment, Ligand L of formula (II) or formula (IIa) is selected from the following compounds:

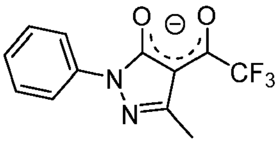 (A1), 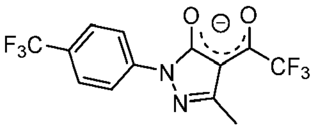 (A5), 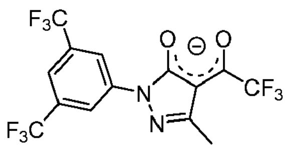 (A9),

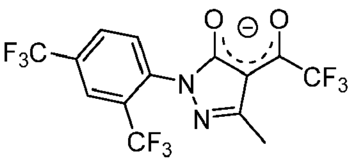 (A13), 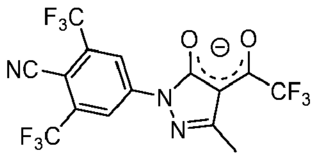 (A17),

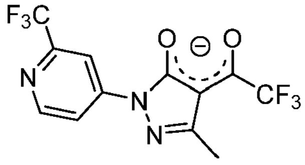 (A33), 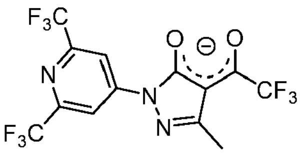 (A37),

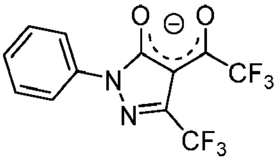 (A53), 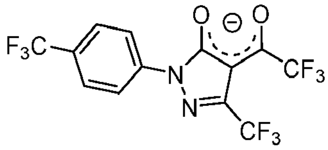 (A57), 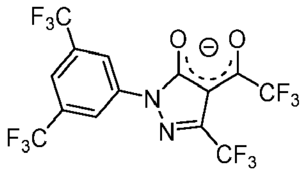 (A61),

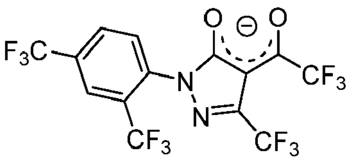 (A65), 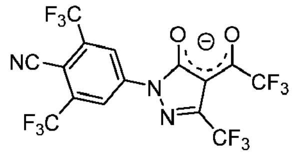 (A69),

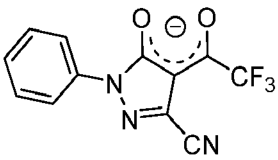 (A105), 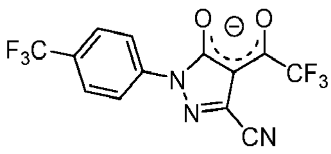 (A109),

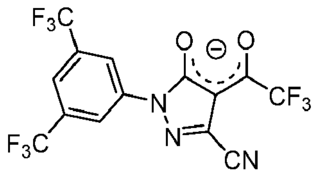 (A113), 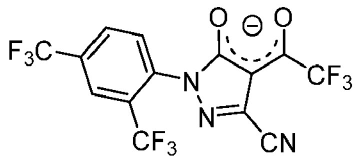 (A117),

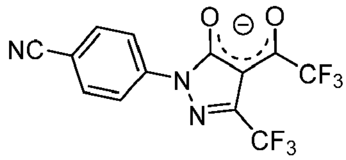 (A212), 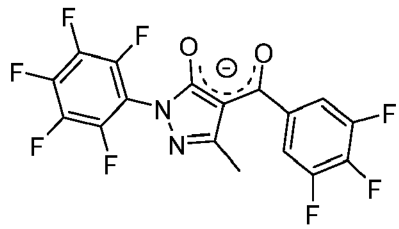 (A213)

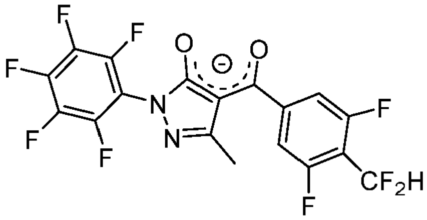 (A214) 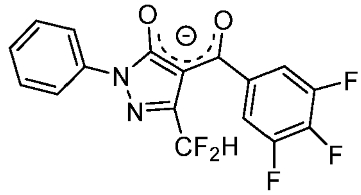 (A215)

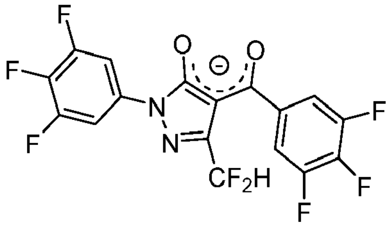 (A216)

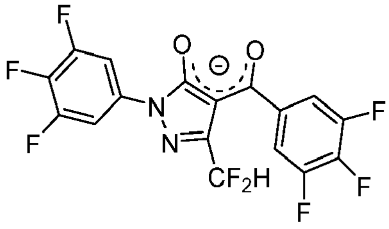 (A217)

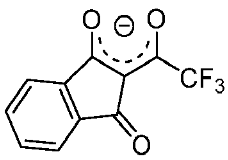 B1,

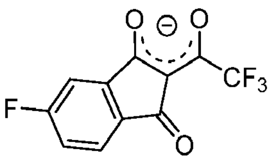 B2,

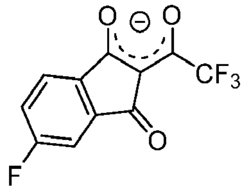 B3,

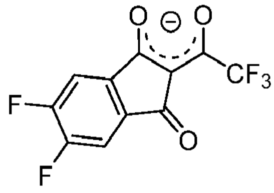 B4,

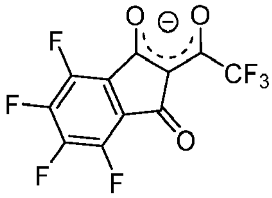 B5,

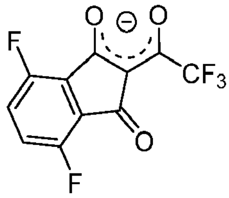 B6,

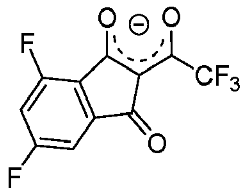 B7,

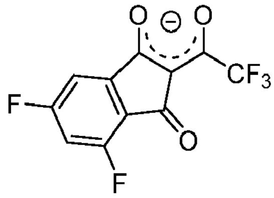 B8,

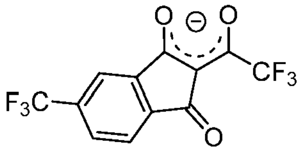 B9,

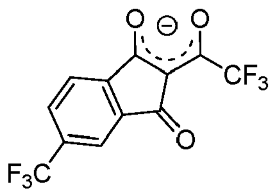 B10,

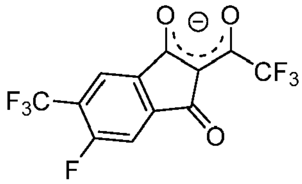 B11,

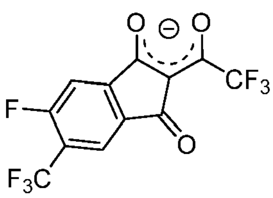 B12,

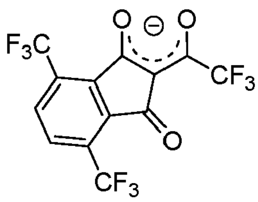 B13,

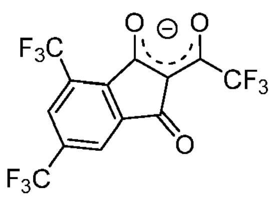 B14,

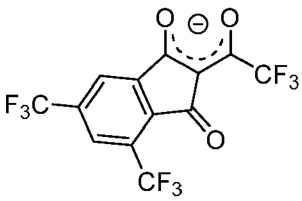 B15,

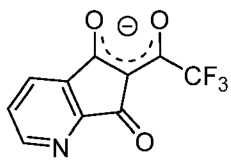 B29,

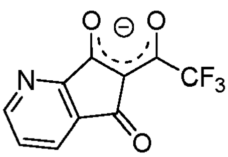 B30,

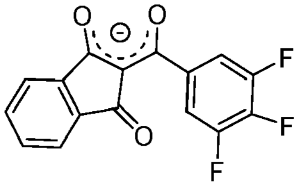 (B114),

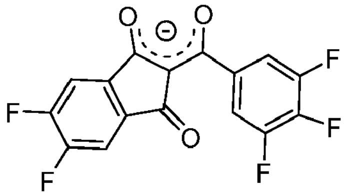 (B115),

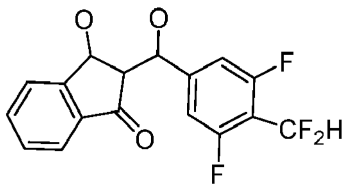 (B116), 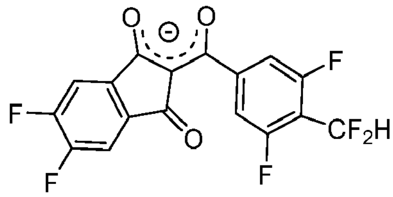 (B117),

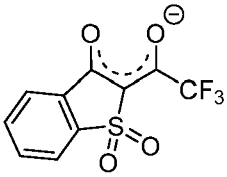 (C1), 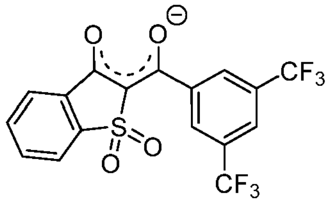 (C13), 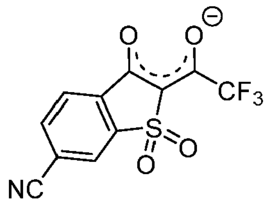 (C19),

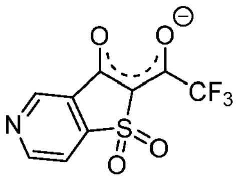 (C20), 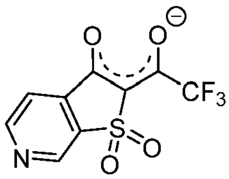 (C21), 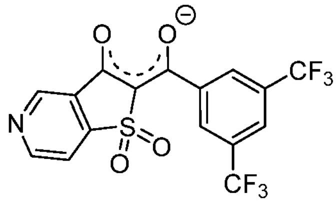 (C22),

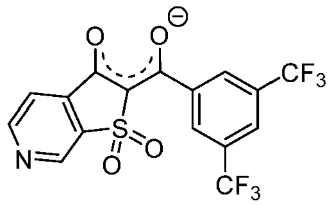 (C23), 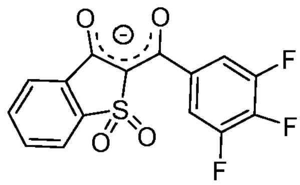 (C28),

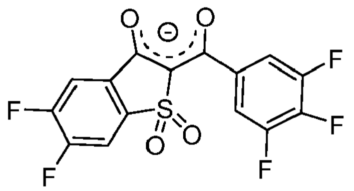 (C29), 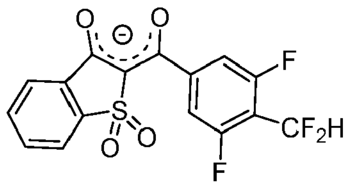 (C30),

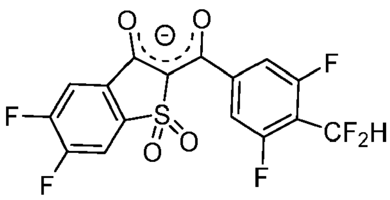 (C31), 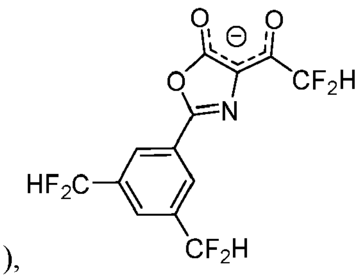 (D42),

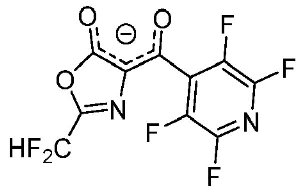 (D72), 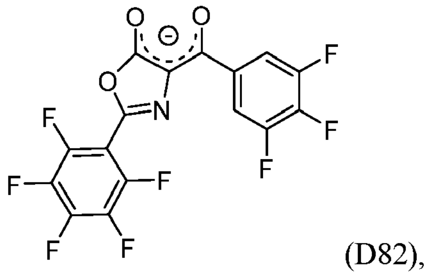 (D82),

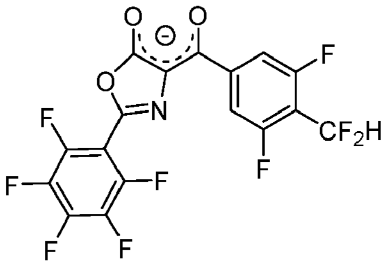 (D83), 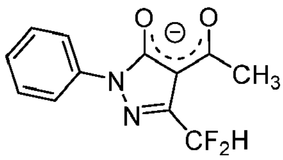 (E1), 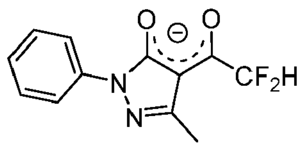 (E3),

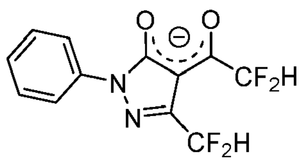 (E5), 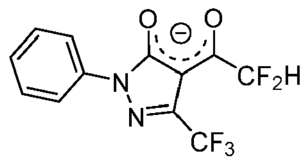 (E6), 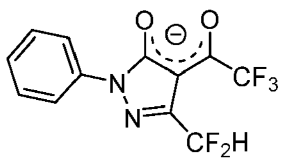 (E7),

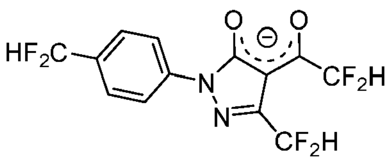 (E10), 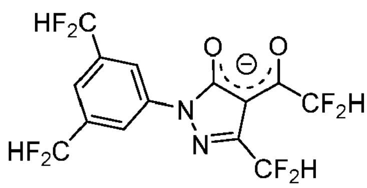 (E11),

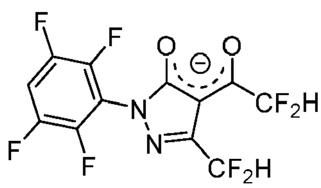 (E13), 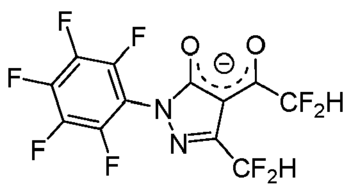 (E14),

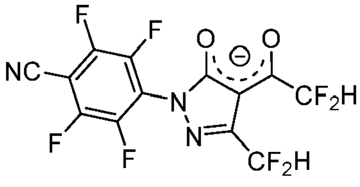 (E15), 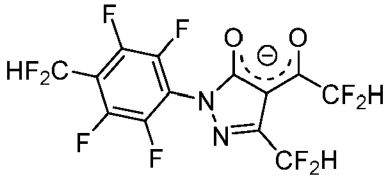 (E16),

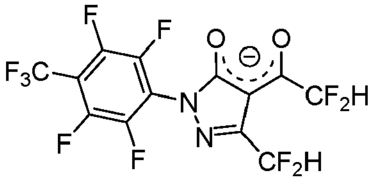 (E17), 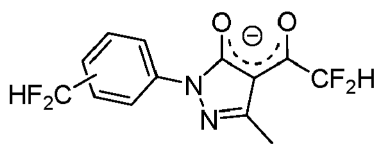 (E32),

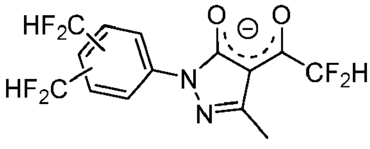 (E33), 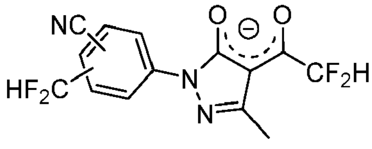 (E34),

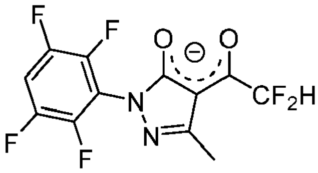 (E35), 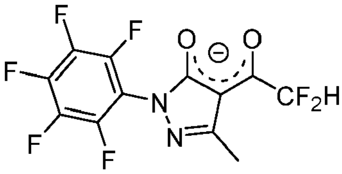 (E36),

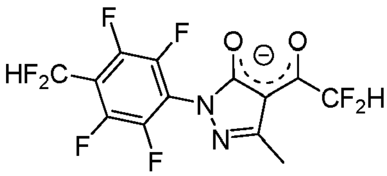 (E37), 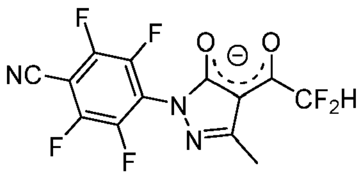 (E39),

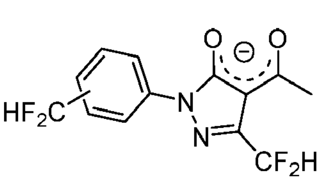 (E40), 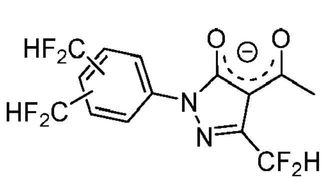 (E41), 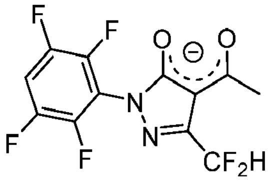 (E43),

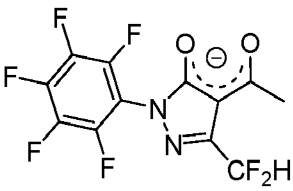 (E44), 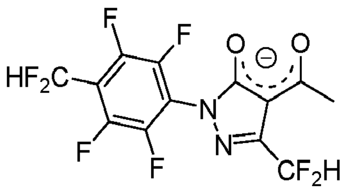 (E45), 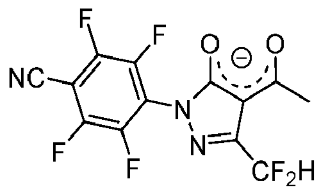 (E47),

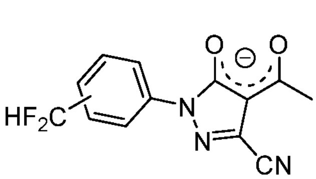 (E54), 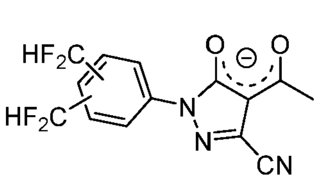 (E55), 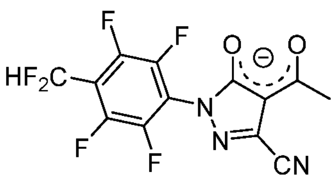 (E57),

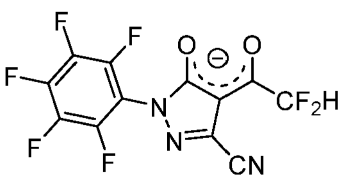 (E62), 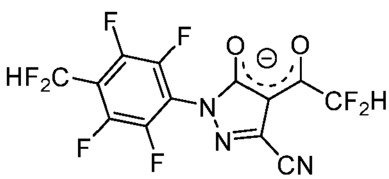 (E63),

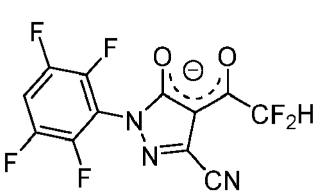 (E66), 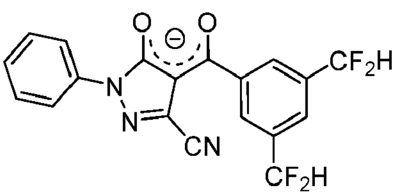 (E68),

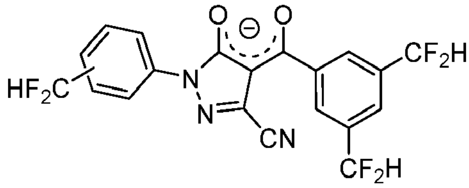 (E74), 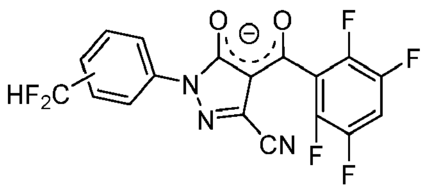 (E77),

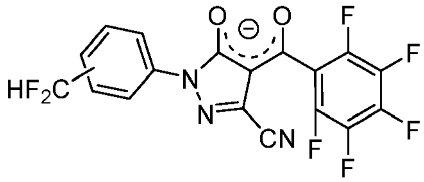 (E78), 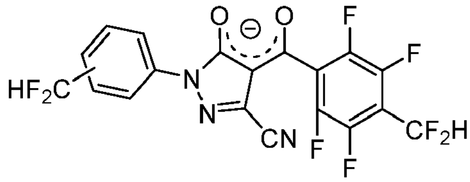 (E79),

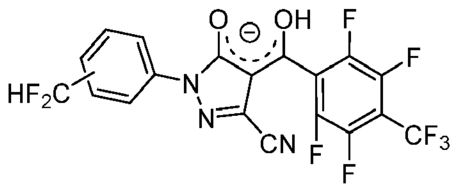 (E80), 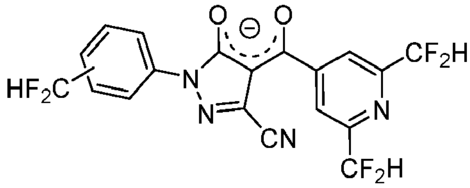 (E84),

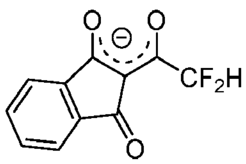 (E116), 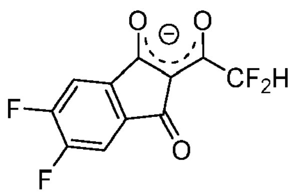 (E118), 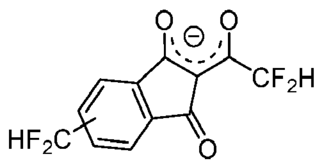 (E119),

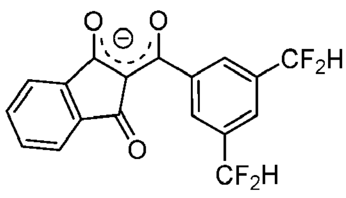 (E124), 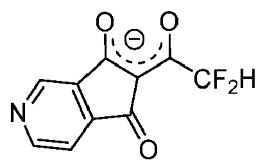 (E131), 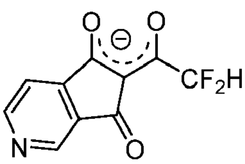 (E132),

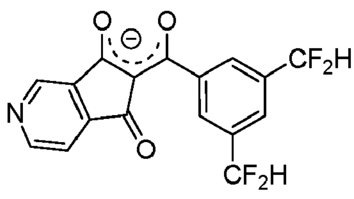 (E134), 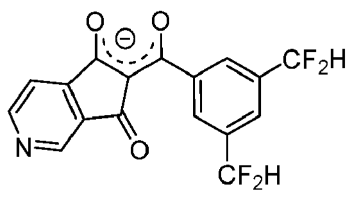 (E138),

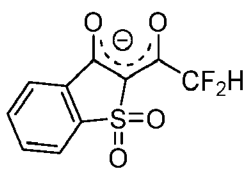 (E141), 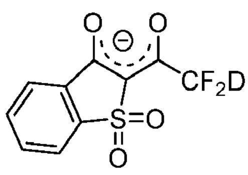 (E141-D),

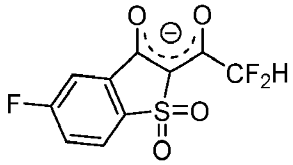 (E142), 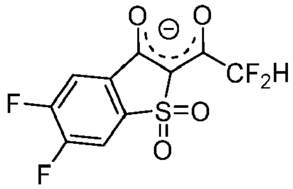 (E143), 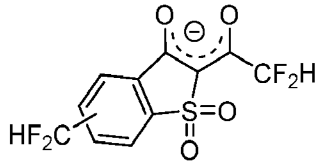 (E144),

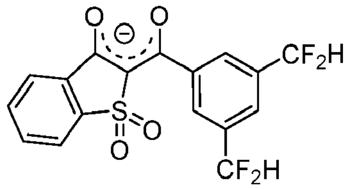 (E149), 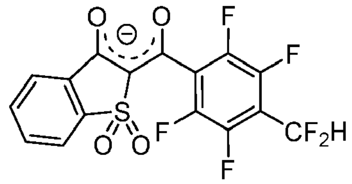 (E151),

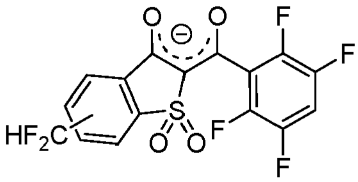 (E152), 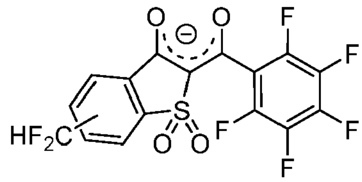 (E153),

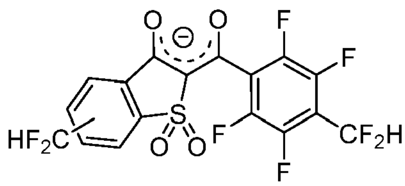 (E154), 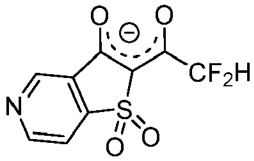 (E156), 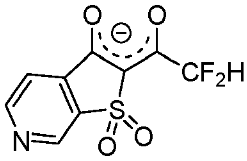 (E157),

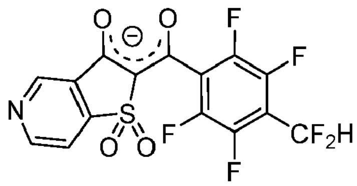 (E161), 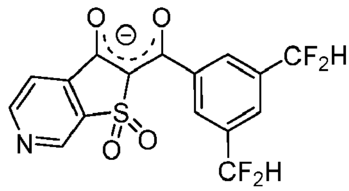 (E163),

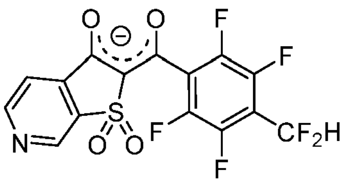 (E165), 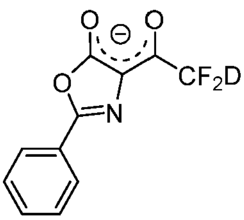 (E166), 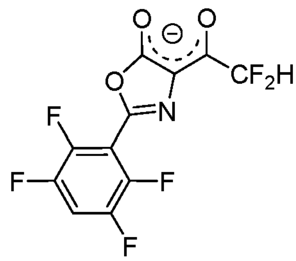 (E167),

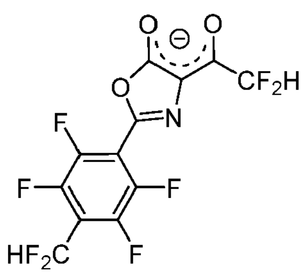 (E169), 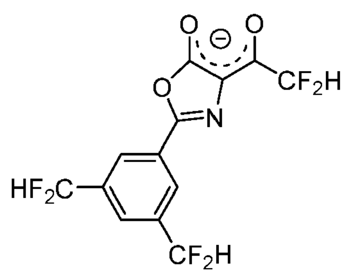 (E170),

According to an embodiment, Ligand L of formula (II) or formula (IIa) is selected from the following compounds:

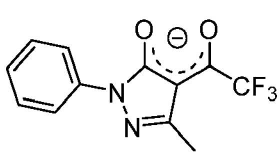 (A1), 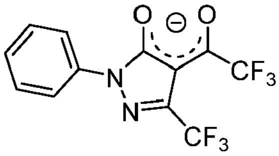 (A53), 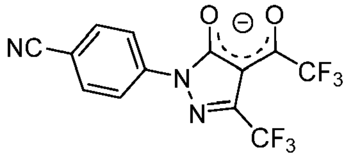 (A212),

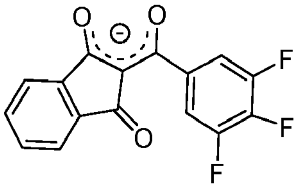 (B114) 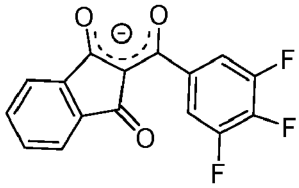 (B115) 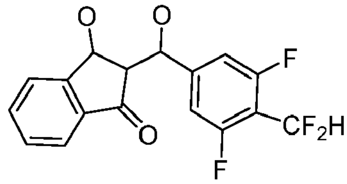

(B116) 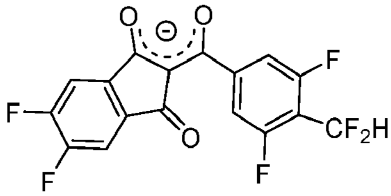 (B117), 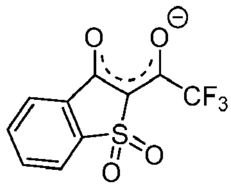 (C1),

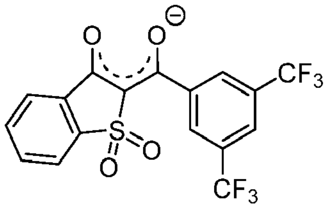 (C13), 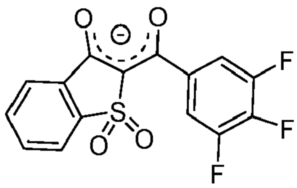 (C28), 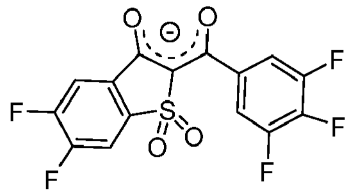

(C29),

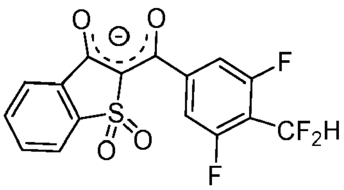 (C30), 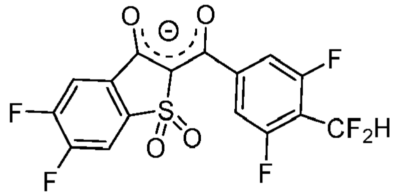 (C31),

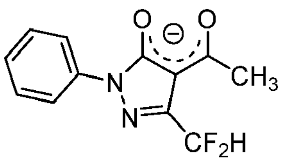 (E1), 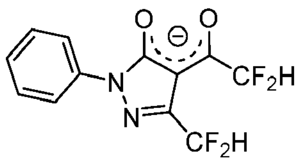 (E5), 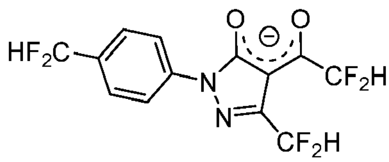 (E10),

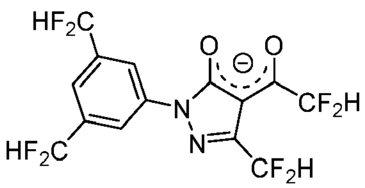 (E11), 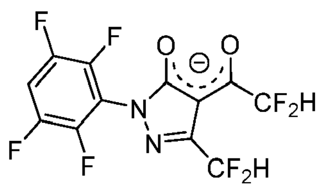 (E13),

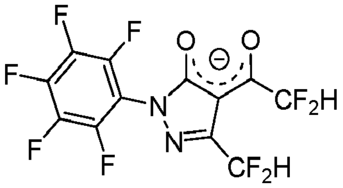 (E14), 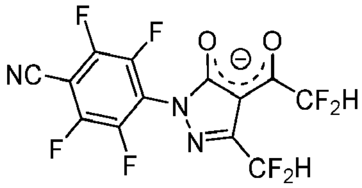 (E15),

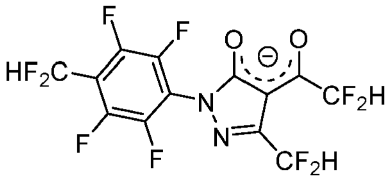 (E16), 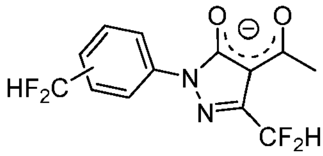 (E40), 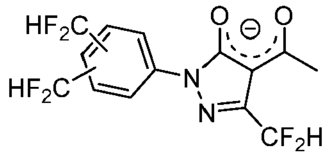

(E41),

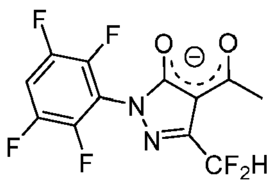 (E43), 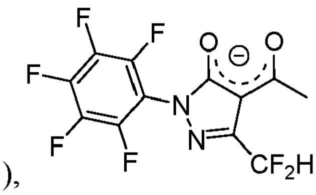 (E44), 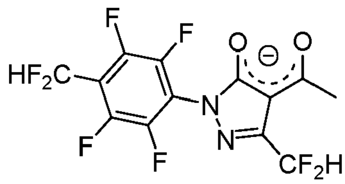 (E45),

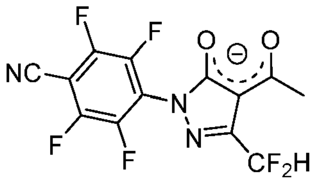 (E47), 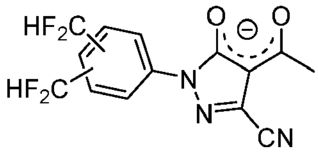 (E55), 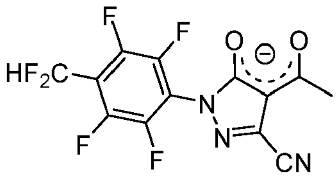 (E57),

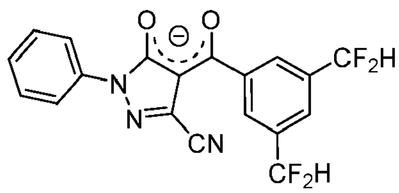 (E68), 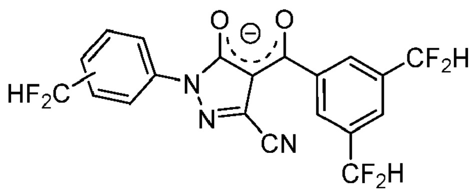 (E74),

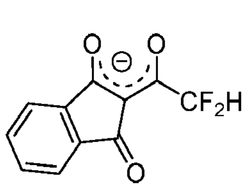 (E116), 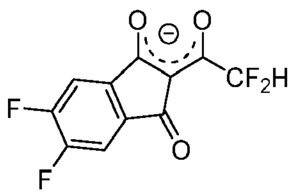 (E118), 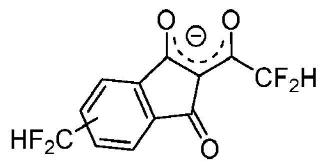 (E119),

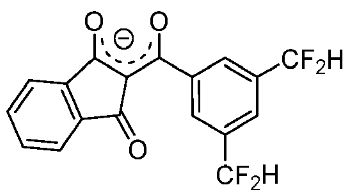 (E124), 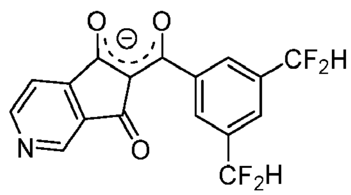 (E138),

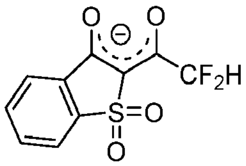 (E141), 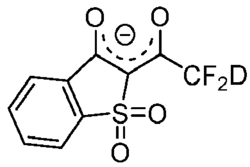 (E141-D),

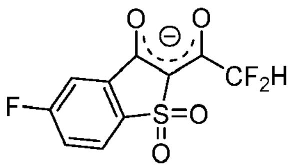 (E142), 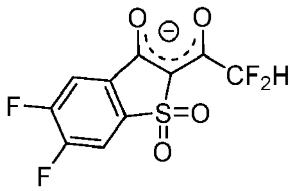 (E143), 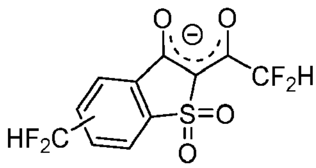 (E144),

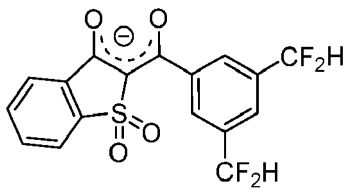 (E149).

Ancillary Ligand "AL"

According to one embodiment of the application, AL (the ancillary ligand) is selected from the group comprising $H_2O$, $C_2$ to $C_{40}$ mono- or multi-dentate ethers and $C_2$ to $C_{40}$ thioethers, $C_2$ to $C_{40}$ amines, $C_2$ to $C_{40}$ phosphine, $C_2$ to $C_{20}$ alkyl nitrile or $C_2$ to $C_{40}$ aryl nitrile, or a compound according to Formula (AL-I);

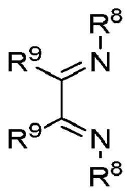 (AL-I),

wherein

$R^8$ and $R^9$ are independently selected from $C_1$ to $C_{20}$ alkyl, $C_1$ to $C_{20}$ heteroalkyl, $C_6$ to $C_{20}$ aryl, heteroaryl with 5 to 20 ring-forming atoms, halogenated or perhalogenated $C_1$ to $C_{20}$ alkyl, halogenated or perhalogenated $C_1$ to $C_{20}$ heteroalkyl, halogenated or perhalogenated $C_6$ to $C_{20}$ aryl, halogenated or perhalogenated heteroaryl with 5 to 20 ring-forming atoms, or at least one $R^6$ and $R^7$ are bridged and form a 5 to 20 member ring, or the two $R^6$ and/or the two $R^7$ are bridged and form a 5 to 40 member ring or form a 5 to 40 member ring comprising an unsubstituted or $C_1$ to $C_{12}$ substituted phenanthroline.

According to one embodiment of the application, index m (which stands for the number of Ancillary Ligands) is zero.

According to one embodiment of the application AL is $H_2O$ and m is 1.

Metal complex of Formula (I) or Formula (Ia)

According to an embodiment, wherein the metal complex of Formula (I) or Formula (Ia) is selected from one of the following compounds:

| Referred to as: | Ligand L | m |
|---|---|---|
| MC1 | A1 | 0 |

(continued)

| Referred to as: | Ligand L | m |
|---|---|---|
| MC2 | A2 | 0 |
| MC3 | A3 | 0 |
| MC4 | A4 | 0 |
| MC5 | A5 | 0 |
| MC6 | A6 | 0 |
| MC7 | A7 | 0 |
| MC8 | A8 | 0 |
| MC9 | A9 | 0 |
| MC10 | A10 | 0 |
| MC11 | A11 | 0 |
| MC12 | A12 | 0 |
| MC13 | A13 | 0 |
| MC14 | A14 | 0 |
| MC15 | A15 | 0 |
| MC16 | A16 | 0 |
| MC17 | A17 | 0 |
| MC18 | A18 | 0 |
| MC19 | A19 | 0 |
| MC20 | A20 | 0 |
| MC21 | A21 | 0 |
| MC22 | A22 | 0 |
| MC23 | A23 | 0 |
| MC24 | A24 | 0 |
| MC25 | A25 | 0 |
| MC26 | A26 | 0 |
| MC27 | A27 | 0 |
| MC28 | A28 | 0 |
| MC29 | A29 | 0 |
| MC30 | A30 | 0 |
| MC31 | A31 | 0 |
| MC32 | A32 | 0 |
| MC33 | A33 | 0 |
| MC34 | A34 | 0 |
| MC35 | A35 | 0 |
| MC36 | A36 | 0 |
| MC37 | A37 | 0 |
| MC38 | A38 | 0 |
| MC39 | A39 | 0 |
| MC40 | A40 | 0 |

(continued)

| Referred to as: | Ligand L | m |
|---|---|---|
| MC41 | A41 | 0 |
| MC42 | A42 | 0 |
| MC43 | A43 | 0 |
| MC44 | A44 | 0 |
| MC45 | A45 | 0 |
| MC46 | A46 | 0 |
| MC47 | A47 | 0 |
| MC48 | A48 | 0 |
| MC49 | A49 | 0 |
| MC50 | A50 | 0 |
| MC51 | A51 | 0 |
| MC52 | A52 | 0 |
| MC53 | A53 | 0 |
| MC54 | A54 | 0 |
| MC55 | A55 | 0 |
| MC56 | A56 | 0 |
| MC57 | A57 | 0 |
| MC58 | A58 | 0 |
| MC59 | A59 | 0 |
| MC60 | A60 | 0 |
| MC61 | A61 | 0 |
| MC62 | A62 | 0 |
| MC63 | A63 | 0 |
| MC64 | A64 | 0 |
| MC65 | A65 | 0 |
| MC66 | A66 | 0 |
| MC67 | A67 | 0 |
| MC68 | A68 | 0 |
| MC69 | A69 | 0 |
| MC70 | A70 | 0 |
| MC71 | A71 | 0 |
| MC72 | A72 | 0 |
| MC73 | A73 | 0 |
| MC74 | A74 | 0 |
| MC75 | A75 | 0 |
| MC76 | A76 | 0 |
| MC77 | A77 | 0 |
| MC78 | A78 | 0 |
| MC79 | A79 | 0 |

(continued)

| Referred to as: | Ligand L | m |
|---|---|---|
| MC80 | A80 | 0 |
| MC81 | A81 | 0 |
| MC82 | A82 | 0 |
| MC83 | A83 | 0 |
| MC84 | A84 | 0 |
| MC85 | A85 | 0 |
| MC86 | A86 | 0 |
| MC87 | A87 | 0 |
| MC88 | A88 | 0 |
| MC89 | A89 | 0 |
| MC90 | A90 | 0 |
| MC91 | A91 | 0 |
| MC92 | A92 | 0 |
| MC93 | A93 | 0 |
| MC94 | A94 | 0 |
| MC95 | A95 | 0 |
| MC96 | A96 | 0 |
| MC97 | A97 | 0 |
| MC98 | A98 | 0 |
| MC99 | A99 | 0 |
| MC100 | A100 | 0 |
| MC101 | A101 | 0 |
| MC102 | A102 | 0 |
| MC103 | A103 | 0 |
| MC104 | A104 | 0 |
| MC105 | A105 | 0 |
| MC106 | A106 | 0 |
| MC107 | A107 | 0 |
| MC108 | A108 | 0 |
| MC109 | A109 | 0 |
| MC110 | A110 | 0 |
| MC111 | A111 | 0 |
| MC112 | A112 | 0 |
| MC113 | A113 | 0 |
| MC114 | A114 | 0 |
| MC115 | A115 | 0 |
| MC116 | A116 | 0 |
| MC117 | A117 | 0 |
| MC118 | A118 | 0 |

(continued)

| Referred to as: | Ligand L | m |
|---|---|---|
| MC119 | A119 | 0 |
| MC120 | A120 | 0 |
| MC121 | A121 | 0 |
| MC122 | A122 | 0 |
| MC123 | A123 | 0 |
| MC124 | A124 | 0 |
| MC125 | A125 | 0 |
| MC126 | A126 | 0 |
| MC127 | A127 | 0 |
| MC128 | A128 | 0 |
| MC129 | A129 | 0 |
| MC130 | A130 | 0 |
| MC131 | A131 | 0 |
| MC132 | A132 | 0 |
| MC133 | A133 | 0 |
| MC134 | A134 | 0 |
| MC135 | A135 | 0 |
| MC136 | A136 | 0 |
| MC137 | A137 | 0 |
| MC138 | A138 | 0 |
| MC139 | A139 | 0 |
| MC140 | A140 | 0 |
| MC141 | A141 | 0 |
| MC142 | A142 | 0 |
| MC143 | A143 | 0 |
| MC144 | A144 | 0 |
| MC145 | A145 | 0 |
| MC146 | A146 | 0 |
| MC147 | A147 | 0 |
| MC148 | A148 | 0 |
| MC149 | A149 | 0 |
| MC150 | A150 | 0 |
| MC151 | A151 | 0 |
| MC152 | A152 | 0 |
| MC153 | A153 | 0 |
| MC154 | A154 | 0 |
| MC155 | A155 | 0 |
| MC156 | A156 | 0 |
| MC157 | A157 | 0 |

(continued)

| Referred to as: | Ligand L | m |
|---|---|---|
| MC158 | A158 | 0 |
| MC159 | A160 | 0 |
| MC160 | A161 | 0 |
| MC161 | A162 | 0 |
| MC162 | A163 | 0 |
| MC163 | A164 | 0 |
| MC164 | A165 | 0 |
| MC165 | A166 | 0 |
| MC166 | A167 | 0 |
| MC167 | A168 | 0 |
| MC168 | A169 | 0 |
| MC169 | A170 | 0 |
| MC170 | A171 | 0 |
| MC171 | A172 | 0 |
| MC172 | A173 | 0 |
| MC173 | A174 | 0 |
| MC174 | A175 | 0 |
| MC175 | A176 | 0 |
| MC176 | A177 | 0 |
| MC177 | A178 | 0 |
| MC178 | A179 | 0 |
| MC179 | A180 | 0 |
| MC180 | A181 | 0 |
| MC181 | A182 | 0 |
| MC182 | A183 | 0 |
| MC183 | A184 | 0 |
| MC184 | A185 | 0 |
| MC185 | A186 | 0 |
| MC186 | A187 | 0 |
| MC187 | A188 | 0 |
| MC188 | A189 | 0 |
| MC189 | A190 | 0 |
| MC190 | A191 | 0 |
| MC191 | A192 | 0 |
| MC192 | A193 | 0 |
| MC193 | A194 | 0 |
| MC194 | A195 | 0 |
| MC195 | A196 | 0 |
| MC196 | A197 | 0 |

(continued)

| Referred to as: | Ligand L | m |
|---|---|---|
| MC197 | A198 | 0 |
| MC198 | A199 | 0 |
| MC199 | A200 | 0 |
| MC200 | A201 | 0 |
| MC201 | A202 | 0 |
| MC202 | A203 | 0 |
| MC203 | A204 | 0 |
| MC204 | A205 | 0 |
| MC205 | A206 | 0 |
| MC206 | A207 | 0 |
| MC207 | A208 | 0 |
| MC208 | A209 | 0 |
| MC209 | A210 | 0 |
| MC210 | A211 | 0 |
| MC211 | A212 | 0 |
| MC212 | A213 | 0 |
| MC213 | A214 | 0 |
| MC214 | A215 | 0 |
| MC215 | A216 | 0 |
| MC216 | A217 | 0 |
| MC217 | E1 | 0 |
| MC218 | E2 | 0 |
| MC219 | E3 | 0 |
| MC220 | E5 | 0 |
| MC221 | E6 | 0 |
| MC222 | E7 | 0 |
| MC223 | E8 | 0 |
| MC224 | E9 | 0 |
| MC225 | E10 | 0 |
| MC226 | E11 | 0 |
| MC227 | E12 | 0 |
| MC228 | E13 | 0 |
| MC229 | E14 | 0 |
| MC230 | E15 | 0 |
| MC231 | E16 | 0 |
| MC232 | E17 | 0 |
| MC233 | E18 | 0 |
| MC234 | E19 | 0 |
| MC235 | E20 | 0 |

(continued)

| Referred to as: | Ligand L | m |
|---|---|---|
| MC236 | E21 | 0 |
| MC237 | E22 | 0 |
| MC238 | E23 | 0 |
| MC239 | E24 | 0 |
| MC240 | E25 | 0 |
| MC241 | E26 | 0 |
| MC242 | E27 | 0 |
| MC243 | E28 | 0 |
| MC244 | E29 | 0 |
| MC245 | E30 | 0 |
| MC246 | E31 | 0 |
| MC247 | E32 | 0 |
| MC248 | E33 | 0 |
| MC249 | E34 | 0 |
| MC250 | E35 | 0 |
| MC251 | E36 | 0 |
| MC252 | E37 | 0 |
| MC253 | E38 | 0 |
| MC254 | E39 | 0 |
| MC255 | E40 | 0 |
| MC256 | E41 | 0 |
| MC257 | E42 | 0 |
| MC258 | E43 | 0 |
| MC259 | E44 | 0 |
| MC260 | E45 | 0 |
| MC261 | E46 | 0 |
| MC262 | E47 | 0 |
| MC263 | E48 | 0 |
| MC264 | E49 | 0 |
| MC265 | E50 | 0 |
| MC266 | E51 | 0 |
| MC267 | E52 | 0 |
| MC268 | E53 | 0 |
| MC269 | E54 | 0 |
| MC270 | E55 | 0 |
| MC271 | E56 | 0 |
| MC272 | E57 | 0 |
| MC273 | E58 | 0 |
| MC274 | E59 | 0 |

(continued)

| Referred to as: | Ligand L | m |
|---|---|---|
| MC275 | E60 | 0 |
| MC276 | E61 | 0 |
| MC277 | E62 | 0 |
| MC278 | E63 | 0 |
| MC279 | E64 | 0 |
| MC280 | E65 | 0 |
| MC281 | E66 | 0 |
| MC282 | E67 | 0 |
| MC283 | E68 | 0 |
| MC284 | E69 | 0 |
| MC285 | E70 | 0 |
| MC286 | E71 | 0 |
| MC287 | E72 | 0 |
| MC288 | E73 | 0 |
| MC289 | E74 | 0 |
| MC290 | E75 | 0 |
| MC291 | E76 | 0 |
| MC292 | E77 | 0 |
| MC293 | E78 | 0 |
| MC294 | E79 | 0 |
| MC295 | E80 | 0 |
| MC296 | E81 | 0 |
| MC297 | E82 | 0 |
| MC298 | E83 | 0 |
| MC299 | E84 | 0 |
| MC300 | E85 | 0 |
| MC301 | E86 | 0 |
| MC302 | E87 | 0 |
| MC303 | E88 | 0 |
| MC304 | E89 | 0 |
| MC305 | E90 | 0 |
| MC306 | E91 | 0 |
| MC307 | E92 | 0 |
| MC308 | E93 | 0 |
| MC309 | E94 | 0 |
| MC310 | E95 | 0 |
| MC311 | E96 | 0 |
| MC312 | E97 | 0 |
| MC313 | E98 | 0 |

(continued)

| Referred to as: | Ligand L | m |
|---|---|---|
| MC314 | E99 | 0 |
| MC315 | E100 | 0 |
| MC316 | E101 | 0 |
| MC317 | E102 | 0 |
| MC318 | E103 | 0 |
| MC319 | E104 | 0 |
| MC320 | E105 | 0 |
| MC321 | E106 | 0 |
| MC322 | E107 | 0 |
| MC323 | E108 | 0 |
| MC324 | E109 | 0 |
| MC325 | E110 | 0 |
| MC326 | E111 | 0 |
| MC327 | E112 | 0 |
| MC328 | E113 | 0 |
| MC329 | E114 | 0 |
| MC330 | E115 | 0 |
| MC331 | B1 | 0 |
| MC332 | B2 | 0 |
| MC333 | B3 | 0 |
| MC334 | B4 | 0 |
| MC335 | B5 | 0 |
| MC336 | B6 | 0 |
| MC337 | B7 | 0 |
| MC338 | B8 | 0 |
| MC339 | B9 | 0 |
| MC340 | B10 | 0 |
| MC341 | B11 | 0 |
| MC342 | B12 | 0 |
| MC343 | B13 | 0 |
| MC344 | B14 | 0 |
| MC345 | B15 | 0 |
| MC346 | B16 | 0 |
| MC347 | B17 | 0 |
| MC348 | B18 | 0 |
| MC349 | B19 | 0 |
| MC350 | B20 | 0 |
| MC351 | B21 | 0 |
| MC352 | B22 | 0 |

(continued)

| Referred to as: | Ligand L | m |
|---|---|---|
| MC353 | B23 | 0 |
| MC354 | B24 | 0 |
| MC355 | B25 | 0 |
| MC356 | B26 | 0 |
| MC357 | B27 | 0 |
| MC358 | B28 | 0 |
| MC359 | B29 | 0 |
| MC360 | B30 | 0 |
| MC361 | B31 | 0 |
| MC362 | B32 | 0 |
| MC363 | B33 | 0 |
| MC364 | B34 | 0 |
| MC365 | B35 | 0 |
| MC366 | B36 | 0 |
| MC367 | B37 | 0 |
| MC368 | B38 | 0 |
| MC369 | B39 | 0 |
| MC370 | B40 | 0 |
| MC371 | B41 | 0 |
| MC372 | B42 | 0 |
| MC373 | B43 | 0 |
| MC374 | B44 | 0 |
| MC375 | B45 | 0 |
| MC376 | B46 | 0 |
| MC377 | B47 | 0 |
| MC378 | B48 | 0 |
| MC379 | B49 | 0 |
| MC380 | B50 | 0 |
| MC381 | B51 | 0 |
| MC382 | B52 | 0 |
| MC383 | B53 | 0 |
| MC384 | B54 | 0 |
| MC385 | B55 | 0 |
| MC386 | B56 | 0 |
| MC387 | B57 | 0 |
| MC388 | B58 | 0 |
| MC389 | B59 | 0 |
| MC390 | B60 | 0 |
| MC391 | B61 | 0 |

(continued)

| Referred to as: | Ligand L | m |
|---|---|---|
| MC392 | B62 | 0 |
| MC393 | B63 | 0 |
| MC394 | B64 | 0 |
| MC395 | B65 | 0 |
| MC396 | B66 | 0 |
| MC397 | B67 | 0 |
| MC398 | B68 | 0 |
| MC399 | B69 | 0 |
| MC400 | B70 | 0 |
| MC401 | B71 | 0 |
| MC402 | B72 | 0 |
| MC403 | B73 | 0 |
| MC404 | B74 | 0 |
| MC405 | B75 | 0 |
| MC406 | B76 | 0 |
| MC407 | B77 | 0 |
| MC408 | B78 | 0 |
| MC409 | B79 | 0 |
| MC410 | B80 | 0 |
| MC411 | B81 | 0 |
| MC412 | B82 | 0 |
| MC413 | B83 | 0 |
| MC414 | B84 | 0 |
| MC415 | B85 | 0 |
| MC416 | B86 | 0 |
| MC417 | B87 | 0 |
| MC418 | B88 | 0 |
| MC419 | B89 | 0 |
| MC420 | B90 | 0 |
| MC421 | B91 | 0 |
| MC422 | B92 | 0 |
| MC423 | B93 | 0 |
| MC424 | B94 | 0 |
| MC425 | B95 | 0 |
| MC426 | B96 | 0 |
| MC427 | B97 | 0 |
| MC428 | B98 | 0 |
| MC429 | B99 | 0 |
| MC430 | B100 | 0 |

(continued)

| Referred to as: | Ligand L | m |
|---|---|---|
| MC431 | B101 | 0 |
| MC432 | B102 | 0 |
| MC433 | B103 | 0 |
| MC434 | B104 | 0 |
| MC435 | B105 | 0 |
| MC436 | B106 | 0 |
| MC437 | B107 | 0 |
| MC438 | B108 | 0 |
| MC439 | B109 | 0 |
| MC440 | B110 | 0 |
| MC441 | B111 | 0 |
| MC442 | B112 | 0 |
| MC443 | B113 | 0 |
| MC444 | B114 | 0 |
| MC445 | B115 | 0 |
| MC446 | B116 | 0 |
| MC447 | B117 | 0 |
| MC448 | E116 | 0 |
| MC449 | E116-D | 0 |
| MC450 | E117 | 0 |
| MC451 | E118 | 0 |
| MC452 | E119 | 0 |
| MC453 | E120 | 0 |
| MC454 | E121 | 0 |
| MC455 | E122 | 0 |
| MC456 | E123 | 0 |
| MC457 | E124 | 0 |
| MC458 | E125 | 0 |
| MC459 | E126 | 0 |
| MC460 | E127 | 0 |
| MC461 | E128 | 0 |
| MC462 | E129 | 0 |
| MC463 | E130 | 0 |
| MC464 | E131 | 0 |
| MC465 | E132 | 0 |
| MC466 | E133 | 0 |
| MC467 | E134 | 0 |
| MC468 | E135 | 0 |
| MC469 | E136 | 0 |

(continued)

| Referred to as: | Ligand L | m |
|---|---|---|
| MC470 | E137 | 0 |
| MC471 | E138 | 0 |
| MC472 | E139 | 0 |
| MC473 | E140 | 0 |
| MC474 | C1 | 0 |
| MC475 | C2 | 0 |
| MC476 | C3 | 0 |
| MC477 | C4 | 0 |
| MC478 | C5 | 0 |
| MC479 | C6 | 0 |
| MC480 | C7 | 0 |
| MC481 | C8 | 0 |
| MC482 | C9 | 0 |
| MC483 | C10 | 0 |
| MC484 | C11 | 0 |
| MC485 | C12 | 0 |
| MC486 | C13 | 0 |
| MC487 | C14 | 0 |
| MC488 | C15 | 0 |
| MC489 | C16 | 0 |
| MC490 | C17 | 0 |
| MC491 | C18 | 0 |
| MC492 | C19 | 0 |
| MC493 | C20 | 0 |
| MC494 | C21 | 0 |
| MC495 | C22 | 0 |
| MC496 | C23 | 0 |
| MC497 | C24 | 0 |
| MC498 | C25 | 0 |
| MC499 | C26 | 0 |
| MC500 | C27 | 0 |
| MC501 | C28 | 0 |
| MC502 | C29 | 0 |
| MC503 | C30 | 0 |
| MC504 | C31 | 0 |
| MC505 | E141 | 0 |
| MC506 | E141-D | 0 |
| MC507 | E142 | 0 |
| MC508 | E143 | 0 |

(continued)

| Referred to as: | Ligand L | m |
|---|---|---|
| MC509 | E144 | 0 |
| MC510 | E145 | 0 |
| MC511 | E146 | 0 |
| MC512 | E147 | 0 |
| MC513 | E148 | 0 |
| MC514 | E149 | 0 |
| MC515 | E150 | 0 |
| MC516 | E151 | 0 |
| MC517 | E152 | 0 |
| MC518 | E153 | 0 |
| MC519 | E154 | 0 |
| MC520 | E155 | 0 |
| MC521 | E156 | 0 |
| MC522 | E157 | 0 |
| MC523 | E158 | 0 |
| MC524 | E159 | 0 |
| MC525 | E160 | 0 |
| MC526 | E161 | 0 |
| MC527 | E162 | 0 |
| MC528 | E163 | 0 |
| MC529 | E164 | 0 |
| MC530 | E165 | 0 |
| MC531 | D1 | 0 |
| MC532 | D2 | 0 |
| MC533 | D3 | 0 |
| MC534 | D4 | 0 |
| MC535 | D5 | 0 |
| MC536 | D6 | 0 |
| MC537 | D7 | 0 |
| MC538 | D8 | 0 |
| MC539 | D9 | 0 |
| MC540 | D10 | 0 |
| MC541 | D11 | 0 |
| MC542 | D12 | 0 |
| MC543 | D13 | 0 |
| MC544 | D14 | 0 |
| MC545 | D16 | 0 |
| MC546 | D17 | 0 |
| MC547 | D18 | 0 |

(continued)

| Referred to as: | Ligand L | m |
|---|---|---|
| MC548 | D19 | 0 |
| MC549 | D20 | 0 |
| MC550 | D21 | 0 |
| MC551 | D22 | 0 |
| MC552 | D23 | 0 |
| MC553 | D24 | 0 |
| MC554 | D25 | 0 |
| MC555 | D26 | 0 |
| MC556 | D27 | 0 |
| MC557 | D28 | 0 |
| MC558 | D29 | 0 |
| MC559 | D30 | 0 |
| MC560 | D31 | 0 |
| MC561 | D32 | 0 |
| MC562 | D33 | 0 |
| MC563 | D34 | 0 |
| MC564 | D35 | 0 |
| MC565 | D36 | 0 |
| MC566 | D37 | 0 |
| MC567 | D38 | 0 |
| MC568 | D39 | 0 |
| MC569 | D40 | 0 |
| MC570 | D41 | 0 |
| MC571 | D42 | 0 |
| MC572 | D43 | 0 |
| MC573 | D44 | 0 |
| MC574 | D45 | 0 |
| MC575 | D46 | 0 |
| MC576 | D47 | 0 |
| MC577 | D48 | 0 |
| MC578 | D49 | 0 |
| MC579 | D50 | 0 |
| MC580 | D51 | 0 |
| MC581 | D52 | 0 |
| MC582 | D53 | 0 |
| MC583 | D54 | 0 |
| MC584 | D55 | 0 |
| MC585 | D56 | 0 |
| MC586 | D57 | 0 |

(continued)

| Referred to as: | Ligand L | m |
|---|---|---|
| MC587 | D58 | 0 |
| MC588 | D59 | 0 |
| MC589 | D60 | 0 |
| MC590 | D61 | 0 |
| MC591 | D62 | 0 |
| MC592 | D63 | 0 |
| MC593 | D64 | 0 |
| MC594 | D65 | 0 |
| MC595 | D66 | 0 |
| MC596 | D67 | 0 |
| MC597 | D68 | 0 |
| MC598 | D69 | 0 |
| MC599 | D70 | 0 |
| MC600 | D71 | 0 |
| MC601 | D72 | 0 |
| MC602 | D73 | 0 |
| MC603 | D74 | 0 |
| MC604 | D75 | 0 |
| MC605 | D76 | 0 |
| MC606 | D77 | 0 |
| MC607 | D78 | 0 |
| MC608 | D79 | 0 |
| MC609 | D80 | 0 |
| MC610 | D81 | 0 |
| MC611 | D82 | 0 |
| MC612 | D83 | 0 |
| MC613 | E166 | 0 |
| MC614 | E167 | 0 |
| MC615 | E168 | 0 |
| MC616 | E169 | 0 |
| MC617 | E170 | 0 |
| MC618 | E171 | 0 |
| MC619 | E172 | 0 |
| MC620 | E173 | 0 |

According to one embodiment, the metal complex of formula (I) or (Ia) is selected from the following:

| Referred to as: | Ligand L | m |
|---|---|---|
| MC1 | A1 | 0 |
| MC9 | A9 | 0 |

(continued)

| Referred to as: | Ligand L | m |
|---|---|---|
| MC53 | A53 | 0 |
| MC85 | A85 | 0 |
| MC158 | A158 | 0 |
| MC159 | A160 | 0 |
| MC160 | A161 | 0 |
| MC163 | A164 | 0 |
| MC165 | A166 | 0 |
| MC167 | A168 | 0 |
| MC168 | A169 | 0 |
| MC169 | A170 | 0 |
| MC170 | A171 | 0 |
| MC173 | A174 | 0 |
| MC176 | A177 | 0 |
| MC177 | A178 | 0 |
| MC179 | A180 | 0 |
| MC18 | A182 | 0 |
| MC183 | A184 | 0 |
| MC184 | A185 | 0 |
| MC187 | A188 | 0 |
| MC190 | A191 | 0 |
| MC193 | A194 | 0 |
| MC198 | A199 | 0 |
| MC200 | A201 | 0 |
| MC201 | A202 | 0 |
| MC203 | A204 | 0 |
| MC206 | A207 | 0 |
| MC211 | A212 | 0 |
| MC217 | E1 | 0 |
| MC219 | E3 | 0 |
| MC22 | E5 | 0 |
| MC221 | E6 | 0 |
| MC222 | E7 | 0 |
| MC225 | E10 | 0 |
| MC226 | E11 | 0 |
| MC228 | E13 | 0 |
| MC229 | E14 | 0 |
| MC230 | E15 | 0 |
| MC231 | E16 | 0 |
| MC255 | E40 | 0 |

(continued)

| Referred to as: | Ligand L | m |
|---|---|---|
| MC256 | E41 | 0 |
| MC257 | E43 | 0 |
| MC258 | E44 | 0 |
| MC259 | E45 | 0 |
| MC260 | E47 | 0 |
| MC263 | E48 | 0 |
| MC270 | E55 | 0 |
| MC272 | E57 | 0 |
| MC283 | E68 | 0 |
| MC289 | E74 | 0 |
| MC331 | B1 | 0 |
| MC335 | B5 | 0 |
| MC339 | B9 | 0 |
| MC344 | B14 | 0 |
| MC347 | B17 | 0 |
| MC360 | B30 | 0 |
| MC363 | B33 | 0 |
| MC401 | B71 | 0 |
| MC413 | B83 | 0 |
| MC414 | B84 | 0 |
| MC433 | B103 | 0 |
| MC439 | B109 | 0 |
| MC440 | B110 | 0 |
| MC441 | B111 | 0 |
| MC442 | B112 | 0 |
| MC443 | B113 | 0 |
| MC444 | B114 | 0 |
| MC445 | B115 | 0 |
| MC446 | B116 | 0 |
| MC447 | B117 | 0 |
| MC448 | E116 | 0 |
| MC449 | E116-D | 0 |
| MC450 | E117 | 0 |
| MC451 | E118 | 0 |
| MC452 | E119 | 0 |
| MC457 | E124 | 0 |
| MC471 | E138 | 0 |
| MC474 | C1 | 0 |
| MC475 | C2 | 0 |

(continued)

| Referred to as: | Ligand L | m |
|---|---|---|
| MC476 | C3 | 0 |
| MC477 | C4 | 0 |
| MC478 | C5 | 0 |
| MC479 | C6 | 0 |
| MC480 | C7 | 0 |
| MC481 | C8 | 0 |
| MC482 | C9 | 0 |
| MC483 | C10 | 0 |
| MC484 | C11 | 0 |
| MC485 | C12 | 0 |
| MC486 | C13 | 0 |
| MC487 | C14 | 0 |
| MC488 | C15 | 0 |
| MC489 | C16 | 0 |
| MC490 | C17 | 0 |
| MC491 | C18 | 0 |
| MC492 | C19 | 0 |
| MC493 | C20 | 0 |
| MC494 | C21 | 0 |
| MC495 | C22 | 0 |
| MC496 | C23 | 0 |
| MC497 | C24 | 0 |
| MC498 | C25 | 0 |
| MC499 | C26 | 0 |
| MC500 | C27 | 0 |
| MC501 | C28 | 0 |
| MC502 | C29 | 0 |
| MC503 | C30 | 0 |
| MC504 | C31 | 0 |
| MC505 | E141 | 0 |
| MC506 | E141-D | 0 |
| MC507 | E142 | 0 |
| MC508 | E143 | 0 |
| MC509 | E144 | 0 |
| MC514 | E149 | 0 |
| MC611 | D82 | 0 |
| MC612 | D83 | 0 |
| MC613 | E166 | 0 |
| MC614 | E167 | 0 |

According to one embodiment, the metal complex of formula (I) or (Ia) is selected from the following:

| Referred to as: | Ligand L | m |
|---|---|---|
| MC53 | A53 | 0 |
| MC211 | A212 | 0 |
| MC217 | E1 | 0 |
| MC220 | E5 | 0 |
| MC225 | E10 | 0 |
| MC226 | E11 | 0 |
| MC228 | E13 | 0 |
| MC229 | E14 | 0 |
| MC230 | E15 | 0 |
| MC231 | E16 | 0 |
| MC255 | E40 | 0 |
| MC256 | E41 | 0 |
| MC258 | E43 | 0 |
| MC259 | E44 | 0 |
| MC260 | E45 | 0 |
| MC262 | E47 | 0 |
| MC270 | E55 | 0 |
| MC272 | E57 | 0 |
| MC283 | E68 | 0 |
| MC289 | E74 | 0 |
| MC444 | B114 | 0 |
| MC445 | B115 | 0 |
| MC446 | B116 | 0 |
| MC447 | B117 | 0 |
| MC451 | E118 | 0 |
| MC452 | E119 | 0 |
| MC457 | E124 | 0 |
| MC471 | E138 | 0 |
| MC474 | C1 | 0 |
| MC486 | C13 | 0 |
| MC501 | C28 | 0 |
| MC502 | C29 | 0 |
| MC503 | C30 | 0 |
| MC504 | C31 | 0 |
| MC505 | E141 | 0 |
| MC506 | E141-D | 0 |
| MC507 | E142 | 0 |
| MC508 | E143 | 0 |
| MC509 | E144 | 0 |

(continued)

| Referred to as: | Ligand L | m |
|---|---|---|
| MC514 | E149 | 0 |

Organic electronic device

In the following the setup and/or further components of organic electronic device will be described in more detail whereby all features can be combined *ad libitum* wherever possible or useful:

According to an embodiment, wherein the organic electronic device comprises a *photoactive layer,* which can be a light-absorbing layer or light-emitting layer in particular a light-emitting layer
According to an embodiment, wherein the semiconductor layer further comprises a hole transport matrix compound.

According to an embodiment, wherein the semiconductor layer is a hole injection layer. hole transport layer, or a hole extraction layer.
According to an embodiment, wherein the semiconductor layer is a hole injection layer, or a hole extraction layer.
According to an embodiment, wherein the semiconductor layer is a hole injection layer.
According to an embodiment, wherein the organic electronic device comprises a substrate, an anode layer formed on the substrate, a semiconductor layer comprising the metal complex of Formula (I), a hole transport layer, a photoactive layer, an electron transport layer, and a cathode layer.
According to an embodiment, wherein the organic electronic device comprises a substrate, an anode layer formed on the substrate, a semiconductor layer comprising the metal complex of Formula (I), a hole transport layer, an electron blocking layer, a photoactive layer, a hole blocking layer, an electron transport layer, cathode layer.
According to an embodiment, wherein the organic electronic device comprises a substrate, an anode layer formed on the substrate, a semiconductor layer comprising the metal complex of Formula (I), a hole transport layer, an electron blocking layer, a photoactive layer, a hole blocking layer, an electron transport layer, an electron injection layer, and a cathode layer.
According to one embodiment of the present invention, the first electrode of the organic electronic device is an anode and the second electrode is a cathode.
According to an embodiment of the present invention, the organic semiconductor layer is arranged adjacent to the anode layer, preferably the organic semiconductor layer is arranged in direct contact with the anode layer.
According to an embodiment, wherein the organic electronic device comprises a photoactive layer, and wherein the organic semiconductor layer is arranged adjacent to the anode layer, preferably the organic semiconductor layer is arranged in direct contact with the anode layer.
According to an embodiment, the semiconductor layer comprises a hole transport matrix compound.
According to an embodiment, wherein the organic electronic device comprises a photoactive layer, the first electrode is an anode electrode and the second electrode is a cathode electrode; wherein preferably the semiconductor layer is a hole injection layer.
According to an embodiment, wherein the organic electronic device comprises a photoactive layer, the first electrode is an anode electrode and the second electrode is a cathode electrode, wherein the hole injection layer is in direct contact to the anode electrode; wherein preferably the semiconductor layer is a hole injection layer.
According to an embodiment, wherein the organic electronic device comprises a photoactive layer, a substrate, the first electrode is an anode electrode and the second electrode is a cathode electrode; wherein preferably the semiconductor layer is a hole injection layer; wherein .
According to an embodiment, wherein the photoactive layer is a light-emitting layer.

Semiconductor layer

Another aspect of the present invention is related to a semiconductor layer comprising a metal complex of Formula (I).
All specification and embodiments shown for the metal complex of formula (I) and its individual moieties apply *mutatis mutandis.*
According to one embodiment of the present invention, the semiconductor layer is a hole transport layer.
According to one embodiment of the present invention, the semiconductor layer is a hole injection layer.
According to one embodiment of the present invention, the semiconductor layer is a hole extraction layer.
According to one embodiment of the present invention, the semiconductor layer is adjacent or in direct contact to

an anode layer.

According to one embodiment of the present invention, the semiconductor layer is in direct contact to an anode layer.

According to an embodiment, the semiconductor layer furthermore comprises a hole transport matrix compound.

This hole transport compound can be a covalent or substantially covalent matrix compound.

Substantially covalent matrix compound/ covalent matrix compound

The substantially covalent matrix compound, also named matrix compound, may be an organic aromatic matrix compound, which comprises organic aromatic covalent bonded carbon atoms. The substantially covalent matrix compound may be an organic compound, consisting substantially from covalently bound C, H, O, N, S, which may optionally comprise also covalently bound B, P or Si. The substantially covalent matrix compound may be an organic aromatic covalent bonded compound, which is free of metal atoms, and the majority of its skeletal atoms may be selected from C, O, S, N and preferably from C, O and N, wherein the majority of atoms are C-atoms. Alternatively, the covalent matrix compound is free of metal atoms and majority of its skeletal atoms may be selected from C and N, preferably the covalent matrix compound is free of metal atoms and majority of its skeletal atoms may be selected from C and the minority of its skeletal atoms may be N.

According to one embodiment, the substantially covalent matrix compound may have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol, also preferred a molecular weight Mw of ≥ 600 and ≤ 800 g/mol.

In one embodiment, the HOMO level of the substantially covalent matrix compound may be more negative than the HOMO level of N2,N2,N2',N2',N7,N7,N7',N7'-octakis(4-methoxyphenyl)-9,9'-spirobi[fluorene]-2,2',7,7'-tetraamine (CAS 207739-72-8) when determined under the same conditions.

In one embodiment of the present invention, the substantially covalent matrix compound may be free of alkoxy groups.

Preferably, the substantially covalent matrix compound comprises at least one arylamine moiety, alternatively a diarylamine moiety, alternatively a triarylamine moiety.

Preferably, the substantially covalent matrix compound is free of TPD or NPB.

Compound of formula (IIIa) or a compound of formula (IIIb)

According to another aspect of the present invention, the substantially covalent matrix compound or covalent matrix compound, also referred to as matrix compound herein, may comprises at least one arylamine compound, diarylamine compound, triarylamine compound, a compound of formula (IIIa) or a compound of formula (IIIb):

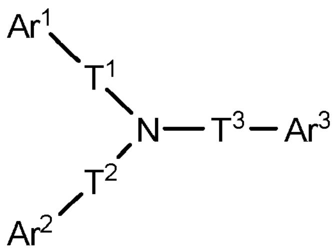 (IIIa), 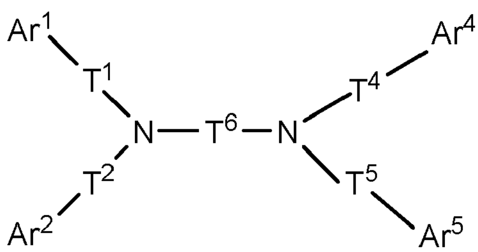 (IIIb),

wherein:

| | |
|---|---|
| $T^1$, $T^2$, $T^3$, $T^4$ and $T^5$ | are independently selected from a single bond, phenylene, biphenylene, terphenylene or naphthenylene, preferably a single bond or phenylene; |
| $T^6$ | is phenylene, biphenylene, terphenylene or naphthenylene; |
| $Ar^1$, $Ar^2$, $Ar^3$, $Ar^4$ and $Ar^5$ | are independently selected from substituted or unsubstituted $C_6$ to $C_{20}$ aryl, or substituted or unsubstituted $C_3$ to $C_{20}$ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofur- |

ane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;

wherein
the substituents of $Ar^1$, $Ar^2$, $Ar^3$, $Ar^4$ and $Ar^5$ are selected the same or different from the group comprising H, D, F, $C(-O)R^2$, CN, $Si(R^2)_3$, $P(-O)(R^2)_2$, $OR^2$, $S(-O)R^2$, $S(-O)_2R^2$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted substituted or unsubstituted aromatic ring systems having 6 to 40 aromatic Atoms, and substituted or unsubstituted heteroaromatic ring systems having 5 to 40 aromatic Atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle, wherein $R^2$ may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl.

Preferably, the substituents of $Ar^1$, $Ar^2$, $Ar^3$, $Ar^4$ and $Ar^5$ are selected the same or different from the group comprising H, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl, $C_3$ to $C_{18}$ heteroaryl, a fused ring system comprising 2 to 4 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle; more preferred the substituents are selected the same or different from the group consisting of H, straight-chain alkyl having 1 to 4 carbon atoms, branched alkyl having 1 to 4 carbon atoms, cyclic alkyl having 3 to 4 carbon atoms and/or phenyl.

Thereby, the compound of formula (IIIa) or (IIIb) may have a rate onset temperature suitable for mass production.

According to an embodiment the substantially covalent matrix compound comprises a compound of formula (IIIa) or formula (IIIb):

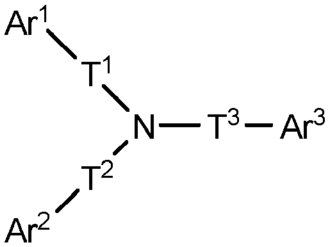
(IIIa),
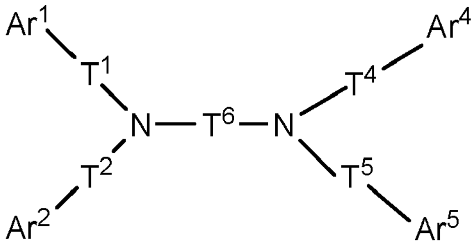
(IIIb),

wherein

| | |
|---|---|
| $T^1$, $T^2$, $T^3$, $T^4$ and $T^5$ | may be independently selected from a single bond, phenylene, biphenylene, terphenylene or naphthenylene, preferably a single bond or phenylene; |
| $T^6$ | is phenylene, biphenylene, terphenylene or naphthenylene; |
| $Ar^1$, $Ar^2$, $Ar^3$, $Ar^4$ and $Ar^5$ | may be independently selected from unsubstituted $C_6$ to $C_{20}$ aryl, or unsubstituted $C_3$ to $C_{20}$ heteroarylene, unsubstituted biphenylene, unsubstituted fluorene, substituted 9-fluorene, substituted 9,9-fluorene, unsubstituted naphthalene, unsubstituted anthracene, unsubstituted phenanthrene, unsubstituted pyrene, unsubstituted perylene, unsubstituted tri- |

phenylene, unsubstituted tetracene, unsubstituted tetraphene, unsubstituted dibenzofurane, unsubstituted dibenzothiophene, unsubstituted xanthene, unsubstituted carbazole, substituted 9-phenylcarbazole, unsubstituted azepine, unsubstituted dibenzo[b,f]azepine, unsubstituted 9,9'-spirobi[fluorene], unsubstituted spiro[fluorene-9,9'-xanthene], or a unsubstituted aromatic fused ring system comprising at least three unsubstituted aromatic rings selected from the group comprising unsubstituted non-hetero, unsubstituted hetero 5-member rings, unsubstituted 6-member rings and/or unsubstituted 7-member rings, unsubstituted fluorene, or a fused ring system comprising 2 to 6 unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle.

According to an embodiment, the substantially covalent matrix compound comprises a compound of formula (IIIa) or formula (IIIb):

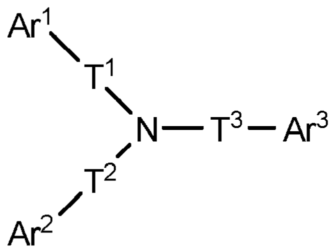
(IIIa),

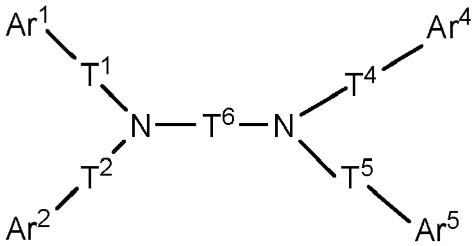
(IIIb),

wherein

| | |
|---|---|
| $T^1$, $T^2$, $T^3$, $T^4$ and $T^5$ | may be independently selected from a single bond, phenylene, biphenylene, terphenylene or naphthenylene, preferably a single bond or phenylene; |
| $T^6$ | is phenylene, biphenylene, terphenylene or naphthenylene; |
| $Ar^1$, $Ar^2$, $Ar^3$, $Ar^4$ and $Ar^5$ | may be independently selected from unsubstituted $C_6$ to $C_{20}$ aryl, or unsubstituted $C_3$ to $C_{20}$ heteroarylene, unsubstituted biphenylene, unsubstituted fluorene, substituted 9-fluorene, substituted 9,9-fluorene, unsubstituted naphthalene, unsubstituted anthracene, unsubstituted phenanthrene, unsubstituted pyrene, unsubstituted perylene, unsubstituted triphenylene, unsubstituted tetracene, unsubstituted tetraphene, unsubstituted dibenzofurane, unsubstituted dibenzothiophene, unsubstituted xanthene, unsubstituted carbazole, substituted 9-phenylcarbazole, unsubstituted azepine, unsubstituted dibenzo[b,f]azepine, unsubstituted 9,9'-spirobi[fluorene], unsubstituted spiro[fluorene-9,9'-xanthene]. |

Thereby, the compound of formula (IIIa) or (IIIb) may have a rate onset temperature suitable for mass production.

According to an embodiment wherein $T^1$, $T^2$, $T^3$, $T^4$ and $T^5$ may be independently selected from a single bond, phenylene, biphenylene or terphenylene.

According to an embodiment wherein $T^1$, $T^2$, $T^3$, $T^4$ and $T^5$ may be independently selected from phenylene, biphenylene or terphenylene and one of $T^1$, $T^2$, $T^3$, $T^4$ and $T^5$ are a single bond.

According to an embodiment wherein $T^1$, $T^2$, $T^3$, $T^4$ and $T^5$ may be independently selected from phenylene or biphenylene and one of $T^1$, $T^2$, $T^3$, $T^4$ and $T^5$ are a single bond.

According to an embodiment wherein $T^1$, $T^2$, $T^3$, $T^4$ and $T^5$ may be independently selected from phenylene or biphenylene and two of $T^1$, $T^2$, $T^3$, $T^4$ and $T^5$ are a single bond.

According to an embodiment wherein $T^1$, $T^2$ and $T^3$ may be independently selected from phenylene and one of $T^1$, $T^2$ and $T^3$ are a single bond.

According to an embodiment wherein $T^1$, $T^2$ and $T^3$ may be independently selected from phenylene and two of $T^1$, $T^2$ and $T^3$ are a single bond.

According to an embodiment wherein $T^6$ may be phenylene, biphenylene, terphenylene. According to an embodiment wherein $T^6$ may be phenylene.

According to an embodiment wherein $T^6$ may be biphenylene. According to an embodiment wherein $T^6$ may be terphenylene.

According to an embodiment wherein $Ar^1$, $Ar^2$, $Ar^3$, $Ar^4$ and $Ar^5$ may be independently selected from formulae (G1) to (G16):

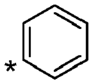 (G1), 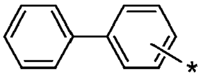 (G2), 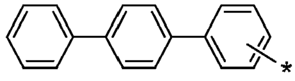 (G3), 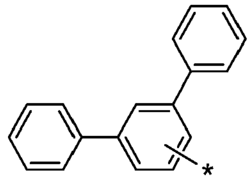 (G4),

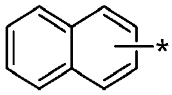 (G5), 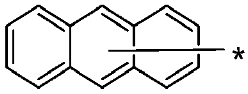 (G6), 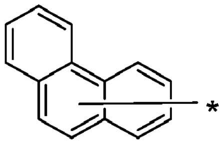 (G7), 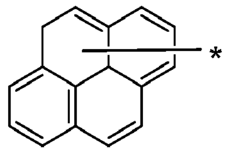 (G8),

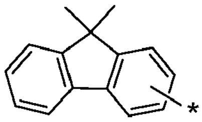 (G9), 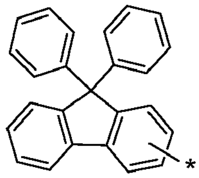 (G10), 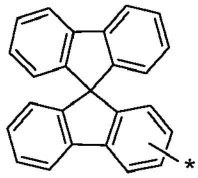 (G11),

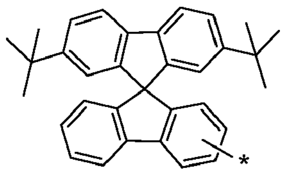 (G12), 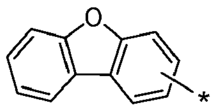 (G13), 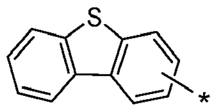 (G14),

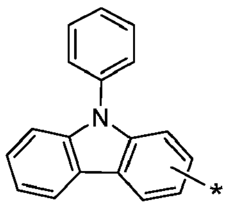 (G15), 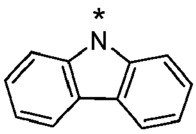 (G16),

wherein the asterix "*" denotes the binding position.

According to an embodiment, wherein $Ar^1$, $Ar^2$, $Ar^3$, $Ar^4$ and $Ar^5$ may be independently selected from (G1) to (G15); alternatively selected from (G1) to (G10) and (G13) to (G15).

According to an embodiment, wherein $Ar^1$, $Ar^2$, $Ar^3$, $Ar^4$ and $Ar^5$ may be independently selected from the group consisting of (G1), (G2), (G5), (G7), (G9), (G10), (G13) to (G16).

The rate onset temperature may be in a range particularly suited to mass production, when $Ar^1$, $Ar^2$, $Ar^3$, $Ar^4$ and $Ar^5$ are selected in this range.

The "matrix compound of formula (IIIa) or formula (IIIb) " may be also referred to as "hole transport compound".

According to one embodiment the compound of formula (IIIa) or formula (IIIb) may comprises at least ≥ 1 to ≤ 6 substituted or unsubstituted aromatic fused ring systems comprising heteroaromatic rings.

According to one embodiment the compound of formula (IIIa) or formula (IIIb) may comprises at least ≥ 1 to ≤ 6 substituted or unsubstituted aromatic fused ring systems comprising heteroaromatic rings and at least ≥ 1 to ≤ 3 substituted or unsubstituted unsaturated 5- to 7-member ring of a heterocycle, preferably ≥ 2 to ≤ 5 substituted or unsubstituted aromatic fused ring systems comprising heteroaromatic rings.

According to one embodiment the compound of formula (IIIa) or formula (IIIb) may comprises at least ≥ 1 to ≤ 6 substituted or unsubstituted aromatic fused ring systems comprising heteroaromatic rings and at least ≥ 1 to ≤ 3 substituted or unsubstituted unsaturated 5- to 7-member ring of a heterocycle, preferably ≥ 2 to ≤ 5 substituted or unsubstituted aromatic fused ring systems comprising heteroaromatic rings, and at least ≥ 1 to ≤ 3 substituted or unsubstituted unsaturated 5- to 7-member ring of a heterocycle, further preferred 3 or 4 substituted or unsubstituted

aromatic fused ring systems comprising heteroaromatic rings and optional at least ≥ 1 to ≤ 3 substituted or unsubstituted unsaturated 5- to 7-member ring of a heterocycle, and additional preferred wherein the aromatic fused ring systems comprising heteroaromatic rings are unsubstituted and optional at least ≥ 1 to ≤ 3 unsubstituted unsaturated 5- to 7-member ring of a heterocycle.

According to one embodiment the compound of formula (IIIa) or formula (IIIb) may comprise:

- a substituted or unsubstituted aromatic fused ring systems with at least ≥ 2 to ≤ 6, preferably ≥ 3 to ≤ 5, or 4 fused aromatic rings selected from the group comprising substituted or unsubstituted non-hetero aromatic rings, substituted or unsubstituted hetero 5-member rings, substituted or unsubstituted 6-member rings and/or substituted or unsubstituted unsaturated 5-to 7- member ring of a heterocycle; or
- an unsubstituted aromatic fused ring systems with at least ≥ 2 to ≤ 6, preferably ≥ 3 to ≤ 5, or 4 fused aromatic rings selected from the group comprising unsubstituted non-hetero aromatic rings, unsubstituted hetero 5-member rings, unsubstituted 6-member rings and/or unsubstituted unsaturated 5- to 7-member ring of a heterocycle.

It should be noted here that the wording "aromatic fused ring system" may include at least one aromatic and at least one substituted or unsubstituted unsaturated 5- to 7- member ring. It should be noted here that the substituted or unsubstituted unsaturated 5- to 7- member ring may not be an aromatic ring.

According to one embodiment, the substantially covalent matrix compound comprises at least one naphthyl group, carbazole group, dibenzofurane group, dibenzothiophene group and/or substituted fluorenyl group, wherein the substituents are independently selected from methyl, phenyl or fluorenyl.

According to an embodiment of the present invention, the compound of formula (IIIa) or formula (IIIb) are selected from formulae (F1) to (F23):

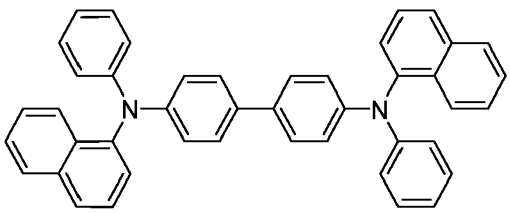
(F1),

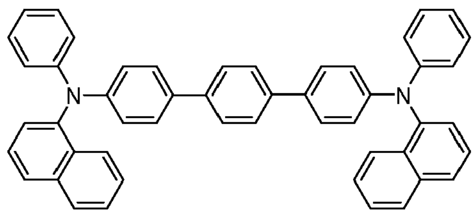
(F2),

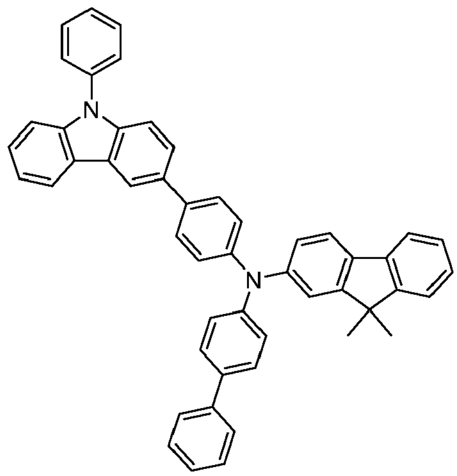
(F3),

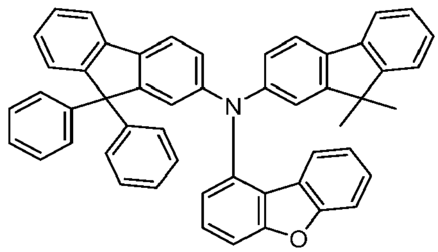
(F4),

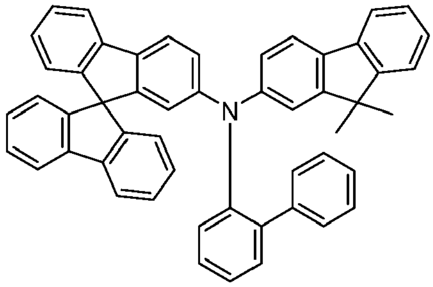
(F5),

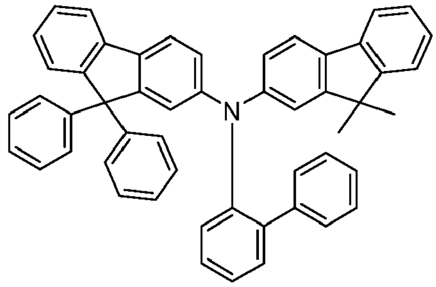
(F6),

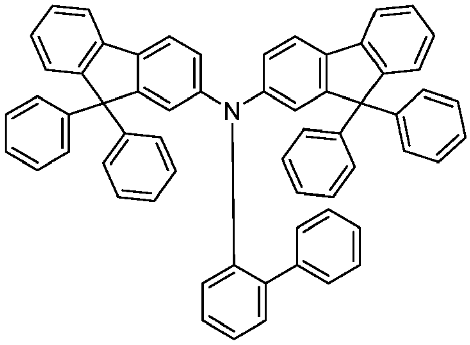 (F7), 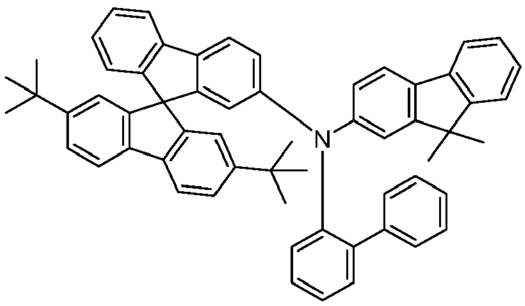 (F8),

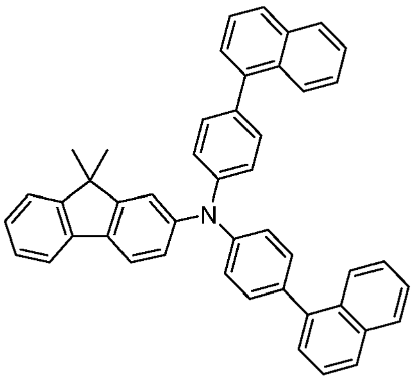 (F9), 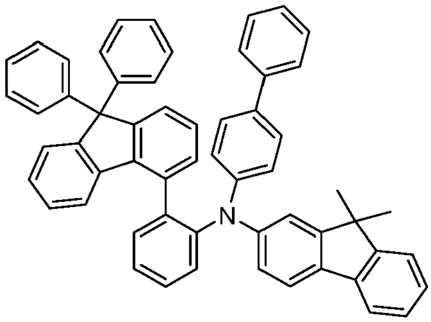 (F10),

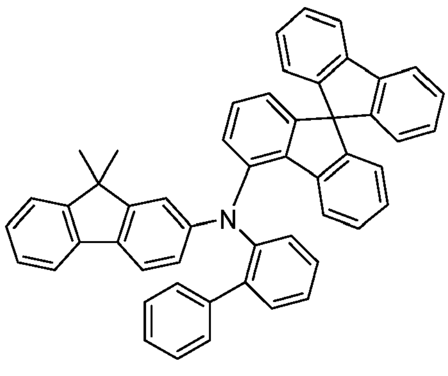 (F11), 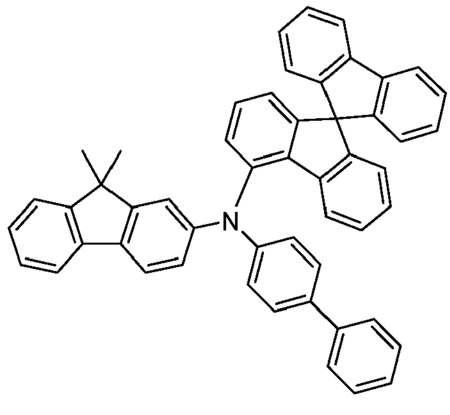 (F12),

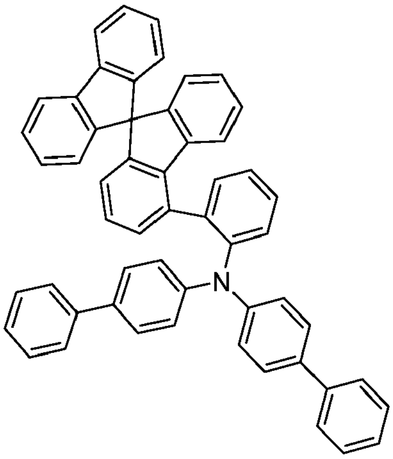 (F13), 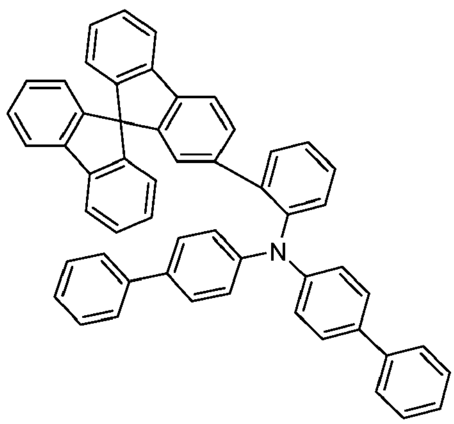 (F14),

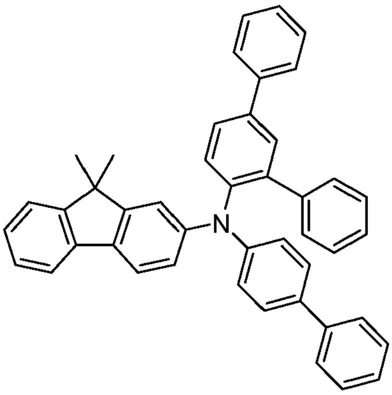 (F15),

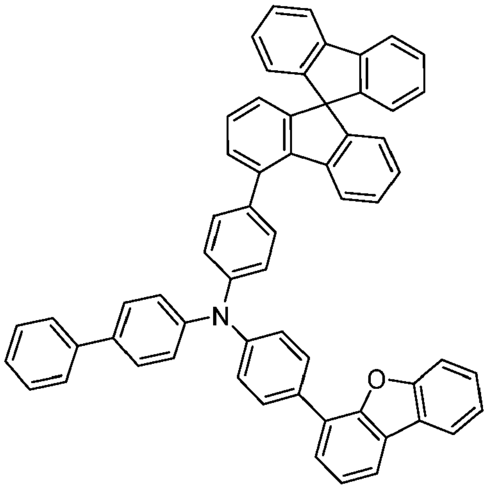 (F16),

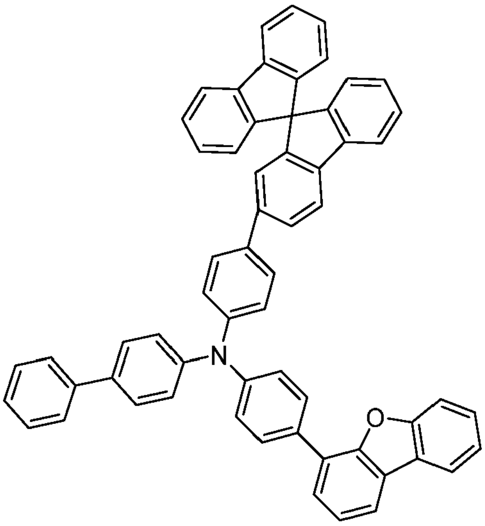 (F17)

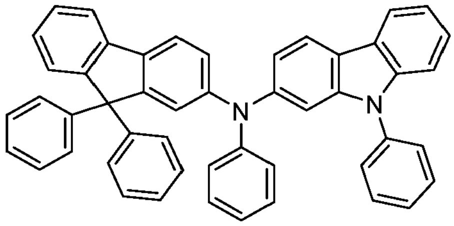 (F18)

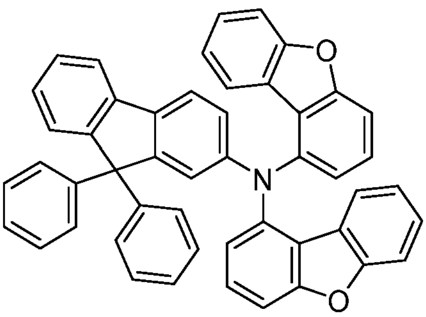 (F19),

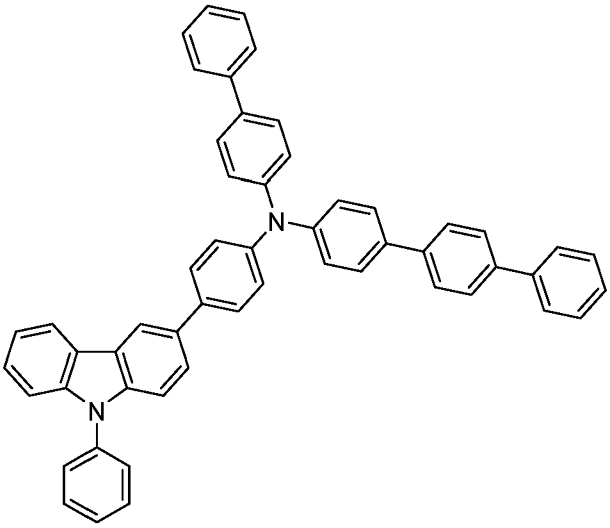 (F20),

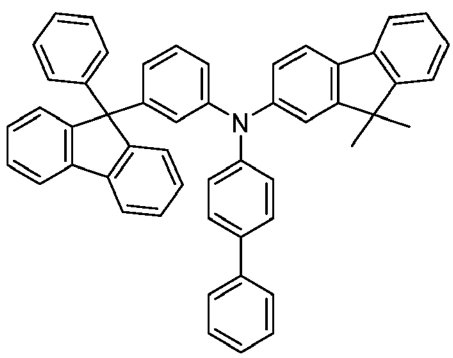 (F21), 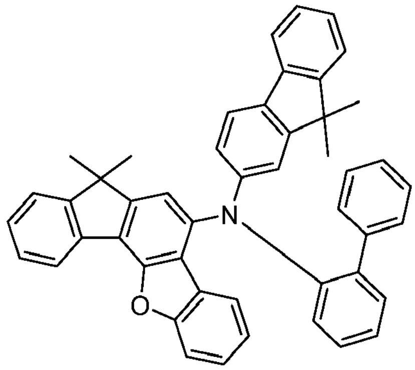 (F22),

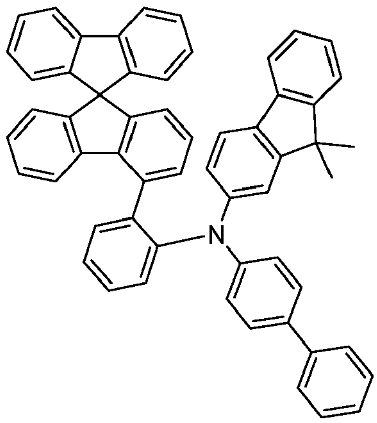 (F23);

preferably the compound of formula (IIIa) or formula (IIIb) is selected from formulae (F3) to (F23), more preferred from (F4) to (F23), most preferred from (F18).

Organic light emitting device device

According to one aspect of the present invention, the organic electronic device is is an organic light emitting device (OLED).

According to an embodiment said organic electronic device comprises

an anode layer, a cathode layer, a light-emitting layer, a cathode layer, a semiconductor layer;
wherein preferabyl the semiconductor layer is arranged between the anode layer and the light-emitting layer;
wherein the semiconductor layer comprises the metal complex of Formula (I).

The organic light emitting device converts an electrical current into photons.

According to one embodiment said organic electronic device comprises

an anode layer, a cathode layer, a hole transport region, a light-emitting layer a cathode layer, a semiconductor layer;
wherein the hole transport region and the light-emitting layer are arranged between the anode layer and the cathode layer;
wherein the hole transport region is arranged between the anode layer and the organic light-emitting layer;
wherein the semiconductor layer is arranged between the anode layer and the hole transport region;
wherein the semiconductor layer comprises the metal complex of Formula (I).

The hole transport region may comprise a hole transport layer, and/or electron blocking layer.

According to one aspect of the present invention, there is provided an organic light-emitting diode (OLED) comprising: a substrate; an anode layer formed on the substrate; a semiconductor layer comprising a metal complex of Formula (I), a hole transport layer, an emission layer, an electron transport layer and a cathode layer.

According to another aspect of the present invention, there is provided an OLED comprising: a substrate; an anode layer formed on the substrate; a semiconductor layer comprising a metal complex of Formula (I), a hole transport

layer, an electron blocking layer, an emission layer, a hole blocking layer, an electron transport layer and a cathode layer.

According to another aspect of the present invention, there is provided an OLED comprising: a substrate; an anode layer formed on the substrate; a semiconductor layer comprising a metal complex of Formula (I), a hole transport layer, an electron blocking layer, an emission layer, a hole blocking layer, an electron transport layer, an electron injection layer, and a cathode layer.

According to one embodiment of the present invention, the organic light-emitting device is an electroluminescent device, an organic light emitting diode (OLED) or a light emitting device.

According to one aspect, the OLED may comprise a layer structure of a substrate that is adjacent arranged to an anode electrode, the anode electrode is adjacent arranged to a first hole injection layer, a semiconductor layer comprising a metal complex of Formula (I), wherein the semiconductor layer is a first hole injection layer is adjacent arranged to a first hole transport layer, the first hole transport layer is adjacent arranged to a first electron blocking layer, the first electron blocking layer is adjacent arranged to a first emission layer, the first emission layer is adjacent arranged to a first electron transport layer, the first electron transport layer is adjacent arranged to an n-type charge generation layer, the n-type charge generation layer is adjacent arranged to a p-type charge generation layer, the p-type charge generation layer is adjacent arranged to a second hole transport layer, the second hole transport layer is adjacent arranged to a second electron blocking layer, the second electron blocking layer is adjacent arranged to a second emission layer, between the second emission layer and the cathode electrode an optional electron transport layer and/or an optional injection layer are arranged.

The p-type charge generation layer may comprise a metal complex of Formula (I).

The semiconductor layer and the p-type charge generation layer may comprise the same or a different metal complex of Formula (I); wherein the semiconductor layer is a hole injection layer.

Photoconversion unit /Organic photodetector

According to one aspect of the present invention, the organic electronic device is an organic photodetector and/or comprises a photoconversion unit.

In the following the further components of the photoconversion unit and/or the organic photodetector will be described in more detail whereby all features can be combined *ad libitum -.*

The photoconversion unit converts photons into an electrical current.

The photoconversion unit may be formed by vacuum deposition, spin coating, slot-die coat-ing, printing, casting, LB deposition, or the like. When the photoconversion unit is formed using vacuum deposition or spin coating, the conditions for deposition and coating may be similar to those for the formation of the HIL (cf. later). However, the conditions for deposition and coating may vary, according to the actual embodiments used.

According to an embodiment, wherein the semiconductor layer of the organic photodetector is a hole injection layer, hole transport layer, or hole extraction layer.

According to an embodiment, wherein the semiconductor layer of the organic photodetector is a hole injection layer, or hole extraction layer.

According to an embodiment, wherein the semiconductor layer of the organic photodetector is a hole extraction layer.

According to an embodiment, wherein the organic photodetector further comprises an electron blocking layer.

According to an embodiment, wherein the organic photodetector comprises a hole extraction layer, wherein the hole extraction layer comprises a metal complex of Formula (I) or Formula (Ia), wherein the hole extraction layer is arranged adjacent or in direct contact to the photoconversion unit; preferably in direct contact to the photoconversion unit.

According to an embodiment, the organic photodetector has a dark current density of $-1\times10^{-4}$ mA/cm or less when a reverse Bias of $-3V\pm0.05$ is applied.

The dark current density of an organic photodetector may be measured in dark conditions by applying a voltage at $-3V\pm0.05$.

The dark current density of an organic photodetector may be measured in dark conditions by applying a voltage at $-3V\pm0.05$, wherein the positive pol of the current-voltage measurement device is connected to the anode layer of the organic photodetector, and wherein the negative pol of the current-voltage measurement device is connected to the cathode layer of the organic photodetector.

The voltage may be applied for a period of at least one second before the current is measured.

The minimum measurement time of the current is selected so that the effects of current fluctuations in the external grid on the measured value disappear.

The "dark current density" is the current density which is determined when the organic photodetector is not exposed to light.

The organic photodetector messured may have an area size from 0.01 $mm^2$ - 30 $mm^2$, preferably 2.0 $mm^2$ to 10.0 $mm^2$, more preferably 4.0 to 7.0 $mm^2$, and most preferably 6.0 $mm^2$ to 7.0 $mm^2$.

The area size of the organic photodetector is determined by the area wherein the anode layer, cathode layer, and the layers between the anode layer and the cathode layer overlaps.

In the overlap of the area anode layer, cathode layer, and the layer between the anode layer and cathode layer are stacked on top of each other. The anode layer area may be defined by a pixel definition layer aperture like shown in figures 21/22.

For the measurement of the dark current density, the organic photodetector may be encapsulated. The encapsulation of the organic photodetector may be a thin film encapsulation or an encapsulation lid, wherein the encapsulation lid provides a cavity, which includes a getter material. In particular, the encapsulation lid is a glass lid.

The applying of the voltage and the measurement of the current may be conducted by means of a Keithley SM2635B.

When using a Keithley SM2635B, the voltage may be applied for a period of at least one second before the current is measured with a minimum measurement time of the current, wherein the minimum measurement time of the current is selected so that the effects of the current fluctuations in the external grid on the measured value disappear.

When using a Keithley SM2635B, the minimum measurement time of the current is at least 5 NPLC (Number of Power Line-Cycles).According to an embodiment, wherein the organic photodetector comprises a hole transport region; preferably the hole transport region comprises a hole transport layer.

According to an embodiment, wherein the hole transport region of the organic photodetector comprises a hole injection layer.

According to an embodiment, wherein the hole transport region of the organic photodetector comprises a hole injection layer, wherein the hole injection layer is adjacent or in direct to the anode layer.

According to an embodiment, wherein the hole transport region of the organic photodetector comprises a hole injection layer, wherein the hole injection layer comprises a p-dopant; preferably an organic p-dopant or a metal compound; more preferably an organic p-dopant or a metal complex of Formula (I) or Formula (Ia), wherein the metal complex of Formula (I) or Formula (Ia) can be the same or different from the metal complex of Formula (I) or Formula (Ia) in the semiconductor layer; and most preferably a metal complex of Formula (I) or Formula (Ia) wherein the metal complex of Formula (I) or Formula (Ia) can be the same or different from the metal complex of Formula (I) or Formula (Ia) in the semiconductor layer.

According to an embodiment, wherein the hole transport region of organic photodetector comprises a hole injection layer, and/or a hole transport layer.

According to an embodiment, wherein the hole transport region of organic photodetector comprises a hole injection layer, and a hole transport layer.

According to an embodiment, wherein the hole transport region of organic photodetector comprises a hole injection layer, and/or a hole transport layer, and wherein the organic photodetector further comprises an electron blocking layer.

According to an embodiment, wherein the hole transport region of organic photodetector comprises a hole injection layer, and a hole transport layer, and wherein the organic photodetector further comprises an electron blocking layer.

According to an embodiment, wherein the organic photodetector further comprises an electron blocking layer.

According to an embodiment, wherein the organic photodetector further comprises an electron transport region, wherein the electron transport region is arranged between the photoconversion unit and the cathode layer. In particular the electron transport region comprises a layer selected from a hole blocking layer, an electron transport layer, an electron injection layer.

According to an embodiment, wherein the organic photodetector further comprises a hole blocking layer, an electron transport layer, an electron injection layer; a hole injection layer, hole transport layer, an electron blocking layer, an electron transport layer, and/or an electron injection layer.

According to an embodiment, wherein the organic photodetector further comprises a hole blocking layer, an electron transport layer and/or an electron injection layer; preferably an electron transport layer and an electron injection layer; more preferably an electron transport layer and an electron injection layer, wherein the organic semiconductor layer is a hole blocking layer.

According to an embodiment, wherein the hole transport region of organic photodetector comprises a hole injection layer, and a hole transport layer, and wherein the organic photodetector further comprises an electron blocking layer, an electron transport layer, and an electron injection layer.

According to an embodiment, wherein the hole transport region of organic photodetector comprises a hole injection layer, and a hole transport layer, and wherein the organic photodetector further comprises an electron blocking layer, a hole blocking layer, an electron transport layer, and an electron injection layer.

Semiconductor layer of the Photoconversion unit

According to an embodiment of the present invention, the photoconversion unit comprises a semiconductor layer which comprises a metal complex of Formula (I) or Formula (Ia).

According to an embodiment of the present invention, the photoconversion unit comprises a hole extraction layer which comprises a metal complex of Formula (I) or Formula (Ia).

According to an embodiment of the present invention, the photoconversion unit comprises a hole extraction layer which comprises a metal complex of Formula (I) or Formula (Ia) which is identical to the metal complex of the semiconductor layer mentioned earlier.

The organic semiconductor layer and/or hole extraction layer may be formed on the anode layer or cathode layer by vacuum deposition, spin coating, printing, casting, slot-die coating, Langmuir-Blodgett (LB) deposition, or the like. When the organic semiconductor layer is formed using vacuum deposition, the deposition conditions may vary according to the compound(s) that are used to form the layer, and the desired structure and thermal properties of the layer. In general, however, conditions for vacuum deposition may include a deposition temperature of 100° C to 350° C, a pressure of $10^{-8}$ to $10^{-3}$ Torr (1 Torr equals 133.322 Pa), and a deposition rate of 0.1 to 10 nm/sec.

When the organic semiconductor layter is formed using spin coating or printing, coating conditions may vary according to the compound(s) that are used to form the layer, and the desired structure and thermal properties of the organic semiconductor layer. For example, the coating conditions may include a coating speed of about 2000 rpm to about 5000 rpm, and a thermal treatment temperature of about 80° C to about 200° C. Thermal treatment removes a solvent after the coating is performed.

The thickness of the organic semiconductor layer may be in the range from about 1 nm to about 20 nm, and for example, from about 2 nm to about 15 nm, alternatively about 2 nm to about 12 nm.

According to one embodiment of the present invention, the organic semiconductor layer may comprise:

- at least about ≥ 0.5 wt.-% to about ≤ 30 wt.-%, preferably about ≥ 0.5 wt.-% to about ≤ 20 wt.-%, and more preferred about ≥ 1 wt.-% to about ≤ 15 wt.-% of a metal complex of Formula (I) or Formula (Ia), and
- at least about ≥ 70 wt.-% to about ≤ 99.5 wt.-%, preferably about ≥ 80 wt.-% to about ≤ 99.5 wt.-%, and more preferred about ≥ 85 wt.-% to about ≤ 99 wt.-% of an electron donor compound; preferably the wt.-% of the metal complex of Formula (I) or Formula (Ia) is lower than the wt.-% of the electron donor compound; wherein the weight-% of the components are based on the total weight of the organic semiconductor layer.

According to one embodiment of the present invention, the organic semiconductor layer may comprise:

- at least about ≥ 0.5 wt.-% to about ≤ 30 wt.-%, preferably about ≥ 0.5 wt.-% to about ≤ 20 wt.-%, and more preferred about ≥ 1 wt.-% to about ≤ 15 wt.-% of a metal complex of Formula (I) or Formula (Ia), and
- at least about ≥ 70 wt.-% to about ≤ 99.5 wt.-%, preferably about ≥ 80 wt.-% to about ≤ 99.5 wt.-%, and more preferred about ≥ 85 wt.-% to about ≤ 99 wt.-% of an electron blocking compound; preferably the wt.-% of the metal complex of Formula (I) or Formula (Ia) is lower than the wt.-% of the electron blocking compound; wherein the weight-% of the components are based on the total weight of the organic semiconductor layer.

According to one embodiment of the present invention the organic semiconductor layer and/or the metal complex of Formula (I) or Formula (Ia) are non-emissive.

In the context of the present specification the term "essentially non-emissive" or "non-emissive" means that the contribution of the compound or layer to the visible emission spectrum from the device is less than 10%, preferably less than 5 % relative to the visible emission spectrum. The visible emission spectrum is an emission spectrum with a wavelength of about ≥ 380 nm to about ≤ 780 nm.

According to an embodiment, the semiconductor layer is a hole extraction layer. The term "hole extraction layer" especially means a layer which facilitates the extraction of holes from the photoconversion unit.

In other words, a hole extraction layer means a layer which facilitates the entry of an electron into the photoconversion unit, while a positive charge will be formed in the hole extraction layer.

According to one embodiment of the present invention the organic semiconductor layer is in direct contact to the photoconversion unit.

According to one embodiment of the present invention the organic semiconductor layer is a hole extraction layer and in direct contact to the photoconversion unit.

According to one embodiment of the present invention the organic semiconductor layer is a hole extraction layer and in direct contact to the photoconversion unit.

According to one embodiment of the present invention the organic semiconductor layer is a hole extraction layer and comprises a metal complex of Formula (I) or Formula (Ia).

According to one embodiment of the present invention the organic semiconductor layer is a hole extraction layer and comprises a metal complex of Formula (I) or Formula (Ia).

According to one embodiment of the present invention the organic semiconductor layer is a hole extraction layer in direct contact to the photoconversion unit and comprises a metal complex of Formula (I) or Formula (Ia).

According to one embodiment of the present invention the organic semiconductor layer is a hole extraction layer in direct contact to the photoconversion unit and comprises a metal complex of Formula (I) or Formula (Ia).

Electron donor compound

According to an embodiment, the electron donor compound absorbs light in the range of ≥ 380 nm to ≤ 2.5 μm, preferably ≥ 490 to ≤ 2.5 μm.

According to an embodiment, the electron donor compound has an energy gap Egap between its HOMO energy level and its LUMO energy level of ≥ 0.4 eV to ≤ 3.3 eV preferably ≥ 0.4 eV to ≤2.8 eV, wherein the energy gap, the HOMO energy level, and the LUMO energy level calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

According to an embodiment, wherein the electron donor compound absorbs light in the wave length range of ≥ 380 nm to ≤ 2.5 μm, preferably ≥ 490 to ≤ 2.5 μm.

According to an embodiment, wherein the electron donor compound has an energy gap $E_{gap}$ between its LUMO energy level and its HOMO energy level ≥ 0.4 eV to ≤ 3.3 eV preferably ≥ 0.4 eV to ≤2.8 eV,
wherein the energy gap, the HOMO energy level, and the LUMO energy level are calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

According to an embodiment, wherein the electron donor compound has a LUMO energy level in the range of ≥ -4.0 eV to ≤ -1.0 eV, preferably ≥ -4.0 eV to ≤ -2.0 eV, more preferably ≥ - 4.0 eV to ≤-2.5 eV, wherein the LUMO energy level is calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

According to an embodiment, the electron donor compound comprises a phthalocyanine compound, a perylene-based compound, a squaraine dye compound, subphthalocyanine (SubPc), zinc phthalocyanine (ZnPc), ditolyaminothienyl-benzothiadiazole-dicyanovinylene (DTDCTB), lead phthalocyanine (PbPc), 5,10,15,20-Tetraphenyl bisbenz[5,6] indeno[1,2,3-cd: 1',2',3'-lm]perylene (DBP), copper phthalocyanine (CuPc), tin phthalocyanine (SnPc), quinacridone, quinacridone-derivatives

Electron acceptor compound

According to an embodiment, the electron **acceptor** compound has a LUMO energy level in the range of ≥ -4.5 eV to ≤ -2.5 eV, preferably ≥ -4.5 eV to ≤ -3.0 eV, wherein the LUMO energy level is calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

According to an embodiment, the electron acceptor compound has a LUMO energy level in the range of ≥ -4.5 eV to ≤ -2.5 eV, preferably ≥ -4.5 eV to ≤ -3.0 eV, wherein the LUMO energy level is calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

According to an embodiment, wherein the electron acceptor compound has an energy gap Egap between its LUMO energy level and its HOMO energy level in the range of ≥0.01 eV to ≤5.0 eV; preferably ≥0.4 eV to ≤3.3 eV, and more preferably ≥0.4 eV to ≤2.8 eV, wherein the energy gap, the HOMO energy level, and the LUMO energy level are calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the

optimized geometries and the HOMO and LUMO energy levels of the molecular structures are determined by applying the hybrid functional B3LYP with a 6-31G* basis set in the gas phase.

According to an embodiment, the electron acceptor compound comprises Fullerene-$C_{70}$ [115383-22-7], Fullerence-$C_{60}$ [99685-96-8], [6,6]-phenyl-$C_{71}$-butyric acid methyl ester (abbreviation: $PC_{71}BM$), [6,6]-phenyl-$C_{61}$-butyric acid methyl ester (abbreviation: $PC_{61}BM$), and 1',1",4',4"-tetrahydro-di[1,4]methanonaphthaleno[1,2:2',3',56,60:2",3"][5,6]fullerene-$C_{60}$ (abbreviation: ICBA), a fullerene derivative, a perylene tetracarboxylic diimide (PTCDI) derivative, a perylene tetracarboxylic dianhydride (PTCDA) derivative, or the like

Electron donor compound & Electron acceptor compound

According to an embodiment, the electron donor compound has a LUMO energy level and wherein the electron **acceptor** compound has a LUMO energy level LUMO (electron acceptor compound), wherein the LUMO energy level of the electron donor compound is larger than the LUMO energy level of the electron acceptor compound, wherein the LUMO energy level

is calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

According to an embodiment, the electron donor compound has a LUMO energy level and wherein the electron acceptor compound has a LUMO energy level LUMO (electron acceptor compound), wherein the LUMO energy level of the electron acceptor compound is further away from vacuum level than the LUMO energy level of the electron donor compound, wherein the LUMO energy level is calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

Further layers

In accordance with the invention, the organic electronic device may comprise, besides the layers already mentioned above, further layers. Exemplary embodiments of respective layers are described in the following:

*Substrate*

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate or a silicon substrate.

*Anode layer*

The anode layer, also named anode electrode, may be formed by depositing or sputteA material that is used to form the anode layer. The material used to form the anode layer may be a high work-function material, so as to facilitate hole injection. The anode layer may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode layer. The anode layer may also be formed using metals, typically silver (Ag), gold (Au), or metal alloys.

The anode layer may comprise two or more anode sub-layers.

According to one embodiment, the anode layer comprises a first anode sub-layer and a second anode sub-layer, wherein the first anode sub-layer is arranged closer to the substrate and the second anode sub-layer is arranged closer to the cathode layer.

According to one embodiment, the anode layer may comprise a first anode sub-layer comprising or consisting of Ag or Au and a second anode-sub-layer comprising or consisting of transparent conductive oxide.

According to one embodiment, the anode layer comprises a first anode sub-layer, a second anode sub-layer and a third anode sub-layer, wherein the first anode sub-layer is arranged closer to the substrate and the second anode sub-layer is arranged closer to the cathode layer, and the third anode sub-layer is arranged between the substrate and the first anode sub-layer.

According to one embodiment, the anode layer may comprise a first anode sub-layer comprising or consisting of Ag or Au, a second anode-sub-layer comprising or consisting of transparent conductive oxide and optionally a third anode sub-layer comprising or consisting of transparent conductive oxide. Preferably the first anode sub-layer may comprise or consists of Ag, the second anode-sublayer may comprise or consists of ITO or IZO and the third anode sublayer may comprises or consists of ITO or IZO.

Preferably the first anode sub-layer may comprise or consists of Ag, the second anode-sublayer may comprise or consists of ITO and the third anode sub-layer may comprise or consist of ITO.

Preferably, the transparent conductive oxide in the second and third anode sub-layer may be selected the same.

According to one embodiment, the anode layer may comprise a first anode sub-layer comprising Ag or Au having a thickness of 100 to 150 nm, a second anode sub-layer comprising or consisting of a transparent conductive oxide having a thickness of 3 to 20 nm and a third anode sub-layer comprising or consisting of a transparent conductive oxide having a thickness of 3 to 20 nm.

It is to be understood that the third anode layer is not part of the substrate.

*Hole injection layer*

As indicated above, the semiconductor layer, according to one embodiment, may be a hole injection layer.

A hole injection layer (HIL) may be formed on the anode electrode by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of $10^{-8}$ to $10^{-3}$ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The HIL may be formed of any compound that is commonly used to form a HIL. Examples of compounds that may be used to form the HIL, especially if the semiconductor layer is not a hole injection layer, include a phthalocyanine compound, such as copper phthalocyanine (CuPc), 4,4',4"-tris (3-methylphenylphenylamino) triphenylamine (m-MTDATA), TDATA, 2T-NATA, polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS).

The HIL may comprise or consist of p-type dopant and the p-type dopant may be selected from tetrafluoro-tetracyanoquinonedimethane (F4TCNQ), 2,2'-(perfluoronaphthalen-2,6-diylidene) dimalononitrile or 2,2',2"-(cyclopropane-1,2,3-triylidene)tris(2-(p-cyanotetrafluorophenyl)acetonitrile) but not limited hereto. The HIL may be selected from a holetransporting matrix compound doped with a p-type dopant. Typical examples of known doped hole transport materials are: copper phthalocyanine (CuPc), which HOMO level is approximately -5.2 eV, doped with tetrafluoro-tetracyanoquinonedimethane (F4TCNQ), which LUMO level is about -5.2 eV; zinc phthalocyanine (ZnPc) (HOMO = -5.2 eV) doped with F4TCNQ; α-NPD (N,N'-Bis(naphthalen-1-yl)-N,N'-bis(phenyl)-benzidine) doped with F4TCNQ. α-NPD doped with 2,2'-(perfluoronaphthalen-2,6-diylidene) dimalononitrile. The p-type dopant concentrations can be selected from 1 to 20 wt.-%, more preferably from 3 wt.-% to 10 wt.-%.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

*Hole transport layer*

As indicated above, the semiconductor layer, according to one embodiment, may be a hole transport layer.

The hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

In case that the semiconductor layer is not a hole transport layer and/or there are other hold transport layers present, the HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

According to a preferred embodiment of the present invention, the hole transport layer may comprise a substantially covalent matrix compound.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

*Electron blocking layer*

The function of an electron blocking layer (EBL) is to prevent electrons from being transferred from an emission layer to the hole transport layer and thereby confine electrons to the emission layer. Thereby, efficiency, operating voltage and/or lifetime may be improved.

The electron blocking layer comprises an electron blocking compound.

Typically, the electron blocking layer comprises a triarylamine compound such as N,N-di([1,1'-biphenyl]-4-yl)-7,7-dimethyl-7H-fluoreno[4,3-b]benzofuran-10-amine ([1616706-52-5]), or N-([1,1'-biphenyl]-4-yl)-9,9-dimethyl-N-(3-(9-phenyl-9H-fluoren-9-yl)phenyl)-9H-fluoren-2-amine (2226747-62-0).

The electron blocking compound in particular a triarylamine compound may have a LUMO level closer to vacuum level than the LUMO level of the hole transport layer. The electron blocking compound may have a HOMO level that is further away from vacuum level compared to the HOMO level of the hole transport layer.

The electron blocking compound in particular a triarylamine compound may have a LUMO level closer to vacuum level than the LUMO level of the electron donor compound in the emission layer.

The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

*Photoactive layer (PAL)*

The photoactive layer converts an electrical current into photons or photons into an electrical current.

The PAL may be formed on the HTL by vacuum deposition, spin coating, slot-die coating, printing, casting, LB deposition, or the like. When the PAL is formed using vacuum deposition or spin coating, the conditions for deposition and coating may be similar to those for the formation of the HIL. However, the conditions for deposition and coating may vary, according to the compound that is used to form the PAL.

It may be provided that the photoactive layer does not comprise the compound of Formula (I).

The photoactive layer may be an emission layer (EML), also named light-emitting layer, or a light-absorbing layer.

*Emission layer (EML)*

The emission layer (EML) converts an electrical current into photons.

According to an embodiment, the emission layer is arranged between the anode layer and the cathode layer, preferably the emission layer is arranged between the organic semiconductor layer and the cathode layer.

The EML may be formed by vacuum deposition, spin coating, slot-die coat-ing, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

The emission layer (EML) may comprise an organic emitter host and a light-emitting compound dopant. Examples of the organic emitter host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).

The emitter dopant may be a phosphorescent or fluorescent emitter. Phosphorescent emitters and emitters

which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters, however, fluorescent red emitter dopants could also be used.

Examples of phosphorescent green emitter dopants are Ir(ppy)3 (ppy = phenylpyridine), Ir(ppy)2(acac), Ir(mpyp) 3.

Examples of phosphorescent blue emitter dopants are F2Irpic, (F2ppy)2Ir(tmd) and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

It may be provided that the emission layer does not comprise the metal complex of Formula (I) or Formula (Ia).

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

According to a preferred embodiment of the present invention, the emission layer comprises a light-emitting compound of formula (IV):

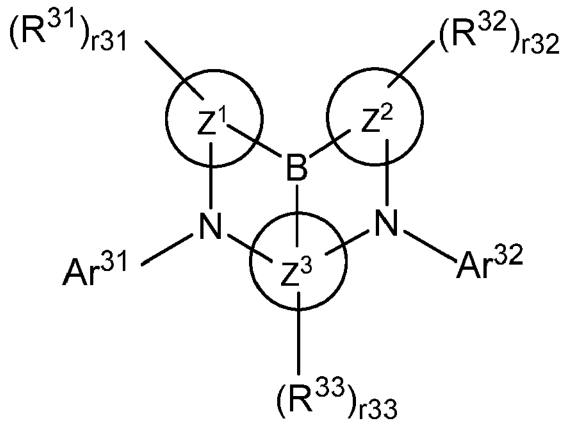

(IV),

wherein

$Z^1$, $Z^2$ and $Z^3$ are the same as or different from each other, and are each independently selected from the group comprising a monocyclic to polycyclic aromatic hydrocarbon ring or monocyclic to polycyclic aromatic hetero ring;
$Ar^{31}$ and $Ar^{32}$ are the same as or selected different from each other, and are each independently a substituted or unsubstituted alkyl group, a substituted or unsubstituted aryl group, or a substituted or unsubstituted heteroaryl group, or are bonded to an adjacent substituent to form a substituted or unsubstituted aromatic ring or a substituted or unsubstituted aliphatic ring;
$R^{31}$, $R^{32}$ and $R^{33}$ are the same as or different from each other, and are each independently selected from the group comprising hydrogen, deuterium, a substituted or unsubstituted alkyl group, a substituted or unsubstituted silyl group, a substituted or unsubstituted amine group, a substituted or unsubstituted aryl group, or a substituted or unsubstituted heteroaryl group, or adjacent substituents are bonded to each other to form a substituted or unsubstituted aromatic ring or a substituted or unsubstituted aliphatic ring,
wherein one or more substituents selected from the group consisting of deuterium, an alkyl group having 1 to 6 carbon atoms, an alkyl silyl group having 1 to 30 carbon atoms, an aryl silyl group having 6 to 50 carbon atoms, an alkylamine group having 1 to 30 carbon atoms, an alkylarylamine group having 1 to 50 carbon atoms, an arylamine group having 6 to 50 carbon atoms, an aryl group having 6 to 30 carbon atoms, and a heteroaryl group having 2 to 30 carbon atoms, or a substituent to which two or more substituents selected from the group are linked, or adjacent substituents are bonded to each other to form an aliphatic hydrocarbon ring having 3 to 60 carbon atoms, which is unsubstituted or substituted with the substituent;
$r^{31}$, $r^{32}$ and $r^{33}$ are each an integer from 0, 1, 2, 3 or 4, and when $r^{31}$ to $r^{33}$ are 2 or higher, substituents in the parenthesis are the same as or different from each other.

According to one embodiment, for formula (III):

$Z^1$, $Z^2$ and $Z^3$ are the same as or selected different from each other, and are each independently selected from

the group comprising a monocyclic to bicyclic aromatic hydrocarbon ring, or a monocyclic to bicyclic aromatic hetero ring containing O, N or S;

$Ar^{31}$ and $Ar^{32}$ are the same as or selected different from, and are each independently selected from the group comprising an alkyl group having 1 to 10 carbon atoms, which is unsubstituted or substituted with an aryl group, an aryl group having 6 to 30 carbon atoms, which is unsubstituted or substituted with an aryl group, or a heteroaryl group having 2 to 30 carbon atoms;

$R^{31}$, $R^{32}$ and $R^{33}$ are the same as or selected different from each other, and are each independently selected from the group comprising hydrogen, deuterium, a substituted or unsubstituted alkyl group, a substituted or unsubstituted cycloalkyl group, a substituted or unsubstituted silyl group, a substituted or unsubstituted aryl group, or a substituted or unsubstituted heteroaryl group.

According to one embodiment, wherein for formula (III):

$Z^1$, $Z^2$ and $Z^3$ are the same as or selected different from each other, and are each independently selected from the group comprising a benzene ring or a thiophene ring;

$Ar^{31}$ and $Ar^{32}$ are the same as or selected different from each other, and are each independently selected from the group comprising phenyl group, a biphenyl group, a naphthyl group, a dimethyl fluorenyl group, a diphenyl fluorenyl group, a dibenzofuran group, or a dibenzothiophene group;

$R^{31}$, $R^{32}$ and $R^{33}$ are the same as or selected different from each other, and are each independently selected from the group comprising hydrogen, deuterium, a substituted or unsubstituted alkyl group having 1 to 10 carbon atoms, a substituted or unsubstituted cycloalkyl group having 5 to 30 carbon atoms, a substituted or unsubstituted silyl group having 1 to 10 carbon atoms, a substituted or unsubstituted aryl group having 6 to 30 carbon atoms, or a substituted or unsubstituted heteroaryl group having 2 to 30 carbon atoms.

According to a preferred embodiment of the present invention, the emission layer comprises a light-emitting compound of formula (IV) is selected from formulae (BD1) to (BD9):

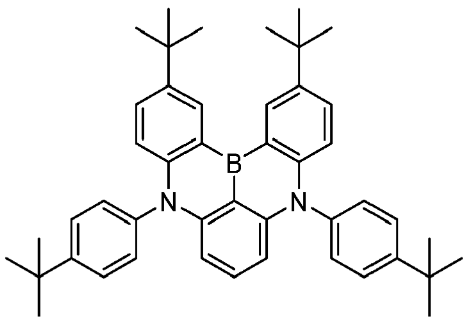
(BD1),

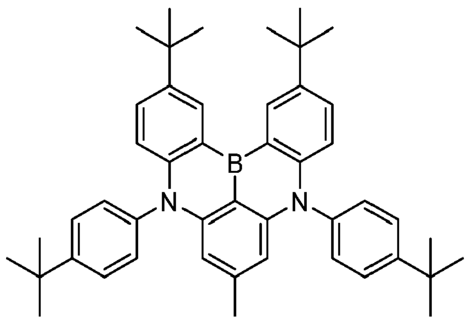
(BD2),

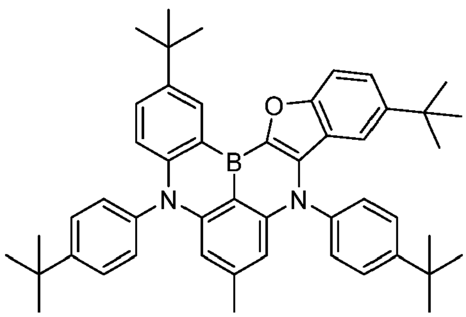
(BD3),

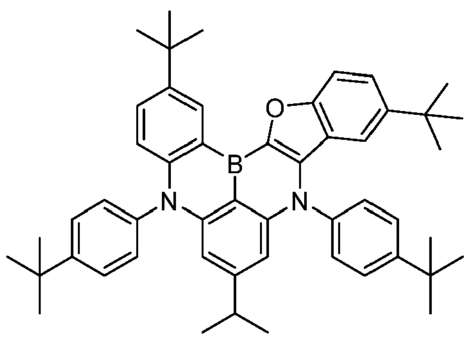
(BD4),

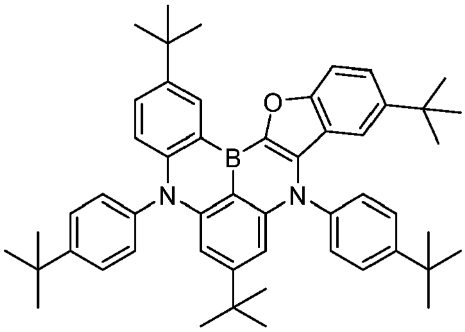 (BD5), 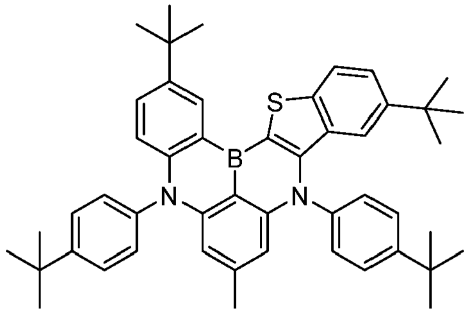 (BD6),

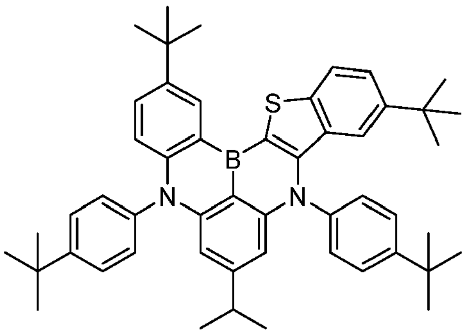 (BD7), 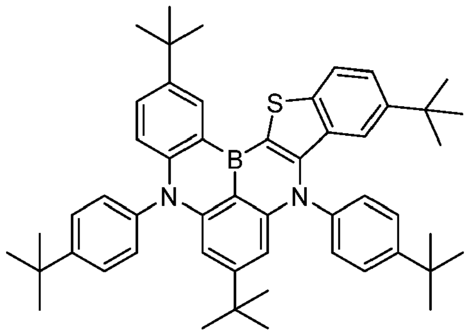 (BD8),

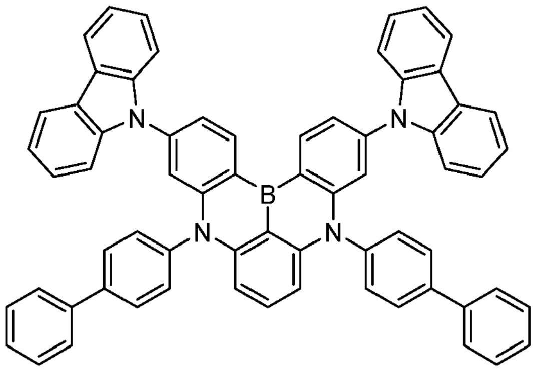 (BD9).

According to a preferred embodiment of the present invention, the emission layer comprises an organic emitter host compound, wherein the organic emitter host compound comprises

- at least one condensed aromatic ring system consisting of 3 to 5 rings, and
- 3 to 7 aromatic or heteroaromatic rings, wherein one or more sub-groups of the aromatic and/or heteroaromatic rings may be condensed to form fused aromatic or heteroaromatic ring systems;

wherein the molecular weight Mw of the organic emitter host compound is in the range of ≥ 400 and ≤ 2000 g/mol.

According to a preferred embodiment of the present invention, the organic emitter host compound has the formula (V)

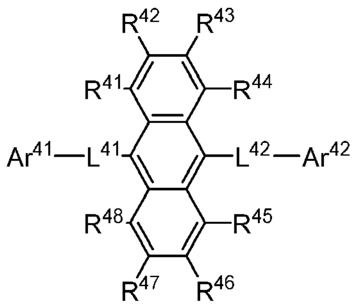

(V),

wherein

$Ar^{41}$ and $Ar^{42}$ are independently selected from substituted or unsubstituted $C_6$ to $C_{24}$ aryl, substituted or unsubstituted $C_3$ to $C_{24}$ heteroaryl;
$L^{41}$ and $L^{42}$ are independently selected from a direct bond or substituted or unsubstituted $C_6$ to $C_{24}$ arylene, substituted or unsubstituted $C_3$ to $C_{24}$ heteroarylene;
$R^{41}$ to $R^{41}$ are independently selected from H, D, substituted or unsubstituted $C_1$ to $C_{12}$ alkyl, substituted or unsubstituted $C_6$ to $C_{19}$ aryl, substituted or unsubstituted $C_3$ to $C_{12}$ heteroaryl;
wherein
the substituents on $Ar^{41}$, $Ar^{42}$, $L^{41}$, $L^{42}$, $R^{41}$ to $R^{48}$ are independently selected from D, $C_6$ to $C_{10}$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy, halogen, F or CN.

According to a preferred embodiment of the present invention, the organic emitter host and/or compound of formula (V) is selected from formulae (BH1) to (BH13):

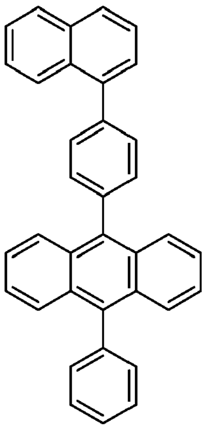

(BH1),

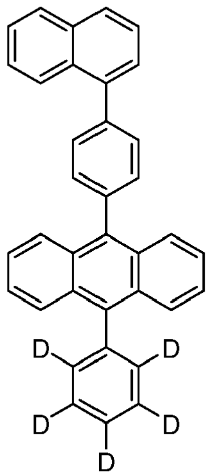

(BH2),

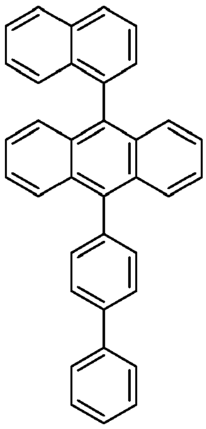

(BH3),

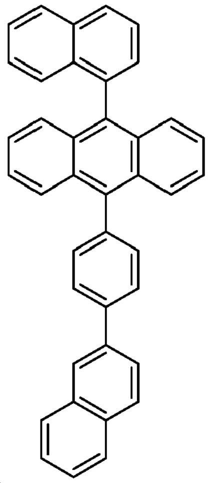

(BH4),

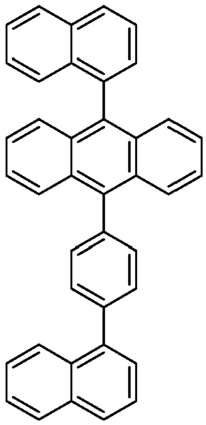 (BH5),

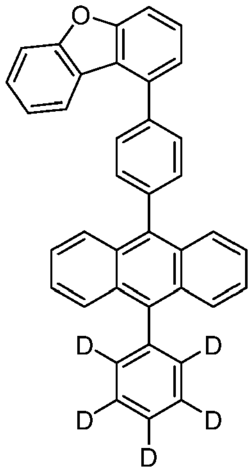 (BH6),

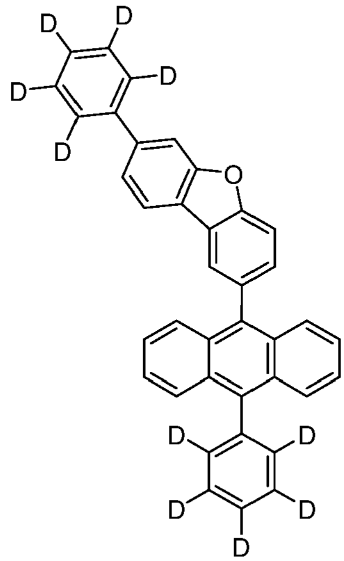 (BH7),

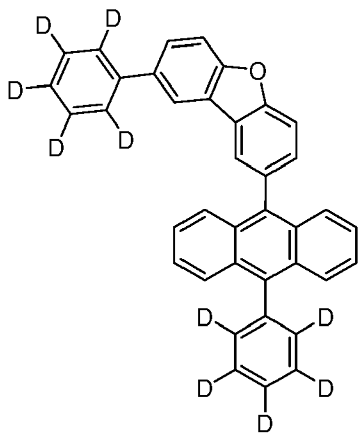 (BH8),

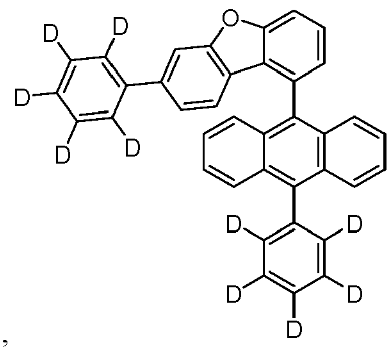 (BH9),

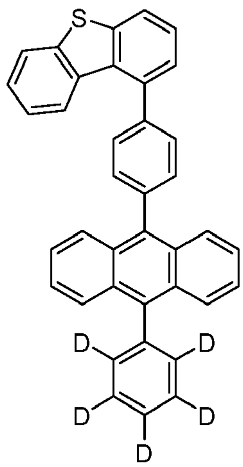 (BH10),

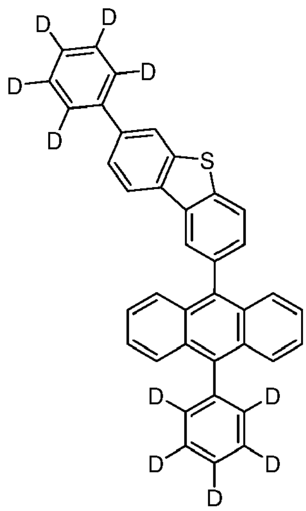 (BH11),

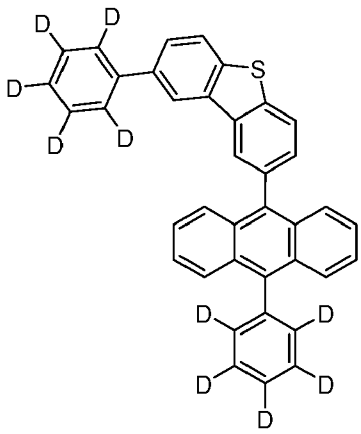
(BH12),
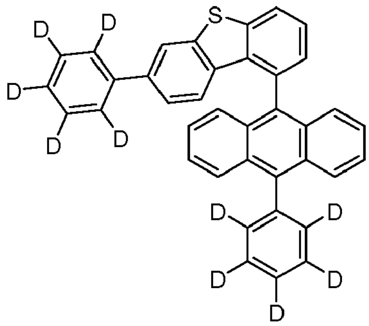
(BH13).

According to a preferred embodiment of the present invention, the light-emitting layer comprises a light-emitting dopant of formula (IV) and an organic emitter host of formula (V).

*Hole blocking layer (HBL)*

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and triazine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

*Electron transport layer (ETL)*

The organic electronic device according to the present invention may further comprise an electron transport layer (ETL), wherein the electron transport layer is arranged between the anode layer and the cathode layer, preferably between the organic semiconductor layer and the cathode layer.

According to another embodiment of the present invention, the electron transport layer may further comprise an azine compound, preferably a triazine compound.

In one embodiment, the electron transport layer may further comprise a dopant selected from an alkali organic complex, preferably LiQ.

The thickness of the ETL may be in the range from about 15 nm to about 50 nm, for example, in the range from about 20 nm to about 40 nm. When the thickness of the EII, is within this range, the ETL may have satisfactory electron-injecting properties, without a substantial penalty in driving voltage.

According to another embodiment of the present invention, the organic electronic device may further comprise a hole blocking layer and an electron transport layer, wherein the hole blocking layer and the electron transport layer comprise an azine compound. Preferably, the azine compound is a triazine compound.

*Electron injection layer (EIL)*

An optional EIL, which may facilitates injection of electrons from the cathode, may be formed on the ETL, preferably directly on the electron transport layer. Examples of materials for forming the EII, include lithium 8-hydroxyquinolinolate (LiQ), LiF, NaCl, CsF, Li20, BaO, Ca, Ba, Yb, Mg which are known in the art. Deposition and coating conditions for forming the EII, are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EII, is within this range, the EII, may have satisfactory electron-injecting properties, without a substantial penalty in driving voltage.

*Cathode layer*

The cathode layer is formed on the ETL or optional EIL. The cathode layer may be formed of a metal, an alloy, an electrically conductive compound, or a mixture thereof. The cathode layer may have a low work function. For example, the cathode layer may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode layer may be formed of a transparent conductive oxide, such as ITO or IZO.
The thickness of the cathode layer may be in the range from about 5 nm to about 1000 nm, for example, in the range from about 10 nm to about 100 nm. When the thickness of the cathode layer is in the range from about 5 nm to about 50 nm, the cathode layer may be transparent or semitransparent even if formed from a metal or metal alloy.
It is to be understood that the cathode layer is not part of an electron injection layer or the electron transport layer.

*Display device*

According to one embodiment of the present invention, the organic electronic device is a display device.
According to one embodiment of the present invention, the organic electronic device is a display device comprising a substrate, an organic photodetector and an organic light-emitting device,

wherein the organic photodetector and the organic light-emitting device are disposed on the substrate;
wherein the organic photodetector comprises
an anode layer, a semiconductor layer, a photoconversion unit, and a cathode layer;
wherein the semiconductor layer and the photoconversion unit is arranged between the anode layer and the cathode layer,
wherein the semiconductor layer is arranged between the anode layer and the photoconversion unit;
wherein the photoconversion unit comprises one or more layers;
wherein the photoconversion unit comprises an electron donor compound and electron acceptor compound;
wherein the organic light-emitting device comprises
an anode layer, a cathode layer, a semiconductor layer, a light-emitting layer, and a cathode layer;
wherein the semiconductor layer and the light-emitting layer are arranged between the anode layer and the cathode layer,
wherein the semiconductor layer is arranged between the anode layer and the organic light-emitting layer;
wherein the semiconductor layer of the organic light-emitting device and the semiconductor layer of the organic photodetector is a common semiconductor layer shared by at least one organic light-emitting device and at least one organic photodetector and whereby the the common semiconductor layer comprises a material of formula (I).

According to one embodiment, the cathode layer of the organic light-emitting device and the cathode layer of the organic photodetector is a common cathode layer shared by the organic light-emitting device and the organic photodetector.

<u>Pixel definition layer</u>

According to an embodiment of the invention, the display device may comprise a pixel definition layer by which the organic photodetector and/or the organic-light emitting device are separated from each other.
The pixel definition layer preferably is in direct contact with the substrate.
According to one embodiment, the pixel definition layer is not positive charged and/or is not an anode or comprises an anode material, preferably the pixel definition layer comprises Si based compound, SiN, a non-positive charged oligomer and/or polymer material. Preferred oligomer material include a polyacrylate-based resin or a polyimide-based resin. Also the pixel definition layer may futher include an inorganic matteri in addition to the polymer material as well as an light absorbing material, such a black pigment and/or a black dye, such as carbon black.
Hereinafter, the embodiments are illustrated in more detail with reference to examples. However, the present disclosure is not limited to the following examples. Reference will now be made in detail to the exemplary aspects.

**Description of the Drawings**

The aforementioned components, as well as the claimed components and the components to be used in accordance with the invention in the described embodiments, are not subject to any special exceptions with respect to their

size, shape, material selection and technical concept such that the selection criteria known in the pertinent field can be applied without limitations.

Additional details, characteristics and advantages of the object of the invention are disclosed in the dependent claims and the following description of the respective figures which in an exemplary fashion show preferred embodiments according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.

Figures 1 to 12

FIG. 1 is a schematic sectional view of an organic electronic device, according to an exemplary embodiment of the present invention;
FIG. 2 is a schematic sectional view of an organic light-emitting diode (OLED), according to an exemplary embodiment of the present invention;
FIG. 3 is a schematic sectional view of an organic light-emitting diode (OLED), according to an exemplary embodiment of the present invention.
FIG. 4 is a schematic sectional view of an organic light-emitting diode (OLED), according to an exemplary embodiment of the present invention;
FIG. 5 is a schematic sectional view of an organic light-emitting diode (OLED), according to an exemplary embodiment of the present invention.
FIG. 6 is a schematic sectional view of an organic light-emitting diode (OLED), according to an exemplary embodiment of the present invention.
Fig. 7 is schematic view of an organic photodetector according to an exemplary embodiment of the present invention.
Fig. 8 is schematic view of an organic photodetector according to an exemplary embodiment of the present invention.
Fig. 9 is schematic view of an organic electron device comprising an organic photodetector according to an exemplary embodiment of the present invention.
Fig. 10 is schematic view of an organic electron device comprising an organic photodetector according to an exemplary embodiment of the present invention.
FIG. 11 is a schematic view of an organic photodetector device according to an exemplary embodiment of the present invention;and
FIG. 12 is a schematic top view of an organic photodetector device according to an exemplary embodiment of the present invention.

Hereinafter, the figures 1 to 12 are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

FIG. 1 is a schematic sectional view of an organic electronic device 101, according to an exemplary embodiment of the present invention. The organic electronic device 101 includes a substrate (110), an anode layer (120), ac semiconductor layer comprising a metal complex of Formula (I) (130), a photoactive layer (PAL) (151) and a cathode layer (190).

FIG. 2 is a schematic sectional view of an organic light-emitting diode (OLED) 100, according to an exemplary embodiment of the present invention. The OLED 100 includes a substrate (110), an anode layer (120), a semiconductor layer comprising a metal complex of Formula (I) (130), an emission layer (EML) (150) and a cathode layer (190).

FIG. 3 is a schematic sectional view of an organic light-emitting diode (OLED) 100, according to an exemplary embodiment of the present invention. The OLED 100 includes a substrate (110), an anode layer (120), a semiconductor layer comprising a metal complex of Formula (I) (130), a hole transport layer (HTL) (140), an emission layer (EML) (150), an electron transport layer (ETL) (160) and a cathode layer (190).

FIG. 4 is a schematic sectional view of an organic light-emitting diode (OLED) 100, according to an exemplary embodiment of the present invention. The OLED 100 includes a substrate (110), an anode layer (120), a semiconductor layer comprising a metal complex of Formula (I) (130), a hole transport layer (HTL) (140), an electron blocking layer (EBL) (145), an emission layer (EML) (150), a hole blocking layer (HBL) (155), an electron transport layer (ETL) (160), an optional electron injection layer (EIL) (180), and a cathode layer (190).

FIG. 5 is a schematic sectional view of an organic light-emitting diode (OLED) 100, according to an exemplary embodiment of the present invention. The OLED 100 includes a substrate (110), an anode layer (120) that comprises a first anode sub-layer (121) and a second anode sub-layer (122), ac semiconductor layer comprising metal complex of Formula (I) (130), a hole transport layer (HTL) (140), an electron blocking layer (EBL) (145), an emission layer (EML) (150), a hole blocking layer (EBL) (155), an electron transport layer (ETL) (160) and a cathode layer (190).

FIG. 6 is a schematic sectional view of an organic light-emitting diode (OLED) 100, according to an exemplary embodiment of the present invention. The OLED 100 includes a substrate (110), an anode layer (120) that comprises a first anode sub-layer (121), a second anode sub-layer (122) and a third anode sub-layer (123), an organic semiconductor layer comprising compound of Formula (I) (130), a hole transport layer (HTL) (140), an electron blocking layer (EBL) (145), an emission layer (EML) (150), a hole blocking layer (EBL) (155), an electron transport layer (ETL) (160) and a cathode layer (190). The layers are disposed exactly in the order as mentioned before.

In the description above the method of manufacture an organic electronic device 101 of the present invention is for example started with a substrate (110) onto which an anode layer (120) is formed, on the anode layer (120), an organic semiconductor layer comprising compound of Formula (I) (130), a photoactive layer (151) and a cathode layer 190 are formed, exactly in that order or exactly the other way around.

In the description above the method of manufacture an OLED 100 of the present invention is started with a substrate (110) onto which an anode layer (120) is formed, on the anode layer (120), an organic semiconductor layer comprising compound of Formula (I) (130), optional a hole transport layer (140), optional an electron blocking layer (145), an emission layer (150), optional a hole blocking layer (155), optional an electron transport layer (160), optional an electron injection layer (180), and a cathode layer (190) are formed, exactly in that order or exactly the other way around.

The organic semiconductor layer comprising a compound of Formula (I) (130) can be a hole injection layer.

FIG. 7 is a schematic sectional view of an organic photodetector according to an exemplary embodiment of the present invention. The organic photodetector (200) includes a substrate (110), an anode layer (120), a semiconductor layer comprising a metal complex of Formula (I) (130), a photoactive layer (PAL) (151) and a cathode layer (190).

Fig. 8 is aschematic sectional view of an organic photodetector according to an exemplary embodiment of the present invention.

The organic photodetector 200 includes a substrate 110, an anode layer 120, a hole injection layer 146, a hole transport layer 131, an electron blocking layer 133, a semiconductor layer 130 which comprises the metal complex of formula (I) which is in particular a hole extraction layer, a photoactive layer 151 which is a photoconversion unit, a hole blocking layer 160, an electron transport layer 170, an electron injection layer 180, and a cathode layer 190; wherein the photoconversion unit 151 may comprise one or more layer, wherein the photoconversion unit comprises an electron donor compound and an electron acceptor compound. The photoconversion unit 151 may comprise one layer, wherein the one layer comprises the electron donor compound and the electron acceptor compound; or the photoconversion unit 151 may comprises two layer (not shown), wherein the first of the two layer comprises the electron donor compound, and the second of the two layer comprises the electron acceptor compound; preferably the first layer of the two layer comprising the electron donor compound is arranged closer to the semiconductor layer 130 than the second layer of the two layer.

Referring to Fig. 9 the organic electronic device 300, which in particular is a display, includes a substrate 210, an organic photodetector 400 and an organic light-emitting device 500, which are separated by a pixel definition layer 700.

The organic photodetector includes 300 includes an anode layer 420, a hole transport region 232, a semiconductor layer 430 comprising comprises a metal complex of formula (I), wherein the semiconductor layer is in particular a hole extraction layer, and a photoconversion unit 451, and a cathode layer 290; wherein the photoconversion unit 451 may comprise one or more layer, wherein the photoconversion unit comprises an electron donor compound and an electron acceptor compound. The photoconversion unit 451 may comprise a one layer, wherein the one layer of the comprises the electron donor compound and the electron acceptor compound, or the photoconversion unit 451 may comprises two layer (not shown), wherein the first of the two layer comprises the electron donor compound, and the second of the two layer comprises the electron acceptor compound; preferably the first layer of the two layer comprising the electron donor compound is arranged closer to the semiconductor layer 430 than the second layer of the two layer.

The organic light-emitting device 500 includes an anode layer 520, a hole transport layer 232, a light-emitting layer 541, and a cathode layer 290.

The organic electronic device 200 have a hole transport region 232, wherein hole transport can a common hole transport region which is shared by the organic photodetector 400 and the organic light-emitting device 500, or (not shown) the organic photodetector 400 and organic light-emitting device 500 may each have its own hole transport region and each organic light emitting device 400 may have its own hole transport region. Preferably, the hole transport regions is a common hole transport region.

Further, the organic electronic device 200 have a common cathode layer 290, wherein the common cathode layer 290 is shared by the organic photodetector 400 and the organic light-emitting device 500.

The organic photodetector 400 may further comprise an electron blocking layer (not shown).

The organic light-emitting device 500 may further comprises an electron blocking layer (not shown).

The electron blocking layer (not shown) of the organic photodetector 400 and the electron blocking layer (not shown) of the organic light-emitting device 500 may be shared by at least one organic photodetector and by at least one organic light-emitting diode.

Fig. 9 is schematic view of an organic electron device comprising an organic photodetector according to an exemplary embodiment of the present invention.

Referring to Fig. 9 the organic electronic device 300, which in particular is a display, includes a substrate 210, an organic photodetector 400 and an organic light-emitting device 500, which are separated by a pixel definition layer 700.

The organic photodetector includes 300 includes an anode layer 420, a hole transport region 232, a semiconductor layer 430 comprising comprises a metal complex of formula (I), wherein the semiconductor layer is in particular a hole extraction layer, and a photoconversion unit 451, and a cathode layer 290; wherein the photoconversion unit 451 may comprise one or more layer, wherein the photoconversion unit comprises an electron donor compound and an electron acceptor compound. The photoconversion unit 451 may comprise a one layer, wherein the one layer of the comprises the electron donor compound and the electron acceptor compound, or the photoconversion unit 451 may comprises two layer (not shown), wherein the first of the two layer comprises the electron donor compound, and the second of the two layer comprises the electron acceptor compound; preferably the first layer of the two layer comprising the electron donor compound is arranged closer to the semiconductor layer 430 than the second layer of the two layer.

The organic light-emitting device 500 includes an anode layer 520, a hole transport layer 232, a light-emitting layer 541, and a cathode layer 290.

The organic electronic device 200 have a hole transport region 232, wherein hole transport can a common hole transport region which is shared by the organic photodetector 400 and the organic light-emitting device 500, or (not shown) the organic photodetector 400 and organic light-emitting device 500 may each have its own hole transport region and each organic light emitting device 400 may have its own hole transport region. Preferably, the hole transport regions is a common hole transport region.

Further, the organic electronic device 200 have a common cathode layer 290, wherein the common cathode layer 290 is shared by the organic photodetector 400 and the organic light-emitting device 500.

The organic photodetector 400 may further comprise an electron blocking layer (not shown).

The organic light-emitting device 500 may further comprises an electron blocking layer (not shown).

The electron blocking layer (not shown) of the organic photodetector 400 and the electron blocking layer (not shown) of the organic light-emitting device 500 may be shared by at least one organic photodetector and by at least one organic light-emitting diode.

Fig. 10 is schematic view of an organic electron device comprising an organic photodetector according to an exemplary embodiment of the present invention.

Referring to Fig. 10 the organic electronic device 300, which in particular is a display, includes a substrate 210, an organic photodetector 400 and an organic light-emitting device 500 which are separated by a pixel definition layer 700.

The organic photodetector includes 400 includes an anode layer 420, a hole transport region 232, a semiconductor layer 430 , comprising comprises a metal complex of formula (I), wherein the semiconductor layer is in particular a hole extraction layer, and a photoconversion unit 451, an electron transport region 260 which may comprises an electron transport layer, hole blocking layer and/or electron injection layer, and a cathode layer 290; wherein the photoconversion unit 451 may comprise one or more layer, wherein the photoconversion unit comprises an electron donor compound and an electron acceptor compound. The photoconversion unit 451 may comprise a one layer, wherein the one layer of the comprises the electron donor compound and the electron acceptor compound, or the photoconversion unit 451 may comprises two layer (not shown), wherein the first of the two layer comprises the electron donor compound, and the second of the two layer comprises the electron acceptor compound; preferably the first layer of the two layer comprising the electron donor compound is arranged closer to the semiconductor layer 430 than the second layer of the two layer.

The organic light-emitting device 500 includes an anode layer 520, a hole transport region 232, a light-emitting layer 541, an electron transport region 260 which is in particular an electron transport layer, hole blocking layer and/or electron injection layer, and a cathode layer 290.

The organic electronic device 300 have a hole transport region 232, wherein hole transport region can a common hole transport region which is shared by the organic photodetector 400 and the organic light-emitting device 500, or (not shown) the organic photodetector 400 and organic light-emitting device 500 may each have its own hole transport region and each organic light emitting device 400 may have its own hole transport region. Preferably, the hole transport regions a common hole transport region.

The organic electronic device 200 have a common electron transport region 260 which may comprises a common electron transport layer, a common hole blocking layer and/or a common electron injection layer, wherein the common electron transport region 260 is shared by the organic photodetector 400 and the organic light-emitting device 500.

Further, the organic electronic device 200 have a common cathode layer 290, wherein the common cathode layer 290 is shared by the organic photodetector 400 and the organic light-emitting device 500.

The organic photodetector 400 may further comprise an electron blocking layer (not shown).
The organic light-emitting device 500 may further comprises an electron blocking layer (not shown).
The electron blocking layer (not shown) of the organic photodetector 400 and the electron blocking layer (not shown) of the organic light-emitting device 500 may be shared by the organic photodetector 400 and by the organic light-emitting diode 500.
Fig. 11 is a schematic view of an organic photodetector device, used to determine dark and photo current, according to an exemplary embodiment of the present invention.
Referring to Fig. 11 the organic photodetector device includes a substrate 210, an anode layer 320, a pixel definition layer 700 defining the area size of the organic photodetector device, an organic semiconductor layer stack 800 and a cathode layer.
Fig. 12 is a schematic top view of an organic photodetector device, used to determine dark and photo current, according to an exemplary embodiment of the present invention.
Referring to Fig. 12 the organic photodetector device includes a substrate 210, an anode layer 320, a pixel definition layer 700 defining the area size 710 of the organic photodetector device, an organic semiconductor layer stack 800 and a cathode layer.
While not shown in Fig. 1 to Fig. 12, a capping layer and/or a sealing layer may further be formed on the cathode layer (190), in order to seal the OLEDs 100. In addition, various other modifications may be applied thereto.
Hereinafter, one or more exemplary embodiments of the present invention will be described in detail with, reference to the following examples. However, these examples are not intended to limit the purpose and scope of the one or more exemplary embodiments of the present invention.

**Detailed discussion**

The invention is furthermore illustrated by the following examples which are illustrative only and non-binding.

Synthesis of 1-phenyl-3-(trifluoromethyl)-1H-pyrazol-5-ol

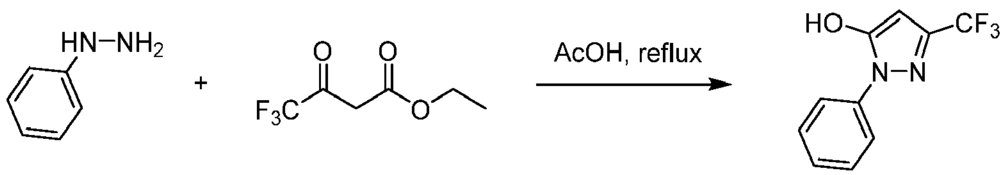


To a solution of 60 g (555 mmol) of ethyl 4,4,4-trifluoro-3-oxobutanoate in AcOH (240 ml) was added 102.2 g (555 mmol) phenylhydrazine and the resulting mixture was refluxed for 6 h. The reaction mixture was cooled to RT and stirred overnight. Formed solid was filtered off and washed with cold AcOH (2x75 ml) and hexane (200 ml), Crude solid product was triturated in 500 ml hexane for 30 min, filtered and washed with hexane and dried. Yield: 84.6 g (66.8%).

Synthesis of 2,2,2-trifluoro-1-(5-hydroxy-1-phenyl-3-(trifluoromethyl)-1H-pyrazol-4-yl)ethan-1-one (A53)

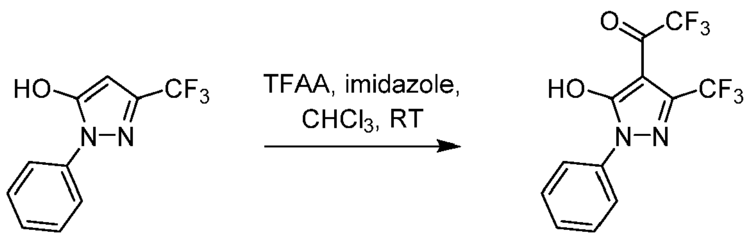


To a solution of 16.3 g (80 mmol) of imidazole in 200 ml chloroform was added 20.1 g (80 mmol) of TFAA dropwise under ice-cooling. Then 18.2 g (80 mmol) of 1-phenyl-3-(trifluoromethyl)-1H-pyrazol-5-ol was added portionswise. The resulting mixture was warmed to RT over 1 h and stirred further 24 h at RT. The reaction mixture was diluted with 200 ml chloroform, washed with 2x200 ml 2M HCl, 200 ml water and dried over $MgSO_4$, and concentrated. Crude product was stirred with hexane for 1 h, filtered , washed with 20 ml of hexane and dried. Yield: 19.95 g (77%).

Synthesis of 2,2,2-trifluoro-1-(5-((oxo((1-phenyl-4-(2,2,2-trifluoroacetyl)-3-(trifluoromethyl)-1H-pyrazol-5-yl)oxy)vanadio)oxy)-1-phenyl-3-(trifluoromethyl)-1H-pyrazol-4-yl)ethan-1-one (MC53)

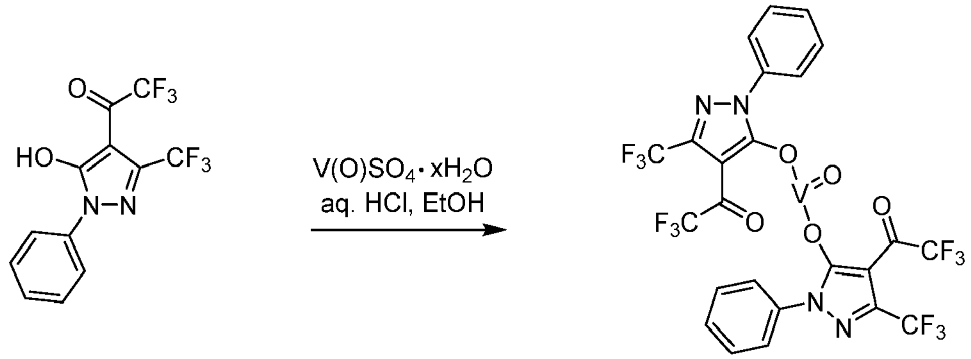


To a stirred mixture of 0.846 g (4.67mmole) of vanadium(IV) oxide-sulfate*$H_2O$ in 30 ml 0.5M aq. hydrochloric acid was dropped a solution of 3.0 g (9.25mmole) 2-phenyl-4-(2,2,2-trifluoroacetyl)-5-(trifluoromethyl)-2,4-dihydro-3H-pyrazol-3-one in 40ml ethanol. After 2 h of stirring the resulting green solution was distilled off in order to reduce the volume of solvents by 50%. By cooling in an ice-bath and stirring for a few hours a precipitate formed, that was filtered off, washed with water and dried overnight in vacuum. Yield: 2.09 g (63%) of yellow-greenish powder. Material was further purified by sublimation in a high vacuum.

Other inventive complexes of formula I can be prepared by a person skilled in the art by analogy with the protocol described above.

Rate onset temperature

The rate onset temperature ($T_{RO}$) is determined by loading 100 mg compound into a VTE source. As VTE source a point source for organic materials may be used as supplied by Kurt J. Lesker Company (www.lesker.com) or CreaPhys GmbH (http://www.creaphys.com). The VTE source is heated at a constant rate of 15 K/min at a pressure of less than $10^{-5}$ mbar and the temperature inside the source measured with a thermocouple. Evaporation of the compound is detected with a QCM detector which detects deposition of the compound on the quartz crystal of the detector. The deposition rate on the quartz crystal is measured in Ångstrom per second. To determine the rate onset temperature, the deposition rate is plotted against the VTE source temperature. The rate onset is the temperature at which noticeable deposition on the QCM detector occurs. For accurate results, the VTE source is heated and cooled three time and only results from the second and third run are used to determine the rate onset temperature.

To achieve good control over the evaporation rate of an organic compound, the rate onset temperature may be in the range of 200 to 255 °C. If the rate onset temperature is below 200 °C the evaporation may be too rapid and therefore difficult to control. If the rate onset temperature is above 255 °C the evaporation rate may be too low which may result in low tact time and decomposition of the organic compound in VTE source may occur due to prolonged exposure to elevated temperatures.

The rate onset temperature is an indirect measure of the volatility of a compound. The higher the rate onset temperature the lower is the volatility of a compound.

Melting point

The melting point (Tm) is determined as peak temperatures from the DSC curves of the above TGA-DSC measurement or from separate DSC measurements (Mettler Toledo DSC822e, heating of samples from room temperature to completeness of melting with heating rate 10 K/min under a stream of pure nitrogen. Sample amounts of 4 to 6 mg are placed in a 40 μL Mettler Toledo aluminum pan with lid, a <1 mm hole is pierced into the lid).

Decomposition temperature

The decomposition temperature, also named $T_{dec}$, is determined in degree Celsius.

The decomposition temperature is measured by loading a sample of 9 to 11 mg into a Mettler Toledo 100 μL aluminum pan without lid under nitrogen in a Mettler Toledo TGA-DSC 1machine. The following heating program was

used: 25°C isothermal for 3 min; 25°C to 600°C with 10 K/min.

The decomposition temperature was determined based on the onset of the decomposition in TGA.

Calculated HOMO and LUMP

The energy of the lowest unoccupied molecular orbital (LUMO) of compounds of Formula (I) and comparative compounds was calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany). The LUMO energy levels of the molecular structures are determined by applying the hybrid functional B3LYP with a Def2-TZVP basis set and the Stuttgart/Dresden (SDD) effective core potential (ECP) for the metals from the optimized geometries obtained by applying the functional BP86 with a Def2-SVP basis set the Stuttgart/Dresden (SDD) effective core potential (ECP) for the metals. All the calculations were performed in the gas phase

General procedure for fabrication of OLEDs

For the examples according to the invention and comparative examples in Table 3, a glass substrate with an anode layer comprising a first anode sub-layer of 10 nm ITO, a second anode sub-layer of 120 nm Ag and a third anode sub-layer of 8 nm ITO was cut to a size of 100 mm x 100 mm x 0.7 mm, ultrasonically washed with water for 60 minutes and then with isopropanol for 20 minutes. The plasma treatment was performed in an atmosphere comprising 97.6 vol.-% nitrogen and 2.4 vol.-% oxygen.

Then N-(9,9-diphenyl-9H-fluoren-2-yl)-N,9-diphenyl-9H-carbazol-2-amine (F18) as a hole transport matrix compound was vacuum deposited with 10 wt.% of an inventive compound of table 2 or a comparative compound as a dopant to form a hole injection layer (HIL) having a thickness 10 nm according to Table 3

Then N-(9,9-diphenyl-9H-fluoren-2-yl)-N,9-diphenyl-9H-carbazol-2-amine (F18) was vacuum deposited, to form a hole transport layer (HTL) having a thickness of 128 nm

Then N,N-di([1,1'-biphenyl]-4-yl)-3'-(9H-carbazol-9-yl)-[1,1'-biphenyl]-4-amine was vacuum deposited on the HTL, to form an electron blocking layer (EBL) having a thickness of 5 nm.

Then, an emission layer (EML) having a thickness of 20 nm is formed on the EBL by co-depositing 99 vol.-% Dibenzofuran, 7-(phenyl-2 ,3 ,4 ,5 ,6 -d )-1-[10-(phenyl-2 ,3 ,4 ,5 ,6 -d )-9-anthracenyl] [2457172-82-4] as EML host and 1 vol.-% 5H ,9H -[1]Benzothieno-[2',3':5,6][1,4]azaborino[2,3,4-kl ]phenazaborine, 2,7,11-tris(1,1-dimethylethyl)-5,9-bis [4-(1,1-dimethylethyl)phenyl] [2482607-57-6] as blue dopant.

Then, a hole blocking layer having a thickness of 5 nm is formed on the EML by depositing compound 4-([1,1'-biphenyl]-4-yl)-6-(3'-(9,9-dimethyl-9H-fluoren-4-yl)-[1,1'-biphenyl]-4-yl)-2-phenylpyrimidine.

Then, an electron transport layer having a thickness of 31 nm is formed on the hole blocking layer by co-depositing compound 6,6'-(naphthalene-1,2-diylbis(4,1-phenylene))bis(2,4-diphenyl-1,3,5-triazine) and LiQ in a ratio of 50:50 vol%.

Then Yb was evaporated at a rate of 0.01 to 1 Å/s at $10^{-7}$ mbar to form an electron injection layer (EIL) with a thickness of 2 nm on the electron transporting layer.

Ag/Mg (90 vol% of Ag) is evaporated at a rate of 0.01 to 1 Å/s at $10^{-7}$ mbar to form a cathode with a thickness of 13 nm.

Then, N-(1[1,1-'biphenyl]-4-yl)-9,9,dimethyl-N-(4-(9-phenyl-9H-carbazol-3-yl)phenyl)-9H-fluoren-2-amine} ([1242056-42-3]) (F3) was vacuum deposited on the cathode layer to form a capping layer with a thickness of 75 nm.

To assess the performance of the inventive examples compared to the prior art, the current efficiency is measured at 20°C. The current-voltage characteristic is determined using a Keithley 2635 source measure unit, by sourcing a voltage in V and measuring the current in mA flowing through the device under test. The voltage applied to the device is varied in steps of 0.1V in the range between 0V and 10V. Likewise, the luminance-voltage characteristics and CIE coordinates are determined by measuring the luminance in cd/m$^2$ using an Instrument Systems CAS-140CT array spectrometer (calibrated by Deutsche Akkreditierungsstelle (DAkkS)) for each of the voltage values. The cd/A efficiency at 10 mA/cm$^2$ is determined by interpolating the luminance-voltage and current-voltage characteristics, respectively.

In bottom emission devices, the emission is predominately Lambertian and quantified in percent external quantum efficiency (EQE). To determine the efficiency EQE in % the light output of the device is measured using a calibrated photodiode at 10 mA/cm$^2$.

In top emission devices, the emission is forward directed, non-Lambertian and also highly dependent on the mirco-cavity. Therefore, the efficiency EQE will be higher compared to bottom emission devices. To determine the efficiency EQE in % the light output of the device is measured using a calibrated photodiode at 10 mA/cm$^2$.

Lifetime LT of the device is measured at ambient conditions (20°C) and 20 mA/cm$^2$, using a Keithley 2400 sourcemeter, and recorded in hours.

The brightness of the device is measured using a calibrated photo diode. The lifetime LT is defined as the time till

the brightness of the device is reduced to 97 % of its initial value.

The increase in operating voltage ΔU is used as a measure of the operational voltage stability of the device. This increase is determined during the LT measurement and by subtracting the operating voltage after 1 hour after the start of operation of the device from the operating voltage after 100 hours.

$$\Delta U=[U100\ h)-\ U(1h)]$$

or the operating voltage after 1 hour after the start of operation of the device from the operating voltage after 400 hours.

$$\Delta U=[U400\ h)-\ U(1h)]$$

The smaller the value of ΔU the better is the operating voltage stability.

In Table 1 are shown the calculated LUMO energy levels of metal complexes of Formula (I) or (Ia). If more than one spin-state is viable, the spin-state is shown in the respective column.

**Table 1: Calculated LUMO energy levels of metal complexes of Formula (I) or (Ia)**

| Referred to as: | Ligand L | m | LUMO [eV] | Spin state |
|---|---|---|---|---|
| Comp-1 | 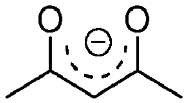 | 0 | -1.97 | α |
| MC53 | A53 | 0 | -3.52 | α |
| MC217 | E1 | 0 | -2.64 | α |
| MC220 | E5 | 0 | -3.23 | α |
| MC225 | E10 | 0 | -3.42 | α |
| MC226 | E11 | 0 | -3.53 | α |
| MC228 | E13 | 0 | -3.4 | α |
| MC229 | E14 | 0 | -3.48 | α |
| MC230 | E15 | 0 | -3.75 | α |
| MC231 | E16 | 0 | -3.51 | α |
| MC255 | E40 | 0 | -2.82 | α |
| MC256 | E41 | 0 | -2.82 | α |
| MC258 | E43 | 0 | -2.72 | α |
| MC259 | E44 | 0 | -2.82 | α |
| MC260 | E45 | 0 | -2.88 | α |
| MC262 | E47 | 0 | -3.1 | α |
| MC270 | E55 | 0 | -3.19 | α |
| MC272 | E57 | 0 | -3.45 | α |
| MC283 | E68 | 0 | -3.41 | α |
| MC289 | E74 | 0 | -3.53 | α |
| MC444 | B114 | 0 | -3.28 | α |
| MC445 | B115 | 0 | -3.53 | α |
| MC446 | B116 | 0 | -3.34 | α |
| MC447 | B117 | 0 | -3.58 | α |
| MC451 | E118 | 0 | -3.62 | α |
| MC452 | E119 | 0 | -3.54 | α |

(continued)

| Referred to as: | Ligand L | m | LUMO [eV] | Spin state |
|---|---|---|---|---|
| MC457 | E124 | 0 | -3.13 | α |
| MC471 | E138 | 0 | -3.53 | α |
| MC474 | C1 | 0 | -3.79 | α |
| MC486 | C13 | 0 | -3.65 | α |
| MC501 | C28 | 0 | -3.51 | α |
| MC502 | C29 | 0 | -3.75 | α |
| MC503 | C30 | 0 | -3.64 | α |
| MC504 | C31 | 0 | -3.87 | α |
| MC505 | E141 | 0 | -3.67 | α |
| MC506 | E141-D | 0 | | α |
| MC507 | E142 | 0 | -3.86 | α |
| MC508 | E143 | 0 | -3.9 | α |
| MC509 | E144 | 0 | -3.86 | α |
| MC514 | E149 | 0 | -3.51 | α |

Table 2 shows the melting and Rate onset temperature of a comparative example and an inventive compound.

**Table 2: Properties of a comparative and one inventive compound.**

| | **Name** | **Ligand L** | **Tm [°C]** | **Rate onset temperature [°C]** |
|---|---|---|---|---|
| Comparative example 1 | Comp-1 | 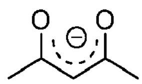 | 261 | 66 |
| Inventive example 1 | MC53 | A53 | 319 | 144 |

Comparative Compound Comp-1 (Comparative example 1) contains an acyclic acetylacetonate ligand.
The inventive compound MC53 (inventive example 1) comprises a cyclic ligand A53.
The inventive compound MC53 exhibits a higher rate onset temperature than the comparative compound Comp-1.
In addition, MC53 exhibits a good decomposition temperature of 322°C.
A high melting temperature may be beneficial for the stability of an organic electronic device at elevated temperature.
A high rate onset temperature may be beneficial for mass production by means of vacuum thermal evaporation.
Table 3 shows the setup and experimental results for several comparative and inventive devices.
In the comparative example, the metal complex CC-1 was used

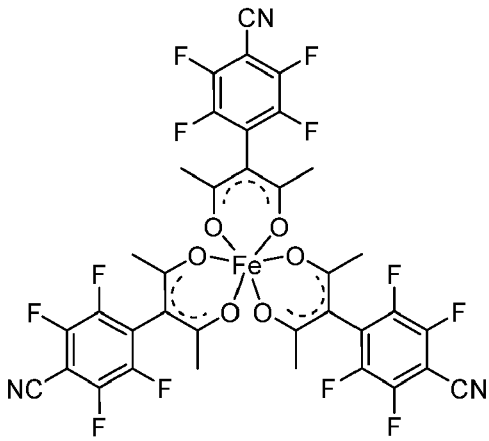

(CC-1).

**Table 3: Setup and experimental results for several comparative and inventive devices**

| Example | Metal Complex in Hole injection layer | CIEY | Voltage at 10mA/cm2 [V] | Ceff at 10mA/cm2 [cd/A] | Ceff/CIEy at 10mA/cm2 [cd/A] | EQE at 10mA/cm2 [%] | LT97 at 20mA/cm2 [h] | Vrise (1-100h) at 20mA/cm2 [V] |
|---|---|---|---|---|---|---|---|---|
| Comparative device example 1 | CC-1 | 0.044 | 3.44 | 9.6 | 218 | 20.6 | 126 | 0.371 |
| Inventive device example 1 | MC53 | 0.047 | 3.31 | 9.9 | 222 | 21.0 | 145 | 0.029 |

The comparative device (Comparative device example 1) contains the metal complex CC-1 in the hole injection layer.

The inventive device (Inventive device example 1) contains the metal complex MC53 according to formula (I) in the hole injection layer.

The inventive device (Inventive device example 1) exhibits an operational voltage of 3.31V, while the comparative device (Comparative device example 1) exhibits an operational voltage of 3.44 V. Thus, the operational voltage of the inventive device comprising a metal complex of formula (I) exhibits a remarkable lower operational voltage.

A lower operating voltage may be beneficial for the battery life of organic electronic devices, in particular mobile devices.

The inventive device (Inventive device example 1) exhibits a current efficiency of 9.9 cd/A, while the comparative device (Comparative device example 1) exhibits a current efficiency of 9.6 cd/A. Thus, the current efficiency of the inventive device comprising a metal complex of formula (I) exhibits a remarkable higher current efficiency.

A high current efficiency may be beneficial for reduced power consumption and improved battery life, in particular in mobile devices.

The inventive device (Inventive device example 1) exhibits an EQE of 21.0%, while the comparative device (Comparative device example 1) exhibits an EQE of 20.6%. Thus, the EQE of the inventive device comprising a metal complex of formula (I) exhibits a remarkable higher EQE.

A high EQE may be beneficial for reduced power consumption and improved battery life, in particular in mobile devices.

The inventive device (Inventive device example 1) exhibits a lifetime of 145 h, while the comparative device (Comparative device example 1) exhibits a lifetime of 126 h. Thus, the lifetime of the inventive device comprising a metal complex of formula (I) exhibits a remarkable higher lifetime.

A long lifetime may result in improved long-term stability of electronic devices.

The inventive device (Inventive device example 1) exhibits a voltage rise (Vrise) of 0.029 V, while the comparative device (Comparative device example 1) exhibits a voltage rise of 0.371 V. Thus, the voltage rise of the inventive device comprising a metal complex of formula (I) exhibits a remarkable lower voltage rise.

A low voltage rise over time may result in improved long-term stability of electronic devices.

The particular combinations of elements and features in the above detailed embodiments are exemplary only; the interchanging and substitution of these teachings with other teachings in this and the patents/applications incorporated by reference are also expressly contemplated. As those skilled in the art will recognize, variations, modifications, and other implementations of what is described herein can occur to those of ordinary skill in the art without departing from the spirit and the scope of the invention as claimed. Accordingly, the foregoing description is by way of example only and is not intended as limiting. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. The invention's scope is defined in the following claims and the equivalents thereto. Furthermore, reference signs used in the description and claims do not limit the scope of the invention as claimed.

## Claims

1. A organic electronic device comprising:
a first electrode, a second electrode, and a semiconductor layer arranged between the first and the second electrode wherein the semiconductor layer comprises a metal complex of Formula (I):

$$O{=}V(L)_2(AL)_m \qquad (I)$$

wherein:

L is a ligand independently selected from formula (II)

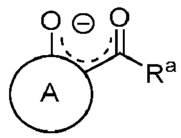
(II),

wherein
A is selected from a substituted or unsubstituted $C_3$ to $C_{40}$ carbocyclic ring or ring system, substituted or unsubstituted $C_2$ to $C_{40}$ heterocyclic ring or ring system, substituted or unsubstituted $C_6$ to $C_{40}$ aryl ring or ring system, or substituted or unsubstituted $C_2$ to $C_{40}$ heteroaryl ring or ring system, wherein the carbocyclic ring or the heterocyclic ring may contain one or more double bonds, and wherein the ring system may comprise two or three rings, preferably two rings;
$R^a$ is selected from CN, substituted or unsubstituted $C_1$ to $C_{20}$ alkyl, $CH_3$, $CH_2D$, $CHD_2$, $CD_3$, a partially fluorinated or perfluorinated $C_1$ to $C_{20}$ alkyl, $CFH_2$, CFDH, $CFD_2$, $CF_2H$, $CF_2D$, $CF_3$, substituted or unsubstituted $C_1$ to $C_{20}$ alkenyl, substituted or unsubstituted $C_1$ to $C_{20}$ alkinyl, substituted or unsubstituted $C_3$ to $C_{40}$ cycloalkyl, substituted or unsubstituted $C_2$ to $C_{40}$ heterocycloalkyl, substituted or unsubstituted $C_3$ to $C_{40}$ carbocyclyl ring, substituted or unsubstituted $C_2$ to $C_{40}$ heterocyclyl, substituted or unsubstituted $C_2$ to $C_{40}$ heteroaryl, or substituted or unsubstituted $C_6$ to $C_{40}$ aryl;
AL is an ancillary ligand;
m is an integer selected from 0 to 2.

2. The organic electronic device of claim 1, whereby the organic electronic device is an electroluminescent device, an organic electroluminescent device, an organic light emitting diode (OLED), a light emitting device, a thin film transistor, a battery, a display device, an organic photovoltaic cell (OPV), an organic solar cell (OSC), or an organic photodetector (OPD).

3. The organic electronic device of Claim 1, whereby the metal complex of formula (I) does not include the following compounds:

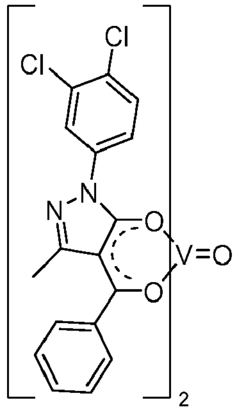

and

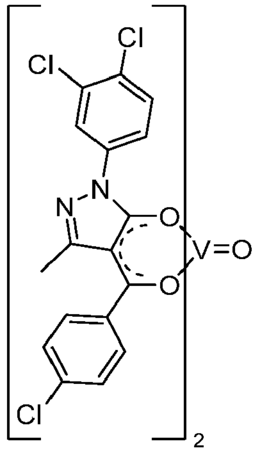

.

**4.** The organic electronic device of any of the claims 1 to 3, wherein L is a ligand of formula (IIb):

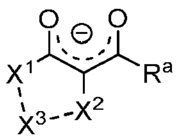

(IIb),

wherein the dashed lines in formula (IIb) denote a single bond or a double bond;
$X^1$ is selected from a direct bond, N, O, $NR^1$, $CR^1$;
$X^2$ is selected from N, O, $CR^2$, CO, $SO_2$;
$X^3$ is selected from N, O, $CR^3$, $NR^3$ or substituted or unsubstituted $C_1$ to $C_3$ alkylenediyl group;
$R^1$ is selected from substituted or unsubstituted $C_1$ to $C_{12}$ alkyl, substituted or unsubstituted $C_6$ to $C_{19}$ aryl or $C_2$ to $C_{20}$ heteroaryl group;
$R^2$ is selected from H, D, CN, substituted or unsubstituted $C_1$ to $C_{12}$ alkyl, substituted or unsubstituted $C_3$ to $C_5$ alkenyl, substituted or unsubstituted $C_6$ to $C_{19}$ aryl or $C_2$ to $C_{20}$ heteroaryl group;
$R^3$ is selected from H, D, substituted or unsubstituted $C_1$ to $C_{12}$ alkyl, substituted or unsubstituted $C_3$ to $C_5$ alkenyl, substituted or unsubstituted $C_6$ to $C_{19}$ aryl or $C_2$ to $C_{20}$ heteroaryl group;
wherein two of $X^1$, $X^3$, $R^1$ and $R^3$ may form a 5 to 7 membered ring;
$R^a$ is selected from CN, substituted or unsubstituted $C_1$ to $C_{20}$ alkyl, $CH_3$, $CH_2D$, $CHD_2$, $CD_3$, a partially fluorinated or perfluorinated $C_1$ to $C_{20}$ alkyl, $CFH_2$, CFDH, $CFD_2$, $CF_2H$, $CF_2D$, $CF_3$, substituted or unsubstituted $C_1$ to $C_{20}$ alkenyl, substituted or unsubstituted $C_1$ to $C_{20}$ alkinyl, substituted or unsubstituted $C_3$ to $C_{40}$ cycloalkyl, substituted or unsubstituted $C_2$ to $C_{40}$ heterocycloalkyl, substituted or unsubstituted $C_3$ to $C_{40}$ carbocyclyl ring, substituted or unsubstituted $C_2$ to $C_{40}$ heterocyclyl, substituted or unsubstituted $C_2$ to $C_{40}$ heteroaryl, or substituted or unsubstituted $C_6$ to $C_{40}$ aryl.

**5.** The organic device of any of the claims 1 to 4, wherein L is a ligand of formulae (IIc) to (IIf):

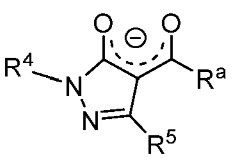

(IIc),

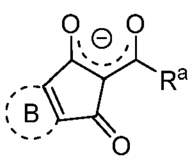

(IId),

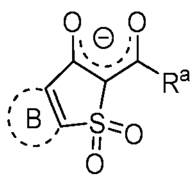

(IIe),

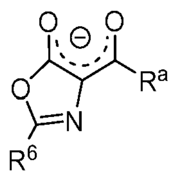

(IIf),

wherein

$R^4$ is selected from unsubstituted and substituted $C_1$ to $C_{12}$ alkyl, substituted or unsubstituted $C_6$ to $C_{19}$ aryl, substituted or unsubstituted $C_2$ to $C_{20}$ heteroaryl, substituted or unsubstituted 6-membered heteroaryl, preferably $R^2$ is selected from substituted or unsubstituted $C_6$ to $C_{19}$ aryl, substituted or unsubstituted $C_2$ to $C_{20}$ heteroaryl, substituted or unsubstituted 6-membered heteroaryl;
$R^5$ is selected from substituted or unsubstituted $C_1$ to $C_{12}$ alkyl, substituted or unsubstituted $C_6$ to $C_{19}$ aryl,

substituted or unsubstituted $C_2$ to $C_{20}$ heteroaryl, substituted or unsubstituted 6-membered heteroaryl, or CN; $R^6$ is selected from unsubstituted and substituted $C_1$ to $C_{12}$ alkyl, substituted or unsubstituted $C_6$ to $C_{19}$ aryl, substituted or unsubstituted $C_2$ to $C_{20}$ heteroaryl, substituted or unsubstituted 6-membered heteroaryl;
B is selected from substituted or unsubstituted $C_6$ to $C_{19}$ aryl, substituted or unsubstituted $C_2$ to $C_{20}$ heteroaryl ring or a ring system, wherein the ring system may comprise one or two rings, preferably one ring;
$R^a$ is selected from CN, substituted or unsubstituted $C_1$ to $C_{20}$ alkyl, $CH_3$, $CH_2D$, $CHD_2$, $CD_3$, a partially fluorinated or perfluorinated $C_1$ to $C_{20}$ alkyl, $CFH_2$, CFDH, $CFD_2$, $CF_2H$, $CF_2D$, $CF_3$, substituted or unsubstituted $C_1$ to $C_{20}$ alkenyl, substituted or unsubstituted $C_1$ to $C_{20}$ alkinyl, substituted or unsubstituted $C_3$ to $C_{40}$ cycloalkyl, substituted or unsubstituted $C_2$ to $C_{40}$ heterocycloalkyl, substituted or unsubstituted $C_3$ to $C_{40}$ carbocyclyl ring, substituted or unsubstituted $C_2$ to $C_{40}$ heterocyclyl, substituted or unsubstituted $C_2$ to $C_{40}$ heteroaryl, or substituted or unsubstituted $C_6$ to $C_{40}$ aryl.

6. The organic electronic device of any of the claims 1 to 5 wherein L is selected from formulae (IIg) or (IIh):

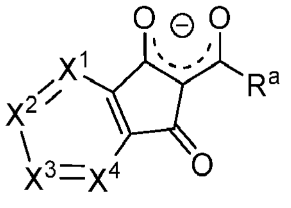 (IIg), 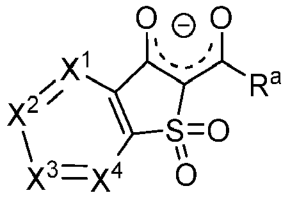 (IIh),

wherein

$X^1$ is selected from $CR^{21}$ or N;
$X^2$ is selected from $CR^{22}$ or N;
$X^3$ is selected from $CR^{23}$ or N;
$X^4$ is selected from $CR^{24}$ or N;
wherein 0, 1 or 2 of the group consisting of $X^1$, $X^2$, $X^3$, $X^4$ are selected from N;
$R^{21}$ to $R^{24}$ are independently selected from H, D, halogen, Cl, F, CN, $NO_2$, $C_1$ to $C_{12}$ alkyl, $C_1$ to $C_{12}$ alkoxy, partially or perfluorinated $C_1$ to $C_{12}$ alkyl, $CF_3$, $CF_2R$, $CFR_2$, $CF_2H$, $CFH_2$, partially or perfluorinated $C_1$ to $C_{12}$ alkoxy, or a combination thereof, wherein R is H or D, preferably H; and whereby any $R^k$ to $R^{k+1}$ may form a ring, wherein k is an integer from 1 to 3;
$R^a$ is selected from CN, substituted or unsubstituted $C_1$ to $C_{20}$ alkyl, $CH_3$, $CH_2D$, $CHD_2$, $CD_3$, a partially fluorinated or perfluorinated $C_1$ to $C_{20}$ alkyl, $CFH_2$, CFDH, $CFD_2$, $CF_2H$, $CF_2D$, $CF_3$, substituted or unsubstituted $C_1$ to $C_{20}$ alkenyl, substituted or unsubstituted $C_1$ to $C_{20}$ alkinyl, substituted or unsubstituted $C_3$ to $C_{40}$ cycloalkyl, substituted or unsubstituted $C_2$ to $C_{40}$ heterocycloalkyl, substituted or unsubstituted $C_3$ to $C_{40}$ carbocyclyl ring, substituted or unsubstituted $C_2$ to $C_{40}$ heterocyclyl, substituted or unsubstituted $C_2$ to $C_{40}$ heteroaryl, or substituted or unsubstituted $C_6$ to $C_{40}$ aryl.

7. The organic electronic device of any of the claims 1 to 6, whereby one or more substituents of A are independently selected from D, electron-withdrawing group, =O, =S, CN, halogen, Cl, F, substituted or unsubstituted $C_1$ to $C_{20}$ alkyl, $CH_3$, $CH_2D$, $CHD_2$, $CD_3$, a partially fluorinated or perfluorinated $C_1$ to $C_{20}$ alkyl, $CFH_2$, CFDH, $CFD_2$, $CF_2H$, $CF_2D$, $CF_3$, substituted or unsubstituted $C_1$ to $C_{20}$ alkenyl, substituted or unsubstituted $C_1$ to $C_{20}$ alkinyl, substituted or unsubstituted $C_3$ to $C_{40}$ cycloalkyl, substituted or unsubstituted $C_2$ to $C_{40}$ heterocycloalkyl, substituted or unsubstituted $C_3$ to $C_{40}$ carbocyclyl ring, or substituted or unsubstituted $C_2$ to $C_{40}$ heterocyclyl, substituted or unsubstituted $C_2$ to $C_{40}$ heteroaryl, or substituted or unsubstituted $C_6$ to $C_{40}$ aryl.

8. The organic electronic device of any of the claims 1 to 7, whereby one or more substituents of A are independently selected from D, electron-withdrawing group, =O, =S, CN, halogen, Cl, F, substituted or unsubstituted $C_1$ to $C_{12}$ alkyl, $CH_3$, $CH_2D$, $CHD_2$, $CD_3$, a partially fluorinated or perfluorinated $C_1$ to $C_{12}$ alkyl, $CFH_2$, CFDH, $CFD_2$, $CF_2H$, $CF_2D$, $CF_3$, substituted or unsubstituted $C_1$ to $C_{12}$ alkenyl, substituted or unsubstituted $C_1$ to $C_{12}$ alkinyl, substituted or unsubstituted $C_5$ to $C_{19}$ cycloalkyl, substituted or unsubstituted $C_2$ to $C_{20}$ heterocycloalkyl, substituted or unsubstituted $C_5$ to $C_{19}$ carbocyclyl ring, or substituted or unsubstituted $C_2$ to $C_{20}$ heterocyclyl, substituted or unsubstituted $C_2$ to $C_{20}$ heteroaryl, or substituted or unsubstituted $C_6$ to $C_{19}$ aryl.

9. The organic electronic device of any of the claims 1 to 8, wherein one or more substituents of A are independently selected from D, electron-withdrawing group, =O, =S, CN, halogen, Cl, F, substituted or unsubstituted $C_1$ to $C_{20}$ alkyl,

$CH_3$, $CH_2D$, $CHD_2$, $CD_3$, a partially fluorinated or perfluorinated $C_1$ to $C_{20}$ alkyl, $CFH_2$, CFDH, $CFD_2$, $CF_2H$, $CF_2D$, $CF_3$, substituted or unsubstituted $C_1$ to $C_{20}$ alkenyl, substituted or unsubstituted $C_1$ to $C_{20}$ alkinyl, substituted or unsubstituted $C_3$ to $C_{40}$ cycloalkyl, substituted or unsubstituted $C_2$ to $C_{40}$ heterocycloalkyl, substituted or unsubstituted $C_3$ to $C_{40}$ carbocyclyl ring, substituted or unsubstituted $C_2$ to $C_{40}$ heterocyclyl, substituted or unsubstituted $C_2$ to $C_{40}$ heteroaryl, or substituted or unsubstituted $C_6$ to $C_{40}$ aryl;
and wherein the one or more substituents on $R^a$ are independently selected from an D, electron-withdrawing group, halogen, Cl, F, CN, partially or perfluorinated $C_1$ to $C_8$ alkyl, $CH_3$, $CH_2D$, $CHD_2$, $CD_3$, $CFH_2$, CFDH, $CFD_2$, $CF_2H$, $CF_2D$, $CF_3$, partially or perfluorinated $C_1$ to $C_8$ alkoxy, $OCH_3$, $OCH_2D$, $OCHD_2$, $OCD_3$, $OCFH_2$, OCFDH, $OCFD_2$, $OCF_2H$, $OCF_2D$, $OCF_3$.

**10.** The organic electronic device of any of the claims 1 to 9 whereby both L are the same.

**11.** The organic electronic device of any of the claims 1 to 9, whereby the first electrode is an anode layer and the second electrode is a cathode layer and wherein the organic semiconductor layer is arranged adjacent to the anode layer, preferably the organic semiconductor layer is arranged in direct contact with the anode layer.

**12.** The organic electronic device of any of the claims 1 to 11, furthermore comprising a photoactive layer which can be a light-absorbing layer or light-emitting layer in particular a light-emitting layer

**13.** The organic electronic device of any of the claims 1 to 12, wherein the semiconductor layer is a hole injection layer, a hole transport layer or a hole extraction layer.

**14.** The organic electronic device according to any of the claims 1 to 13, whereby the organic electronic device is a display device.

**15.** A compound of formula (Ia):

$$O{=}V(L)_2(AL)_m \qquad (Ia)$$

wherein:

L is a ligand independently selected from formula (IIa)

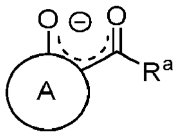

(IIa),

wherein
A is selected from a substituted or unsubstituted $C_3$ to $C_{40}$ carbocyclic ring or ring system, substituted or unsubstituted $C_2$ to $C_{40}$ heterocyclic ring or ring system, substituted or unsubstituted $C_6$ to $C_{40}$ aryl ring or ring system, or substituted or unsubstituted $C_2$ to $C_{40}$ heteroaryl ring or ring system, wherein the carbocyclic ring or the heterocyclic ring may contain one or more double bonds, and wherein the ring system may comprise two or three rings, preferably two rings;
$R^a$ is selected from CN, substituted or unsubstituted $C_1$ to $C_{20}$ alkyl, $CH_3$, $CH_2D$, $CHD_2$, $CD_3$, a partially fluorinated or perfluorinated $C_1$ to $C_{20}$ alkyl, $CFH_2$, CFDH, $CFD_2$, $CF_2H$, $CF_2D$, $CF_3$, substituted or unsubstituted $C_1$ to $C_{20}$ alkenyl, substituted or unsubstituted $C_1$ to $C_{20}$ alkinyl, substituted or unsubstituted $C_3$ to $C_{40}$ cycloalkyl, substituted or unsubstituted $C_2$ to $C_{40}$ heterocycloalkyl, substituted or unsubstituted $C_3$ to $C_{40}$ carbocyclyl ring, substituted or unsubstituted $C_2$ to $C_{40}$ heterocyclyl, substituted or unsubstituted $C_2$ to $C_{40}$ heteroaryl, or substituted or unsubstituted $C_6$ to $C_{40}$ aryl;
AL is an ancillary ligand;
m is an integer selected from 0 to 2,
whereby the following compounds are excluded:

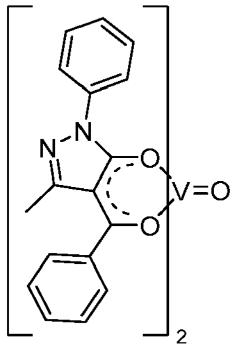 , 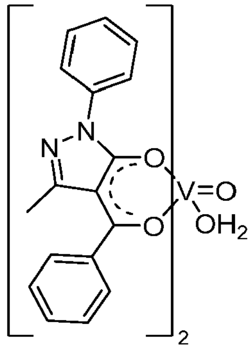 , 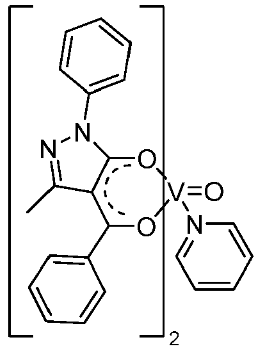 , 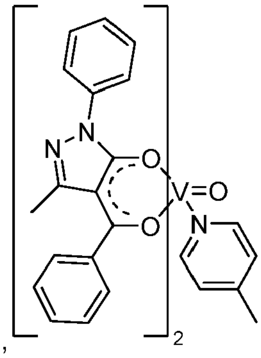 ,

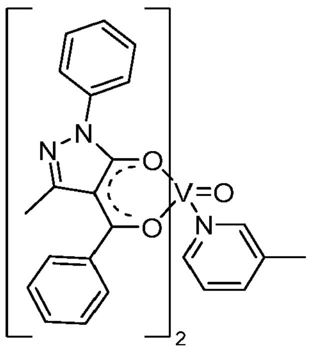 , 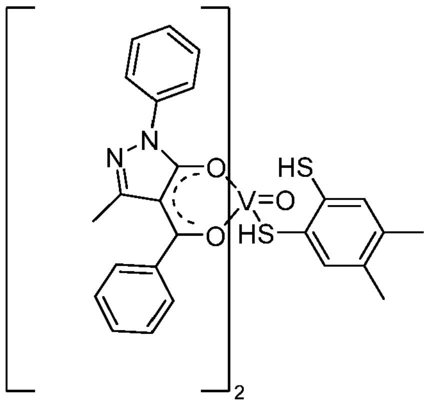 ,

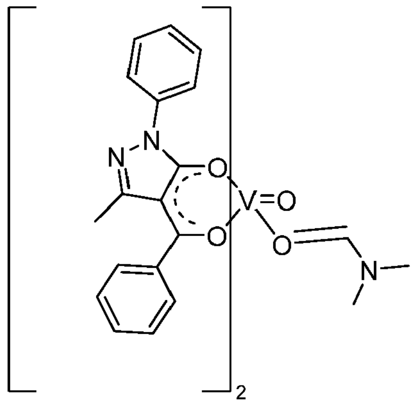 ,

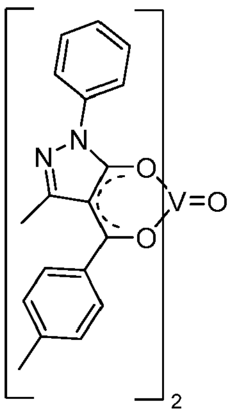 , 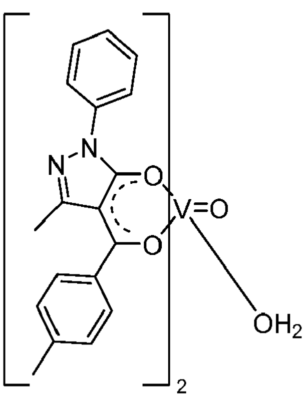 , 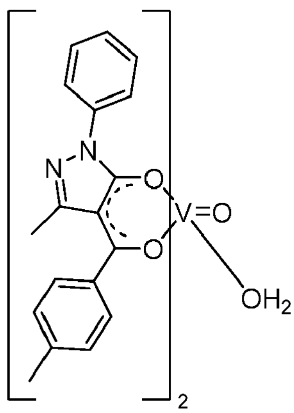 , 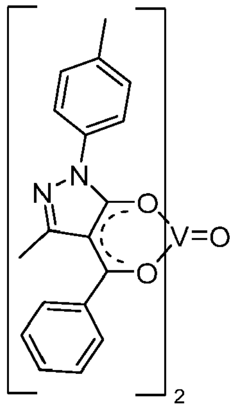 ,

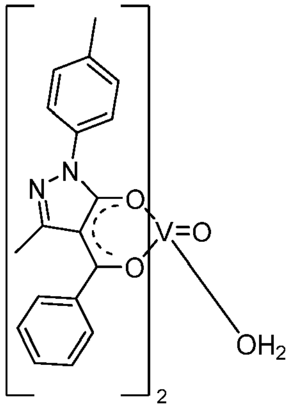 , 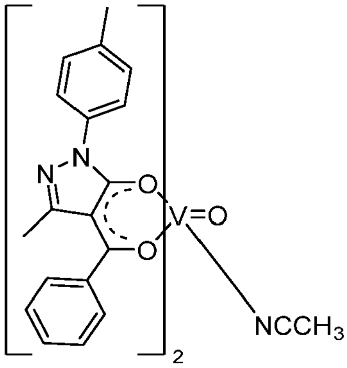 , 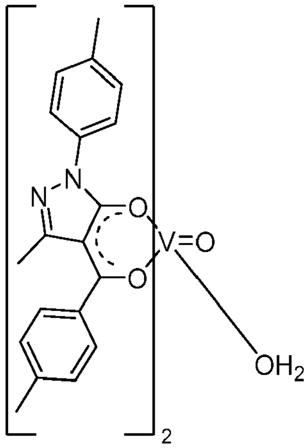 ,

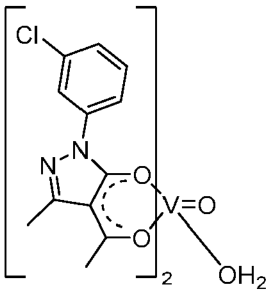 , 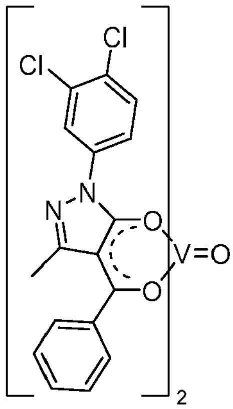 , 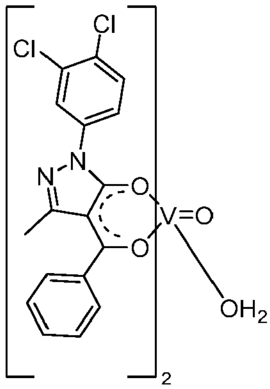 , 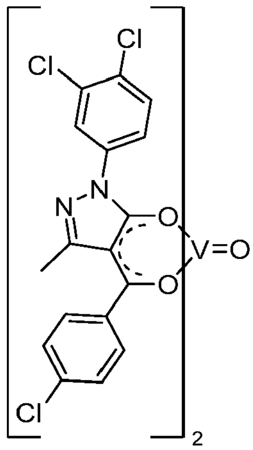 ,

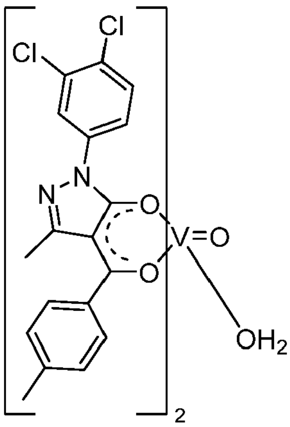 , 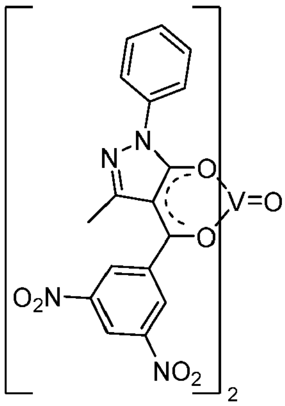 , 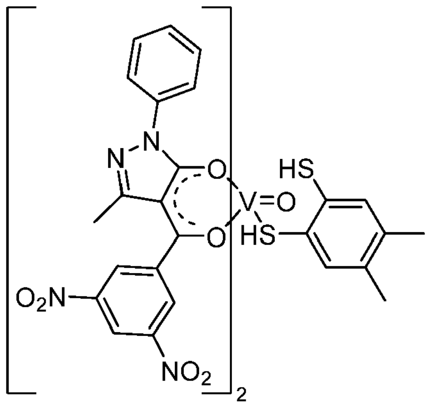 ,

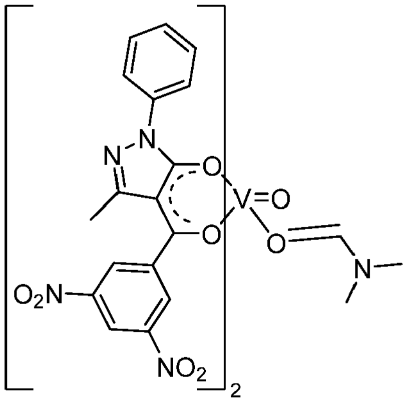

,

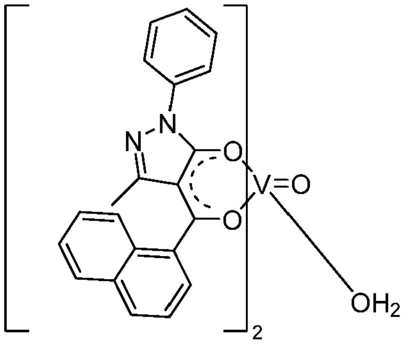

,

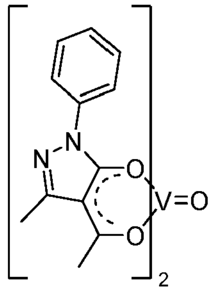

,

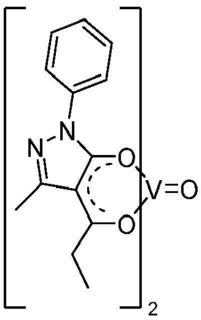

,

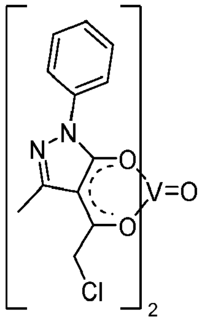

,

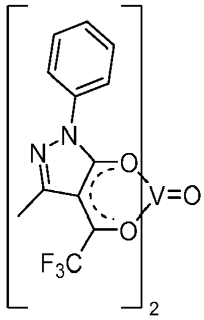

,

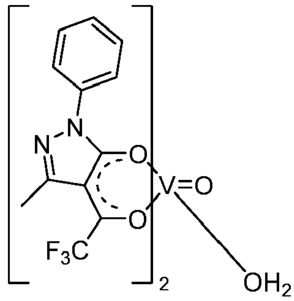

,

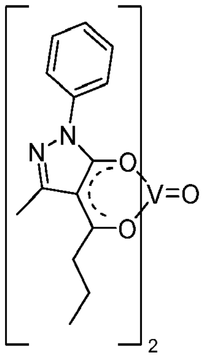

,

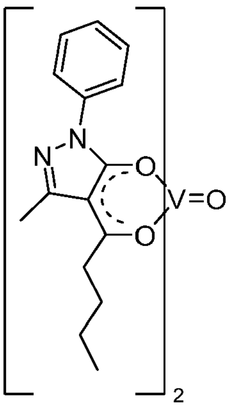

,

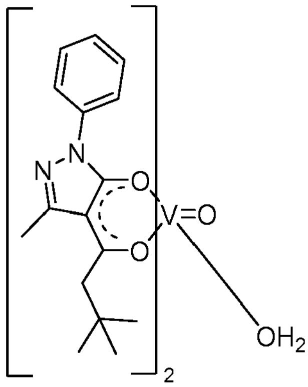

,

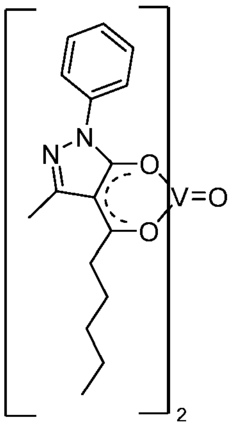

,

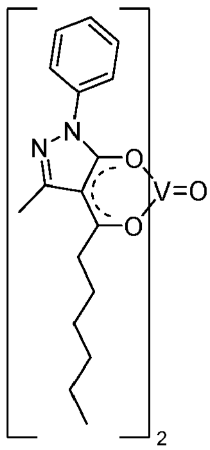

,

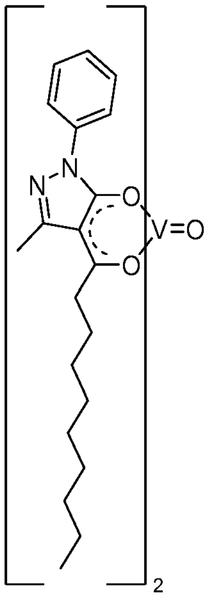, 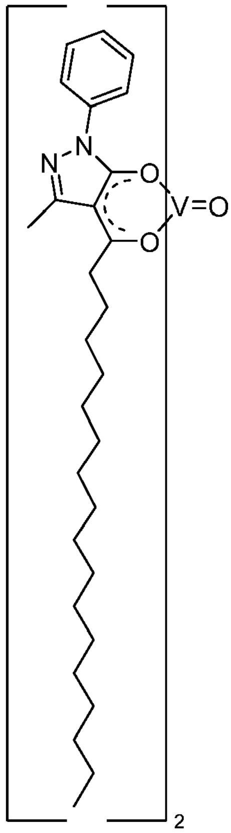, 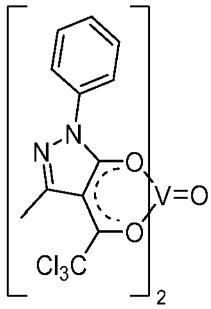, 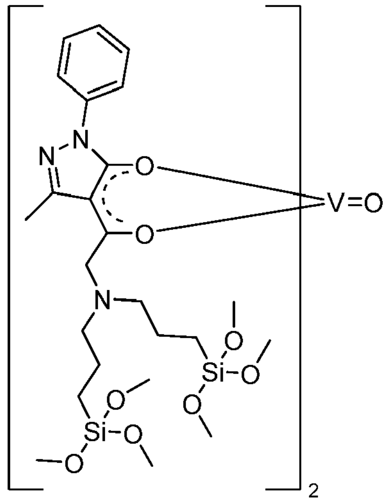,

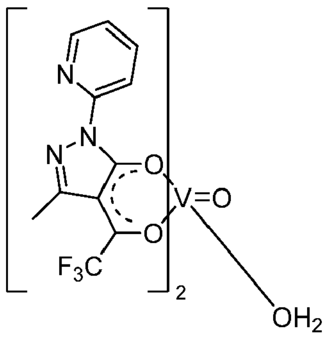, 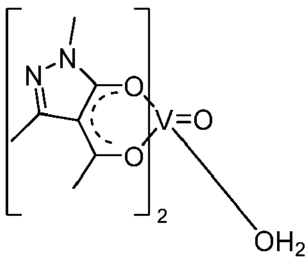, 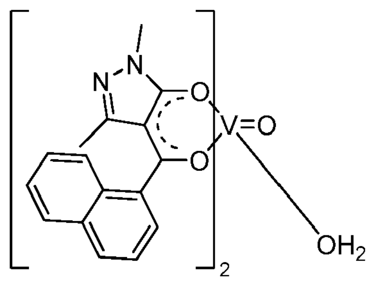,

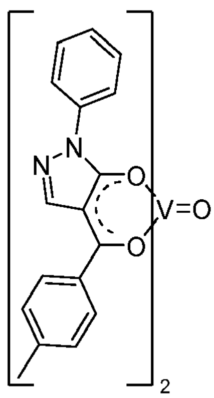.

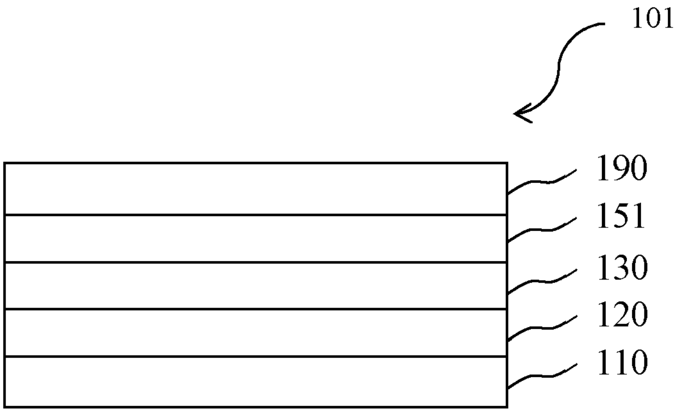


Fig.1

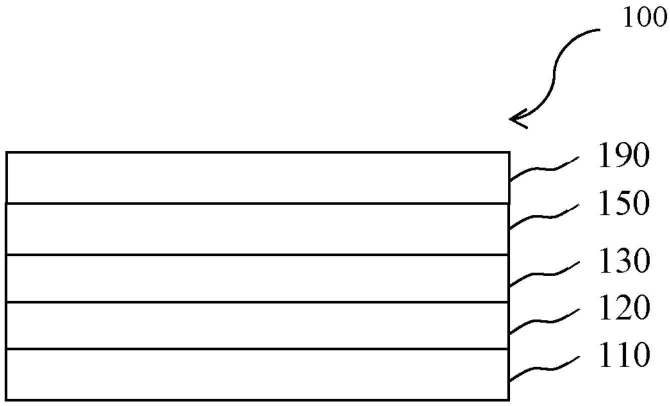


Fig. 2

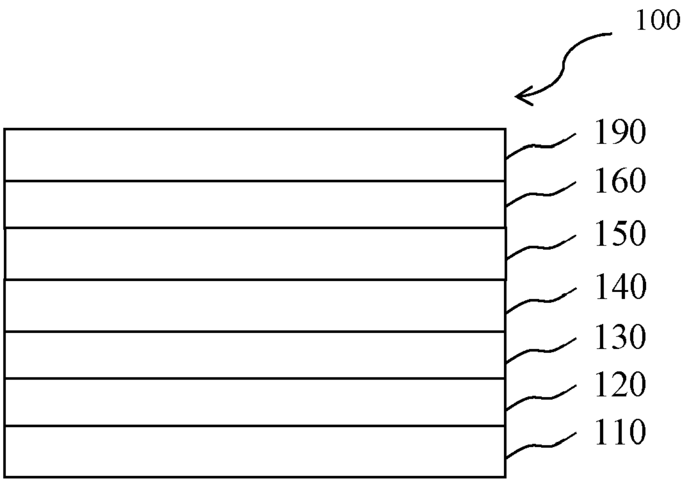


Fig. 3

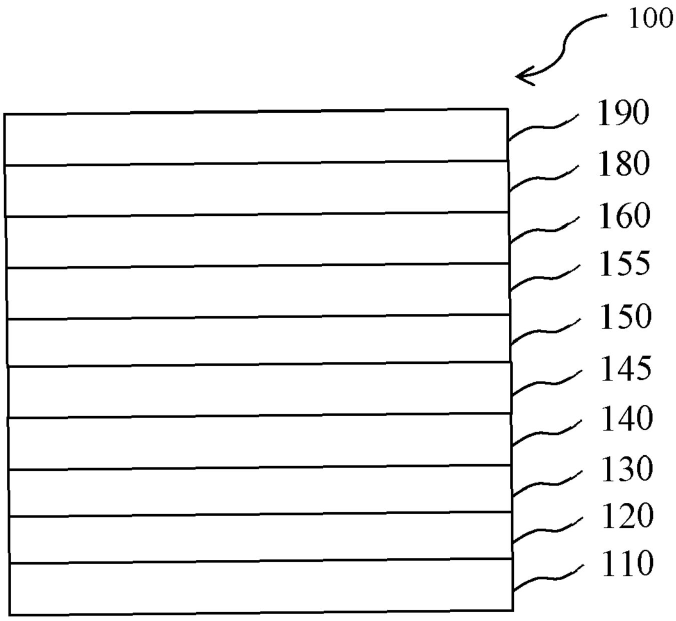


Fig. 4

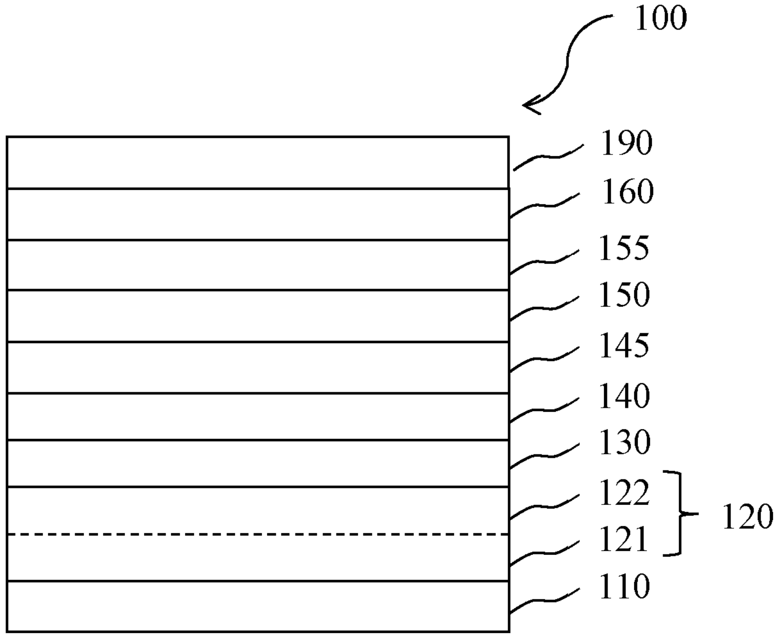


Fig. 5

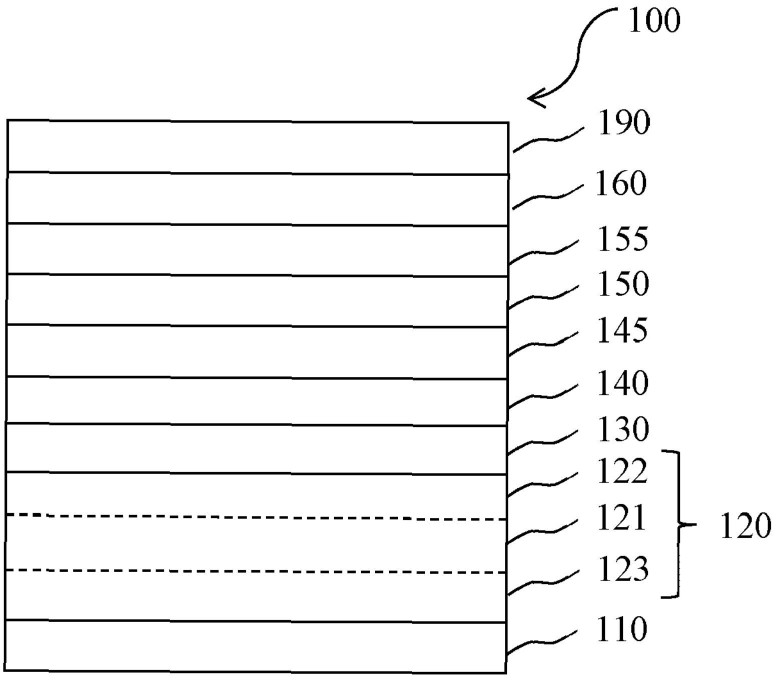


Fig. 6

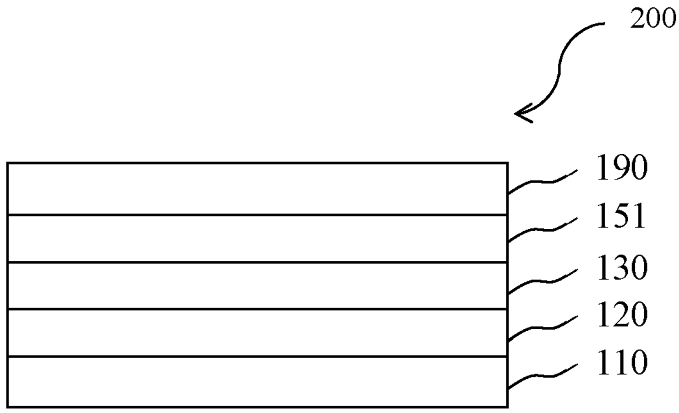


Fig.7

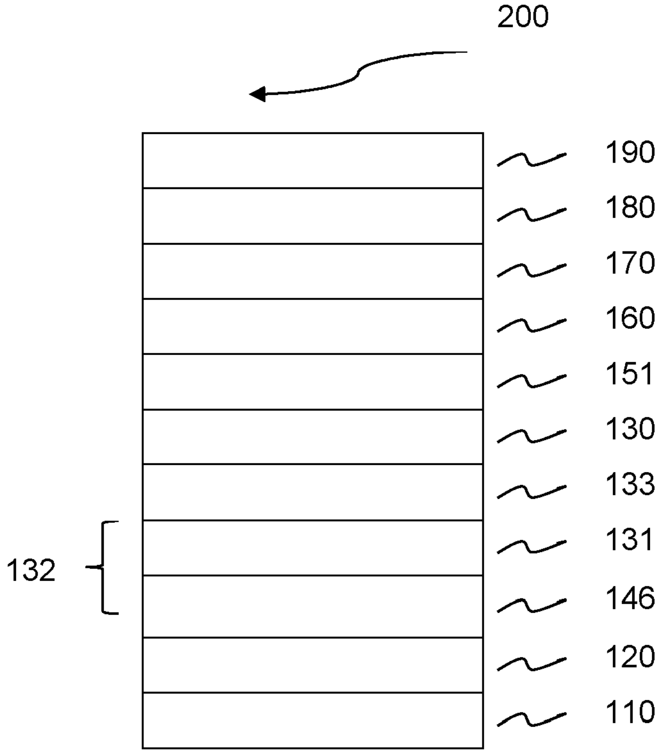


Fig. 8

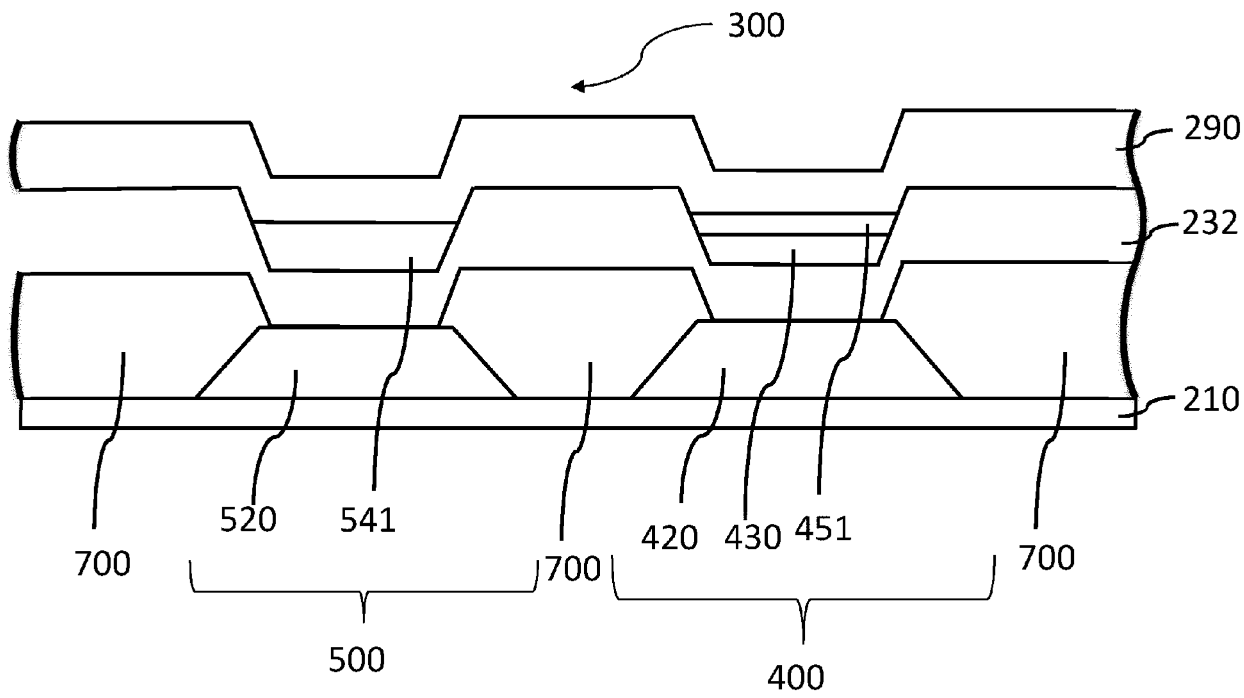


Fig. 9

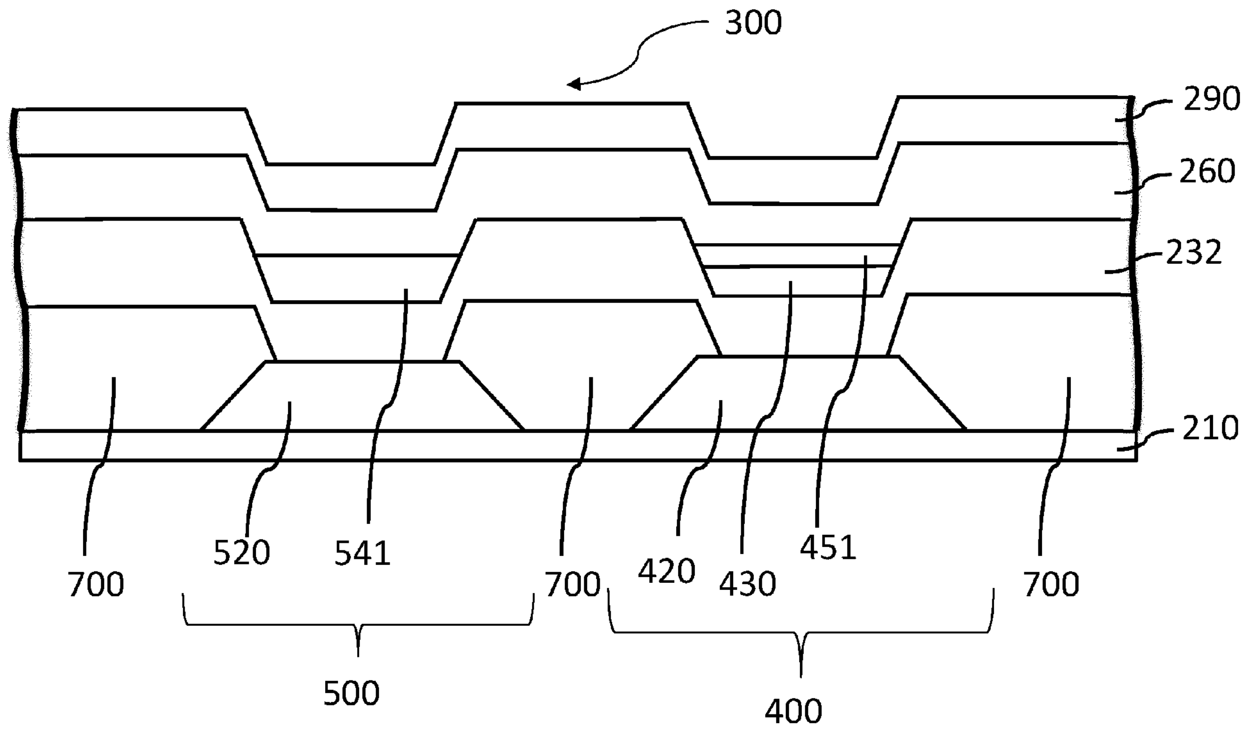


Fig. 10

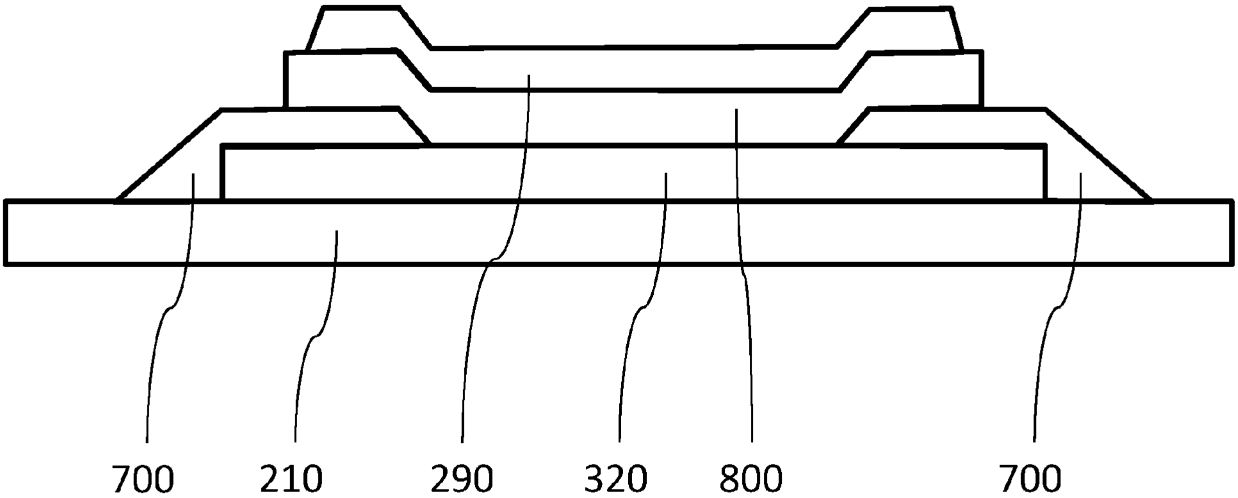


Fig. 11

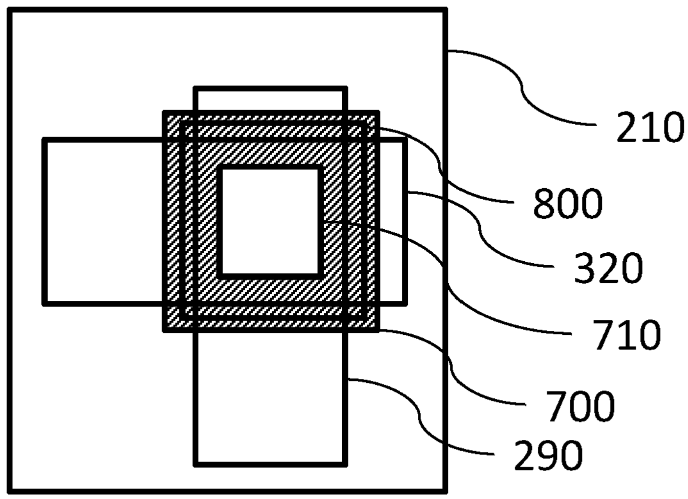


Fig. 12

Europäisches Patentamt
European Patent Office
Office européen des brevets

# EUROPEAN SEARCH REPORT

Application Number
EP 24 15 6446

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | FU GUORUI ET AL: "An efficient and weak efficiency-roll-off near-infrared (NIR) polymer light-emitting diode (PLED) based on a PVK-supported Zn 2+ -Yb 3+ -containing metallopolymer", JOURNAL OF MATERIALS CHEMISTRY C, vol. 6, no. 15, 1 January 2018 (2018-01-01), pages 4114-4121, XP093013435, GB ISSN: 2050-7526, DOI: 10.1039/C7TC05400A Retrieved from the Internet: URL:https://pubs.rsc.org/en/content/articlepdf/2018/tc/c7tc05400a> * abstract * * page 4115 - page 4116 * * page 4119 - page 4120; figure 6 * ----- | 1-15 | INV. H10K85/30 |
| A | EP 2 546 902 A1 (UNIVERSAL DISPLAY CORP [US]) 16 January 2013 (2013-01-16) * paragraph [0054] - paragraph [0067]; claims 1-15; figure 3; table 1 * ----- | 1-15 | |
| A | US 2012/138916 A1 (UENO SHIGEHIRO [JP] ET AL) 7 June 2012 (2012-06-07) * paragraph [0179] - paragraph [0219]; claims 1-15; compound 1 * ----- -/-- | 1-15 | TECHNICAL FIELDS SEARCHED (IPC) H10K |

The present search report has been drawn up for all claims

2

| Place of search | Date of completion of the search | Examiner |
|---|---|---|
| The Hague | 27 August 2024 | Konrádsson, Ásgeir |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 3

Europäisches Patentamt
European Patent Office
Office européen des brevets

# EUROPEAN SEARCH REPORT

Application Number
EP 24 15 6446

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MARCHETTI FABIO ET AL: "Synthesis and characterization of novel oxovanadium(IV) complexes with 4-acyl-5-pyrazolone donor ligands: Evaluation of their catalytic activity for the oxidation of styrene derivatives", APPLIED CATALYSIS A: GENERAL, vol. 378, no. 2, 23 February 2010 (2010-02-23), pages 211-220, XP093192258, AMSTERDAM, NL ISSN: 0926-860X, DOI: 10.1016/j.apcata.2010.02.022 | 15 | |
| A | * the whole document * ----- | 1-14 | |
| X | PARIHAR SANJAY ET AL: "Synthesis and Crystal Structure of an Oxovanadium(IV) Complex with a Pyrazolone Ligand and Its Use as a Heterogeneous Catalyst for the Oxidation of Styrene under Mild Conditions", INORGANIC CHEMISTRY, vol. 51, no. 2, 21 December 2011 (2011-12-21), pages 1152-1161, XP093192259, Easton , US ISSN: 0020-1669, DOI: 10.1021/ic202396q | 15 | TECHNICAL FIELDS SEARCHED (IPC) |
| A | * the whole document * ----- -/-- | 1-14 | |

The present search report has been drawn up for all claims

2

| Place of search | Date of completion of the search | Examiner |
|---|---|---|
| The Hague | 27 August 2024 | Konrádsson, Ásgeir |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 24 15 6446

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br><br><br><br><br><br><br><br><br><br>A | PARIHAR SANJAY ET AL: "Novel oxovanadium(iv) complexes with 4-acyl pyrazolone ligands: synthesis, crystal structure and catalytic activity towards the oxidation of benzylic alcohols",<br>RSC ADVANCES,<br>vol. 4, no. 20,<br>20 December 2013 (2013-12-20), page 10295,<br>XP093192260,<br>GB<br>ISSN: 2046-2069, DOI: 10.1039/c3ra46896h<br>* the whole document *<br>----- | 15<br><br><br><br><br><br><br><br><br><br><br>1-14 | |
| | | | TECHNICAL FIELDS SEARCHED (IPC) |

The present search report has been drawn up for all claims

| Place of search | Date of completion of the search | Examiner |
|---|---|---|
| The Hague | 27 August 2024 | Konrádsson, Ásgeir |

2

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 24 15 6446

This annex lists the patent family members relating to the patent documents cited in the above-mentioned European search report. The members are as contained in the European Patent Office EDP file on
The European Patent Office is in no way liable for these particulars which are merely given for the purpose of information.

27-08-2024

| Patent document cited in search report | Publication date | Patent family member(s) | Publication date |
|---|---|---|---|
| EP 2546902 A1 | 16-01-2013 | CN 102881842 A | 16-01-2013 |
| | | EP 2546902 A1 | 16-01-2013 |
| | | JP 6153703 B2 | 28-06-2017 |
| | | JP 2013026220 A | 04-02-2013 |
| | | KR 20130009625 A | 23-01-2013 |
| | | US 2013015430 A1 | 17-01-2013 |
| | | US 2015255738 A1 | 10-09-2015 |
| US 2012138916 A1 | 07-06-2012 | CN 102598342 A | 18-07-2012 |
| | | EP 2495782 A1 | 05-09-2012 |
| | | JP 4798282 B2 | 19-10-2011 |
| | | JP 2011096733 A | 12-05-2011 |
| | | KR 20120100893 A | 12-09-2012 |
| | | US 2012138916 A1 | 07-06-2012 |
| | | WO 2011052648 A1 | 05-05-2011 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 2722908 A1


### Non-patent literature cited in the description


- *CHEMICAL ABSTRACTS*, 207739-72-8
- Kaiser Wilhelm Platz. *Max Planck Institute für Kohlenforschung*, vol. 1, 45470
- Rolandstrasse. *FAccTs GmbH*, vol. 67, 50677
- *FAccTs GmbH, Rolandstrasse*, vol. 67, 50677
- **YASUHIKO SHIROTA** ; **HIROSHI KAGEYAMA**. *Chem. Rev.*, 2007, vol. 107, 953-1010